(19) Europäisches Patentamt
European Patent Office
Office européen des brevets

(11) EP 4 031 638 B1

(12) # EUROPÄISCHE PATENTSCHRIFT

(45) Veröffentlichungstag und Bekanntmachung des Hinweises auf die Patenterteilung:
**14.01.2026 Patentblatt 2026/03**

(21) Anmeldenummer: **20768621.3**

(22) Anmeldetag: **15.09.2020**

(51) Internationale Patentklassifikation (IPC):
***C09K 11/06*** *(2006.01)* ***H10K 85/60*** *(2023.01)*

(52) Gemeinsame Patentklassifikation (CPC):
**C09K 11/06; H10K 85/615; H10K 85/654; H10K 85/6572; H10K 85/6574; H10K 85/6576;**
C09K 2211/1011; C09K 2211/1014; C09K 2211/1029; C09K 2211/1059; C09K 2211/1088; C09K 2211/1092; C09K 2211/185; H10K 50/11; H10K 71/00; (Forts.)

(86) Internationale Anmeldenummer:
**PCT/EP2020/075689**

(87) Internationale Veröffentlichungsnummer:
**WO 2021/052921 (25.03.2021 Gazette 2021/12)**

(54) **MISCHUNG VON ZWEI HOSTMATERIALIEN UND ORGANISCHE ELEKTROLUMINESZIERENDE VORRICHTUNG DAMIT**

MIXTURE OF TWO HOST MATERIALS, AND ORGANIC ELECTROLUMINESCENT DEVICE COMPRISING SAME

MÉLANGE DE DEUX MATÉRIAUX HÔTES ET DISPOSITIF ÉLECTROLUMINESCENT ORGANIQUE L’UTILISANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.09.2019 EP 19198370**

(43) Veröffentlichungstag der Anmeldung:
**27.07.2022 Patentblatt 2022/30**

(73) Patentinhaber: **Merck Patent GmbH**
**64293 Darmstadt (DE)**

(72) Erfinder:
- **PARHAM, Amir Hossain**
  **60486 FRANKFURT AM MAIN (DE)**
- **KROEBER, Jonas Valentin**
  **60311 FRANKFURT AM MAIN (DE)**
- **ENGELHART, Jens**
  **64285 DARMSTADT (DE)**
- **EHRENREICH, Christian**
  **64285 DARMSTADT (DE)**
- **EICKHOFF, Christian**
  **68259 MANNHEIM (DE)**

(74) Vertreter: **Merck Patent Association**
**Merck Patent GmbH**
**64271 Darmstadt (DE)**

(56) Entgegenhaltungen:
**WO-A1-2017/178311 KR-B1- 101 857 703**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

(52) Gemeinsame Patentklassifikation (CPC): (Forts.)
H10K 85/342; H10K 2101/10; H10K 2101/90

## Beschreibung

Die vorliegende Erfindung betrifft eine organische elektrolumineszierende Vorrichtung nach Anspruch 1 enthaltend ein elektronentransportierendes Hostmaterial und ein lochtransportierendes Hostmaterial, sowie eine Formulierung nach Anspruch 14 und eine Mischung enthaltend die Hostmaterialien nach Anspruch 13. Das elektronentransportierende Hostmaterial entspricht einer Verbindung der Formel (1), wie nachfolgend beschrieben, aus der Klasse von Verbindungen enthaltend zwei Triazin-Einheiten. Das lochtransportierende Hostmaterial entspricht einer Verbindung der Formel (2a), wie nachfolgend beschrieben, aus der Klasse der Biscarbazole oder deren Derivate.

Der Aufbau organischer Elektrolumineszenzvorrichtungen (z.B. OLEDs - organic light emitting diodes oder OLECs - organic light emitting electrochemical cells), in denen organische Halbleiter als funktionelle Materialien eingesetzt werden, ist seit Langem bekannt. Als emittierende Materialien werden hierbei neben fluoreszierenden Emittern zunehmend metallorganische Komplexe eingesetzt, die Phosphoreszenz statt Fluoreszenz zeigen. Aus quantenmechanischen Gründen ist unter Verwendung metallorganischer Verbindungen als Phosphoreszenzemitter eine bis zu vierfach gesteigerte Energie- und Leistungseffizienz möglich. Generell gibt es bei OLEDs, insbesondere auch bei OLEDs die Triplettemission (Phosphoreszenz) zeigen, jedoch immer noch Verbesserungsbedarf, beispielsweise im Hinblick auf Effizienz, Betriebsspannung und Lebensdauer.

Die Eigenschaften organischer elektrolumineszierender Vorrichtungen werden nicht nur durch die eingesetzten Emitter bestimmt. Hier sind insbesondere auch die anderen verwendeten Materialien, wie Host- und Matrixmaterialien, Lochblockiermaterialien, Elektronentransportmaterialien, Lochtransportmaterialien und Elektronen- bzw. Exzitonenblockiermaterialien von besonderer Bedeutung, und davon insbesondere die Host bzw. Matrixmaterialien. Verbesserungen dieser Materialien können zu deutlichen Verbesserungen elektrolumineszierender Vorrichtungen führen.

Hostmaterialien zur Verwendung in organischen elektronischen Vorrichtungen sind dem Fachmann gut bekannt. Im Stand der Technik wird häufig auch der Begriff Matrixmaterial verwendet, wenn ein Hostmaterial für phosphoreszierende Emitter gemeint ist. Diese Verwendung des Begriffs gilt auch für die vorliegende Erfindung. Mittlerweile wurde eine Vielzahl von Hostmaterialien sowohl für fluoreszierende als auch für phosphoreszierende elektronische Vorrichtungen entwickelt.

Eine weitere Möglichkeit, die Leistungsdaten elektronischer Vorrichtungen, insbesondere von organischen Elektrolumineszenzvorrichtungen, zu verbessern, besteht darin, Kombinationen aus zwei oder mehr Materialien, insbesondere Hostmaterialien bzw. Matrixmaterialien, zu verwenden.

In US 6,392,250 B1 wird die Verwendung einer Mischung bestehend aus einem Elektronentransportmaterial, einem Lochtransportmaterial und einem fluoreszierenden Emitter in der Emissionsschicht einer OLED offenbart. Mit Hilfe dieser Mischung konnte die Lebensdauer der OLED gegenüber dem Stand der Technik verbessert werden.

In US 6,803,720 B1 wird die Verwendung einer Mischung enthaltend einen phosphoreszierenden Emitter sowie ein Loch- und ein Elektronentransportmaterial in der Emissionsschicht einer OLED offenbart. Dabei sind sowohl das Loch- und das Elektrontransportmaterial kleine organische Moleküle.

In KR20100131745 werden speziell verbundene Bistriazinverbindungen und deren Verwendung in einer organischen elektrolumineszierenden Vorrichtung als Hostmaterial beschrieben. Beschrieben werden weiterhin Vorrichtungen enthaltend diese Bistriazinverbindungen in der lichtemittierenden Schicht zusammen mit Indolocarbazolverbindungen als weiteres Hostmaterial.

In WO2012048779 werden Tinten zur Verwendung in organischen Elektrolumineszenzvorrichtungen offenbart, umfassend eine Carbazolverbindung, eine Elektronentransportverbindung, eine Triplett-Emitter-Verbindung und mindestens ein Lösungsmittel, wobei die Elektronentransportverbindung eine Ketonverbindung oder eine Triazinverbindung umfasst, die auch eine speziell verbundene Bistriazinverbindung sein kann, und wobei die Carbazolverbindung mindestens zwei Carbazolgruppen aufweist, die über ihre N-Atome miteinander verbunden sind.

In US20140299192 werden speziell verbundene Bistriazinverbindungen und deren Verwendung in einer organischen elektrolumineszierenden Vorrichtung offenbart, insbesondere als Elektronentransportmaterial.

In JP2015106658 wird unter anderem auch eine Dibenzofuranverbindung beschrieben, die in der 2- und 8-Position mit 4,6-Diphenyl-1,3,5-triazin-2yl-phenyl substituiert ist, und deren Verwendung als Hostmaterial in einer organischen elektrolumineszierenden Vorrichtung zusammen mit einem weiteren Hostmaterial.

In WO2015169412 werden Verbindungen enthaltend zwei Triazin-Einheiten beschrieben, die als Hostmaterial in einer organischen elektrolumineszierenden Vorrichtung zusammen mit einem weiteren Hostmaterial verwendet werden können.

In US2016329502 werden organische elektrolumineszierende Vorrichtungen enthaltend eine lichtemittierende Schicht aus drei Komponenten, einem ersten Hostmaterial, einer erfindungsgemäßen Verbindung als zweites Hostmaterial und einem Emitter offenbart, wobei die erfindungsgemäßen Verbindungen zwei Triazineinheiten enthalten könnten.

In US20170054087 werden spezielle Triazinderivate beschrieben und deren Verwendung als Hostmaterial zusammen mit anderen Hostmaterialien in einer lichtemittierenden elektronischen Vorrichtung.

In WO2017178311 werden spezielle Dibenzofuranverbindungen oder Dibenzothiophenverbindungen beschrieben, die zwei Triazinsubstituenten tragen können, und deren Verwendung in einer organischen elektrolumineszierenden Vorrichtung, wobei diese Verbindungen auch als Hostmaterial eingesetzt werden können. Es wird ferner beschrieben, dass derartige Verbindungen mit weiteren Hostmaterialien kombiniert werden können. In Tabelle 1 wird beispielsweise der Aufbau einer organischen lichtemittierenden Diode beschrieben (E11), die zwei Hostmaterialien in der lichtemittierenden Schicht enthält, wobei 7,7-Dimethyl-5-phenyl-2-(9-phenylcarbazol-3-yl)indeno[2,1-b]carbazol als zweites Hostmaterial verwendet wird.

In CN108250189 werden spezielle Dibenzofuranverbindungen oder Dibenzothiophenverbindungen beschrieben, die zwei Triazinsubstituenten tragen können, und deren Verwendung als Hostmaterial in einer organischen elektrolumineszierenden Vorrichtung.

In US2019013490 werden spezielle Dibenzofuranverbindungen oder Dibenzothiophenverbindungen beschrieben und deren Verwendung als Hostmaterial in Kombination mit weiteren Hostmaterialien.

In WO19017730 werden spezielle Dibenzofuranverbindungen oder Dibenzothiophenverbindungen beschrieben und deren Verwendung als Hostmaterial.

In WO19122899 werden spezielle Bistriazinverbindungen beschrieben und deren Verwendung als Hostmaterial in einer lichtemittierenden Schicht zusammen mit einem lichtemittierenden Material.

In KR101857703 B1 werden organische lichtemittierende Vorrichtungen beschrieben, die in der lichtemittierenden Schicht Bistriazinverbindungen zusammen mit einem Biscarbazol H1 als Hostmaterial verwenden.

Allerdings besteht bei Verwendung dieser Materialien oder bei der Verwendung von Mischungen der Materialien mit phosphoreszierenden Emittern noch Verbesserungsbedarf, insbesondere in Bezug auf Effizienz, Betriebsspannung und/oder Lebensdauer der organischen elektrolumineszierenden Vorrichtung.

Aufgabe der vorliegenden Erfindung ist daher die Bereitstellung einer Kombination von Hostmaterialien mit einem phosphoreszierenden Emitter, welche sich für den Einsatz in einer organischen elektrolumineszierenden Vorrichtung, insbesondere in einer phosphoreszierenden OLED eignen und zu guten Device-Eigenschaften insbesondere im Hinblick auf eine verbesserte Lebensdauer, führen, sowie die Bereitstellung der entsprechenden elektrolumineszierenden Vorrichtung.

Es wurde nun gefunden, dass die Kombination mindestens einer Verbindung der Formel (1) als erstes Hostmaterial und mindestens einer lochtransportierenden Verbindung der Formel (2a) als zweites Hostmaterial in einer Licht emittierenden Schicht einer organischen elektrolumineszierenden Vorrichtung nach Anspruch 1, diese Aufgabe löst und die Nachteile aus dem Stand der Technik beseitigen. Die Verwendung einer derartigen Materialkombination zur Herstellung der lichtemittierenden Schicht in einer organischen elektrolumineszierenden Vorrichtung führt zu sehr guten Eigenschaften dieser Vorrichtungen, insbesondere hinsichtlich der Lebensdauer, insbesondere bei gleicher oder verbesserter Effizienz und/oder Betriebsspannung. Die Vorteile zeigen sich mit Emittern der Formel (3), bei Konzentrationen zwischen 2 und 15 Gew.-%.

Ein erster Gegenstand der vorliegenden Erfindung ist daher eine organische elektrolumineszierende Vorrichtung umfassend eine Anode, eine Kathode und mindestens eine organische Schicht, enthaltend mindestens eine lichtemittierende Schicht nach Anspruch 1, wobei die mindestens eine lichtemittierende Schicht mindestens eine Verbindung der Formel (1) als Hostmaterial 1 und mindestens eine Verbindung der Formel (2a) als Hostmaterial 2 enthält,

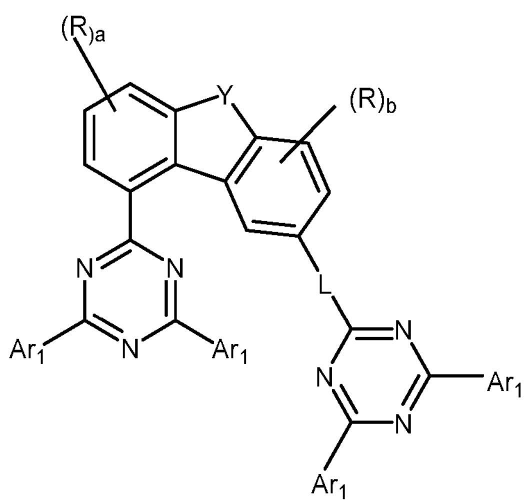

Formel (1)

,

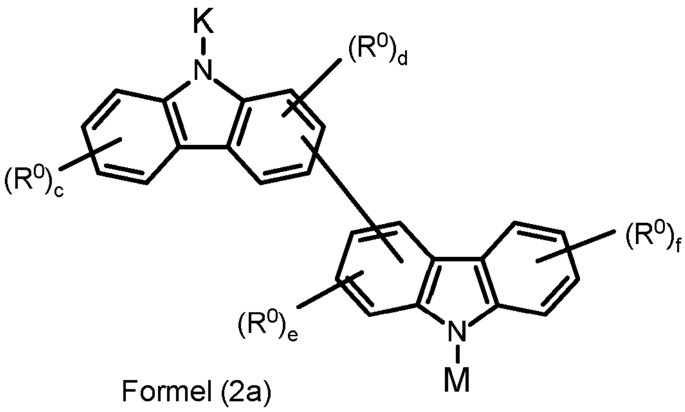

Formel (2a) ,

wobei für die verwendeten Symbole und Indizes gilt:

Y ist ausgewählt aus O, S, $C(CH_3)_2$, $C(Phenyl)_2$ oder wobei * das C-Atom markiert, das an den Rest

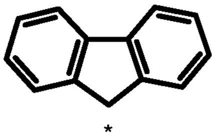

, '

der Formel (1) bindet;

L ist ausgewählt aus einem der bivalenten Linker L-1 bis L-26,

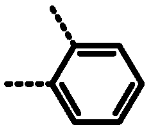

L-1

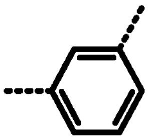

L-2

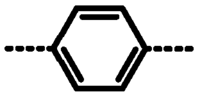

L-3

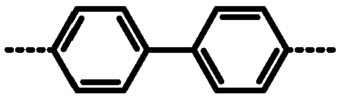

L-4

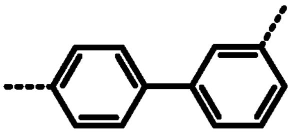

L-5

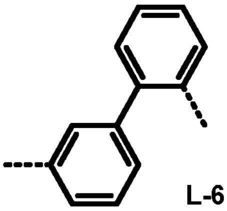

L-6

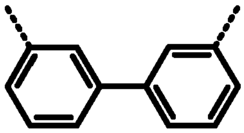

L-7

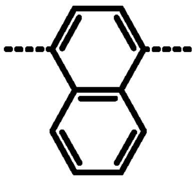

L-8

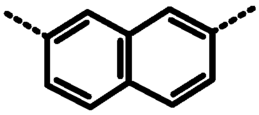

L-9

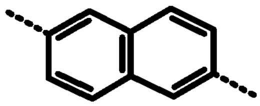

L-10

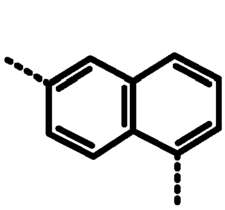

L-11

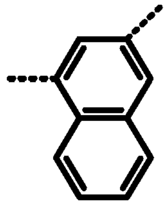

L-12

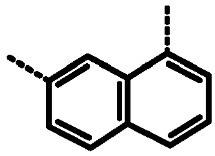

L-13

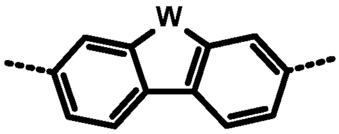

L-14

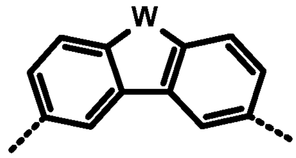

L-15

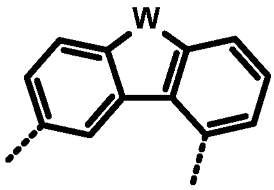

L-16

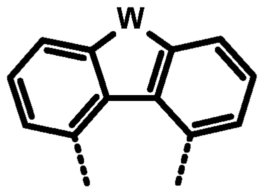

L-17

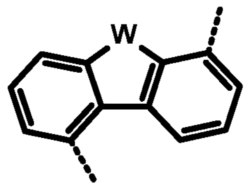

L-18

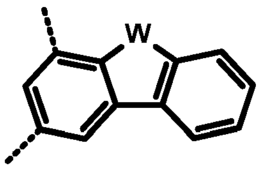

L-19

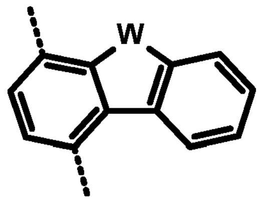

L-20

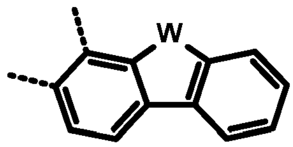

L-21

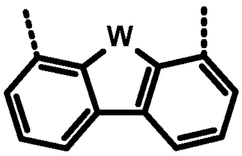

L-22

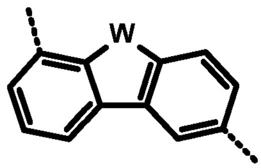

L-23

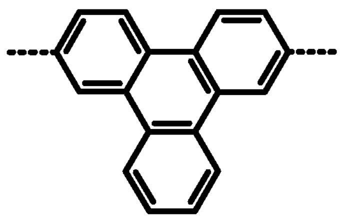

L-24

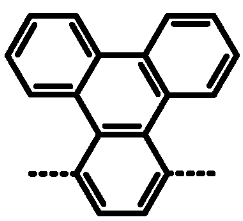

L-25

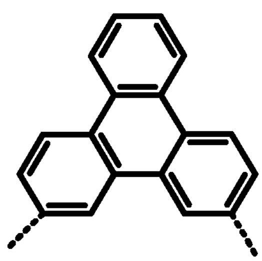

L-26 ,

wobei die Linker L-1 bis L-26 noch mit einem oder mehreren Substituenten R substituiert sein können;

W ist O, S oder $C(CH_3)_2$; bevorzugt O oder S;
a ist 0 oder 1;
b ist 0 oder 1;
R ist bei jedem Auftreten gleich oder verschieden ausgewählt aus der Gruppe bestehend aus CN, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen, einem aromatischen oder heteroaromatischen Ringsystem mit 5 bis 40 aromatischen Ringatomen, einer Aryloxy- oder Heteroaryloxygruppe mit 5 bis 40 aromatischen Ringatomen, oder einer Aralkyl- oder Heteroaralkylgruppe mit 5 bis 40 aromatischen Ringatomen;
$Ar_1$ ist bei jedem Auftreten jeweils unabhängig voneinander eine Aryl- oder Heteroarylgruppe mit 5 bis 40 aromatischen Ringatomen, die mit einem oder mehreren Resten R substituiert sein kann;
K, M sind jeweils unabhängig voneinander ein unsubstituiertes oder teilweise oder vollständig deuteriertes oder einfach durch R* substituiertes aromatisches Ringsystem mit 6 bis 40 aromatischen Ringatomen,
$R^0$ ist bei jedem Auftreten unabhängig voneinander ein unsubstituiertes oder teilweise oder vollständig deuteriertes aromatisches Ringsystem mit 6 bis 18 C-Atomen;
R* ist Dibenzofuranyl oder Dibenzothiophenyl;
c, d, e und f sind unabhängig voneinander 0 oder 1.

Weitere Gegenstände der Erfindung umfassen ein Verfahren zur Herstellung der organischen elektrolumineszierenden Vorrichtungen sowie Mischungen nach Anspruch 13 und eine Formulierung nach Anspruch 14. Die überraschenden und vorteilhaften Effekte werden durch spezifische Selektion der Verbindungen der Formel (1) und der Verbindungen der Formel (2a) und der Emitter nach Formel (3) erreicht.

Die erfindungsgemäße organische elektrolumineszierende Vorrichtung ist beispielsweise ein organischer lichtemittierender Transistor (OLET), ein organisches Feld-Quench-Device (OFQD), eine organische lichtemittierende elektrochemische Zelle (OLEC, LEC, LEEC), eine organische Laserdiode (O-Laser) oder eine organische lichtemittierende Diode (OLED). Die erfindungsgemäße organische elektrolumineszierende Vorrichtung ist insbesondere eine organische lichtemittierende Diode oder eine organische lichtemittierende elektrochemische Zelle. Besonders bevorzugt ist die erfindungsgemäße Vorrichtung eine OLED.

Die organische Schicht der erfindungsgemäßen Vorrichtung, die die lichtemittierende Schicht enthaltend die Materialkombination aus mindestens einer Verbindung der Formel (1) und mindestens einer Verbindung der Formel (2a) und mindestens einen phosphoreszierenden Emitter der Formel (3) enthält, wie zuvor beschrieben oder nachfolgend beschrieben, enthält bevorzugt neben dieser lichtemittierenden Schicht (EML), eine Lochinjektionsschicht (HIL), eine Lochtransportschicht (HTL), eine Elektronentransportschicht (ETL), eine Elektroneninjektionsschicht (EIL) und/oder eine Lochblockierschicht (HBL). Es können in der erfindungsgemäßen Vorrichtung auch mehrere Schichten dieser Gruppe ausgewählt aus EML, HIL, HTL, ETL, EIL und HBL enthalten sein. Die Vorrichtung kann aber auch anorganische Materialien enthalten oder auch Schichten, welche vollständig aus anorganischen Materialien aufgebaut sind.

Es gilt, dass die lichtemittierende Schicht enthaltend mindestens eine Verbindung der Formel (1) und mindestens eine Verbindung der Formel (2a) eine phosphoreszierende Schicht ist, die dadurch gekennzeichnet ist, dass sie zusätzlich zu der Hostmaterialienkombination Verbindungen der Formel (1) und Formel (2a), wie zuvor beschrieben, mindestens einen phosphoreszierenden Emitter der Formel (3) enthält. Eine geeignete Auswahl an Emittern und bevorzugte Emitter werden nachfolgend beschrieben.

Eine Arylgruppe im Sinne dieser Erfindung enthält 6 bis 40 aromatische Ringatome, bevorzugt C-Atome. Eine Heteroarylgruppe im Sinne dieser Erfindung enthält 5 bis 40 aromatische Ringatome, wobei die Ringatome C-Atome und mindestens ein Heteroatom umfassen, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Phenyl, abgeleitet von Benzol, bzw. ein einfacher heteroaromatischer Cyclus, beispielsweise abgeleitet von Pyridin, Pyrimidin oder Thiophen, oder eine kondensierte Aryl- oder Heteroarylgruppe, beispielsweise abgeleitet von Naphthalin, Anthracen, Phenanthren, Chinolin oder Isochinolin, verstanden. Eine Arylgruppe mit 6 bis 18 C-Atomen ist daher vorzugsweise Phenyl, Naphthyl, Phenanthryl oder Triphenylenyl, wobei die Anbindung der Arylgruppe als Substituent dabei nicht eingeschränkt ist. Die Aryl- oder Heteroarylgruppe im Sinne dieser Erfindung kann einen oder mehrere Reste R tragen, wobei der Substituent R nachfolgend beschrieben wird.

Ein aromatisches Ringsystem im Sinne dieser Erfindung enthält 6 bis 40 C-Atome im Ringsystem. Das aromatisches Ringsystem umfasst auch Arylgruppen, wie zuvor beschrieben.

Ein aromatisches Ringsystem mit 6 bis 18 C-Atomen wird vorzugsweise aus Phenyl, Biphenyl, Naphthyl, Phenanthryl und Triphenylenyl ausgewählt.

Ein heteroaromatisches Ringsystem im Sinne dieser Erfindung enthält 5 bis 40 Ringatome und mindestens ein Heteroatom. Ein bevorzugtes heteroaromatisches Ringsystem hat 10 bis 40 Ringatome und mindestens ein Heteroatom.

Das heteroaromatische Ringsystem umfasst auch Heteroarylgruppen, wie zuvor beschrieben. Die Heteroatome im heteroaromatischen Ringsystem sind bevorzugt ausgewählt aus N, O und/oder S.

Unter einem aromatischen oder heteroaromatischen Ringsystem im Sinne dieser Erfindung wird ein System verstanden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische bzw. heteroaromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sind Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls von der Definition des aromatischen bzw. heteroaromatischen Ringsystems umfasst.

Unter einem aromatischen oder heteroaromatischen Ringsystem mit 5 - 40 aromatischen Ringatomen, welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die Abkürzung $Ar_1$ ist bei jedem Auftreten jeweils unabhängig voneinander eine Aryl- oder Heteroarylgruppe mit 5 bis 40 aromatischen Ringatomen, die mit einem oder mehreren Resten R substituiert sein kann, wobei der Rest R eine Bedeutung hat, wie zuvor oder nachfolgend beschrieben.

Unter einer cyclischen Alkyl-, Alkoxy- oder Thioalkylgruppe im Sinne dieser Erfindung wird eine monocyclische, eine bicyclische oder eine polycyclische Gruppe verstanden.

Im Rahmen der vorliegenden Erfindung werden unter einer geradkettigen, verzweigten oder cyclischen $C_1$- bis $C_{20}$-Alkylgruppe beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl, 1,1-Dimethyl-n-hept-1-yl, 1,1-Dimethyl-n-oct-1-yl, 1,1-Dimethyl-n-dec-1-yl, 1,1-Dimethyl-n-dodec-1-yl, 1,1-Dimethyl-n-tetradec-1-yl, 1,1-Dimethyl-n-hexadec-1-yl, 1,1-Dimethyl-n-octadec-1-yl, 1,1-Diethyl-n-hex-1-yl, 1,1-Diethyl-n-hept-1-yl, 1,1-Diethyl-n-oct-1-yl, 1,1-Diethyl-n-dec-1-yl, 1,1-Diethyl-n-dodec-1-yl, 1,1-Diethyl-n-tetradec-1-yl, 1,1-Diethyln-n-hexadec-1-yl, 1,1-Diethyl-n-octadec-1-yl, 1-(n-Propyl)-cyclohex-1-yl, 1-(n-Butyl)-cyclohex-1-yl, 1-(n-Hexyl)-cyclohex-1-yl, 1-(n-Octyl)-cyclohex-1-yl und 1-(n-Decyl)-cyclohex-1-yl verstanden.

Unter einer geradkettigen oder verzweigten $C_1$- bis $C_{20}$-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einer geradkettigen $C_1$- bis $C_{20}$-Thioalkylgruppe werden beispielsweise S-Alkylgruppen verstanden, beispielsweise Thiomethyl, 1-Thioethyl, 1-Thio-i-propyl, 1-Thio-n-propoyl, 1-Thio-i-butyl, 1-Thio-n-butyl oder 1-Thio-t-butyl.

Eine Aryloxy- oder Heteroaryloxygruppe mit 5 bis 40 aromatischen Ringatomen bedeutet O-Aryl oder O-Heteroaryl und bedeutet, dass die Aryl- bzw. Heteroarylgruppe über ein Sauerstoffatom gebunden wird, wobei die Aryl- bzw. Heteroarylgruppe eine Bedeutung hat, wie zuvor beschrieben.

Eine Aralkyl- oder Heteroaralkylgruppe mit 5 bis 40 aromatischen Ringatomen bedeutet, dass eine Alkylgruppe, wie zuvor beschrieben, mit einer Arylgruppe bzw. Heteroarylgruppe substituiert ist, wobei die Aryl- bzw. Heteroarylgruppe eine Bedeutung hat, wie zuvor beschrieben.

Ein phosphoreszierender Emitter im Sinne der vorliegenden Erfindung ist eine Verbindung, die Lumineszenz aus einem angeregten Zustand mit höherer Spinmultiplizität zeigt, also einem Spinzustand > 1, insbesondere aus einem

angeregten Triplettzustand. Im Sinne dieser Anmeldung sollen alle lumineszierenden Komplexe mit Übergangsmetallen oder Lanthaniden als phosphoreszierende Emitter angesehen werden. Eine genauere Definition erfolgt nachfolgend.

Wenn die Hostmaterialien der lichtemittierenden Schicht umfassend mindestens eine Verbindung der Formel (1), wie zuvor beschrieben oder nachfolgend bevorzugt beschrieben, und mindestens eine Verbindung der Formel (2a), wie zuvor beschrieben oder nachfolgend beschrieben, für einen phosphoreszierenden Emitter eingesetzt wird, ist es bevorzugt, wenn deren Triplettenergie nicht wesentlich kleiner als die Triplettenergie des phosphoreszierenden Emitters ist. Dabei gilt bevorzugt für das Triplett-niveau $T_1$(Emitter) - $T_1$(Matrix) $\leq$ 0.2 eV, besonders bevorzugt $\leq$ 0.15 eV, ganz besonders bevorzugt $\leq$ 0.1 eV. Dabei ist $T_1$(Matrix) das Triplettniveau des Matrixmaterials in der Emissionsschicht, wobei diese Bedingung für jedes der beiden Matrixmaterialien gilt, und $T_1$(Emitter) ist das Triplett-niveau des phosphoreszierenden Emitters. Enthält die Emissionsschicht mehr als zwei Matrixmaterialien, so gilt die oben genannte Beziehung bevorzugt auch für jedes weitere Matrixmaterial.

Im Folgenden wird das Hostmaterial 1 und dessen bevorzugte Ausführungsformen beschrieben, welches/welche in der erfindungsgemäßen Vorrichtung enthalten ist. Die bevorzugten Ausführungsformen des Hostmaterials 1 der Formel (1) gelten auch für die erfindungsgemäße Mischung und/oder Formulierung.

In Verbindungen der Formel (1) wird Y ausgewählt aus O, S, $C(CH_3)_2$, $C(Phenyl)_2$ oder

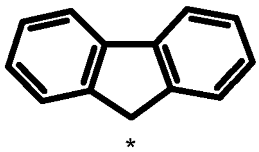

,

wobei * das C-Atom markiert, das an den Rest der Formel (1) bindet.

Bevorzugt wird Y ausgewählt aus O, S und $C(CH_3)_2$.

Besonders bevorzugt wird Y ausgewählt aus O und S.

In einer ganz besonders bevorzugten Ausführungsform des Hostmaterials der Formel (1) steht Y für O.

Demzufolge ist ein weiterer Gegenstand der Erfindung die organische elektrolumineszierende Vorrichtung, wie zuvor beschrieben, wobei im Hostmaterial 1 Y für O steht.

In Verbindungen der Formel (1) steht a für 0 oder 1, vorzugsweise für 0.

In Verbindungen der Formel (1) steht b für 0 oder 1, vorzugsweise für 0.

R in Verbindungen der Formel (1) ist bei jedem Auftreten gleich oder verschieden ausgewählt aus der Gruppe bestehend aus CN, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen, einem aromatischen oder heteroaromatischen Ringsystem mit 5 bis 40 aromatischen Ringatomen, einer Aryloxy- oder Heteroaryloxygruppe mit 5 bis 40 aromatischen Ringatomen, oder einer Aralkyl- oder Heteroaralkylgruppe mit 5 bis 40 aromatischen Ringatomen. Der Substituent R steht bei jedem Auftreten unabhängig voneinander bevorzugt für CN oder eine Arylgruppe mit 6 bis 40 C-Atomen. R ist bei jedem Auftreten unabhängig voneinander besonders bevorzugt Phenyl.

In Verbindungen der Formel (1), wie zuvor beschrieben oder bevorzugt beschrieben, steht $Ar_1$ bei jedem Auftreten unabhängig voneinander bevorzugt für eine Arylgruppe mit 6 bis 40 aromatischen Ringatomen, Dibenzofuranyl oder Dibenzothiophenyl. In Verbindungen der Formel (1), wie zuvor beschrieben oder bevorzugt beschrieben, steht $Ar_1$ jeweils unabhängig voneinander besonders bevorzugt für Phenyl, Triphenylenyl, Biphenyl, Fluorenyl, Naphthyl oder Dibenzofuranyl, wobei die Anbindung an den Rest der Formel (1) über jede beliebige Position der Arylgruppe, des Dibenzofuranyls oder des Dibenzothiophenyls erfolgen kann. Bevorzugt wird beispielsweise ein Dibenzofuran über die Position 1, 3 oder 7 an den Rest der Formel (1) gebunden. Bevorzugt wird beispielsweise ein Fluoren über die Position 8 an den Rest der Formel (1) gebunden. Ein bevorzugtes Biphenyl ist 1,3-Biphenyl.

Besonders bevorzugt steht mindestens ein $Ar_1$ für Phenyl und der andere aromatische Substituent $Ar_1$ steht für eine Arylgruppe mit 6 bis 40 aromatischen Ringatomen, Dibenzofuranyl oder Dibenzothiophenyl. Ganz besonders bevorzugt sind beide Gruppen $Ar_1$ gleich. Ganz besonders bevorzugt stehen beide Gruppen $Ar_1$ für Phenyl. Bevorzugt stehen beide Gruppen $Ar_1$ für Dibenzofuranyl, wobei die Anbindung an das Triazin jeweils unabhängig ist.

In Verbindungen der Formel (1) wird L aus der Gruppe der Linker L-1 bis L-26 ausgewählt, wobei die Linker L-1 bis L-26 noch mit einem oder mehreren Substituenten R substituiert sein können. Bevorzugt sind die Linker L-1 bis L-26 unsubstituiert oder tragen einen Substituenten R. Besonders bevorzugt sind die Linker L-1 bis L-26 unsubstituiert.

Der Substituent R in den Linkern L-1 bis L-26 ist bei jedem Auftreten gleich oder verschieden ausgewählt aus der Gruppe bestehend aus CN, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen, einem aromatischen oder heteroaromatischen Ringsystem mit 5 bis 40 aromatischen Ringatomen, einer Aryloxy- oder Heteroaryloxygruppe mit 5 bis 40 aromatischen Ringatomen, oder einer Aralkyl- oder Heteroaralkylgruppe mit 5 bis 40 aromatischen Ringatomen. In

den Linkern L-1 bis L-26 steht der Substituent R bei jedem Auftreten unabhängig voneinander bevorzugt für CN oder eine Arylgruppe mit 6 bis 40 C-Atomen. In den Linkern L-1 bis L-26 steht der Substituent R bei jedem Auftreten unabhängig voneinander besonders bevorzugt für CN oder Phenyl.

In Verbindungen der Formel (1), wie zuvor beschrieben oder bevorzugt beschrieben, wird L bevorzugt aus den Linkern L-1 bis L-13 und L-24 bis L-26 ausgewählt, wie zuvor beschrieben.

Hostmaterialien der Formel (1) mit den Linkern L-1 bis L-13 und L-24 bis L-26 werden bevorzugt mit Hostmaterialien der Formel (2a) kombiniert, wie nachfolgend beschrieben.

Es ist weiter bevorzugt, wenn in den Hostmaterialien der Formel (1) der Linker L aus den Linkern L-2, L-3, L-4, L-24, L-25 und L-26 ausgewählt wird.

In Verbindungen der Formel (1), wie zuvor beschrieben oder bevorzugt beschrieben, wird L in einer alternativen Ausführungsform bevorzugt aus den Linkern L-2, L-3, L-4, L-16, L-18, L-20, L-24, L-25 und L-26 ausgewählt, wie zuvor beschrieben, wobei W O, S oder $C(CH_3)_2$ bedeutet und wobei W bevorzugt O oder S ist.

Ein weiterer Gegenstand der Erfindung ist demzufolge eine organische elektrolumineszierende Vorrichtung, wie zuvor beschrieben oder bevorzugt beschrieben, wobei der Linker L im Hostmaterial 1 aus den Linkern L-1 bis L-13 und L-24 bis L-26 ausgewählt wird.

Ein weiterer Gegenstand der Erfindung ist demzufolge eine organische elektrolumineszierende Vorrichtung, wie zuvor beschrieben oder bevorzugt beschrieben, wobei der Linker L im Hostmaterial 1 aus den Linkern L-2, L-3, L-4, L-16, L-18, L-20, L-24, L-25 und L-26 ausgewählt wird und W O, S oder $C(CH_3)_2$ bedeutet. Bevorzugt ist W O oder S.

Beispiele für geeignete Hostmaterialien der Formel (1), die erfindungsgemäß ausgewählt werden, und bevorzugt in Kombination mit mindestens einer Verbindung der Formel (2a) in der erfindungsgemäßen elektrolumineszierenden Vorrichtung verwendet werden, sind die nachstehend genannten Strukturen der Tabelle 1.

Tabelle 1:

| | | |
|---|---|---|
| 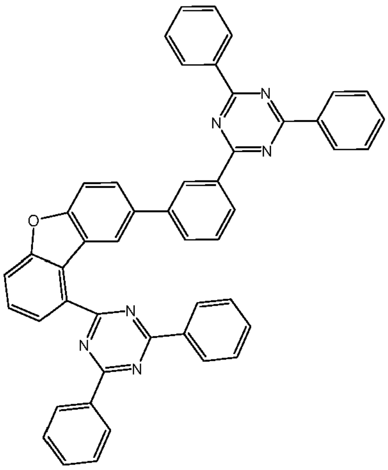 1 | 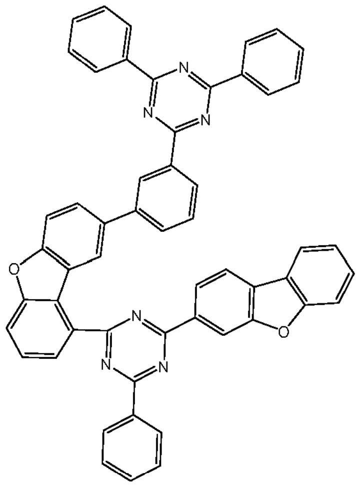 2 | 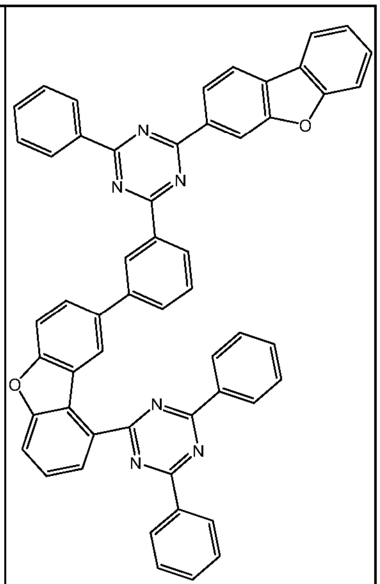 3 |
| 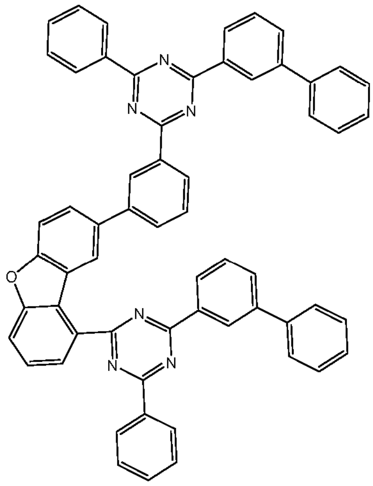 | 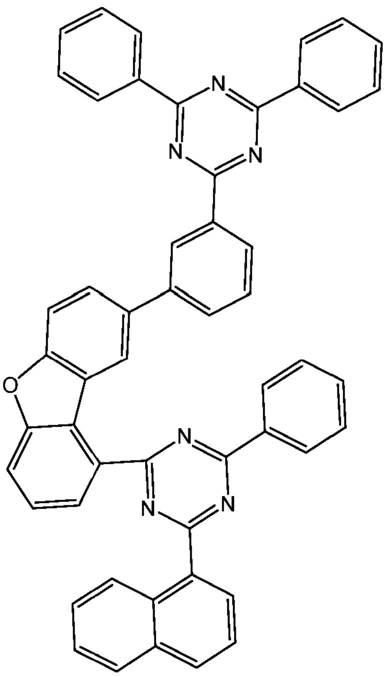 | 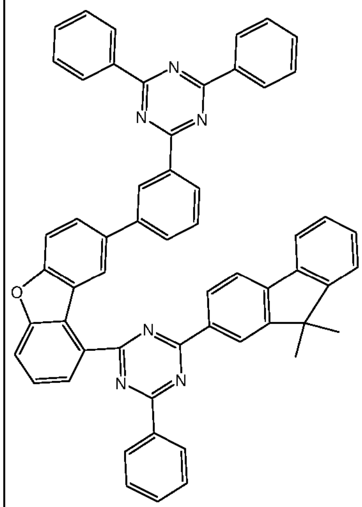 |

| | | |
|---|---|---|
| 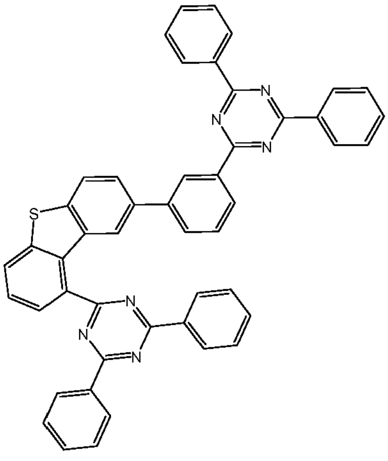 4 | 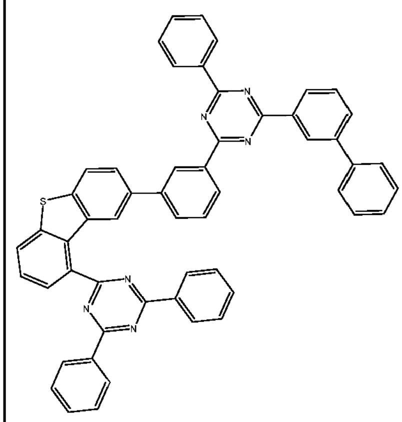 | 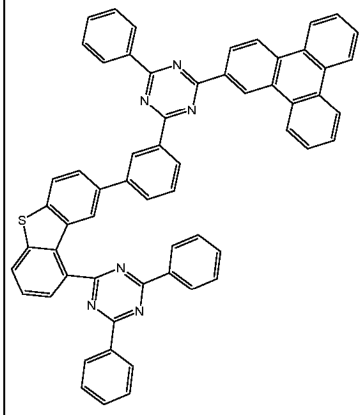 |
| 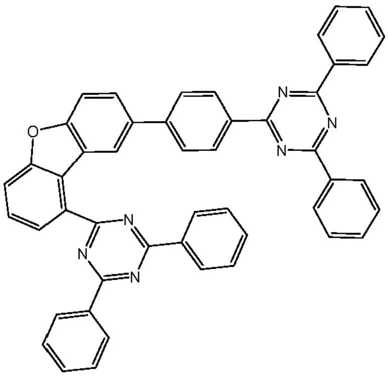 5 | 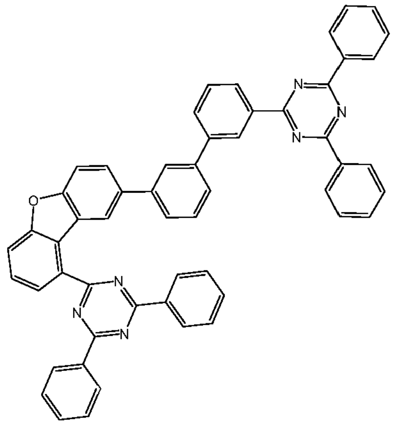 6 | 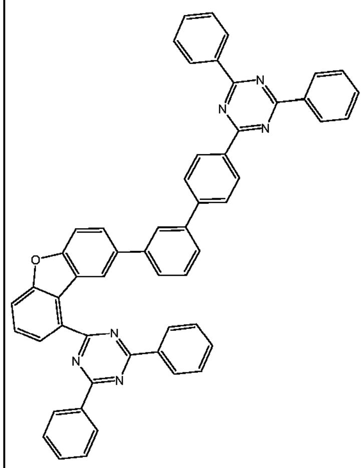 |
| 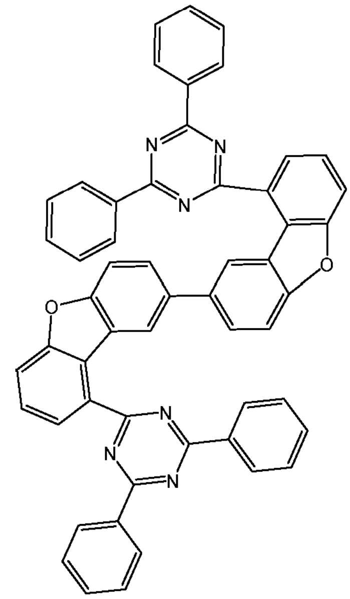 7 | 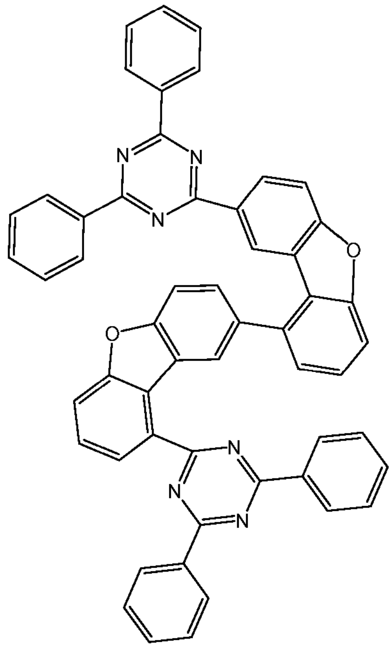 | 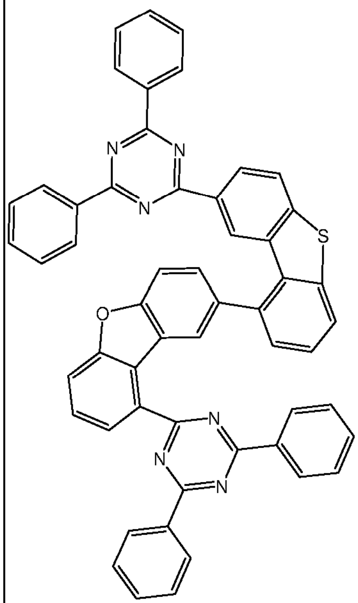 8 |

| | | |
|---|---|---|
| 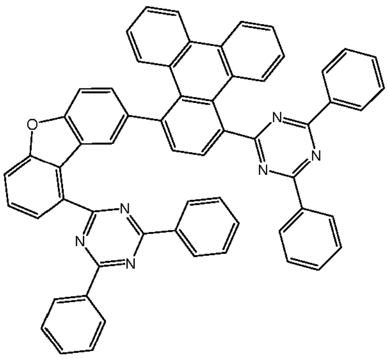 | 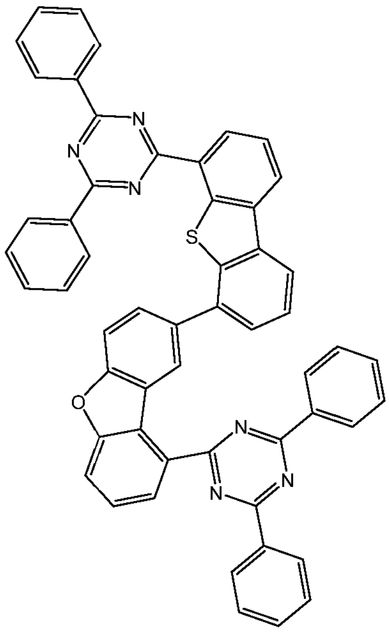 | 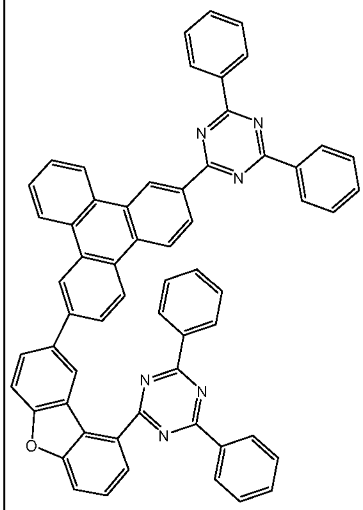 |
| 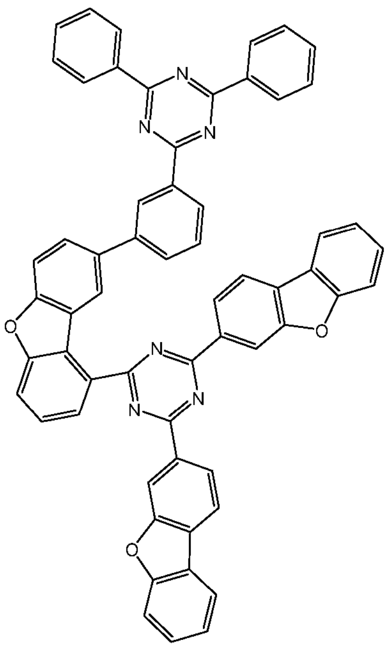 9 | 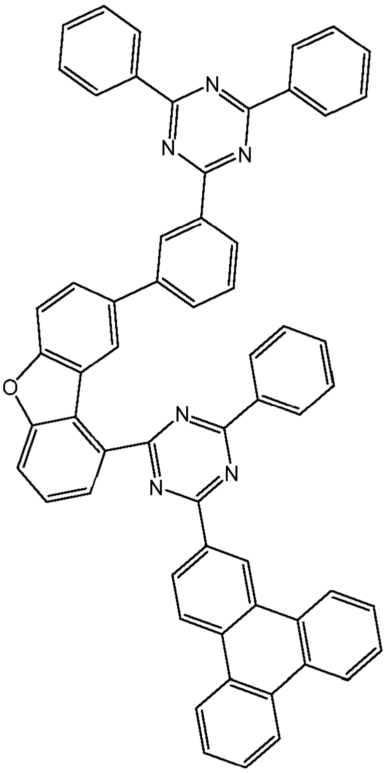 | 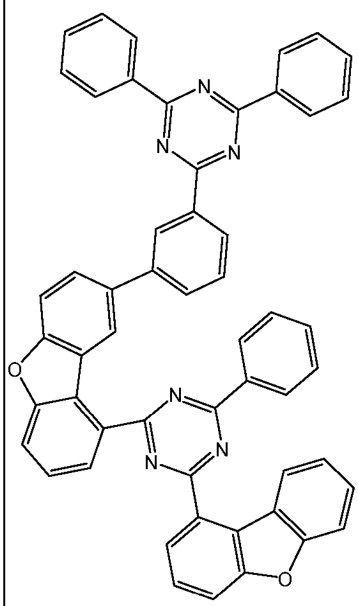 |

| | | |
|---|---|---|
| 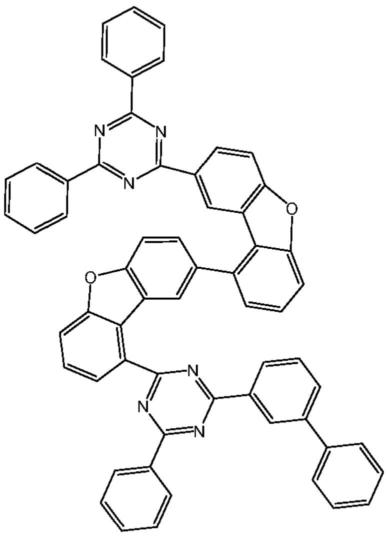 | | |
| | 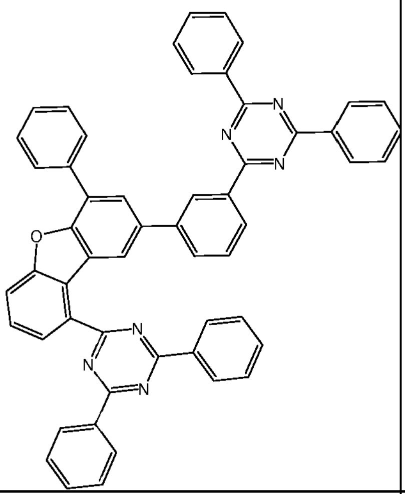 | 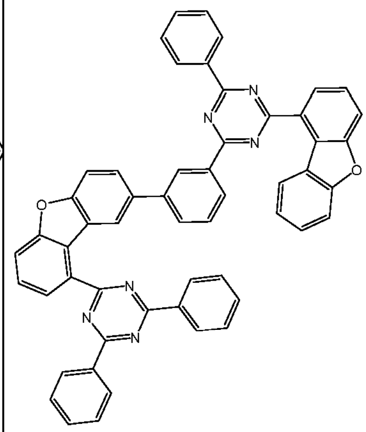 |
| 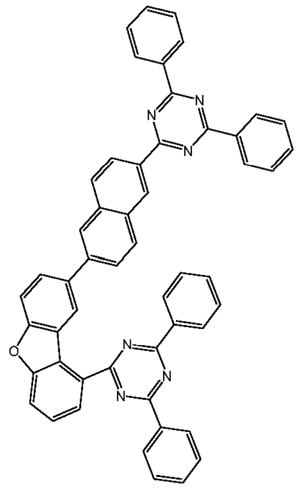 | 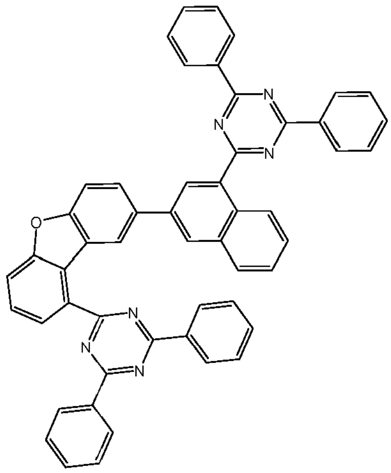 | 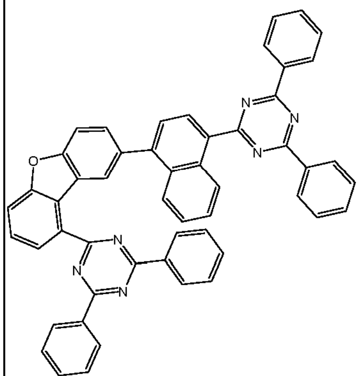 |

| | | |
|---|---|---|
| 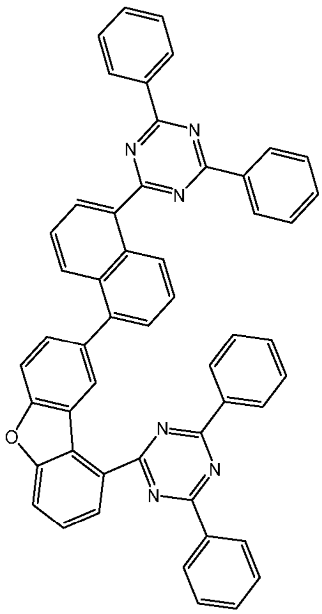 | 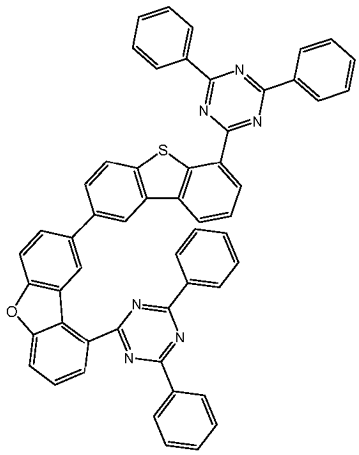 | 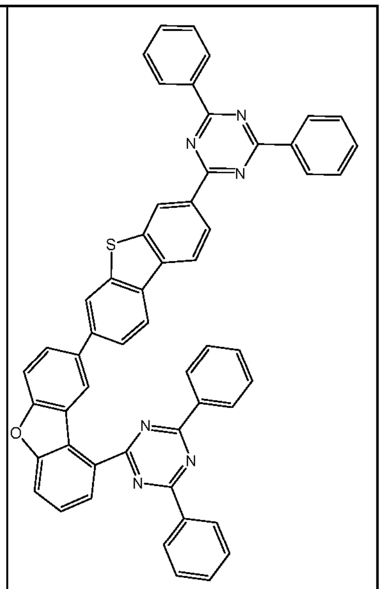 |
| 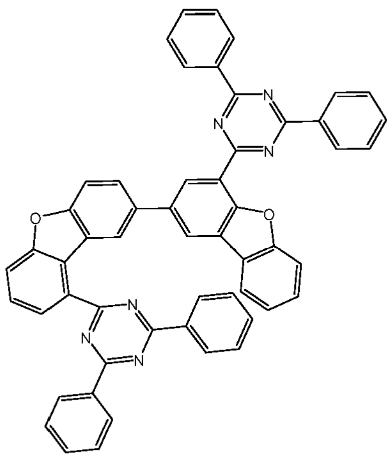 | 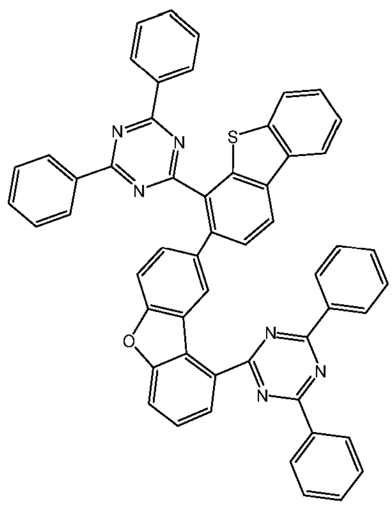 | 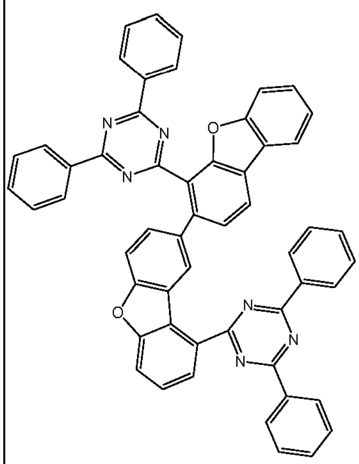 |
| 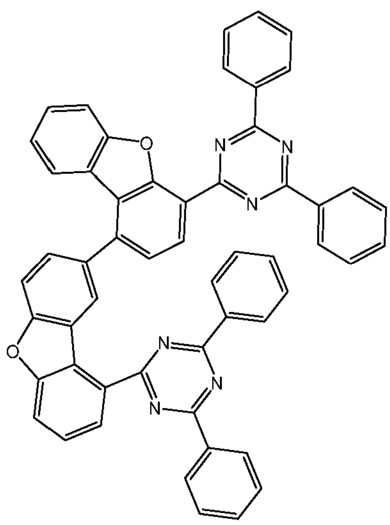 | 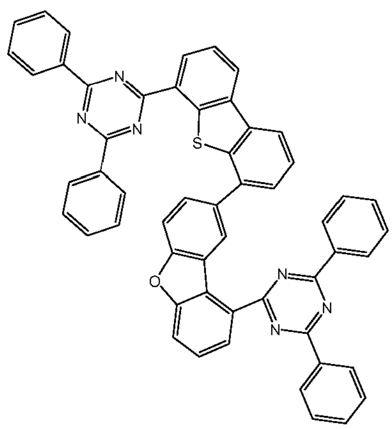 | 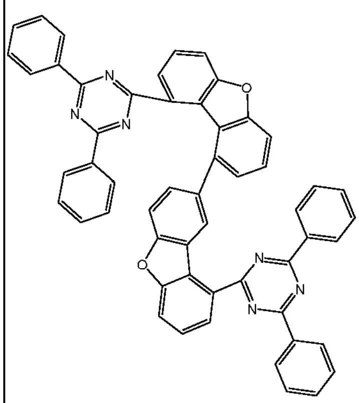 |

| | | |
|---|---|---|
| 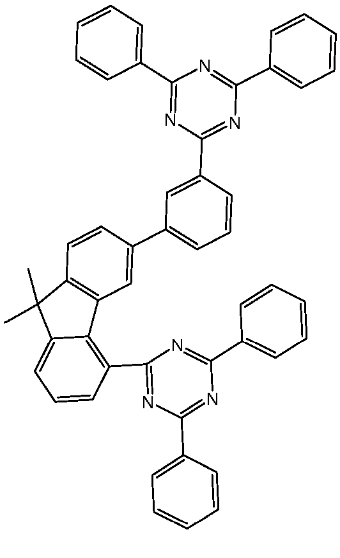 10 | 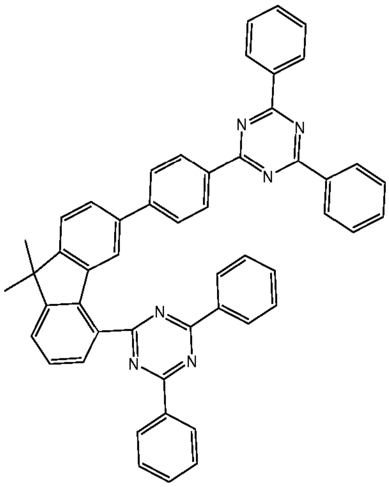 | 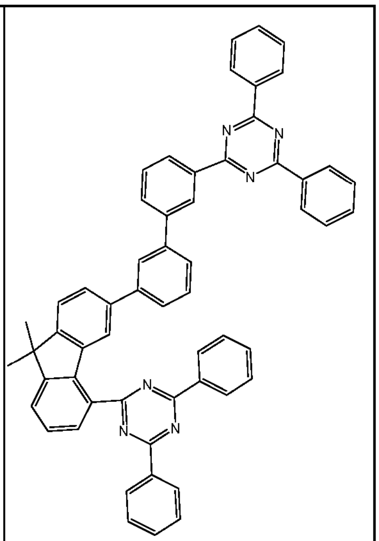 |
| 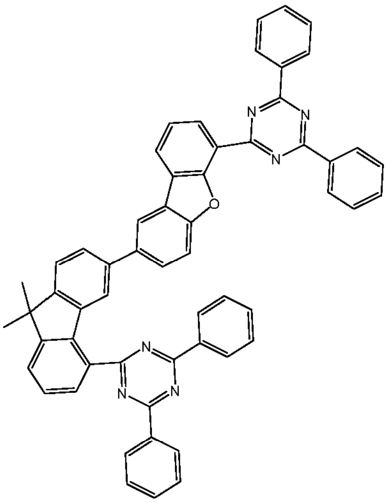 | 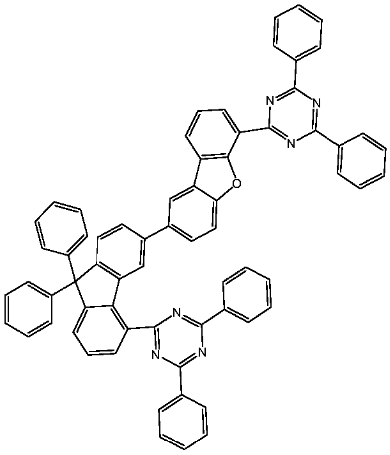 | 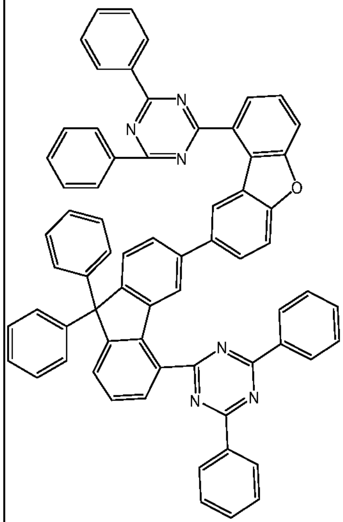 |
| 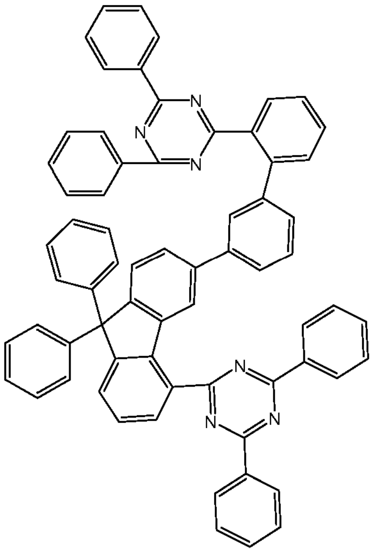 | 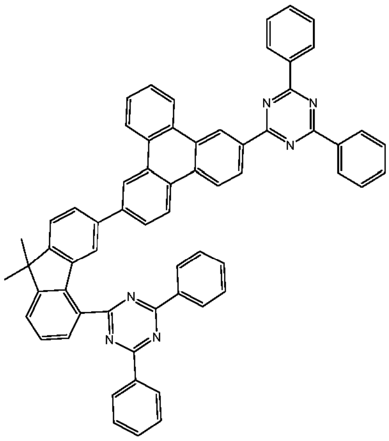 | 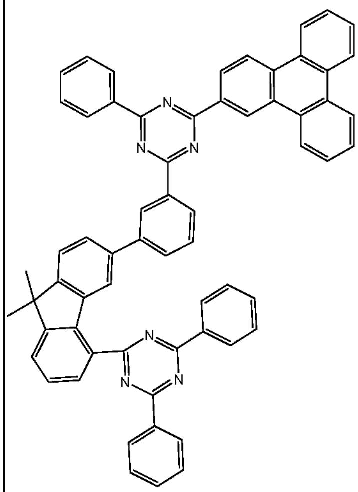 |

| | | |
|---|---|---|
| 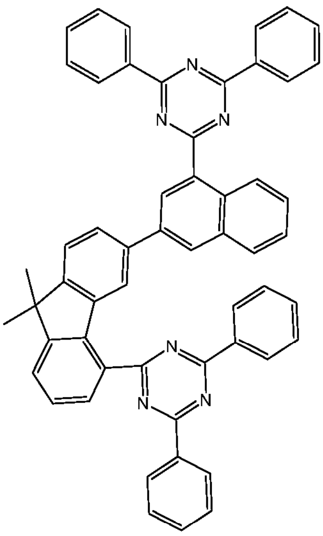 | 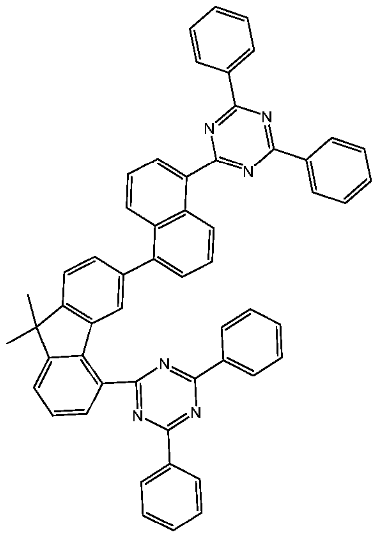 | 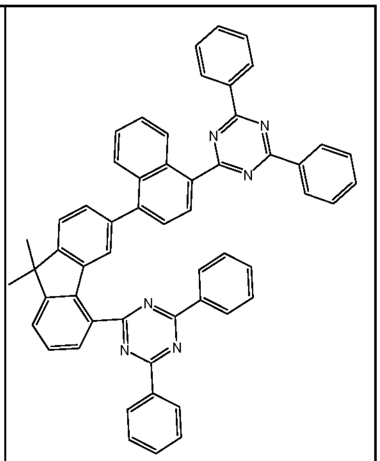 |
| 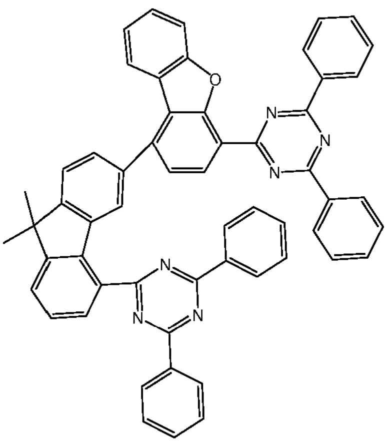 | 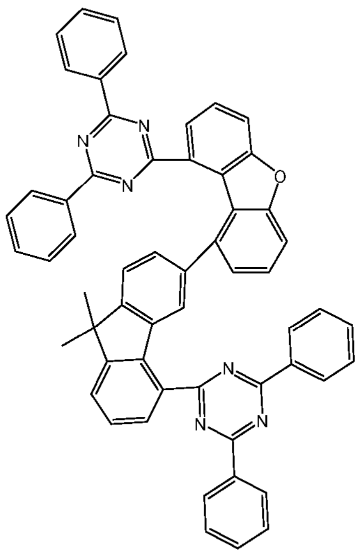 | 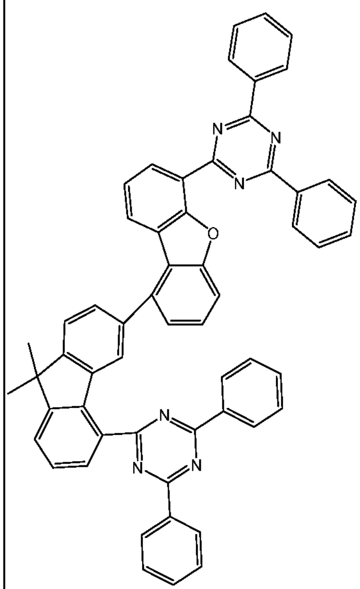 |
| 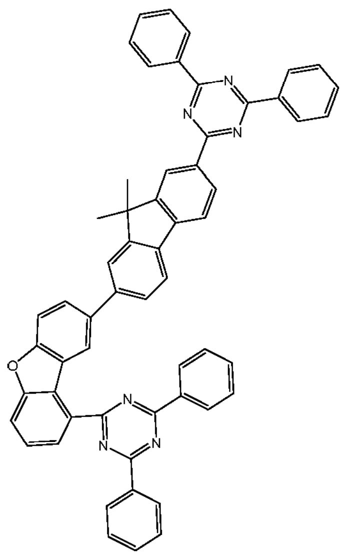 | 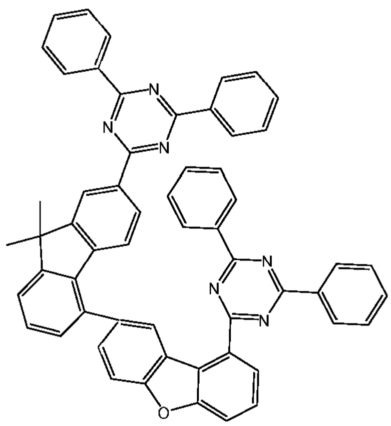 | |

Besonders geeignete Verbindungen der Formel (1), die bevorzugt in Kombination mit mindestens einer Verbindung der Formel (2a) in der erfindungsgemäßen elektrolumineszierenden Vorrichtung verwendet werden, sind die Verbindungen **1** bis **11** und **29** bis **44:**

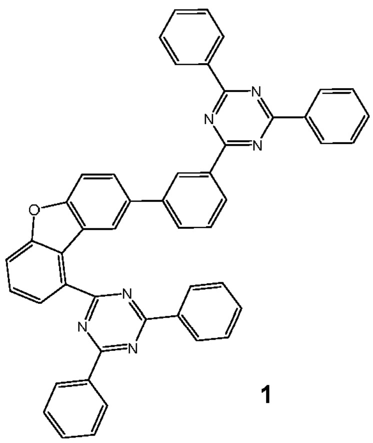

**1**

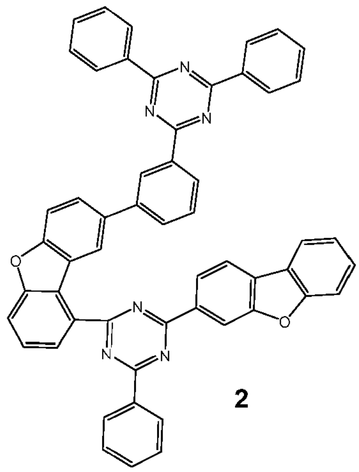

**2**

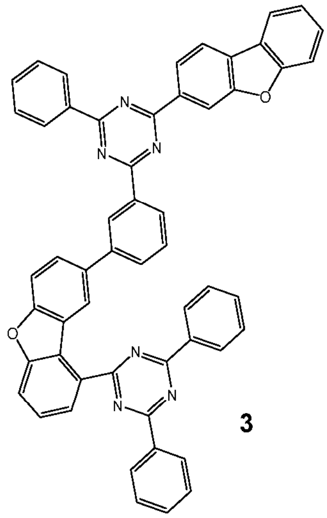

**3**

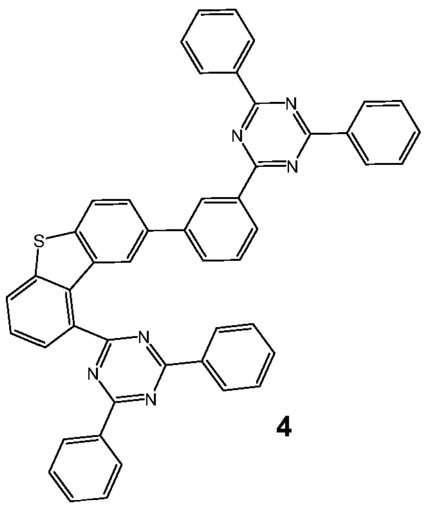

**4**

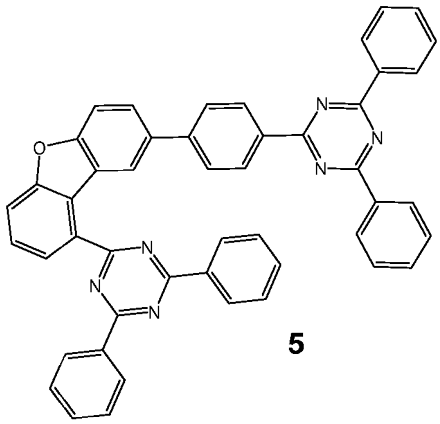

**5**

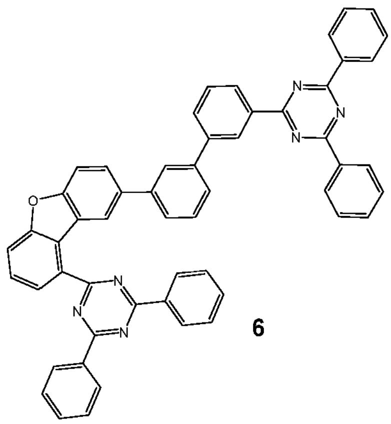

**6**

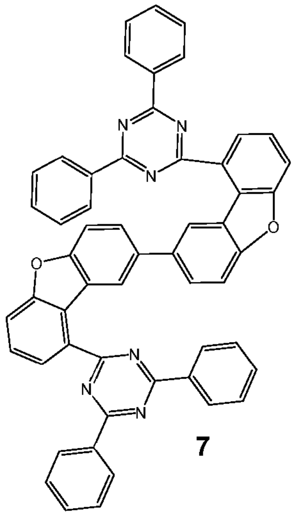

**7**

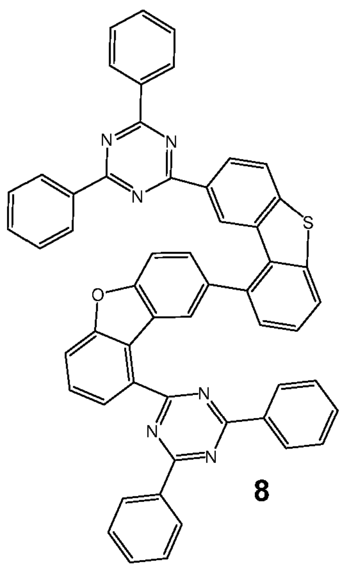

**8**

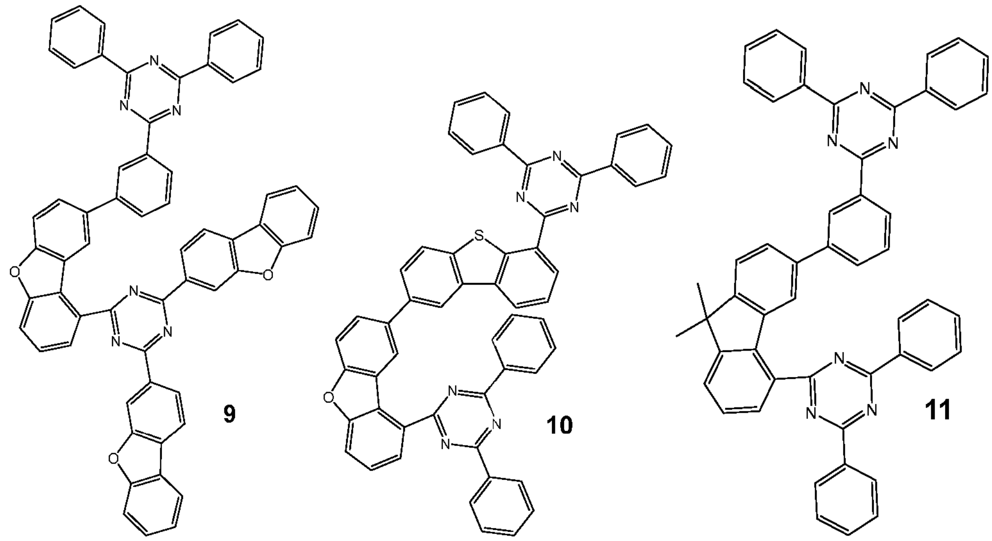

9

10

11

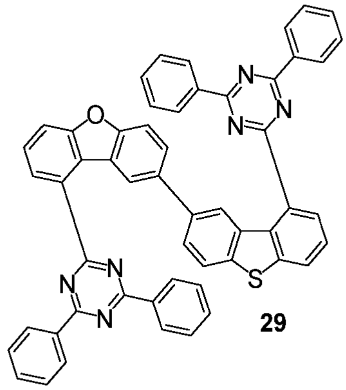

29

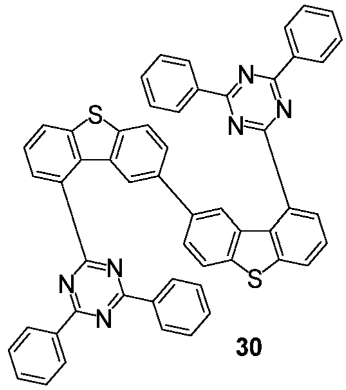

30

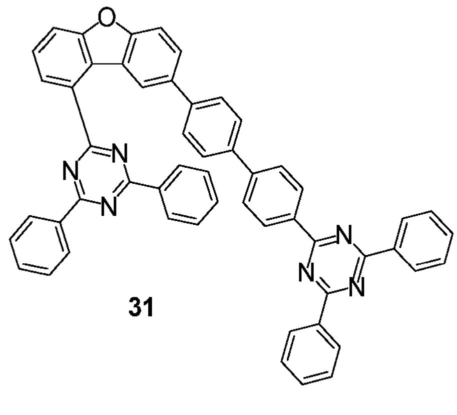

31

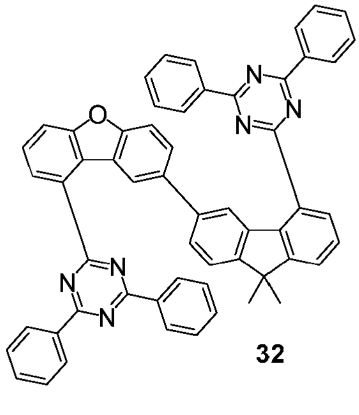

32

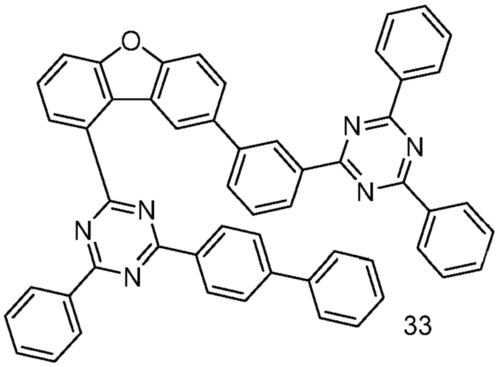

33

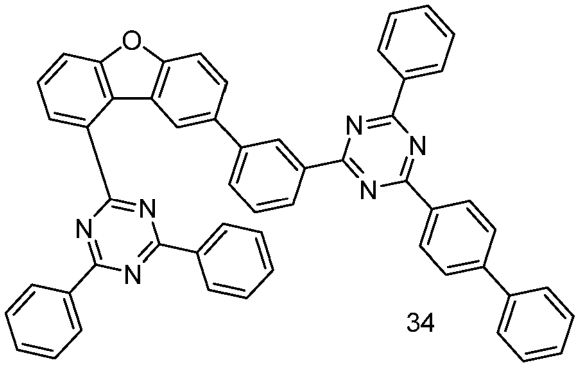

34

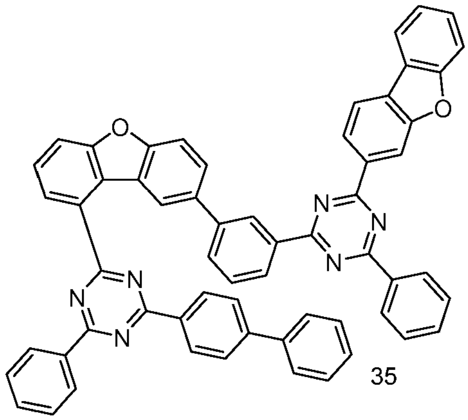
35

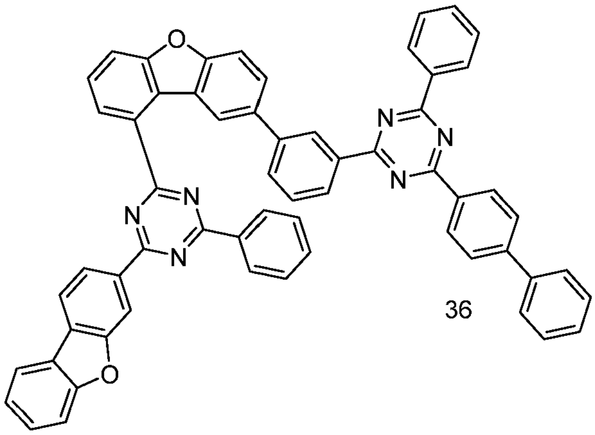
36

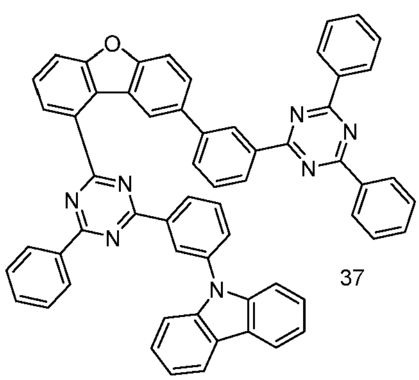
37

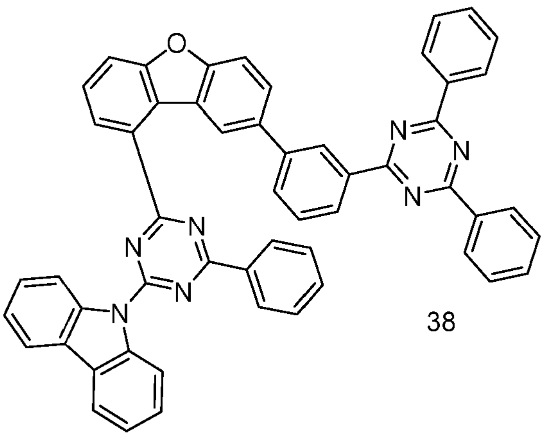
38

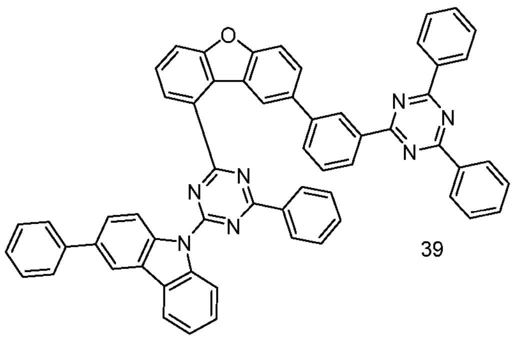
39

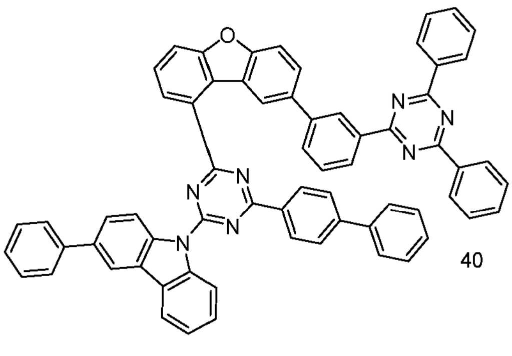
40

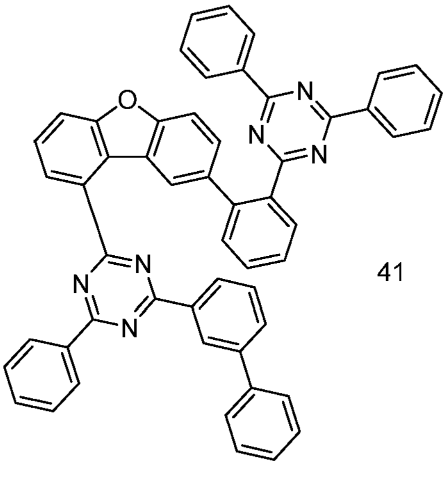
41

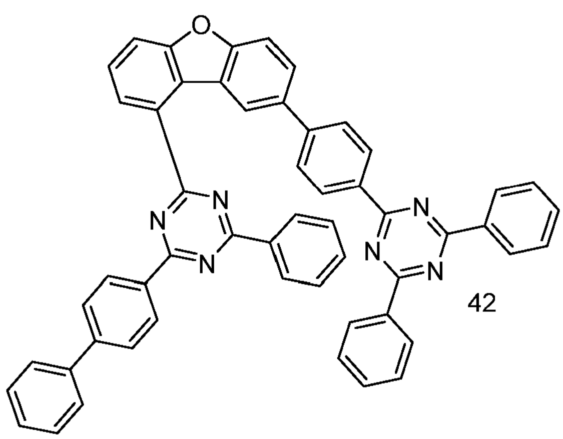
42

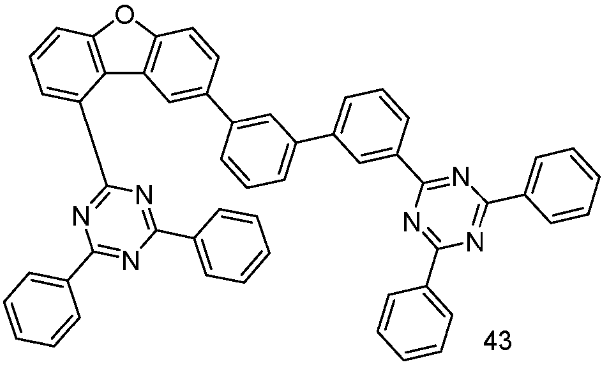

43

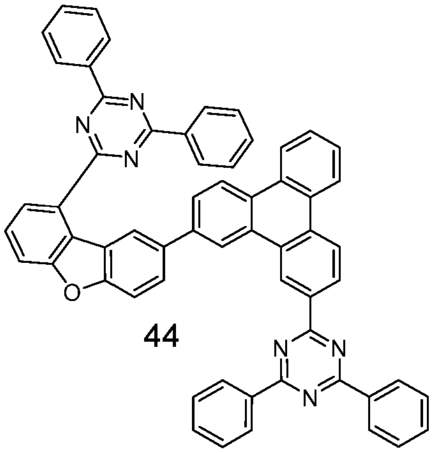

44

.

Die Herstellung der Verbindungen der Formel (1) oder der bevorzugten Verbindungen der Tabelle 1 sowie der Verbindungen **1** bis **11** und **29** bis **44** ist dem Fachmann bekannt. Die Verbindungen können nach dem Fachmann bekannten Syntheseschritten, wie z.B. Halogenierung, bevorzugt Bromierung, und einer sich anschließenden metallorganischen Kupplungsreaktion, z.B. Suzuki-Kupplung, Heck-Kupplung oder Hartwig-Buchwald-Kupplung, hergestellt werden. Die Herstellung der Verbindungen der Formel (1) oder der bevorzugten Verbindungen der Tabelle 1 sowie der Verbindungen **1** bis **11** und **29** bis **44** ist insbesondere aus WO2017178311 ableitbar, insbesondere Seite 46 sowie der Synthesebeispiele der Seiten 81 bis 106.

Die Herstellung der Verbindungen der Formel (1) kann nach folgendem Schema 1 erfolgen, wobei Y, R, a, b, $Ar_1$ und L eine der zuvor angegebenen oder bevorzugt angegebenen Bedeutungen hat.

Schema 1:

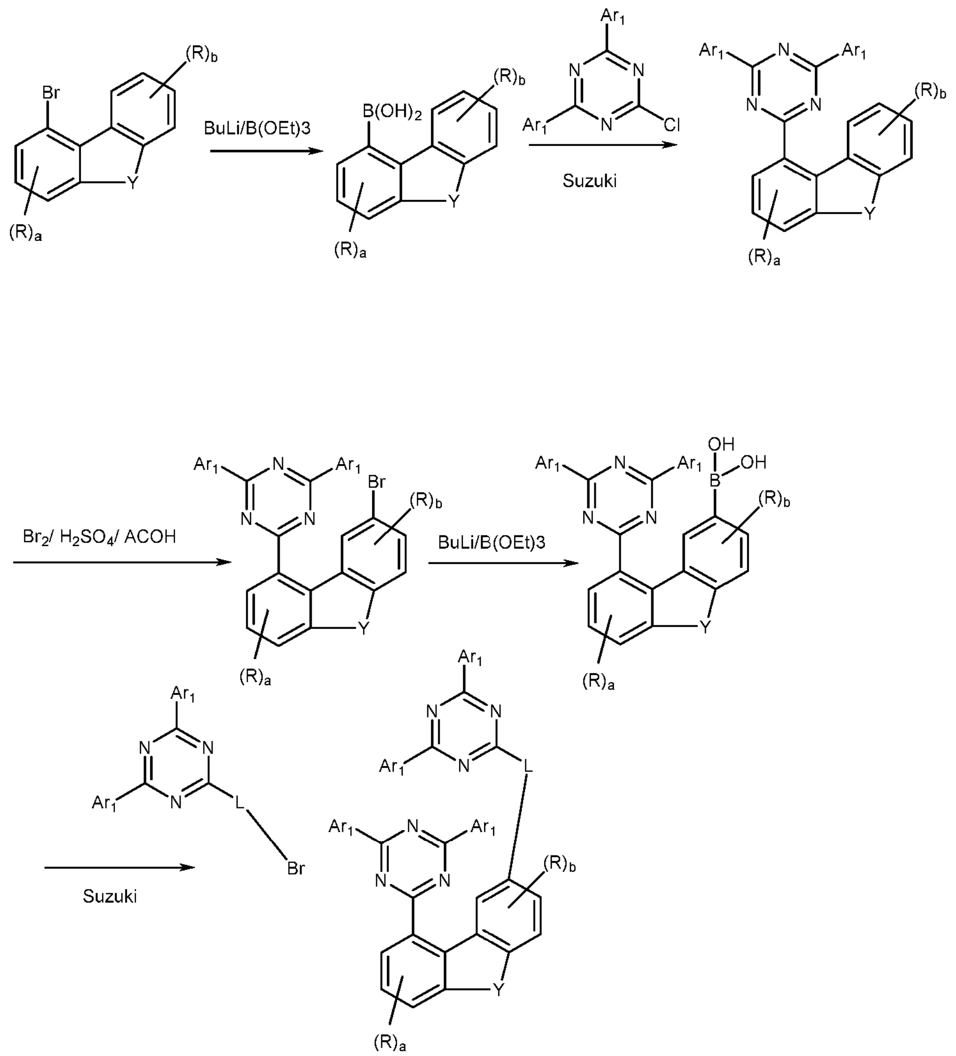


Im Folgenden wird das Hostmaterial 2 und dessen bevorzugte Ausführungsformen beschrieben, welches/welche in der erfindungsgemäßen Vorrichtung enthalten ist.

Hostmaterial 2 ist mindestens eine Verbindung der Formel (2a),

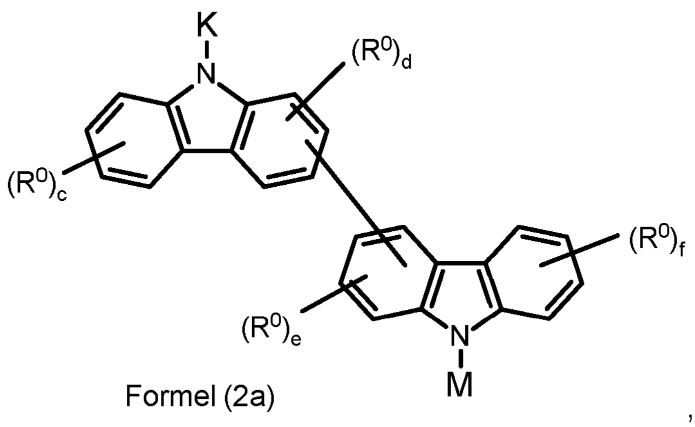

Formel (2a) ,

wobei für die verwendeten Symbole und Indizes gilt:

K, M sind jeweils unabhängig voneinander ein unsubstituiertes oder teilweise oder vollständig deuteriertes

oder einfach durch R* substituiertes aromatisches Ringsystem mit 6 bis 40 aromatischen Ringatomen;

$R^0$ ist bei jedem Auftreten unabhängig voneinander ein unsubstituiertes oder teilweise oder vollständig deuteriertes aromatisches Ringsystem mit 6 bis 18 C-Atomen; und

c, d, e und f sind unabhängig voneinander 0 oder 1.

In einer Ausführungsform der Erfindung werden für die erfindungsgemäße Vorrichtung Verbindungen der Formel (2a) ausgewählt, wie zuvor beschrieben, die mit Verbindungen der Formel (1), wie zuvor beschrieben oder bevorzugt beschrieben, oder mit den Verbindungen der Tabelle 1 oder den Verbindungen **1** bis **11** und **29** bis **44,** in der lichtemittierenden Schicht verwendet werden.

In bevorzugten Verbindungen der Formel (2a) ist die Summe der Indizes c+d+e+f bevorzugt 0 oder 1 und $R^0$ hat eine zuvor oder nachfolgend bevorzugt angegebene Bedeutung.

In Verbindungen der Formel (2a) ist $R^0$ ist bei jedem Auftreten unabhängig voneinander bevorzugt ein unsubstituiertes aromatisches Ringsystem mit 6 bis 18 C-Atomen. $R^0$ ist bei jedem Auftreten unabhängig voneinander bevorzugt Phenyl, 1,3-Biphenyl, 1,4-Biphenyl, Naphthyl oder Triphenylenyl. $R^0$ ist bei jedem Auftreten unabhängig voneinander besonders bevorzugt Phenyl.

In Verbindungen der Formel (2a) sind die Indizes c, d, e und f besonders bevorzugt 0.

In Verbindungen der Formel (2a), sind K und M bei jedem Auftreten unabhängig voneinander bevorzugt ein unsubstituiertes oder teilweise deuteriertes oder einfach durch R* substituiertes aromatisches Ringsystem mit 6 bis 40 aromatischen Ringatomen, wie zuvor beschrieben. K und M in Verbindungen der Formel (2a) sind bei jedem Auftreten unabhängig voneinander besonders bevorzugt Phenyl, mit Dibenzofuran substituiertes Phenyl, mit Dibenzothiophen substituiertes Phenyl, deuteriertes Phenyl, 1,3-Biphenyl, 1,4-Biphenyl, Terphenyl, teilweise deuteriertes Terphenyl, Quaterphenyl, Naphthyl, Fluorenyl, 9,9-Diphenyl-fluorenyl, Bispirofluorenyl oder Triphenylenyl.

Ein weiterer Gegenstand der Erfindung ist demzufolge eine organische elektrolumineszierende Vorrichtung, wie zuvor beschrieben oder bevorzugt beschrieben, wobei die mindestens eine Verbindung der Formel (2a) einer bevorzugten Ausführungsform der Verbindung der Formel (2a) entspricht.

Beispiele für geeignete Hostmaterialien der Formel (2a), die erfindungsgemäß ausgewählt werden, und bevorzugt in Kombination mit mindestens einer Verbindung der Formel (1) in der erfindungsgemäßen elektrolumineszierenden Vorrichtung verwendet werden, sind die nachstehend genannten Strukturen der Tabelle 2.

Tabelle 2:

| | | |
|---|---|---|
| 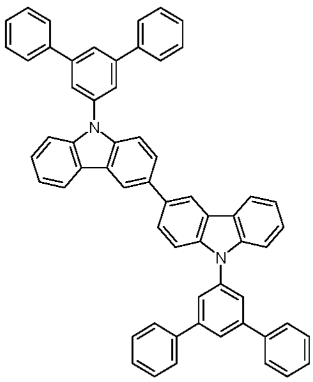 | 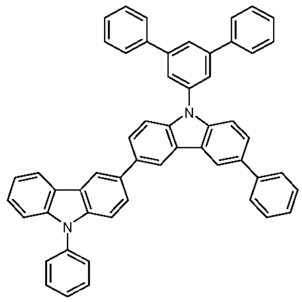 | 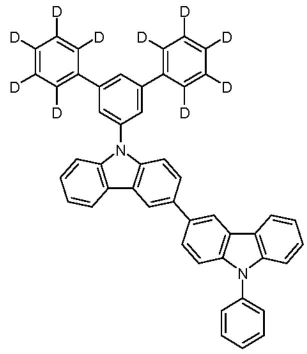 |
| 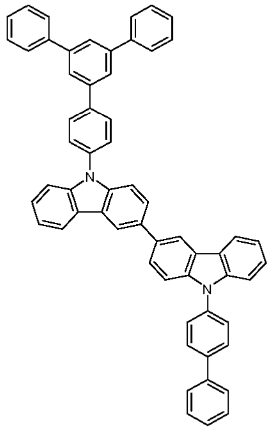 | 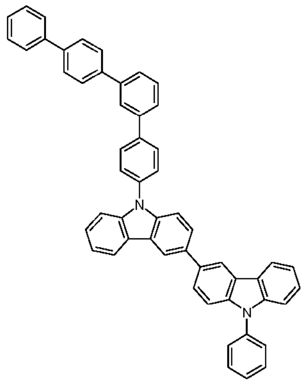 | 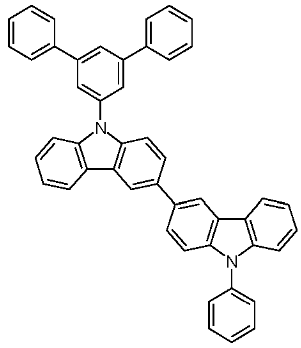 |
| 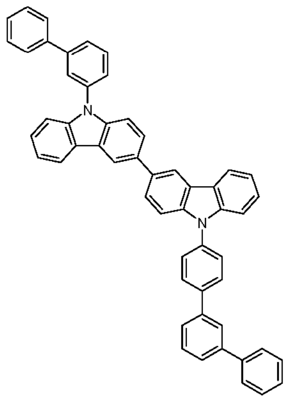 | 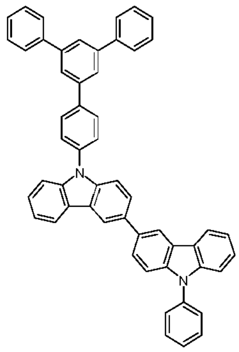 | 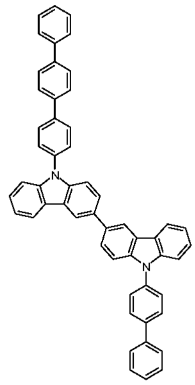 |
| 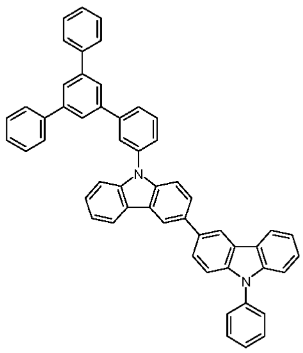 | 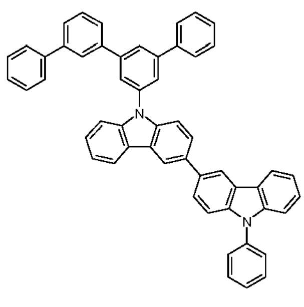 | 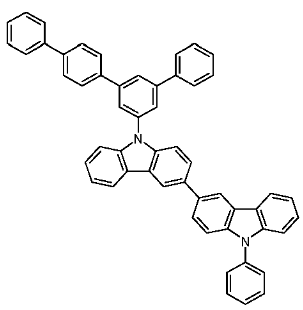 |

| | | |
|---|---|---|
| 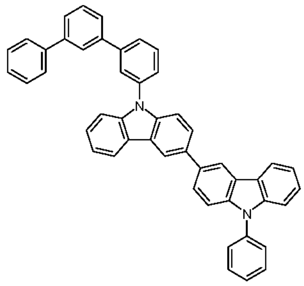 | 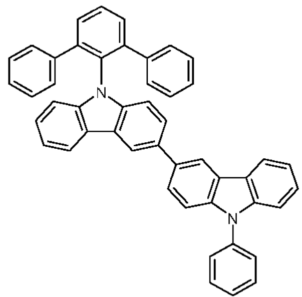 | 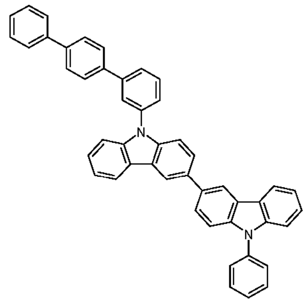 |
| 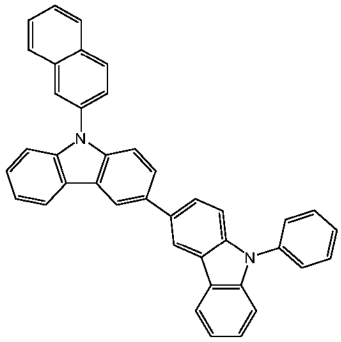 | 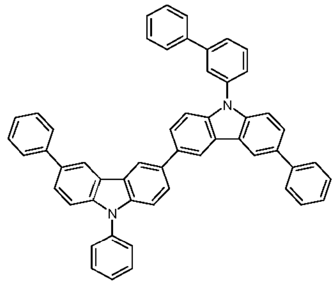 | 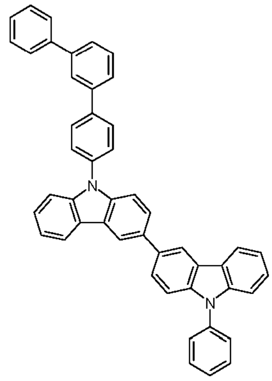 |
| 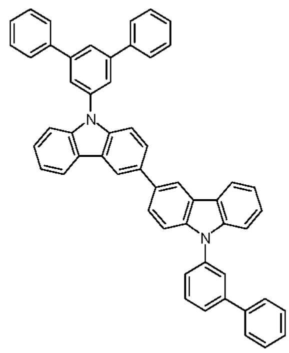 | 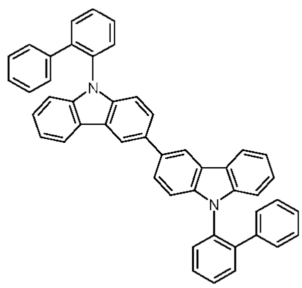 | 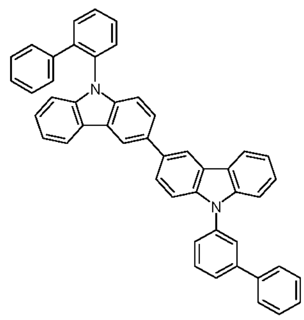 |
| 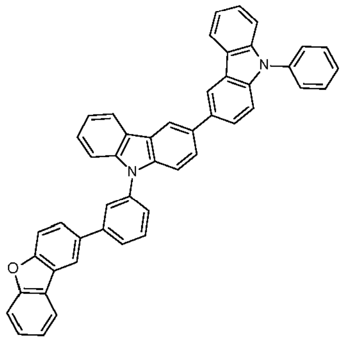 24 | 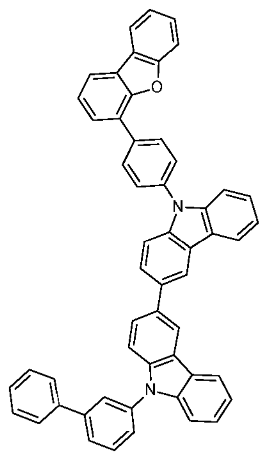 | 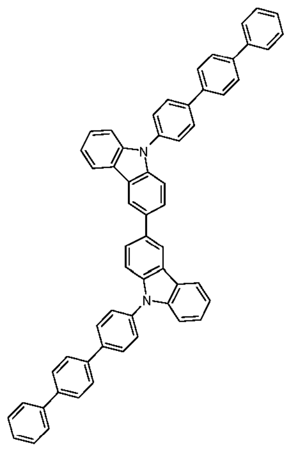 |

| | | |
|---|---|---|
| 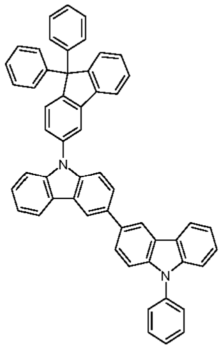 | 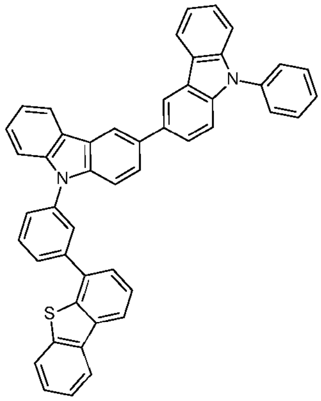 | 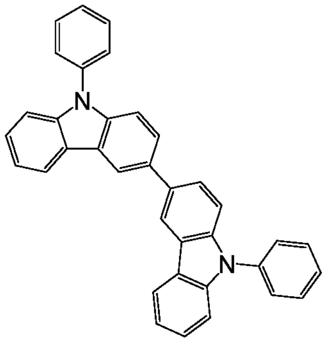<br>**23** |
| | 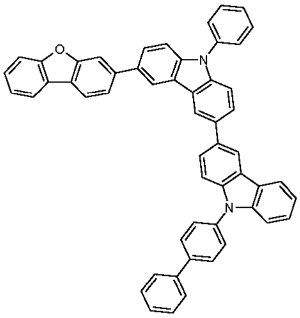 | |
| | 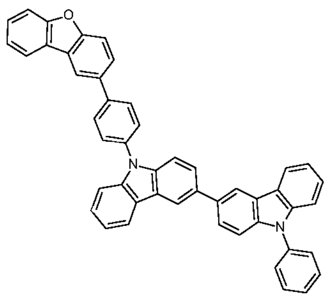 | |
| 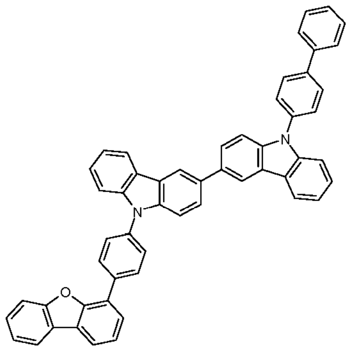 | 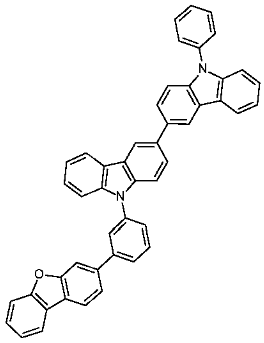 | 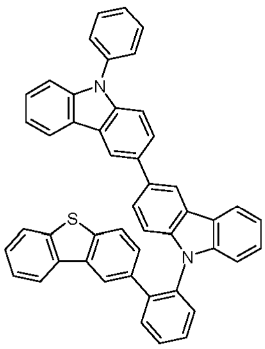 |

| | | |
|---|---|---|
| 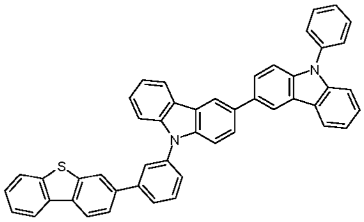 | 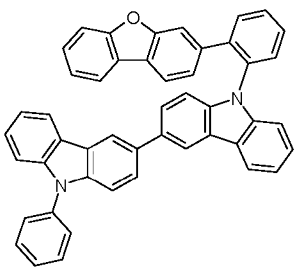 | 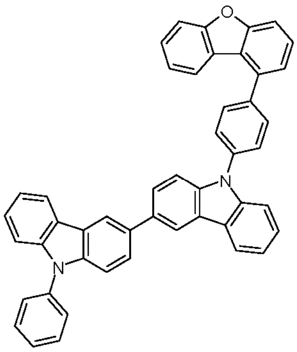 |
| 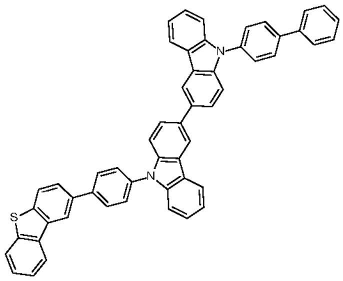 | 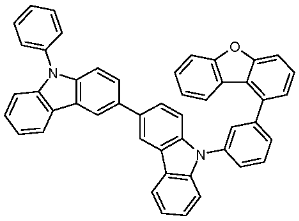 | 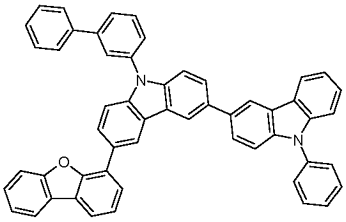 |
| 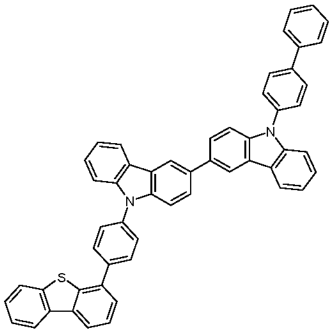 | 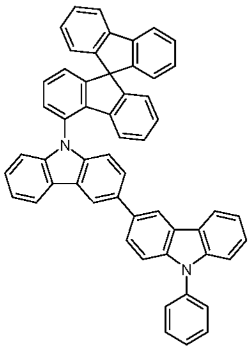 | 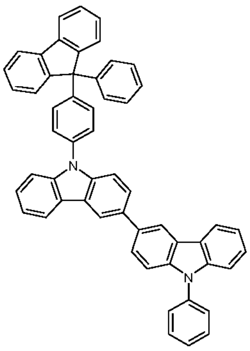 |
| 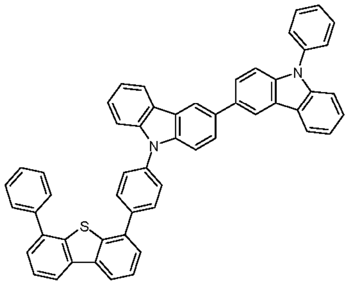 | 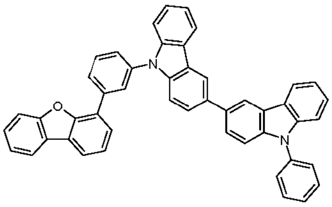 | 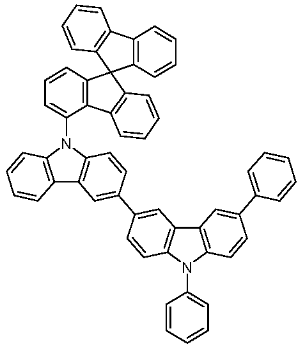 |
| 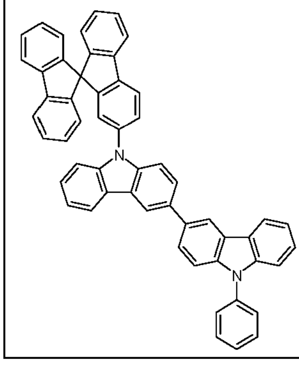 | 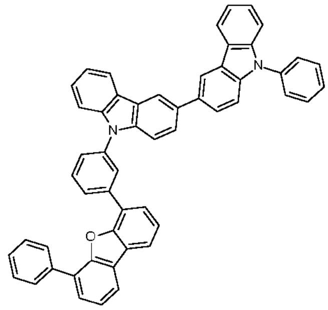 | 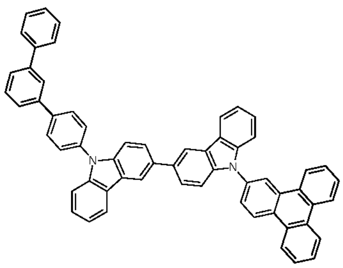 |

| | | |
|---|---|---|
| 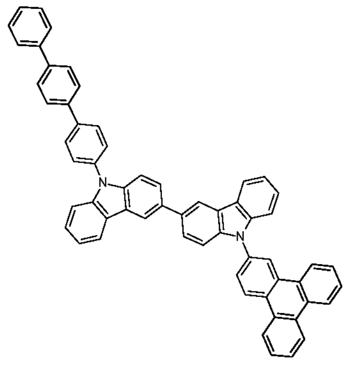 | 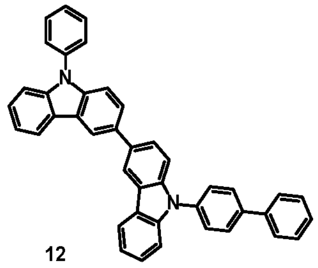 12 | 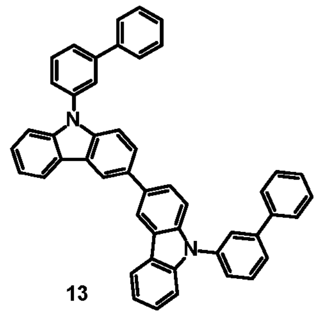 13 |
| 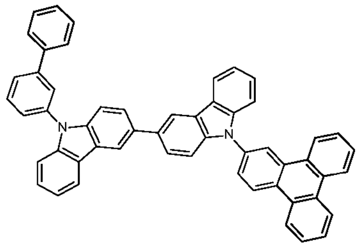 | 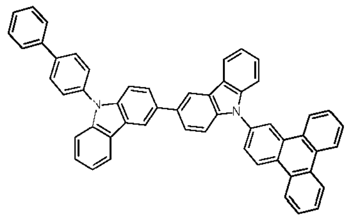 | 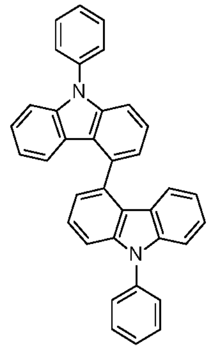 |
| 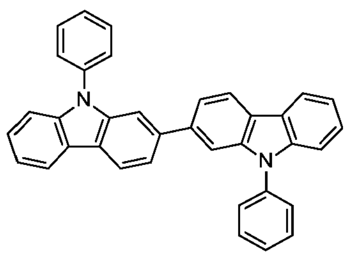 | 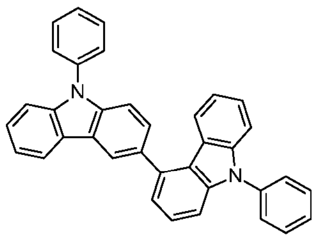 | 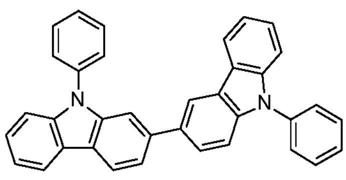 |
| 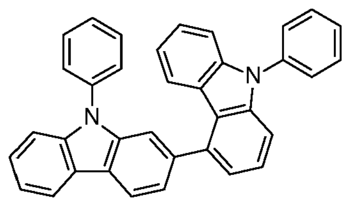 | 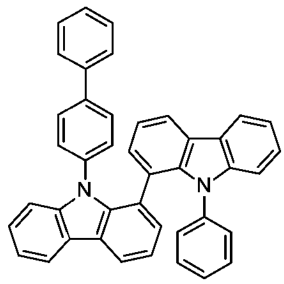 | 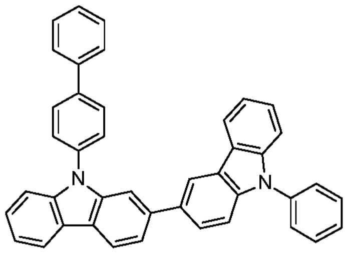 |

| | | |
|---|---|---|
| 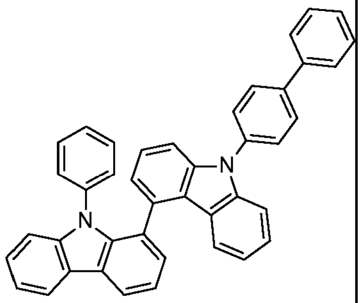 | 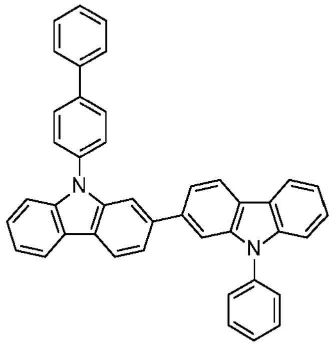 | 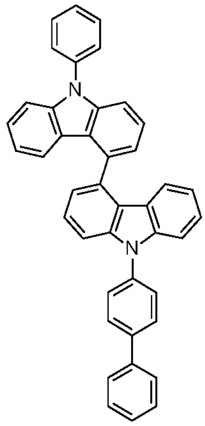 |
| 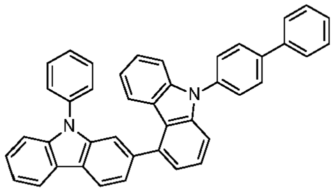 | 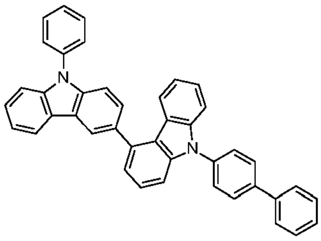 | 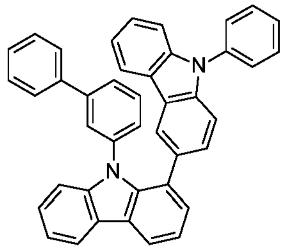 |
| 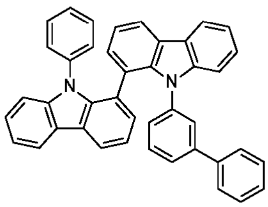 | 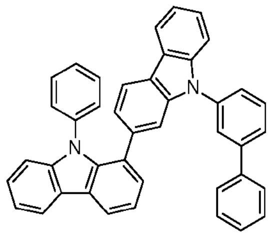 | 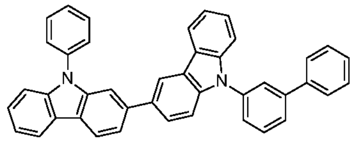 |
| 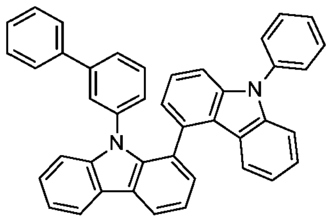 | 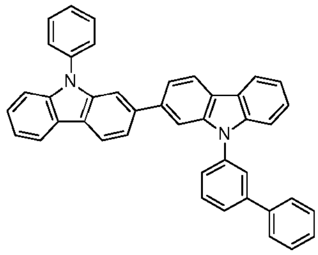 | 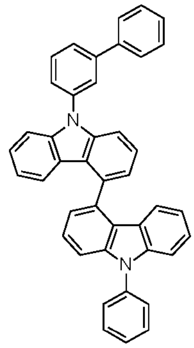 |
| 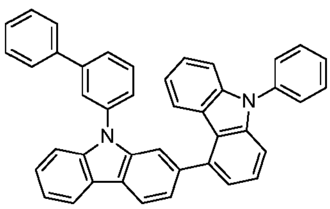 | 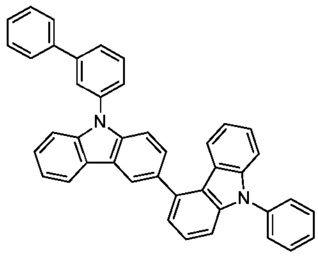 | 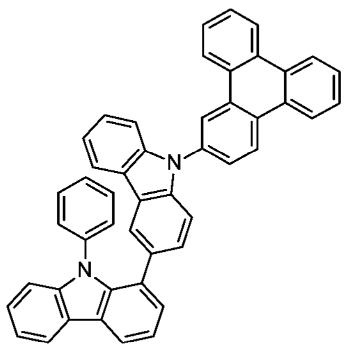 |

| | | |
|---|---|---|
| 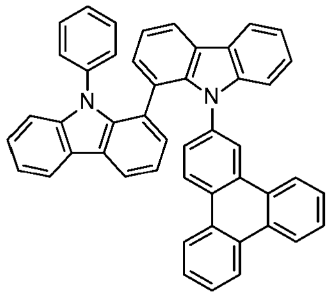 | 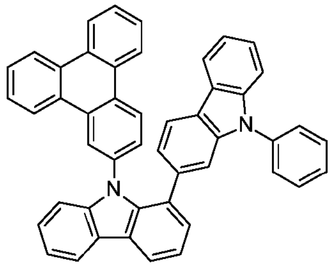 | 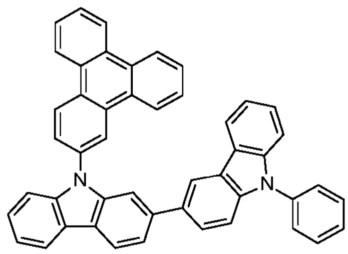 |
| 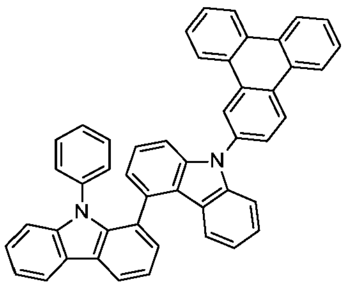 | 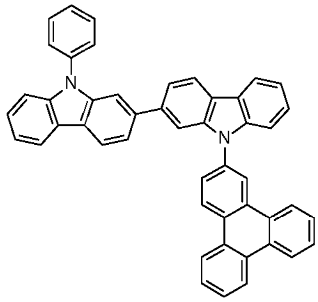 | 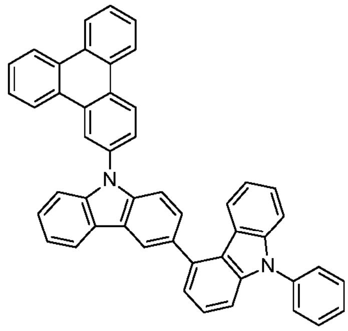 |
| 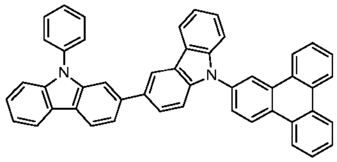 | 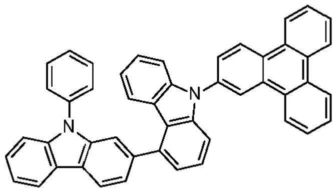 | 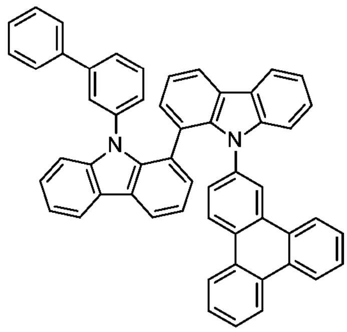 |
| 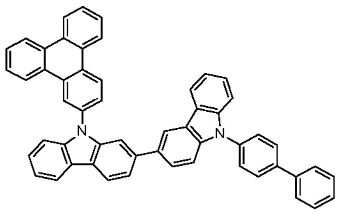 | | |

Besonders geeignete Verbindungen der Formel (2a), die bevorzugt in Kombination mit mindestens einer Verbindung der Formel (1) in der erfindungsgemäßen elektrolumineszierenden Vorrichtung verwendet werden, sind die Verbindungen **12** bis **17, 23** und **24:**

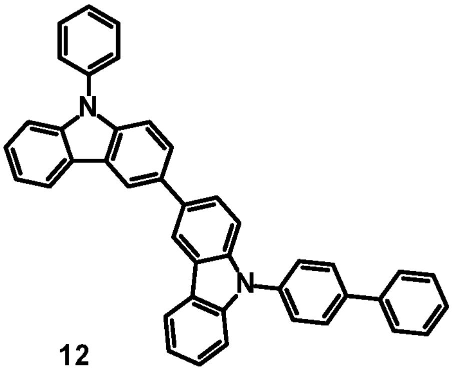

12

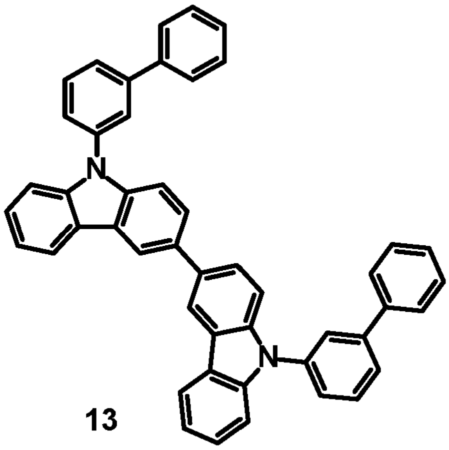

13

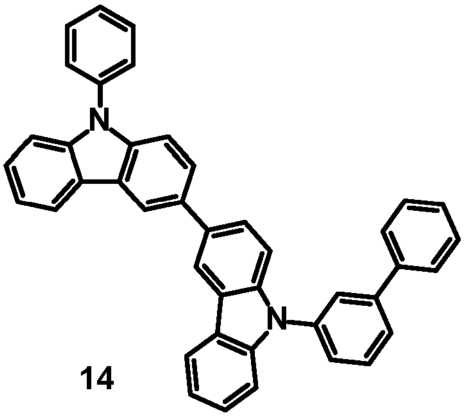

14

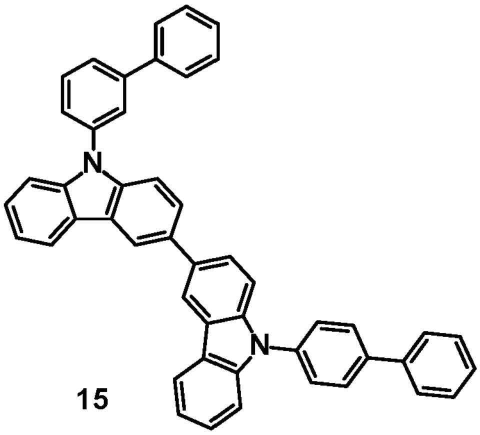

15

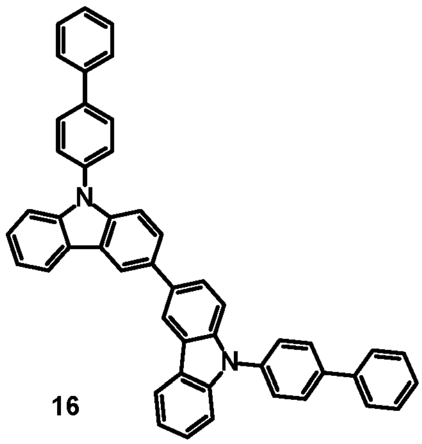

16

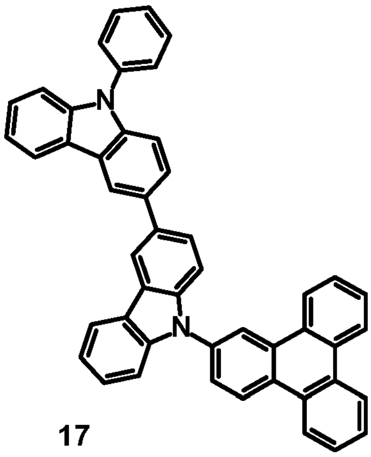

17

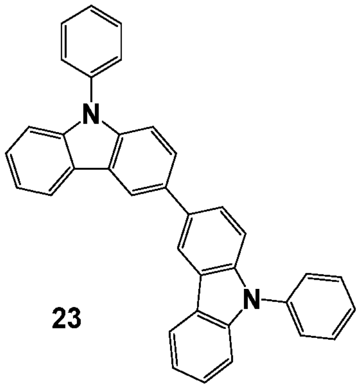

23

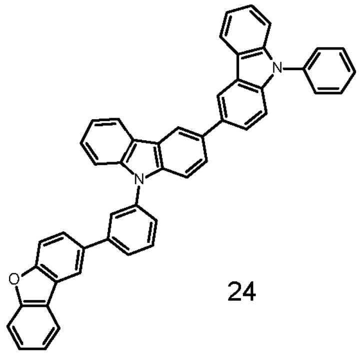

24

Die Herstellung der Verbindungen der Formel (2a) oder der bevorzugten Verbindungen der Formel (2a), sowie der Verbindungen der Tabelle 2 und Verbindungen **12** bis **17, 23** und **24** ist dem Fachmann bekannt. Die Verbindungen können nach dem Fachmann bekannten Syntheseschritten, wie z.B. Halogenierung, bevorzugt Bromierung, und einer sich anschließenden metallorganischen Kupplungsreaktion, z.B. Suzuki-Kupplung, Heck-Kupplung oder Hartwig-Buchwald-Kupplung, hergestellt werden. Zum Teil sind die Verbindungen der Formel (2a) kommerziell erhältlich.

Die vorstehend genannten Hostmaterialien der Formel (1) sowie deren bevorzugt beschriebene Ausführungsformen oder die Verbindungen der Tabelle 1 und der Verbindungen **1** bis **11** und **29** bis **44** können in der erfindungsgemäßen Vorrichtung beliebig mit den genannten Hostmaterialien der Formel(2a) sowie deren bevorzugt beschriebene Ausführungsformen oder den Verbindungen der Tabelle 2 oder den Verbindungen **12** bis **17, 23** und **24** kombiniert werden.

Zuvor genannte spezielle Kombinationen von Hostmaterialien der Formel (1) mit Hostmaterialien der Formel (2a) sind bevorzugt, wie zuvor beschrieben. Bevorzugte Kombinationen von Hostmaterialien sind ebenfalls nachfolgend beschrieben.

Ein weiterer Gegenstand der Erfindung sind ebenfalls Mischungen nach Anspruch 13.

Besonders bevorzugte Mischungen der Hostmaterialien der Formel (1) mit den Hostmaterialien der Formel (2a) für die erfindungsgemäße Vorrichtung erhält man durch Kombination der Verbindungen **1** bis **11** und **29** bis **44** mit den Verbindungen der Tabelle 2.

Ganz besonders bevorzugte Mischungen der Hostmaterialien der Formel (1) mit den Hostmaterialien der Formel (2a) für die erfindungsgemäße Vorrichtung erhält man durch Kombination der Verbindungen 1 bis **11** und **29** bis **44** mit den Verbindungen **12** bis **17, 23** und 24 wie im Folgenden in Tabelle 3 gezeigt.

Tabelle 3:

| | | | | | | | | |
|---|---|---|---|---|---|---|---|---|
| M1 | 1 | 12 | M2 | 2 | 12 | M3 | 3 | 12 |
| M4 | 4 | 12 | M5 | 5 | 12 | M6 | 6 | 12 |
| M7 | 7 | 12 | M8 | 8 | 12 | M9 | 9 | 12 |
| M10 | 10 | 12 | M11 | 11 | 12 | M12 | 29 | 12 |
| M13 | 30 | 12 | M14 | 31 | 12 | M15 | 32 | 12 |
| M16 | 33 | 12 | M17 | 34 | 12 | M18 | 35 | 12 |
| M19 | 36 | 12 | M20 | 37 | 12 | M21 | 38 | 12 |
| M22 | 39 | 12 | M23 | 40 | 12 | M24 | 41 | 12 |
| M25 | 42 | 12 | M26 | 43 | 12 | M27 | 44 | 12 |
| M28 | 1 | 13 | M29 | 2 | 13 | M30 | 3 | 13 |
| M31 | 4 | 13 | M32 | 5 | 13 | M33 | 6 | 13 |
| M34 | 7 | 13 | M35 | 8 | 13 | M36 | 9 | 13 |
| M37 | 10 | 13 | M38 | 11 | 13 | M39 | 29 | 13 |
| M40 | 30 | 13 | M41 | 31 | 13 | M42 | 32 | 13 |
| M43 | 33 | 13 | M44 | 34 | 13 | M45 | 35 | 13 |
| M46 | 36 | 13 | M47 | 37 | 13 | M48 | 38 | 13 |

(fortgesetzt)

| | | | | | | | | |
|---|---|---|---|---|---|---|---|---|
| M49 | 39 | 13 | M50 | 40 | 13 | M51 | 41 | 13 |
| M52 | 42 | 13 | M53 | 43 | 13 | M54 | 44 | 13 |
| M55 | 1 | 14 | M56 | 2 | 14 | M57 | 3 | 14 |
| M58 | 4 | 14 | M59 | 5 | 14 | M60 | 6 | 14 |
| M61 | 7 | 14 | M62 | 8 | 14 | M63 | 9 | 14 |
| M64 | 10 | 14 | M65 | 11 | 14 | M66 | 29 | 14 |
| M67 | 30 | 14 | M68 | 31 | 14 | M69 | 32 | 14 |
| M70 | 33 | 14 | M71 | 34 | 14 | M72 | 35 | 14 |
| M73 | 36 | 14 | M74 | 37 | 14 | M75 | 38 | 14 |
| M76 | 39 | 14 | M77 | 40 | 14 | M78 | 41 | 14 |
| M79 | 42 | 14 | M80 | 43 | 14 | M81 | 44 | 14 |
| M82 | 1 | 15 | M83 | 2 | 15 | M84 | 3 | 15 |
| M85 | 4 | 15 | M86 | 5 | 15 | M87 | 6 | 15 |
| M88 | 7 | 15 | M89 | 8 | 15 | M90 | 9 | 15 |
| M91 | 10 | 15 | M92 | 11 | 15 | M93 | 29 | 15 |
| M94 | 30 | 15 | M95 | 31 | 15 | M96 | 32 | 15 |
| M97 | 33 | 15 | M98 | 34 | 15 | M99 | 35 | 15 |
| M100 | 36 | 15 | M101 | 37 | 15 | M102 | 38 | 15 |
| M103 | 39 | 15 | M104 | 40 | 15 | M105 | 41 | 15 |
| M106 | 42 | 15 | M107 | 43 | 15 | M108 | 44 | 15 |
| M109 | 1 | 16 | M110 | 2 | 16 | M111 | 3 | 16 |
| M112 | 4 | 16 | M113 | 5 | 16 | M114 | 6 | 16 |
| M115 | 7 | 16 | M116 | 8 | 16 | M117 | 9 | 16 |
| M118 | 10 | 16 | M119 | 11 | 16 | M120 | 29 | 16 |
| M121 | 30 | 16 | M122 | 31 | 16 | M123 | 32 | 16 |
| M124 | 33 | 16 | M125 | 34 | 16 | M126 | 35 | 16 |
| M127 | 36 | 16 | M128 | 37 | 16 | M129 | 38 | 16 |
| M130 | 39 | 16 | M131 | 40 | 16 | M132 | 41 | 16 |
| M133 | 42 | 16 | M134 | 43 | 16 | M135 | 44 | 16 |
| M136 | 1 | 17 | M137 | 2 | 17 | M138 | 3 | 17 |
| M139 | 4 | 17 | M140 | 5 | 17 | M141 | 6 | 17 |
| M142 | 7 | 17 | M143 | 8 | 17 | M144 | 9 | 17 |
| M145 | 10 | 17 | M146 | 11 | 17 | M147 | 29 | 17 |
| M148 | 30 | 17 | M149 | 31 | 17 | M150 | 32 | 17 |
| M151 | 33 | 17 | M152 | 34 | 17 | M153 | 35 | 17 |
| M154 | 36 | 17 | M155 | 37 | 17 | M156 | 38 | 17 |
| M157 | 39 | 17 | M158 | 40 | 17 | M159 | 41 | 17 |
| M160 | 42 | 17 | M161 | 43 | 17 | M162 | 44 | 17 |
| M298 | 1 | 23 | M299 | 2 | 23 | M300 | 3 | 23 |
| M301 | 4 | 23 | M302 | 5 | 23 | M303 | 6 | 23 |

(fortgesetzt)

| | | | | | | | | |
|---|---|---|---|---|---|---|---|---|
| M304 | 7 | 23 | M305 | 8 | 23 | M306 | 9 | 23 |
| M307 | 10 | 23 | M308 | 11 | 23 | M309 | 29 | 23 |
| M310 | 30 | 23 | M311 | 31 | 23 | M312 | 32 | 23 |
| M313 | 33 | 23 | M314 | 34 | 23 | M315 | 35 | 23 |
| M316 | 36 | 23 | M317 | 37 | 23 | M318 | 38 | 23 |
| M319 | 39 | 23 | M320 | 40 | 23 | M321 | 41 | 23 |
| M322 | 42 | 23 | M323 | 43 | 23 | M324 | 44 | 23 |
| M325 | 1 | 24 | M326 | 2 | 24 | M327 | 3 | 24 |
| M328 | 4 | 24 | M329 | 5 | 24 | M330 | 6 | 24 |
| M331 | 7 | 24 | M332 | 8 | 24 | M333 | 9 | 24 |
| M334 | 10 | 24 | M335 | 11 | 24 | M336 | 29 | 24 |
| M337 | 30 | 24 | M338 | 31 | 24 | M339 | 32 | 24 |
| M340 | 33 | 24 | M341 | 34 | 24 | M342 | 35 | 24 |
| M343 | 36 | 24 | M344 | 37 | 24 | M345 | 38 | 24 |
| M346 | 39 | 24 | M347 | 40 | 24 | M348 | 41 | 24 |
| M349 | 42 | 24 | M350 | 43 | 24 | M351 | 44 | 24 |

Die Konzentration des elektronentransportierenden Hostmaterials der Formel (1), wie zuvor beschrieben oder bevorzugt beschrieben, in der erfindungsgemäßen Mischung oder in der lichtemittierenden Schicht der erfindungsgemäßen Vorrichtung liegt im Bereich von 5 Gew.-% bis 90 Gew.-%, bevorzugt im Bereich von 10 Gew.-% bis 85 Gew.-%, mehr bevorzugt im Bereich von 20 Gew.-% bis 85 Gew.-%, noch mehr bevorzugt im Bereich von 30 Gew.-% bis 80 Gew.-%, ganz besonders bevorzugt im Bereich von 20 Gew.-% bis 60 Gew.-% und am meisten bevorzugt im Bereich von 30 Gew.-% bis 50 Gew.-%, bezogen auf die gesamte Mischung oder bezogen auf die gesamte Zusammensetzung der lichtemittierenden Schicht.

Die Konzentration des lochtransportierenden Hostmaterials der Formel (2a), wie zuvor beschrieben oder als bevorzugt beschrieben, in der erfindungsgemäßen Mischung oder in der lichtemittierenden Schicht der erfindungsgemäßen Vorrichtung liegt im Bereich von 10 Gew.-% bis 95 Gew.-%, bevorzugt im Bereich von 15 Gew.-% bis 90 Gew.-%, mehr bevorzugt im Bereich von 15 Gew.-% bis 80 Gew.-%, noch mehr bevorzugt im Bereich von 20 Gew.-% bis 70 Gew.-%, ganz besonders bevorzugt im Bereich von 40 Gew.-% bis 80 Gew.-% und am meisten bevorzugt im Bereich von 50 Gew.-% bis 70 Gew.-%, bezogen auf die gesamte Mischung oder bezogen auf die gesamte Zusammensetzung der lichtemittierenden Schicht.

Die vorliegende Erfindung betrifft auch eine Mischung M1 bis M162 und M298 bis M351, die neben diesen genannten Hostmaterialien 1 und 2 mindestens noch einen phosphoreszierenden Emitter enthält.

Die vorliegende Erfindung betrifft auch eine organische elektrolumineszierende Vorrichtung, wie zuvor beschrieben oder bevorzugt beschrieben, wobei die lichtemittierende Schicht neben den vorstehend genannten Hostmaterialien 1 und 2, wie zuvor beschrieben oder bevorzugt beschrieben, mindestens noch einen phosphoreszierenden Emitter der Formel (3) enthält.

Vom Begriff phosphoreszierende Emitter sind typischerweise Verbindungen umfasst, bei denen die Lichtemission durch einen spin-verbotenen Übergang aus einem angeregten Zustand mit höherer Spinmultiplizität, also einem Spinzustand > 1, erfolgt, beispielsweise durch einen Übergang aus einem Triplett-Zustand oder einem Zustand mit einer noch höheren Spinquantenzahl, beispielsweise einem Quintett-Zustand. Bevorzugt wird hierbei ein Übergang aus einem Triplett-Zustand verstanden.

Die Emitter gemäß der vorliegenden Erfindung entsprechen der Formel (3),

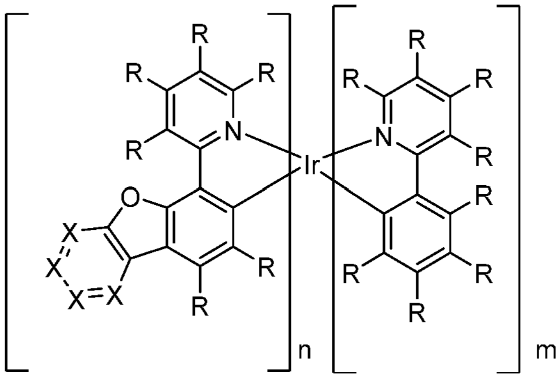

Formel (3)

,

wobei die Symbole und Indizes für diese Formel (3) die Bedeutung haben: n+m ist 3, n ist 1 oder 2, m ist 2 oder 1,

X ist N oder CR,

R ist H, D oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 7 C-Atomen, die teilweise oder vollständig mit Deuterium substituiert sein kann.

In Emittern der Formel (3) ist n bevorzugt 1 und m ist bevorzugt 2.

In Emittern der Formel (3) ist bevorzugt ein X ausgewählt aus N und die anderen X bedeuten CR.

In Emittern der Formel (3) ist mindestens ein R bevorzugt unterschiedlich von H. In Emittern der Formel (3) sind bevorzugt zwei R unterschiedlich von H und haben eine der sonst zuvor für die Emitter der Formel (3) angegebenen Bedeutungen.

Bevorzugte Beispiele von phosphoreszierenden Emittern sind in der folgenden Tabelle 4 aufgeführt.

Tabelle 4:

| | | |
|---|---|---|
| | | 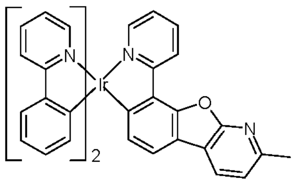 |
| 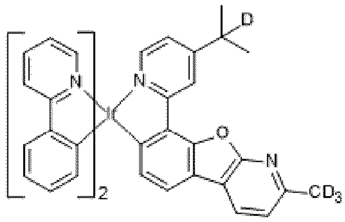 | 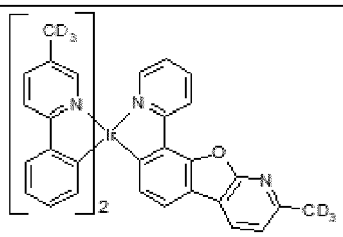 | 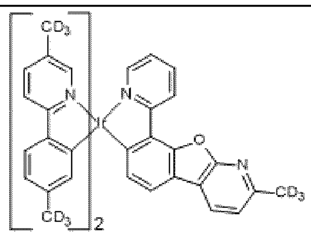 |
| 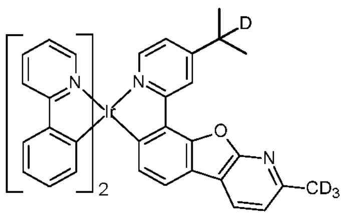 | 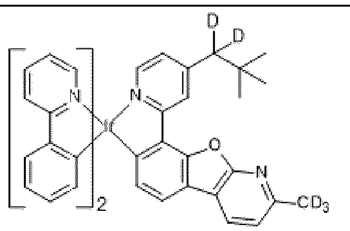 | 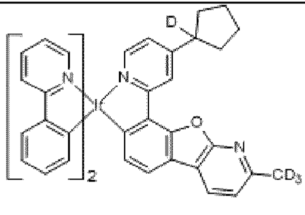 |

| | | |
|---|---|---|
| 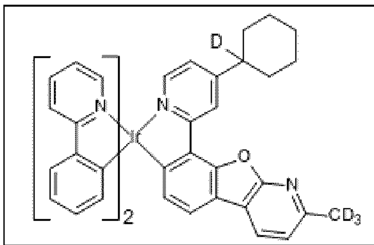 | 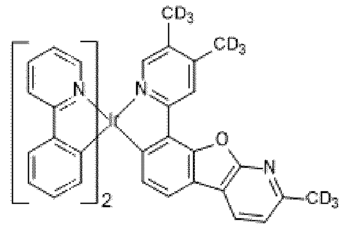 | 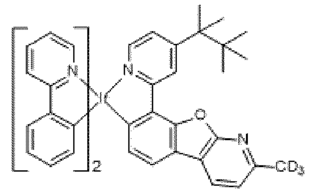 |
| 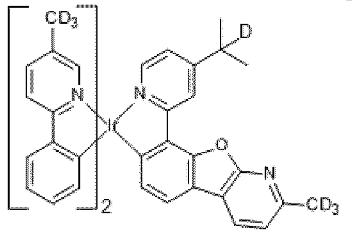 | 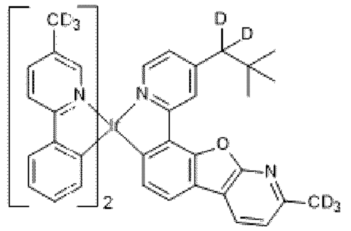 | 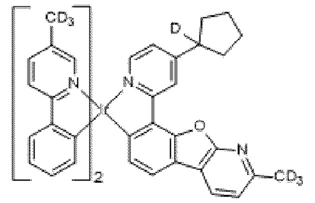 |
| 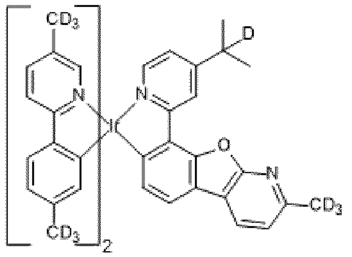 | 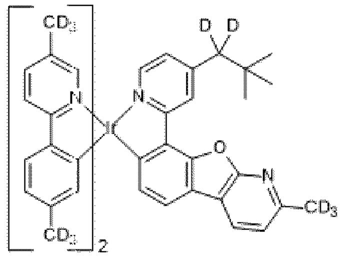 | 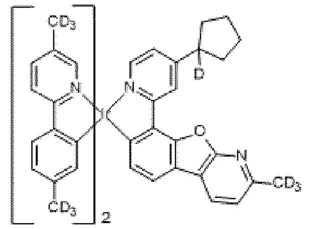 |
| 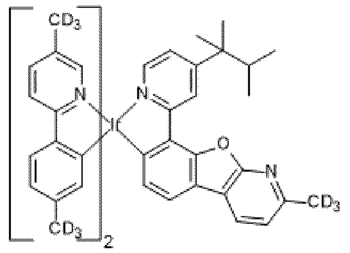 | 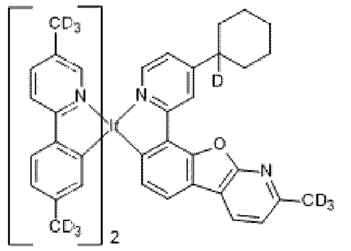 | 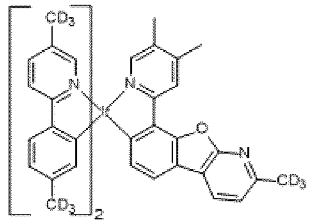 |
| 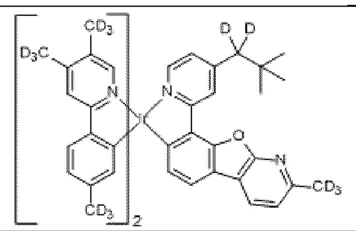 | 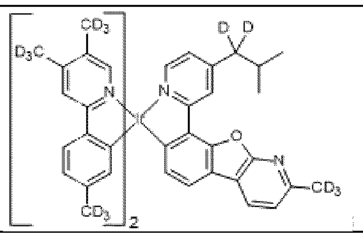 | 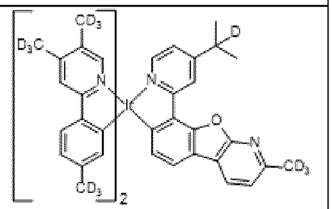 |
| 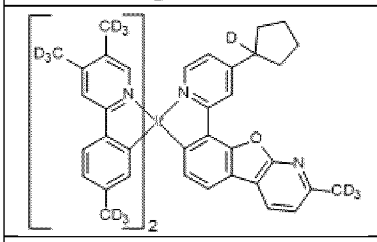 | 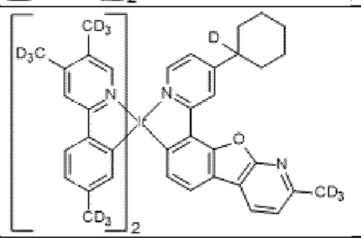 | 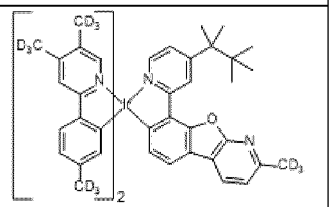 |
| | 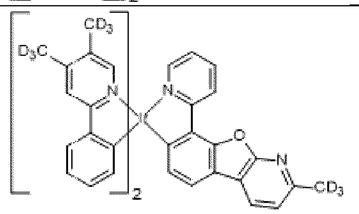 | 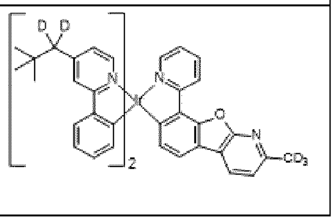 |

In den erfindungsgemäßen Mischungen oder in der lichtemittierenden Schicht der erfindungsgemäßen Vorrichtung wird jede Mischung M1, M2, M3, M4, M5, M6, M7, M8, M9, M10, M11, M12, M13, M14, M15, M16, M17, M18, M19, M20, M21, M22, M23, M24, M25, M26, M27, M28, M29, M30, M31, M32, M33, M34, M35, M36, M37, M38, M39, M40, M41, M42, M43, M44, M45, M46, M47, M48, M49, M50, M51, M52, M53, M54, M55, M56, M57, M58, M59, M60, M61, M62, M63,

M64, M65, M66, M67, M68, M69, M70, M71, M72, M73, M74, M75, M76, M77, M78, M79, M80, M81, M82, M83, M84, M85, M86, M87, M88, M89, M90, M91, M92, M93, M94, M95, M96, M97, M98, M99, M100, M101, M102, M103, M104, M105, M106, M107, M108, M109, M110, M111, M112, M113, M114, M115, M116, M117, M118, M119, M120, M121, M122, M123, M124, M125, M126, M127, M128, M129, M130, M131, M132, M133, M134, M135, M136, M137, M138, M139, M140, M141, M142, M143, M144, M145, M146, M147, M148, M149, M150, M151, M152, M153, M154, M155, M156, M157, M158, M159, M160, M161, M162, M298, M299, M300, M301, M302, M303, M304, M305, M306, M307, M308, M309, M310, M311, M312, M313, M314, M315, M316, M317, M318, M319, M320, M321, M322, M323, M324, M325, M326, M327, M328, M329, M330, M331, M332, M333, M334, M335, M336, M337, M338, M339, M340, M341, M342, M343, M344, M345, M346, M347, M348, M349, M350, M351 mit einer Verbindung der Formel (3) oder einer Verbindung aus Tabelle 4 kombiniert.

Die lichtemittierende Schicht in der erfindungsgemäßen organischen elektrolumineszierenden Vorrichtung enthaltend mindestens einen phosphoreszierenden Emitter ist bevorzugt eine infra-rot emittierende, gelb, orange, rot, grün, blau oder ultra-violett emittierende Schicht, besonders bevorzugt eine gelb oder grün emittierende Schicht und ganz besonders bevorzugt eine grün emittierende Schicht.

Dabei wird unter einer gelb emittierenden Schicht eine Schicht verstanden, deren Photolumineszenzmaximum im Bereich von 540 bis 570 nm liegt.

Unter einer orange emittierenden Schicht wird eine Schicht verstanden, deren Photolumineszenzmaximum im Bereich von 570 bis 600 nm liegt. Unter einer rot emittierenden Schicht wird eine Schicht verstanden, deren Photolumineszenzmaximum im Bereich von 600 bis 750 nm liegt. Unter einer grün emittierenden Schicht wird eine Schicht verstanden, deren Photolumineszenzmaximum im Bereich von 490 bis 540 nm liegt. Unter einer blau emittierenden Schicht wird eine Schicht verstanden, deren Photolumineszenzmaximum im Bereich von 440 bis 490 nm liegt. Dabei wird das Photolumineszenzmaximum der Schicht durch Messung des Photolumineszenzspektrums der Schicht mit einer Schichtdicke von 50 nm bei Raumtemperatur bestimmt, wobei die Schicht die erfindungsgemäße Kombination der Hostmaterialien der Formeln (1) und (2a) und den entsprechenden Emitter enthält.

Die Aufnahme des Photolumineszenzspektrums der Schicht erfolgt beispielsweise mit einem handelsüblichen Photolumineszenzspektrometer.

Das Photolumineszenzspektrum des gewählten Emitters wird in der Regel in Sauerstoff-freier Lösung, 10-5 molar, gemessen, wobei die Messung bei Raumtemperatur erfolgt und jedes Lösemittel geeignet ist, in dem sich der gewählte Emitter in der genannten Konzentration löst. Besonders geeignete Lösemittel sind üblicherweise Toluol oder 2-Methyl-THF, aber auch Dichlormethan. Gemessen wird mit einem handelsüblichen Photolumineszenzspektrometer. Die Triplettenergie T1 in eV wird aus den Photolumineszenzspektren der Emitter bestimmt. Es wird zunächst das Peakmaximum Plmax. (in nm) des Photolumineszenzspektrums bestimmt. Das Peakmaximum Plmax. (in nm) wird dann in eV umgerechnet gemäß:

$$E(T1 \text{ in eV}) = 1240 / E(T1 \text{ in nm}) = 1240 / PLmax. (\text{in nm}).$$

Bevorzugte phosphoreszierende Emitter sind demzufolge infra-rote Emitter der Formel (3) oder aus Tabelle 4, deren Triplettenergie $T_1$ bevorzugt bei ~1.9 eV bis ~1.0 eV liegt.

Bevorzugte phosphoreszierende Emitter sind demzufolge rote Emitter der Formel (3) oder aus Tabelle 4, deren Triplettenergie $T_1$ bevorzugt bei ~2.1 eV bis ~1.9 eV liegt.

Bevorzugte phosphoreszierende Emitter sind demzufolge gelbe Emitter der Formel (3) oder aus Tabelle 4, deren Triplettenergie $T_1$ bevorzugt bei ~2.3 eV bis ~2.1 eV liegt.

Bevorzugte phosphoreszierende Emitter sind demzufolge grüne Emitter der Formel (3) oder aus Tabelle 4, deren Triplettenergie $T_1$ bevorzugt bei ~2.5 eV bis ~2.3 eV liegt.

Bevorzugte phosphoreszierende Emitter sind demzufolge blaue Emitter der Formel (3) oder aus Tabelle 4, deren Triplettenergie $T_1$ bevorzugt bei ~3.1 eV bis ~2.5 eV liegt.

Bevorzugte phosphoreszierende Emitter sind demzufolge ultra-violette Emitter der Formel (3) oder aus Tabelle 4, deren Triplettenergie $T_1$ bevorzugt bei ~4.0 eV bis ~3.1 eV liegt.

Besonders bevorzugte phosphoreszierende Emitter sind demzufolge grüne oder gelbe Emitter der Formel (3) oder aus Tabelle 4, wie zuvor beschrieben.

Ganz besonders bevorzugte phosphoreszierende Emitter sind demzufolge grüne Emitter der Formel (3) oder aus Tabelle 4, deren Triplettenergie $T_1$ bevorzugt bei ~2.5 eV bis ~2.3 eV liegt.

Ganz besonders bevorzugt werden grüne Emitter der Formel (3) oder aus Tabelle 4, wie zuvor beschrieben, für die erfindungsgemäße Zusammensetzung bzw. erfindungsgemäße emittierende Schicht ausgewählt.

In der lichtemittierenden Schicht der erfindungsgemäßen Vorrichtung können auch fluoreszierende Emitter enthalten sein.

Bevorzugte fluoreszierende Emitter sind ausgewählt aus der Klasse der Arylamine. Unter einem Arylamin bzw.

einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte fluoreszierende Emitter sind Indenofluorenamine bzw. -diamine, beispielsweise gemäß WO 2006/108497 oder WO 2006/122630, Benzoindenofluorenamine bzw. -diamine, beispielsweise gemäß WO 2008/006449, und Dibenzoindenofluorenamine bzw. -diamine, beispielsweise gemäß WO 2007/140847, sowie die in WO 2010/012328 offenbarten Indenofluorenderivate mit kondensierten Arylgruppen.

In einer weiteren bevorzugten Ausführungsform der Erfindung kann die mindestens eine lichtemittierende Schicht der organischen elektrolumineszierenden Vorrichtung nach Anspruch 1 neben den Hostmaterialien 1 und 2, wie zuvor beschrieben oder als bevorzugt beschrieben, weitere Hostmaterialien oder Matrixmaterialien umfassen, sogenannte Mixed-Matrix-Systeme. Die Mixed-Matrix-Systeme umfassen bevorzugt drei oder vier verschiedene Matrixmaterialien, besonders bevorzugt drei verschiedene Matrixmaterialien (das heißt, eine weitere Matrixkomponente zusätzlich zu den Hostmaterialien 1 und 2, wie zuvor beschrieben). Besonders geeignete Matrixmaterialien, welche in Kombination als Matrixkomponente eines Mixed-Matrix-Systems verwendet werden können, sind ausgewählt aus *wide-band-gap*-Materialien, bipolaren Hostmaterialien, Elektronentransportmaterialien (ETM) und Lochtransportmaterialien (HTM).

Unter *wide-band-gap*-Material wird hierin ein Material im Sinne der Offenbarung von US 7,294,849 verstanden, das durch eine Bandlücke von mindestens 3.5 eV charakterisiert ist, wobei unter Bandlücke der Abstand zwischen HOMO und LUMO-Energie eines Materials verstanden wird.

Genauere Angaben zu Mixed-Matrix-Systemen sind unter anderem in der Anmeldung WO 2010/108579 enthalten. Besonders geeignete Matrixmaterialien, welche in Kombination mit den Hostmaterialien 1 und 2, wie zuvor beschrieben oder bevorzugt beschrieben, als Matrixkomponenten eines Mixed-Matrix-Systems in phosphoreszierenden organischen Elektrolumineszenzvorrichtungen eingesetzt werden können, sind ausgewählt aus den unten angegebenen bevorzugten Matrixmaterialien für phosphoreszierende Emitter. Das Mixed-Matrix-System wird auf den Emitter der Formel (3) oder aus Tabelle 4 optimiert.

Als weitere Hostmaterialien kommen neben den Hostmaterialien 1 und 2 in der erfindungsgemäßen Vorrichtung, wie zuvor beschrieben, verschiedene Stoffklassen in Frage. Bevorzugte weitere Hostmaterialien sind ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, der Oligoarylenvinylene (z. B. DPVBi oder Spiro-DPVBi gemäß EP 676461), der polypodalen Metallkomplexe (z. B. gemäß WO 2004/081017), der lochleitenden Verbindungen (z. B. gemäß WO 2004/058911), der elektronenleitenden Verbindungen, insbesondere Ketone, Phosphinoxide, Sulfoxide, etc. (z. B. gemäß WO 2005/084081 und WO 2005/084082), der Atropisomere (z. B. gemäß WO 2006/048268), der Boronsäurederivate (z. B. gemäß WO 2006/117052) oder der Benzanthracene (z. B. gemäß WO 2008/145239). Besonders bevorzugte Hostmaterialien sind ausgewählt aus den Klassen der Oligoarylene, enthaltend Naphthalin, Anthracen, Benzanthracen und/oder Pyren oder Atropisomere dieser Verbindungen, der Oligoarylenvinylene, der Ketone, der Phosphinoxide und der Sulfoxide. Ganz besonders bevorzugte Matrixmaterialien sind ausgewählt aus den Klassen der Oligoarylene, enthaltend Anthracen, Benzanthracen, Benzphenanthren und/oder Pyren oder Atropisomere dieser Verbindungen. Unter einem Oligoarylen im Sinne dieser Erfindung soll eine Verbindung verstanden werden, in der mindestens drei Aryl- bzw. Arylengruppen aneinander gebunden sind.

Als weitere Matrixmaterialien kommen neben den Hostmaterialien 1 und 2 in der erfindungsgemäßen Vorrichtung, wie zuvor beschrieben, die folgenden Klassen von Verbindungen in Frage: aromatische Amine, insbesondere Triarylamine, z. B. gemäß US 2005/0069729, Carbazolderivate (z. B. CBP, N,N-Biscarbazolylbiphenyl) oder Verbindungen gemäß WO 2005/039246, US 2005/0069729, JP 2004/288381, EP 1205527 oder WO 2008/086851, verbrückte Carbazolderivate, z. B. gemäß WO 2011/088877 und WO 2011/128017, Indenocarbazolderivate, z. B. gemäß WO 2010/136109 und WO 2011/000455, Azacarbazolderivate, z. B. gemäß EP 1617710, EP 1617711, EP 1731584, JP 2005/347160, Indolocarbazolderivate, z. B. gemäß WO 2007/063754 oder WO 2008/056746, Ketone, z. B. gemäß WO 2004/093207 oder WO 2010/006680, Phosphinoxide, Sulfoxide und Sulfone, z. B. gemäß WO 2005/003253, Oligophenylene, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Aluminiumkomplexe, z. B. BAlq, Diazasilol- und Tetraazasilol-Derivate, z. B. gemäß WO 2010/054729, DiazaphospholDerivate, z. B. gemäß WO 2010/054730 und Aluminiumkomplexe, z. B. BAIQ.

Gemäß einer Ausführungsform enthält die Mischung neben den Bestandteilen elektronentransportierendes Hostmaterial der Formel (1) und lochtransportierendes Hostmaterial der Formel (2a) keine weiteren Bestandteile, das heißt, es handelt sich um Materialmischungen an Hostmaterialien, die als solche zur Herstellung der lichtemittierenden Schicht, verwendet werden. Man bezeichnet diese Mischungen auch als Premix-Systeme, die als einzige Materialquelle bei der Aufdampfung der Hostmaterialien für die lichtemittierende Schicht verwendet wird und die ein konstantes Mischungsverhältnis bei der Aufdampfung haben. Dadurch lässt sich auf einfache und schnelle Art und Weise das Aufdampfen einer Schicht mit gleichmäßiger Verteilung der Komponenten erreichen, ohne dass eine präzise Ansteuerung einer Vielzahl an Materialquellen notwendig ist.

Gemäß einer alternativen Ausführungsform enthält die Mischung neben den Bestandteilen elektronentransportierendes Hostmaterial der Formel (1) und lochtransportierendes Hostmaterial der Formel (2a) noch den phosphoreszierenden Emitter der Formel (3), wie zuvor beschrieben, so dass bei geeignetem Mischungsverhältnis bei der Aufdampfung auch diese Mischung als einzige Materialquelle zur Herstellung der lichtemittierenden Schicht verwendet werden kann.

Die Komponenten bzw. Bestandteile der lichtemittierenden Schicht der erfindungsgemäßen Vorrichtung können somit durch Aufdampfen oder aus Lösung prozessiert werden. Die Materialkombination der Hostmaterialien 1 und 2, wie zuvor beschrieben oder bevorzugt beschrieben, gegebenenfalls mit dem phosphoreszierenden Emitter, wie zuvor beschrieben oder bevorzugt beschrieben, können dazu in einer Formulierung bereitgestellt werden, die mindestens ein Lösemittel enthält. Diese Formulierungen können beispielsweise Lösungen, Dispersionen oder Emulsionen sein. Es kann bevorzugt sein, hierfür Mischungen aus zwei oder mehr Lösemitteln zu verwenden.

Ein weiterer Gegenstand der vorliegenden Erfindung ist daher eine Formulierung nach Anspruch 14.

Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan oder Mischungen dieser Lösemittel.

Die Formulierung nach Anspruch 14 kann dabei auch mindestens eine weitere organische oder anorganische Verbindung enthalten, die ebenfalls in der lichtemittierenden Schicht der erfindungsgemäßen Vorrichtung eingesetzt wird, insbesondere eine weitere emittierende Verbindung und/oder ein weiteres Matrixmaterial. Geeignete emittierende Verbindungen und weitere Matrixmaterialien wurden vorstehend bereits aufgeführt.

Die lichtemittierende Schicht in der erfindungsgemäßen Vorrichtung gemäß den bevorzugten Ausführungsformen und der emittierenden Verbindung enthält vorzugsweise zwischen 99,9 und 1 Vol.-%, weiter vorzugsweise zwischen 99 und 10 Vol.-%, besonders bevorzugt zwischen 98 und 60 Vol.-%, ganz besonders bevorzugt zwischen 97 und 80 Vol.-% an Matrixmaterial aus mindestens einer Verbindung der Formel (1) und mindestens einer Verbindung der Formel (2a) gemäß den bevorzugten Ausführungsformen, bezogen auf die gesamte Zusammensetzung aus Emitter und Matrixmaterial. Entsprechend enthält die lichtemittierende Schicht in der erfindungsgemäßen Vorrichtung vorzugsweise zwischen 0,1 und 99 Vol.-%, weiter vorzugsweise zwischen 1 und 90 Vol.-%, besonders bevorzugt zwischen 2 und 40 Vol.-%, ganz besonders bevorzugt zwischen 3 und 20 Vol.-% des Emitters bezogen auf die gesamte Zusammensetzung der aus Emitter und Matrixmaterial bestehenden lichtemittierenden Schicht. Werden die Verbindungen aus Lösung verarbeitet, so werden statt der oben angegebenen Mengen in Vol.-% bevorzugt die entsprechenden Mengen in Gew.-% verwendet.

Die lichtemittierende Schicht in der erfindungsgemäßen Vorrichtung gemäß den bevorzugten Ausführungsformen und der emittierenden Verbindung enthält vorzugsweise das Matrixmaterial der Formel (1) und das Matrixmaterial der Formel (2a) in einem Volumenprozentverhältnis zwischen 3:1 und 1:3, bevorzugt zwischen 1:2.5 und 1:1, besonders bevorzugt zwischen 1:2 und 1:1. Werden die Verbindungen aus Lösung verarbeitet, so werden statt des oben angegebenen Verhältnisses in Vol.-% bevorzugt das entsprechende Verhältnis in Gew.-% verwendet.

Die Abfolge der Schichten in der erfindungsgemäßen organischen Elektrolumineszenzvorrichtung ist bevorzugt die folgende:

Anode / Lochinjektionsschicht / Lochtransportschicht / emittierende Schicht / Elektronentransportschicht / Elektroneninjektionsschicht / Kathode.

Diese Abfolge der Schichten ist eine bevorzugte Abfolge.

Dabei soll erneut darauf hingewiesen werden, dass nicht alle der genannten Schichten vorhanden sein müssen, und/oder dass zusätzlich weitere Schichten vorhanden sein können.

Die erfindungsgemäße organische Elektrolumineszenzvorrichtung kann mehrere emittierende Schichten enthalten. Mindestens eine der emittierenden Schichten ist die erfindungsgemäße lichtemittierende Schicht enthaltend mindestens eine Verbindung der Formel (1) als Hostmaterial 1 und mindestens eine Verbindung der Formel (2a) als Hostmaterial 2 und mindestens einen phosphoreszierenden Emitter der Formel (3), wie zuvor beschrieben. Besonders bevorzugt weisen diese Emissionsschichten in diesem Fall insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die blaues oder gelbes oder orangefarbenes oder rotes Licht emittieren. Insbesondere bevorzugt sind Dreischichtsysteme, also Systeme mit drei emittierenden Schichten, wobei die drei Schichten blaue, grüne und orange oder rote Emission zeigen (für den prinzipiellen Aufbau siehe z. B.

WO 2005/011013). Es soll angemerkt werden, dass sich für die Erzeugung von weißem Licht anstelle mehrerer farbig emittierender Emitterverbindungen auch eine einzeln verwendete Emitterverbindung eignen kann, welche in einem breiten Wellenlängenbereich emittiert.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Als Materialien für die Elektronentransportschicht können alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise $Alq_3$, Zirkoniumkomplexe, beispielsweise $Zrq_4$, Benzimidazolderviate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Weiterhin geeignete Materialien sind Derivate der oben genannten Verbindungen, wie sie in JP 2000/053957, WO 2003/060956, WO 2004/028217, WO 2004/080975 und WO 2010/072300 offenbart werden.

Als Lochtransportmaterialien sind insbesondere Materialien bevorzugt, die in einer Lochtransport-, Lochinjektions- oder Elektronenblockierschicht verwendet werden können, wie Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627 oder der noch nicht offengelegten EP 12000929.5), Fluoren-Amine (z. B. gemäß WO 2014/015937, WO 2014/015938 und WO 2014/015935), Spiro-Dibenzopyran-Amine (z. B. gemäß WO 2013/083216) und Dihydroacridin-Derivate (z. B. WO 2012/150001).

Als Kathode der erfindungsgemäßen Vorrichtung eignen sich Metalle mit geringer Austrittsarbeit, Metalllegierungen oder mehrlagige Strukturen aus verschiedenen Metallen, wie beispielsweise Erdalkalimetalle, Alkalimetalle, Hauptgruppenmetalle oder Lanthanoide (z. B. Ca, Ba, Mg, Al, In, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/$NiO_x$, Al/$PtO_x$) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-ZinnOxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die erfindungsgemäße organische elektrolumineszierende Vorrichtung wird bei der Herstellung entsprechend (je nach Anwendung) strukturiert, kontaktiert und schließlich versiegelt, da sich die Lebensdauer der erfindungsgemäßen Vorrichtungen bei Anwesenheit von Wasser und/oder Luft verkürzt.

Die Herstellung der erfindungsgemäßen Vorrichtung ist hierbei nicht eingeschränkt. Es ist möglich, dass eine oder mehrere organische Schichten, auch die lichtemittierende Schicht, mit einem Sublimationsverfahren beschichtet

werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Dabei ist es jedoch auch möglich, dass der Anfangsdruck noch geringer ist, beispielsweise kleiner $10^{-7}$ mbar.

Bevorzugt ist die erfindungsgemäße organische Elektrolumineszenzvorrichtung dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist die erfindungsgemäße organische Elektrolumineszenzvorrichtung dadurch gekennzeichnet, dass eine oder mehrere organische Schichten enthaltend die erfindungsgemäße Zusammensetzung aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Hostmaterialien 1 und 2 und phosphoreszierende Emitter nötig. Das Verarbeiten aus Lösung hat den Vorteil, dass beispielsweise die lichtemittierende Schicht sehr einfach und kostengünstig aufgebracht werden kann. Diese Technik eignet sich insbesondere für die Massenproduktion organischer elektrolumineszierender Vorrichtungen.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können auf organische Elektrolumineszenzvorrichtungen angewandt werden.

Ein weiterer Gegenstand der Erfindung ist daher ein Verfahren zur Herstellung der erfindungsgemäßen organischen elektrolumineszierenden Vorrichtung, wie zuvor beschrieben oder bevorzugt beschrieben, dadurch gekennzeichnet, dass die lichtemittierende Schicht durch Gasphasenabscheidung, insbesondere mit einem Sublimationsverfahren und/oder mit einem OVPD (Organic Vapour Phase Deposition) Verfahren und/oder mit Hilfe einer Trägergassublimation, oder aus Lösung, insbesondere durch Spincoating oder mit einem Druckverfahren, aufgebracht wird.

Bei der Herstellung mittels Gasphasenabscheidung bestehen grundsätzlich zwei Möglichkeiten, wie die erfindungsgemäße lichtemittierende Schicht, auf ein beliebiges Substrat bzw. die vorherige Schicht aufgebracht bzw. aufgedampft werden kann. Zum einen können die verwendeten Materialien jeweils in einer Materialquelle vorgelegt und schließlich aus den verschiedenen Materialquellen verdampft werden ("co-evaporation"). Zum anderen können die verschiedenen Materialien vorgemischt ("premixed", Premix-Systeme) und das Gemisch in einer einzigen Materialquelle vorgelegt werden, aus der es schließlich verdampft wird ("premixevaporation"). Dadurch lässt sich auf einfache und schnelle Art und Weise das Aufdampfen der lichtemittierenden Schicht mit gleichmäßiger Verteilung der Komponenten erreichen, ohne dass eine präzise Ansteuerung einer Vielzahl an Materialquellen notwendig ist.

Ein weiterer Gegenstand der Erfindung ist demzufolge ein Verfahren zur Herstellung der erfindungsgemäßen Vorrichtung, dadurch gekennzeichnet, dass die mindestens eine Verbindung der Formel (1), wie zuvor beschrieben oder als bevorzugt beschrieben, und die mindestens eine Verbindung der Formel (2a), wie zuvor beschrieben oder als bevorzugt beschrieben, nacheinander oder gleichzeitig aus mindestens zwei Materialquellen, mit dem mindestens einen phosphoreszierenden Emitter, wie zuvor beschrieben oder bevorzugt beschrieben, aus der Gasphase abgeschieden werden und die lichtemittierende Schicht bilden.

In einer bevorzugten Ausführungsform der vorliegenden Erfindung wird die lichtemittierende Schicht mittels Gasphasenabscheidung aufgebracht, wobei die Bestandeile der Zusammensetzung vorgemischt und aus einer einzigen Materialquelle verdampft werden.

Ein weiterer Gegenstand der Erfindung ist demzufolge ein Verfahren zur Herstellung der erfindungsgemäßen Vorrichtung, dadurch gekennzeichnet, dass die mindestens eine Verbindung der Formel (1) und die mindestens eine Verbindung der Formel (2a) als Mischung, nacheinander oder gleichzeitig mit dem mindestens einen phosphoreszierenden Emitter, aus der Gasphase abgeschieden werden und die lichtemittierende Schicht bilden.

Ein weiterer Gegenstand der Erfindung ist ein Verfahren zur Herstellung der erfindungsgemäßen Vorrichtung, wie zuvor beschrieben oder bevorzugt beschrieben, dadurch gekennzeichnet, dass die mindestens eine Verbindung der Formel (1) und die mindestens eine Verbindung der Formel (2a), wie zuvor beschrieben oder bevorzugt beschrieben, zusammen mit dem mindestens einen phosphoreszierenden Emitter, aus Lösung aufgebracht werden, um die lichtemittierende Schicht zu bilden.

Die erfindungsgemäßen Vorrichtungen zeichnen sich durch folgende überraschende Vorteile gegenüber dem Stand der Technik aus:

Die Verwendung der beschriebenen Materialkombination der Hostmaterialien 1 und 2 mit dem Emitter der Formel (3), wie zuvor beschrieben, führt insbesondere zu einer Steigerung der Lebensdauer der Vorrichtungen.

Wie im nachfolgend angegebenen Beispiel ersichtlich, lässt sich durch Vergleich der Daten für OLEDs mit Kombinationen aus dem Stand der Technik feststellen, dass die erfindungsgemäßen Kombinationen an Matrixmaterialien

in der EML zu Vorrichtungen führen, deren Lebensdauer um ca. 30 bis 70% erhöht sind, unabhängig von der Emitterkonzentration.

Allgemeine Methoden:

In allen quantenchemischen Berechnungen wird das Programmpaket Gaussian16 (Rev. B.01) verwendet. Der neutrale Singulettgrundzustand wird auf dem B3LYP/6-31G(d)-Niveau optimiert. HOMO- und LUMO-Werte werden auf dem B3LYP/6-31G(d)-Niveau für die mit B3LYP/6-31G(d) optimierte Grundzustandsenergie bestimmt. Daraufhin werden TD-DFT-Singulett- und Triplettanregungen (vertikale Anregungen) mit der gleichen Methode (B3LYP/6-31G(d)) und der optimierten Grundzustandsgeometrie berechnet. Die Standardeinstellungen für SCF- und Gradientenkonvergenz werden verwendet.

Aus der Energierechnung erhält man das HOMO als das letzte mit zwei Elektronen besetze Orbital (Alpha occ. eigenvalues) und LUMO als das erste unbesetzte Orbital (Alpha virt. eigenvalues) in Hartree-Einheiten, wobei HEh und LEh für die HOMO Energie in Hartree-Einheiten beziehungsweise für die LUMO-Energie in Hartree-Einheiten steht. Daraus wird der anhand von Cyclovoltammetriemessungen kalibrierte HOMO- und LUMO-Wert in Elektronenvolt wie folgt bestimmt:

$$\text{HOMOcorr} = 0.90603 * \text{HOMO} - 0.84836$$

$$\text{LUMOcorr} = 0.99687 * \text{LUMO} - 0.72445$$

Das Triplett-Niveau T1 eines Materials ist definiert als die relative Anregungsenergie (in eV) des Triplettzustands mit der niedrigsten Energie, der sich aus der quantenchemischen Energierechnung ergibt.

Das Singulett-Niveau S1 eines Materials ist definiert als die relative Anregungsenergie (in eV) des Singulettzustands mit der zweitniedrigsten Energie, der sich aus der quantenchemischen Energierechnung ergibt. Der energetisch niedrigste Singulettzustand wird als S0 bezeichnet.

Die hierin beschriebene Methode ist unabhängig von dem verwendeten Softwarepaket und liefert immer dieselben Ergebnisse. Beispiele oft benutzter Programme für diesen Zweck sind "Gaussian09" (Gaussian Inc.) und Q-Chem 4.1 (Q-Chem, Inc.). Vorliegend wird zur Berechnung der Energien das Programmpaket "Gaussian16 (Rev. B.01)" verwendet.

Beispiel 1: **Herstellung der OLEDs**

In den folgenden Beispielen V1 bis Ex28 (siehe Tabellen 6 und 7) wird der Einsatz der erfindungsgemäßen Materialkombinationen in OLEDs in Vergleich zu Materialkombinationen aus dem Stand der Technik vorgestellt.

**Vorbehandlung für die Beispiele V1 bis Ex28:** Glasplättchen, die mit strukturiertem ITO (Indium Zinn Oxid) der Dicke 50 nm beschichtet sind, werden vor der Beschichtung zunächst mit einem Sauerstoffplasma, gefolgt von einem Argonplasma, behandelt. Diese mit Plasma behandelten Glasplättchen bilden die Substrate, auf welche die OLEDs aufgebracht werden.

Die OLEDs haben prinzipiell folgenden Schichtaufbau: Substrat / Lochinjektionsschicht (HIL) / Lochtransportschicht (HTL) / Elektronenblockierschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 6 zu entnehmen. Die zur Herstellung der OLEDs benötigten Materialien sind in Tabelle 8 gezeigt. Die Device Daten der OLEDs sind in Tabelle 7 aufgelistet.

Die Beispiele V1, V2 und V3 sind Vergleichsbeispiele mit einem lochtransportierenden Host gemäß dem Stand der Technik WO2017/178311. Das Beispiel Ex3 verwendet entsprechende erfindungsgemäße Materialkombinationen in der EML.

Die Beispiele V4 und V5 sind Vergleichsbeispiele zur erfindungsgemäßen OLED des Beispiels Ex4 und die Beispiele V6 und V7 sind Vergleichsbeispiele zur erfindungsgemäßen OLED des Beispiels Ex5 mit symmetrisch substituierten elektronentransportierenden Hostmaterialien gemäß dem Stand der Technik. Die Verbindung VG1 ist beispielsweise abgeleitet aus US2016329502. Die Verbindung VG2 ist beispielsweise in US20140299192 beschrieben.

Die Beispiele Ex6 bis Ex9, Ex11, Ex13, Ex15, Ex19 bis Ex21 und Ex23 zeigen ebenfalls Daten von erfindungsgemäßen OLEDs.

Alle Materialien werden in einer Vakuumkammer thermisch aufgedampft. Dabei besteht die Emissionsschicht immer aus mindestens einem Matrixmaterial (auch Hostmaterial oder Wirtsmaterial), im Sinn der Erfindung mindestens zwei Matrixmaterialien und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie E1:IC3:TEG1 (33%:60%:7%) 30nm bedeutet hierbei, dass das Material E1 in einem Volumenanteil von 33% als Hostmaterial 1, die Verbindung IC3 als Hostmaterial 2 in einem Anteil von 60% und TEG1 in einem Anteil von 7% in einer 30nm dicken Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren und Strom-Spannungs-Leuchtdichte-Kennlinien (IUL-Kennlinien) gemessen. EQE und die Stromeffizienz SE (in cd/A) werden daraus berechnet. Die Berechnung der SE erfolgt unter Annahme einer lambertschen Abstrahlcharakteristik.

Als Lebensdauer LT wird die Zeit definiert, nach der die Leuchtdichte bei Betrieb mit konstanter Stromdichte j0 in $mA/cm^2$ von einer Startleuchtdichte L0 (in $cd/m^2$) auf einen gewissen Anteil L1 (in $cd/m^2$) absinkt. Eine Angabe L1/L0 = 80% in Tabelle 7 bedeutet, dass die in Spalte LT angegebene Lebensdauer der Zeit (in h) entspricht, nach der die Leuchtdichte auf 80% ihres Anfangswertes (L0) absinkt.

**Verwendung von erfindungsgemäßen Mischungen in OLEDs**

Die erfindungsgemäßen Materialkombinationen können in der Emissionsschicht in phosphoreszierenden grünen OLEDs eingesetzt werden.

Beim Vergleich der erfindungsgemäßen Beispiele mit den entsprechenden Vergleichsbeispielen (s.o.), ist klar erkennbar, dass die erfindungsgemäßen Beispiele jeweils einen deutlichen Vorteil in der Device Lebensdauer aufzeigen.

Tabelle 6: Aufbau der OLEDs

| Bsp. | HTL Dicke | IL Dicke | EBL Dicke | EML Dicke | HBL Dicke | ETL Dicke | EIL Dicke |
|---|---|---|---|---|---|---|---|
| V1 | HTCN 5nm | SpMA1 230nm | SpMA2 20nm | E1:IC3:TEG1 (33%:60%:7%) 30nm | ST2 10nm | ST2:LiQ (50%:50%) 30nm | LiQ 1nm |
| Ex1* | HTCN 5nm | SpMA1 230nm | SpMA2 20nm | E1:BC1:TEG1 (33%:60%:7%) 30nm | ST2 10nm | ST2:LiQ (50%:50%) 30nm | LiQ 1nm |
| V2 | HTCN 5nm | SpMA1 230nm | SpMA2 20nm | E1:IC3:TEG2 (28%:60%:12%) 40nm | ST2 5nm | ST2:LiQ (50%:50%) 30nm | LiQ 1nm |
| Ex2* | HTCN 5nm | SpMA1 230nm | SpMA2 20nm | E1:BC1:TEG2 (28%:60%:12%) 40nm | ST2 5nm | ST2:LiQ (50%:50%) 30nm | LiQ 1nm |
| V3 | HTCN 5nm | SpMA1 230nm | SpMA2 20nm | E1:IC3:TEG3 (33%:60%:7%) 40nm | ST2 5nm | ST2:LiQ (50%:50%) 30nm | LiQ 1nm |
| Ex3 | HTCN 5nm | SpMA1 230nm | SpMA2 20nm | E1:BC1:TEG3 (33%:60%:7%) 40nm | ST2 5nm | ST2:LiQ (50%:50%) 30nm | LiQ 1nm |
| V4 | HTCN 5nm | SpMA1 230nm | SpMA2 20nm | VG1:BC2:TEG3 (38%:50%:12%) 40nm | ST2 5nm | ST2:LiQ (50%:50%) 30nm | LiQ 1nm |
| V5 | HTCN 5nm | SpMA1 230nm | SpMA2 20nm | VG2:BC2:TEG3 (38%:50%:12%) 40nm | ST2 5nm | ST2:LiQ (50%:50%) 30nm | LiQ 1nm |
| Ex4 | HTCN 5nm | SpMA1 230nm | SpMA2 20nm | E1:BC2:TEG3 (38%:50%:12%) 40nm | ST2 5nm | ST2:LiQ (50%:50%) 30nm | LiQ 1nm |
| V6 | HTCN 5nm | SpMA1 230nm | SpMA2 20nm | VG1:BC3:TEG3 (38%:50%:12%) 40nm | ST2 5nm | ST2:LiQ (50%:50%) 30nm | LiQ 1nm |

(fortgesetzt)

| Bsp. | HTL Dicke | IL Dicke | EBL Dicke | EML Dicke | HBL Dicke | ETL Dicke | EIL Dicke |
|---|---|---|---|---|---|---|---|
| V7 | HTCN 5nm | SpMA1 230nm | SpMA2 20nm | VG2:BC3:TEG3 (38%:50%:12%) 40nm | ST2 5nm | ST2:LiQ (50%:50%) 30nm | LiQ 1nm |
| Ex5 | HTCN 5nm | SpMA1 230nm | SpMA2 20nm | E1:BC3:TEG3 (38%:50%:12%) 40nm | ST2 5nm | ST2:LiQ (50%:50%) 30nm | LiQ 1nm |
| Ex6 | HTCN 5nm | SpMA1 230nm | SpMA2 20nm | E1:BC4:TEG3 (33%:60%:7%) 40nm | ST2 5nm | ST2:LiQ (50%:50%) 30nm | LiQ 1nm |
| Ex7 | HTCN 5nm | SpMA1 230nm | SpMA2 20nm | E2:BC3:TEG3 (33%:60%:7%) 40nm | ST2 5nm | ST2:LiQ (50%:50%) 30nm | LiQ 1nm |
| Ex8 | HTCN 5nm | SpMA1 230nm | SpMA2 20nm | E2:BC4:TEG3 (33%:60%:7%) 40nm | ST2 5nm | ST2:LiQ (50%:50%) 30nm | LiQ 1nm |
| Ex9 | HTCN 5nm | SpMA1 230nm | SpMA2 20nm | E3:BC5:TEG3 (33%:60%:7%) 40nm | ST2 5nm | ST2:LiQ (50%:50%) 30nm | LiQ 1nm |
| Ex10* | HTCN 5nm | SpMA1 230nm | SpMA2 20nm | E3:BC7:TEG3 (33%:60%:7%) 40nm | ST2 5nm | ST2:LiQ (50%:50%) 30nm | LiQ 1nm |
| Ex11 | HTCN 5nm | SpMA1 230nm | SpMA2 20nm | E4:BC6:TEG3 (33%:60%:7%) 40nm | ST2 5nm | ST2:LiQ (50%:50%) 30nm | LiQ 1nm |
| Ex12* | HTCN 5nm | SpMA1 230nm | SpMA2 20nm | E4:BC8:TEG3 (33%:60%:7%) 40nm | ST2 5nm | ST2:LiQ (50%:50%) 30nm | LiQ 1nm |
| Ex13 | HTCN 5nm | SpMA1 230nm | SpMA2 20nm | E5:BC1:TEG3 (33%:60%:7%) 40nm | ST2 5nm | ST2:LiQ (50%:50%) 30nm | LiQ 1nm |
| Ex14* | HTCN 5nm | SpMA1 230nm | SpMA2 20nm | E5:BC9:TEG3 (33%:60%:7%) 40nm | ST2 5nm | ST2:LiQ (50%:50%) 30nm | LiQ 1nm |
| Ex15 | HTCN 5nm | SpMA1 230nm | SpMA2 20nm | E6:BC3:TEG3 (33%:60%:7%) 40nm | ST2 5nm | ST2:LiQ (50%:50%) 30nm | LiQ 1nm |
| Ex16* | HTCN 5nm | SpMA1 230nm | SpMA2 20nm | E6:BC10:TEG3 (33%:60%:7%) 40nm | ST2 5nm | ST2:LiQ (50%:50%) 30nm | LiQ 1nm |
| Ex17* | HTCN 5nm | SpMA1 230nm | SpMA2 20nm | E7:BC10:TEG3 (33%:60%:7%) 40nm | ST2 5nm | ST2:LiQ (50%:50%) 30nm | LiQ 1nm |
| Ex18* | HTCN 5nm | SpMA1 230nm | SpMA2 20nm | E8:BC13:TEG2 (28%:60%:12%) 40nm | ST2 5nm | ST2:LiQ (50%:50%) 30nm | LiQ 1nm |
| Ex19 | HTCN 5nm | SpMA1 230nm | SpMA2 20nm | E9:BC5:TEG3 (33%:60%:7%) 40nm | ST2 5nm | ST2:LiQ (50%:50%) 30nm | LiQ 1nm |

(fortgesetzt)

| Bsp. | HTL Dicke | IL Dicke | EBL Dicke | EML Dicke | HBL Dicke | ETL Dicke | EIL Dicke |
|---|---|---|---|---|---|---|---|
| Ex20 | HTCN 5nm | SpMA1 230nm | SpMA2 20nm | E10:BC5:TEG3 (33%:60%:7%) 40nm | ST2 5nm | ST2:LiQ (50%:50%) 30nm | LiQ 1nm |
| Ex21 | HTCN 5nm | SpMA1 230nm | SpMA2 20nm | E11 :BC6:TEG3 (38%:50%:12%) 40nm | ST2 5nm | ST2:LiQ (50%:50%) 30nm | LiQ 1nm |
| Ex22* | HTCN 5nm | SpMA1 230nm | SpMA2 20nm | E12:BC12:TEG3 (38%:50%:12%) 40nm | ST2 5nm | ST2:LiQ (50%:50%) 30nm | LiQ 1nm |
| Ex23 | HTCN 5nm | SpMA1 230nm | SpMA2 20nm | E13:BC5:TEG3 (38%:50%:12%) 40nm | ST2 5nm | ST2:LiQ (50%:50%) 30nm | LiQ 1nm |
| Ex24* | HTCN 5nm | SpMA1 230nm | SpMA2 20nm | E14:BC11:TEG3 (33%:60%:7%) 40nm | ST2 5nm | ST2:LiQ (50%:50%) 30nm | LiQ 1nm |
| Ex25* | HTCN 5nm | SpMA1 230nm | SpMA2 20nm | E15:BC14:TEG2 (28%:60%:12%) 40nm | ST2 5nm | ST2:LiQ (50%:50%) 30nm | LiQ 1nm |
| Ex26* | HTCN 5nm | SpMA1 230nm | SpMA2 20nm | E16:BC15:TEG3 (33%:60%:7%) 40nm | ST2 5nm | ST2:LiQ (50%:50%) 30nm | LiQ 1nm |
| Ex27* | HTCN 5nm | SpMA1 230nm | SpMA2 20nm | E9:BC16:TEG3 (33%:60%:7%) 40nm | ST2 5nm | ST2:LiQ (50%:50%) 30nm | LiQ 1nm |
| Ex28* | HTCN 5nm | SpMA1 230nm | SpMA2 20nm | E2:BC17:TEG2 (28%:60%:12%) 40nm | ST2 5nm | ST2:LiQ (50%:50%) 30nm | LiQ 1nm |
| *nicht erfindungsgemäß | | | | | | | |

Tabelle 7: Daten der OLEDs

| Bsp. | j0 (mA/cm$^2$) | L1/L0 (%) | LT (h) |
|---|---|---|---|
| V1 | 40 | 80 | 270 |
| Ex1* | 40 | 80 | 350 |
| V2 | 40 | 80 | 980 |
| Ex2* | 40 | 80 | 1250 |
| V3 | 40 | 80 | 460 |
| Ex3 | 40 | 80 | 620 |
| V4 | 40 | 80 | 480 |
| V5 | 40 | 80 | 560 |
| Ex4 | 40 | 80 | 820 |
| V6 | 40 | 80 | 530 |
| V7 | 40 | 80 | 610 |
| Ex5 | 40 | 80 | 910 |
| Ex6 | 40 | 80 | 690 |

(fortgesetzt)

| Bsp. | j0 (mA/cm2) | L1/L0 (%) | LT (h) |
|---|---|---|---|
| Ex7 | 40 | 80 | 580 |
| Ex8 | 40 | 80 | 650 |
| Ex9 | 40 | 80 | 600 |
| Ex10* | 40 | 80 | 620 |
| Ex11 | 40 | 80 | 580 |
| Ex12* | 40 | 80 | 640 |
| Ex13 | 40 | 80 | 590 |
| Ex14* | 40 | 80 | 640 |
| Ex15 | 40 | 80 | 550 |
| Ex16* | 40 | 80 | 610 |
| Ex17* | 40 | 80 | 705 |
| Ex18* | 40 | 80 | 1100 |
| Ex19 | 40 | 80 | 730 |
| Ex20 | 40 | 80 | 690 |
| Ex21 | 40 | 80 | 940 |
| Ex22* | 40 | 80 | 1055 |
| Ex23 | 40 | 80 | 990 |
| Ex24* | 40 | 80 | 770 |
| Ex25* | 40 | 80 | 790 |
| Ex26* | 40 | 80 | 735 |
| Ex27* | 40 | 80 | 645 |
| Ex28* | 40 | 80 | 970 |
| *nicht erfindungsgemäß | | | |

Tabelle 8: verwendete Materialien

| | |
|---|---|
| 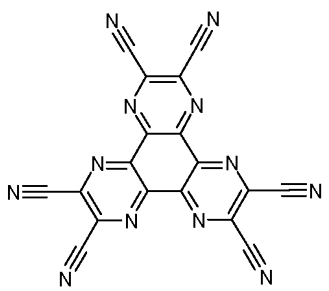 | 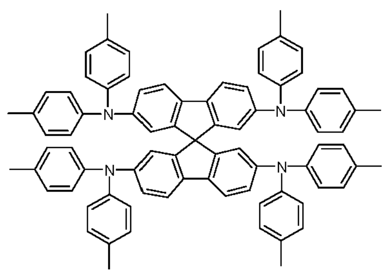 |
| HATCN | SpA1 |
| 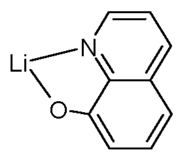 | 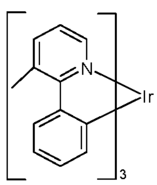 |
| LiQ | TEG1 |

(fortgesetzt)

| | |
|---|---|
| 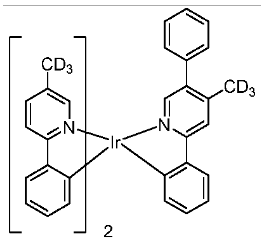 | 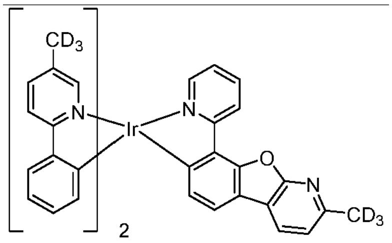 |
| TEG2 | TEG3 |
| 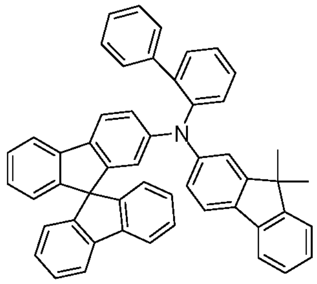 | 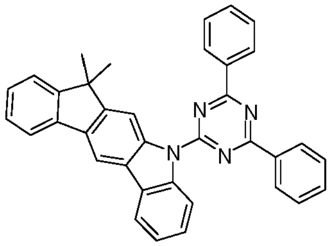 |
| SpMA1 | IC1 |
| 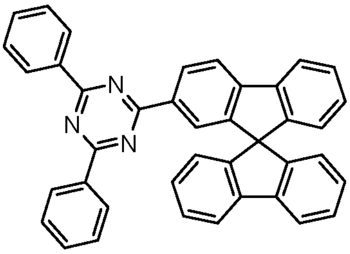 | 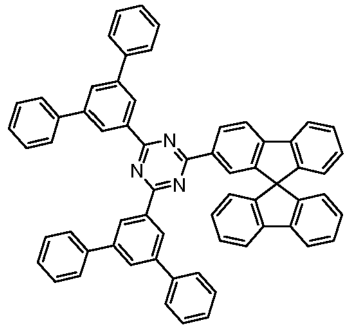 |
| ST1 | ST2 |
| 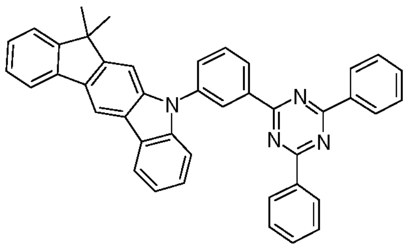 | 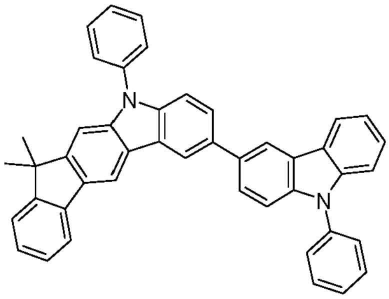 |
| IC2 | IC3 |

(fortgesetzt)

| | |
|---|---|
| 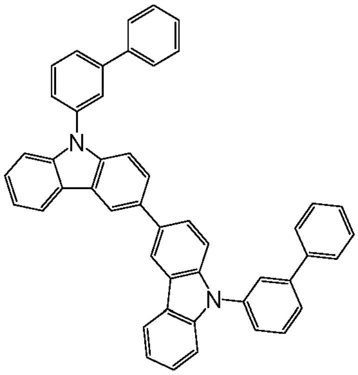 | 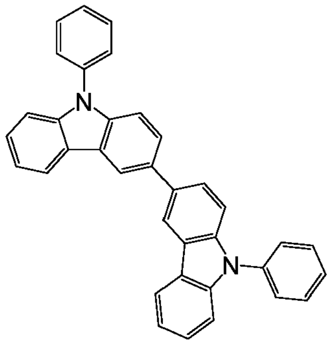 |
| BC1 = **13** | BC2 = **23** |
| 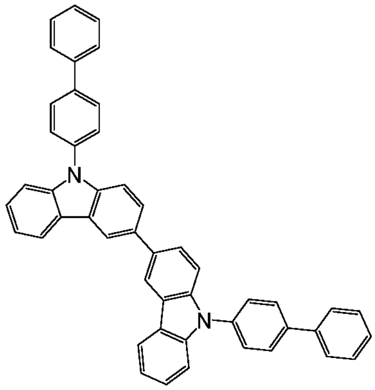 | 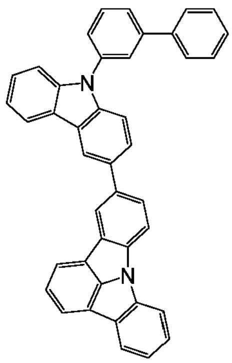 |
| BC3 = **16** | BC4 = **20** |
| 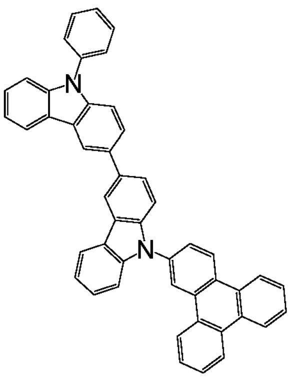 | 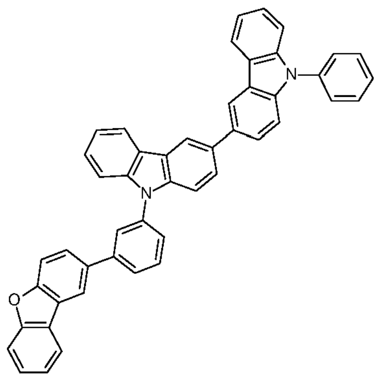 |
| BC5 = **17** | BC6 = **24** |
| 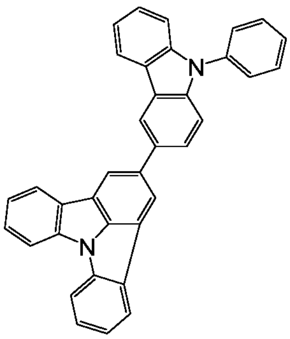 | 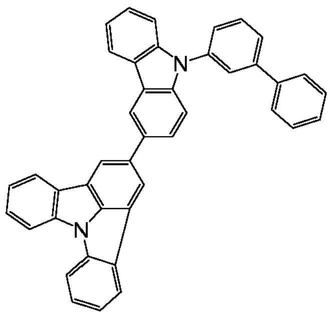 |
| BC7 = **25** | BC8 = **26** |

(fortgesetzt)

| | |
|---|---|
| 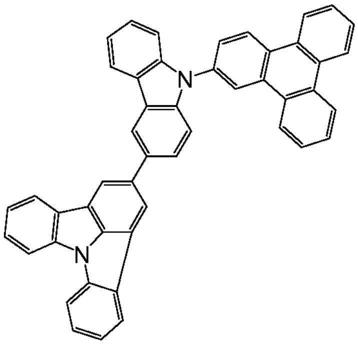 | 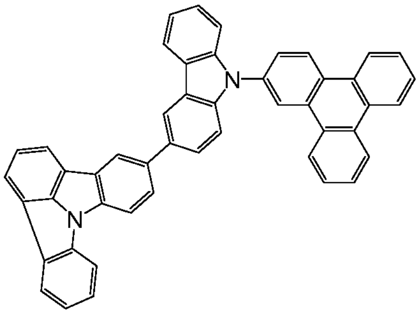 |
| BC9 = **27** | BC10 = **21** |
| 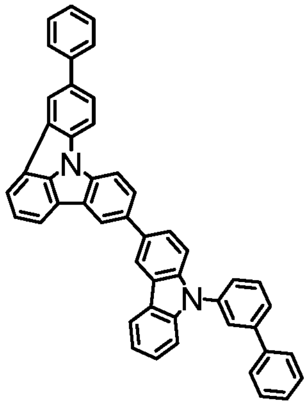 | 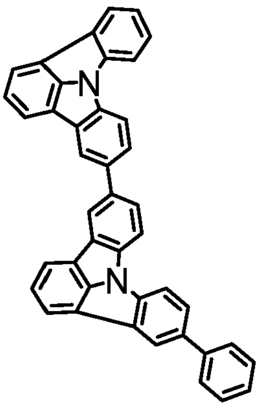 |
| BC11=45 | BC12=46 |
| 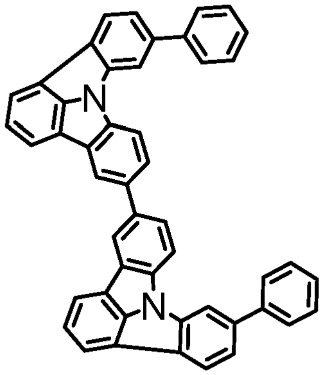 | 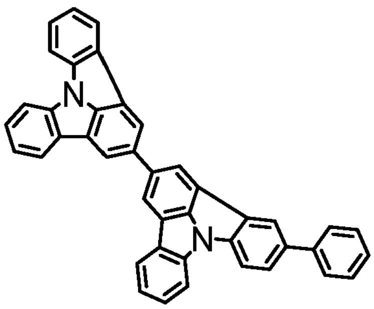 |
| BC13=47 | BC14=50 |
| 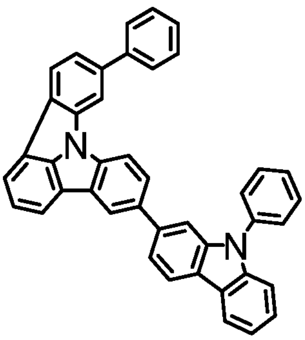 | 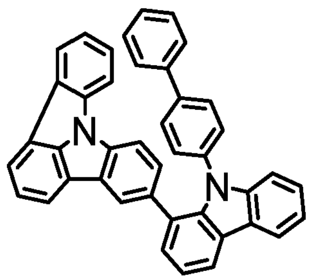 |
| BC15=51 | BC16=52 |

(fortgesetzt)

| | |
|---|---|
| 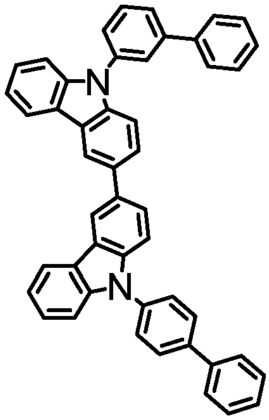 | |
| BC17=15 | |
| 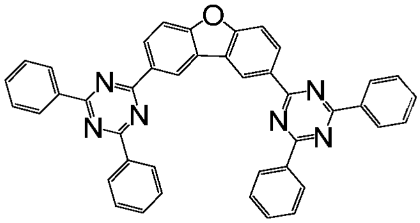 | 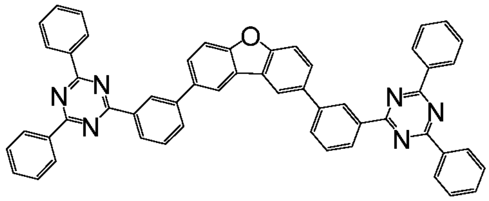 |
| VG1 | VG2 |
| 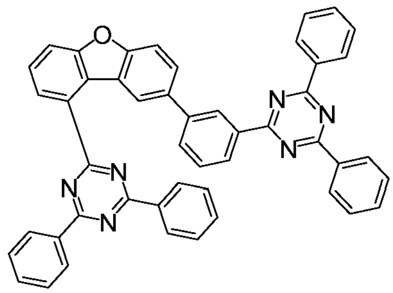 | 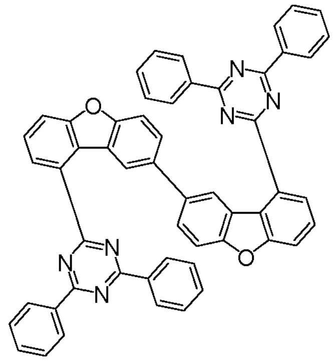 |
| E1 = **1** | E2 = **7** |
| 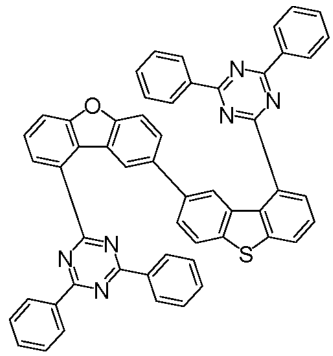 | 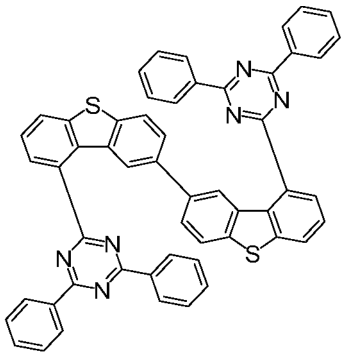 |
| **E3 = 29** | E4 = **30** |

(fortgesetzt)

| | |
|---|---|
| 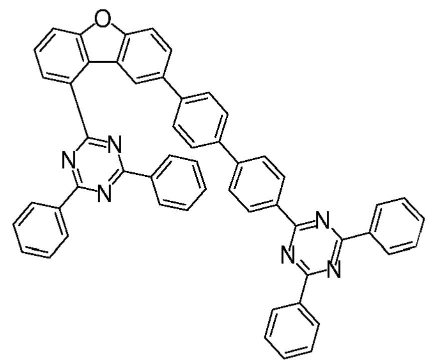 | 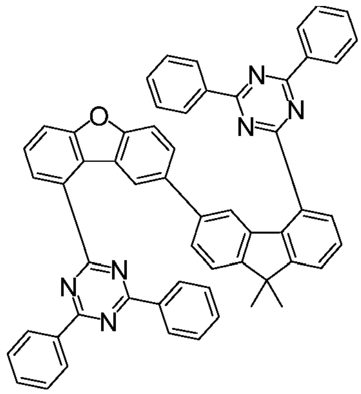 |
| E5 = **31** | E6 = **32** |
| 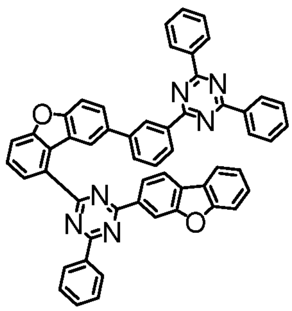 | 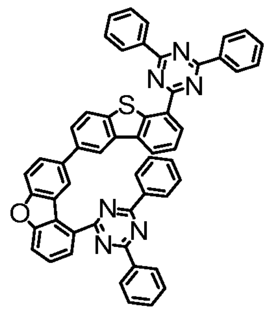 |
| E7=2 | E8=10 |
| 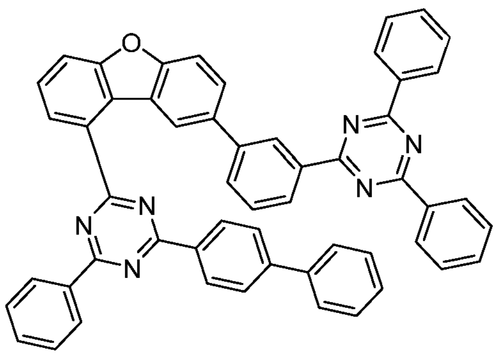 | 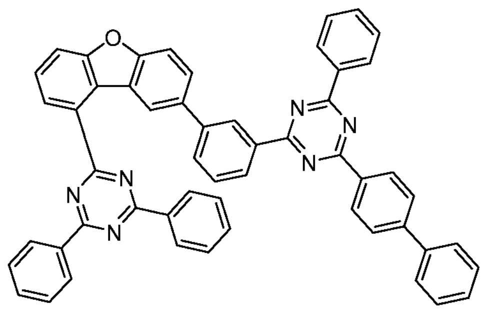 |
| E9=33 | E10=34 |
| 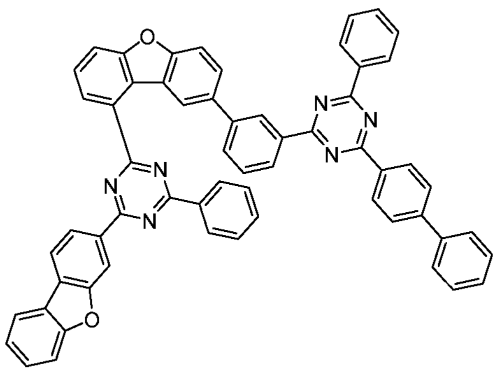 | 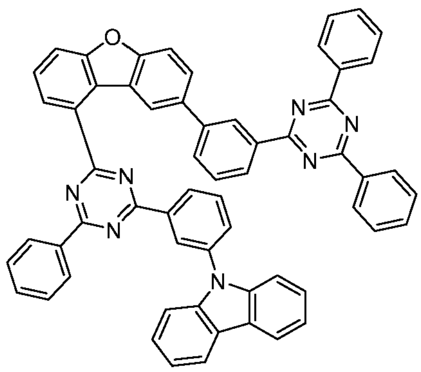 |
| E11=36 | E12=37 |

(fortgesetzt)

| | |
|---|---|
| 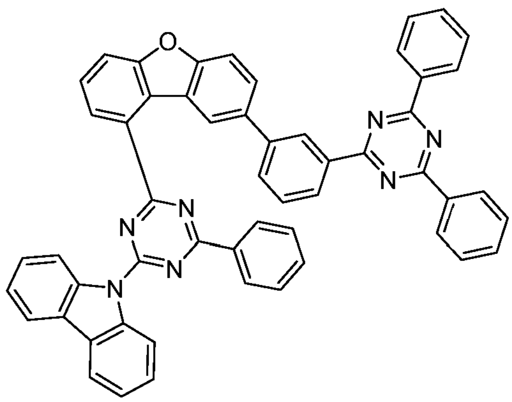 | 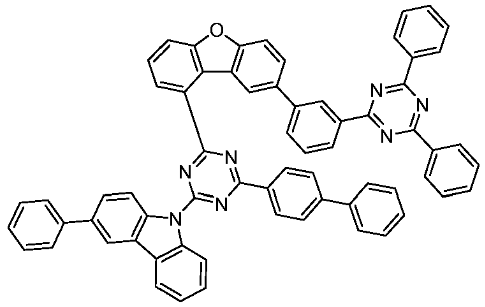 |
| E13=38 | E14=40 |
| 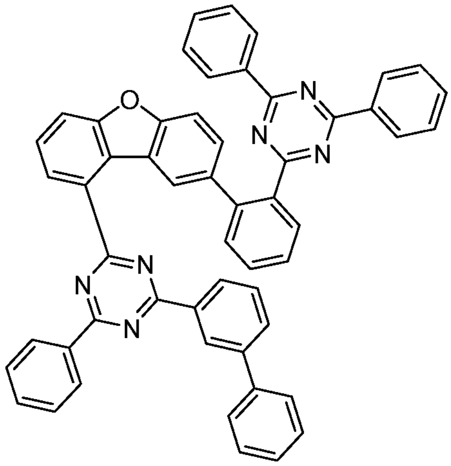 | 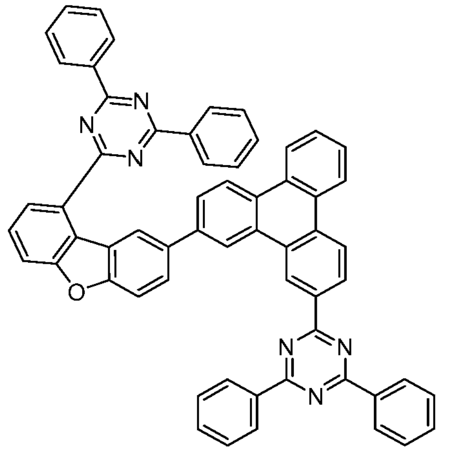 |
| E15=41 | E16=44 |

Beispiel 2: Synthese von Hostmaterialien und deren Vorstufen:

**a) 2-Dibenzofuran-1-yl-4,6-diphenyl-[1,3,5]triazine**

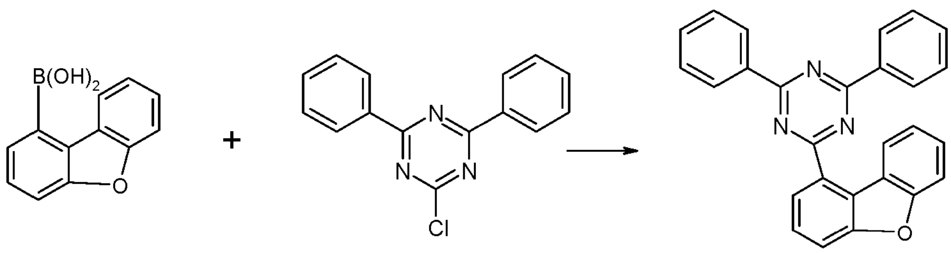

[3842-55-5]

23 g (110.0 mmol) Dibenzofuran-1-boronsäure, 29.5 g (110.0 mmol) 2-Chlor-4,6-diphenyl-1,3,5-triazin und 21 g (210.0 mmol) Natriumcarbonat werden in 500 mL Ethylenglycoldiaminether und 500 mL Wasser suspendiert. Zu dieser Suspension werden 913 mg (3.0 mmol) Tri-o-tolylphosphin und dann 112 mg (0.5 mmol) Palladium(II)acetat gegeben, und die Reaktionsmischung wird 16 h unter Rückfluss erhitzt. Nach Erkalten wird die organische Phase abgetrennt, über Kieselgel filtriert, dreimal mit 200 mL Wasser gewaschen und anschließend zur Trockene eingeengt. Der Rückstand wird aus Toluol und aus Dichlormethan /Heptan umkristallisiert. Die Ausbeute beträgt 37 g (94 mmol), entsprechend 87 % der Theorie.

Analog können folgende Verbindungen erhalten werden:

| | Edukt 1 | Edukt 2 | Produkt | Ausbeute |
|---|---|---|---|---|
| 1a | 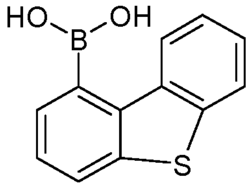 | 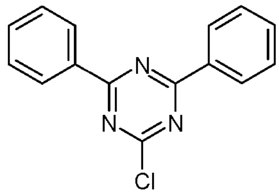 [3842-55-5] | 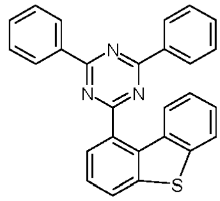 | 63% |
| 2a | 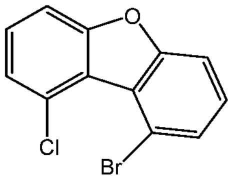 [2179279-83-3 ] | 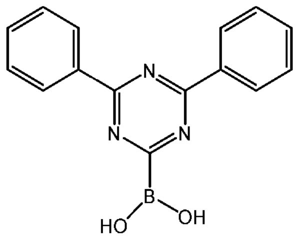 [1251825-65-6 ] | 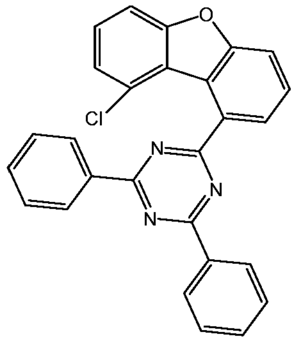 | 61% |
| 3a | 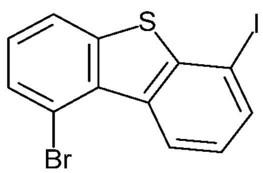 [2361168-70-7 ] | 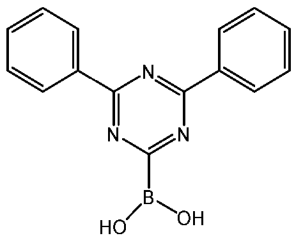 [1251825-65-6 ] | 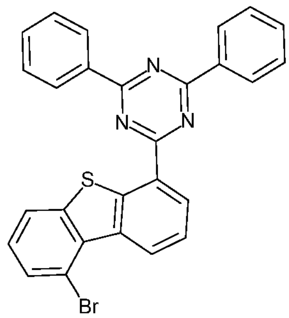 | 60% |
| 4a | 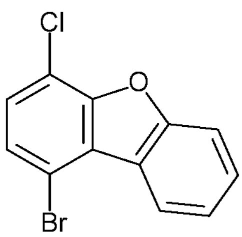 [2252237-87-7 ] | 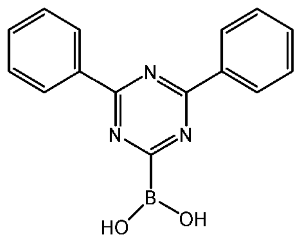 [1251825-65-6 ] | 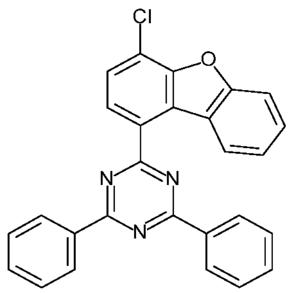 | 64% |
| 5a | 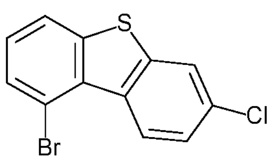 [1622440-57-6 ] | 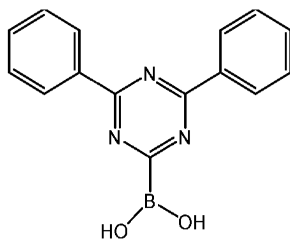 [1251825-65-6 ] | 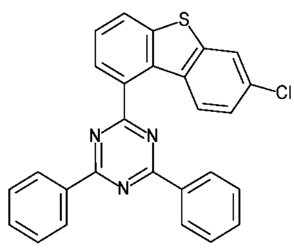 | 58% |

(fortgesetzt)

| | Edukt 1 | Edukt 2 | Produkt | Ausbeute |
|---|---|---|---|---|
| 6a | 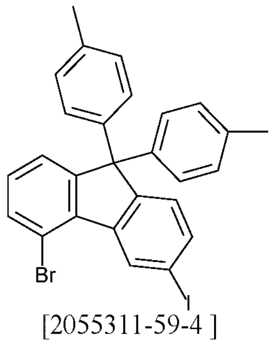 [2055311-59-4 ] | 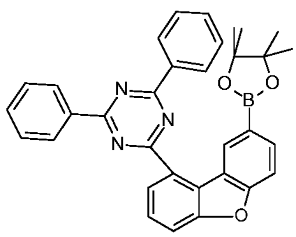 | 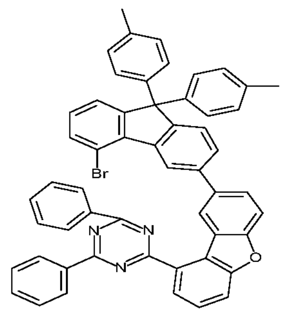 | 64% |
| 7a | 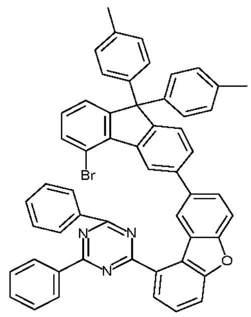 | 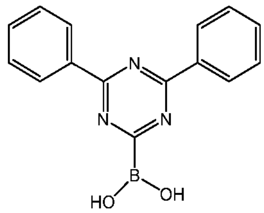 [1251825-65-6 ] | 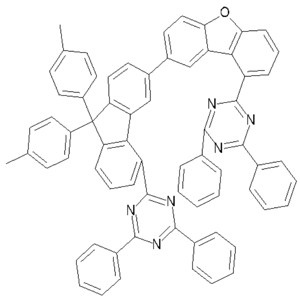 | 75% |
| 8a | 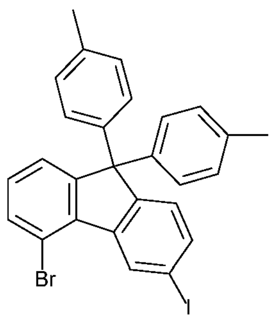 | 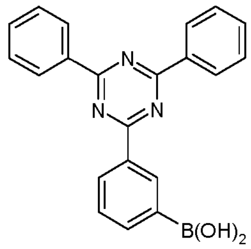 [1612243-82-9] | 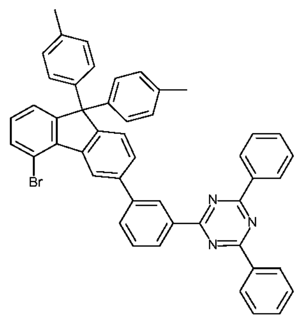 | 65% |
| 9a | 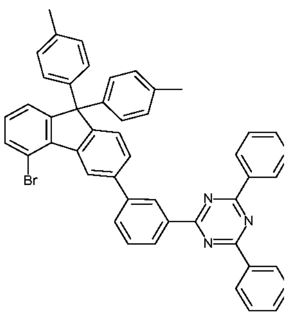 | 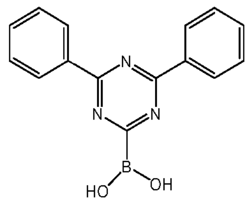 [1251825-65-6 ] | 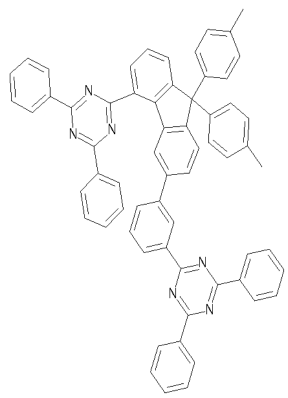 | 68% |

(fortgesetzt)

| | Edukt 1 | Edukt 2 | Produkt | Ausbeute |
|---|---|---|---|---|
| 10a | 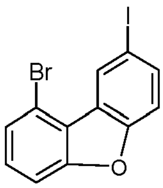 | 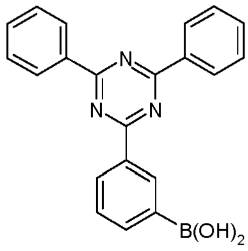 [1612243-82-9] | 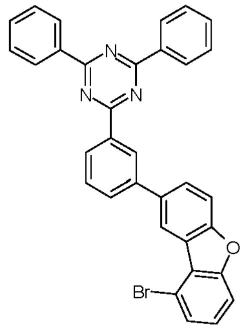 | 62% |
| 11a | 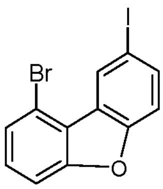 | 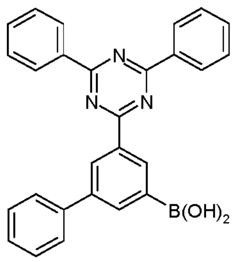 [1518823-39-6] | 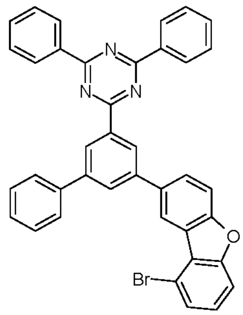 | 57% |
| 12a | 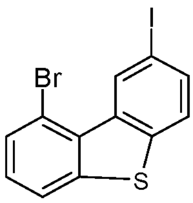 | 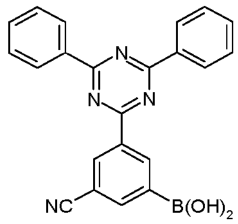 [1651187-50-6] | 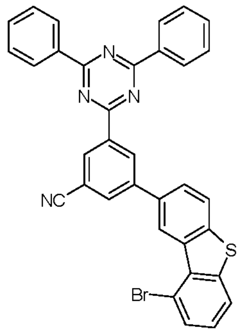 | 64% |
| 13a | 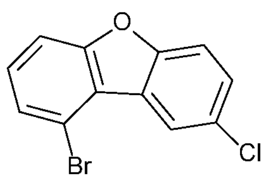 [2173554-83-9 ] | 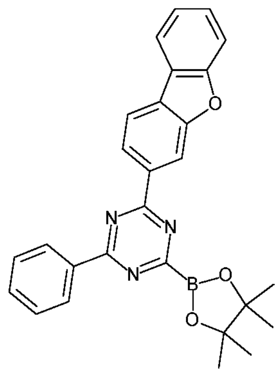 [2287278-31-1 ] | 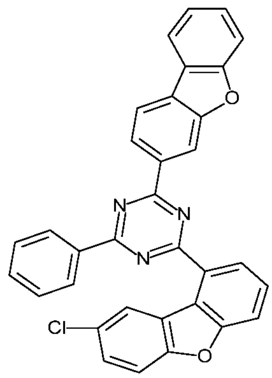 | 61% |

**b) 2-(8-Bromo-dibenzofuran-1-yl)-4,6-diphenyl-[1,3,5]triazine**

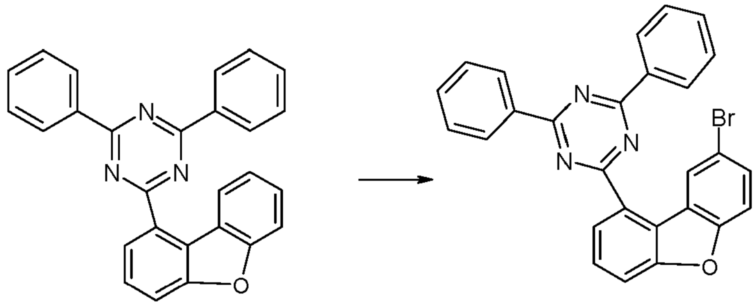

70 g (190.0 mmol) 2-Dibenzofuran-1-yl-4,6-diphenyl-[1,3,5]triazine werden in 2000 mL Essigsäure(100%) und 2000 mL Schwefelsäure (95-98%) suspendiert. Zu dieser Suspension werden portionsweise 34 g (190 mmol) NBS zugegeben und 2 Stunden in Dunkelheit gerührt. Danach mit Wasser/Eis versetzt und Feststoff abgetrennt und mit Ethanol nachgewaschen. Der Rückstand wird im Toluol umkristallisiert. Die Ausbeute beträgt 80 g (167 mmol), entsprechend 87 % der Theorie. Analog dazu werden die folgenden Verbindungen hergestellt:

| | Edukt 1 | Produkt | Ausbeute |
|---|---|---|---|
| 1b | 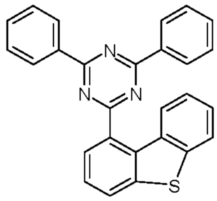 | 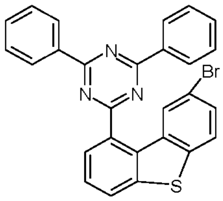 | 83% |

Im Falle von Thiophen-Derivate wird Nitrobenzol statt Schwefelsäure und elementares Brom an Stelle von NBS eingesetzt:

**c) 2,4-Diphenyl-6-[8-(4,4,5,5-tetrametjyl-[1,3,2]dioxaborolan-2-yl)-dibenzofuran-1-yl]-[1,3,5]triazine**

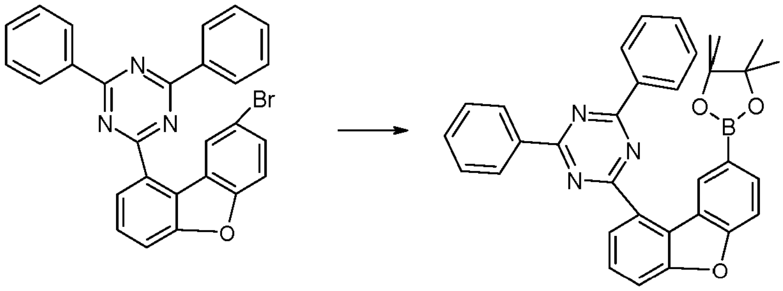

In einem 500 ml-Kolben werden unter Schutzgas 60 g (125 mmol) des 2-(8-Bromo-dibenzofuran-1-yl)-4,6-diphenyl-[1,3,5]triazin zusammen mit 39 g (1051 mmol) Bis-(pinacolato)-diboran (CAS 73183-34-3) in 900 ml trockenem DMF gelöst und für 30 Minuten entgast. Anschließend werden 37 g (376 mmol) Kaliumacetat und 1,9 g (8,7 mmol) Palladiumacetat zugegeben und der Ansatz über Nacht auf 80 °C erhitzt. Nach beendeter Reaktion wird mit 300 ml Toluol verdünnt und das Gemisch mit Wasser extrahiert. Das Lösungsmittel wird am Rotationsverdampfer entfernt und mit Heptan umkristallisiert. Ausbeute: 61 g (117 mmol), 94 % der Theorie. Analog dazu werden die folgenden Verbindungen hergestellt:

| | Edukt 1 | Produkt | Ausbeute |
|---|---|---|---|
| 1c | 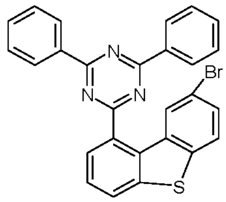 | 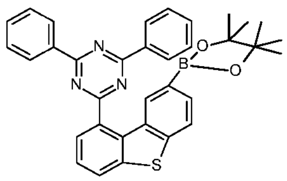 | 98% |

**d ) 2-[4-[9-(4,6-Diphenyl-1,3,5-triazin-2-yl)dibenzofuran-2-yl]phenyl]-4,6-diphenyl-1,3,5-triazine**

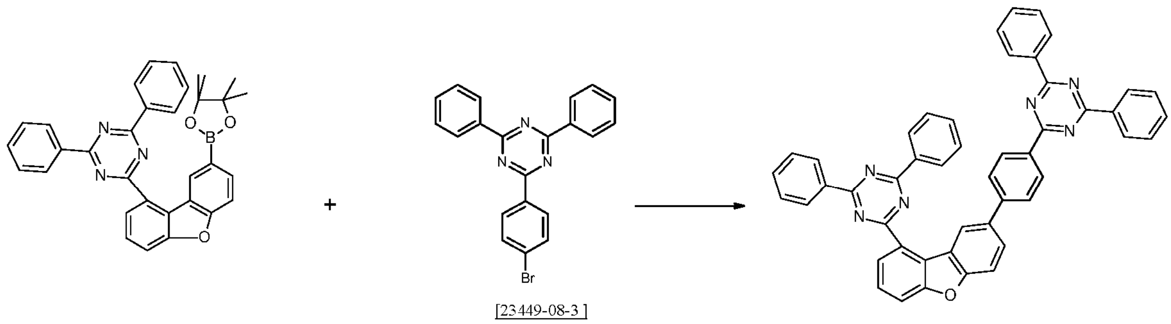
[23449-08-3]

68.7 g (110.0 mmol) 2,4-Diphenyl-6-[8-(4,4,5,5-tetramethyl-[1,3,2]dioxaborolan-2-yl)-dibenzofuran-1-yl]-[1,3,5] triazin, 42 g (110.0 mmol) 2-(4-Bromophenyl)-4,6-diphenyl-1,3,5-triazin und 21 g (210.0 mmol) Natriumcarbonat werden in 500 mL Ethylenglycoldiaminether und 500 mL Wasser suspendiert. Zu dieser Suspension werden 913 mg (3.0 mmol) Trio-tolylphosphin und dann 112 mg (0.5 mmol) Palladium(II)acetat gegeben, und die Reaktionsmischung wird 16 h unter Rückfluss erhitzt. Nach Erkalten wird die organische Phase abgetrennt, über Kieselgel filtriert, dreimal mit 200 mL Wasser gewaschen und anschließend zur Trockene eingeengt. Das Produkt wird via Säulenchromatographie an Kieselgel mit Toluol/$CHCl_3$ (1:1) gereinigt und abschließend im Hochvakuum (p = 5 x $10^{-7}$ mbar) sublimiert (Reinheit 99,9%). Die Ausbeute beträgt 64 g (81mmol), entsprechend 70 % der Theorie.

Analog können folgende Verbindungen hergestellt werden:

| | Edukt 1 | Edukt 2 | Produkt | Ausbeute |
|---|---|---|---|---|
| 1d | 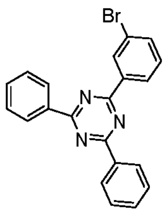 [864377-31-1] | 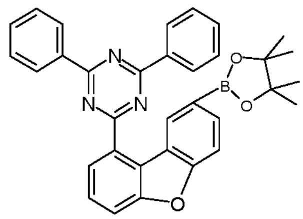 | 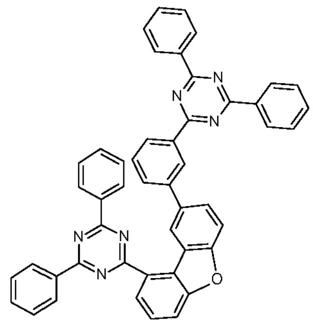 | 61% |

(fortgesetzt)

| | Edukt 1 | Edukt 2 | Produkt | Ausbeute |
|---|---|---|---|---|
| 2d | 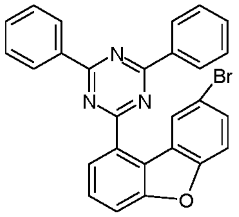 | 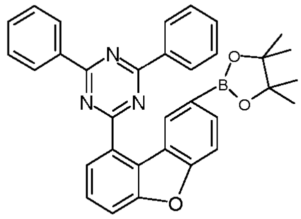 | 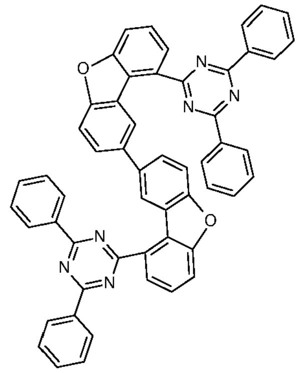 | 65% |
| 3d | 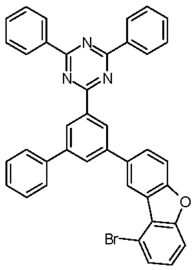 | 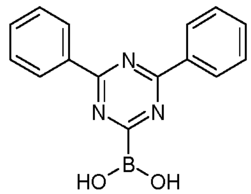 [1252825-65-6] | 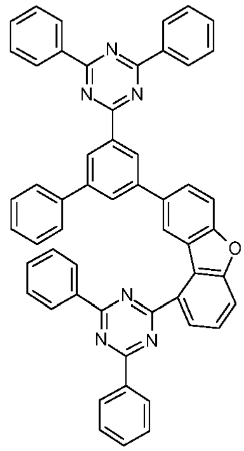 | 67% |
| 4d | 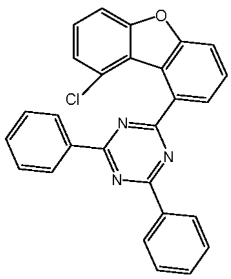 | 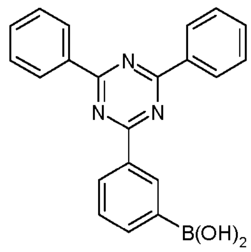 [1612243-82-9] | 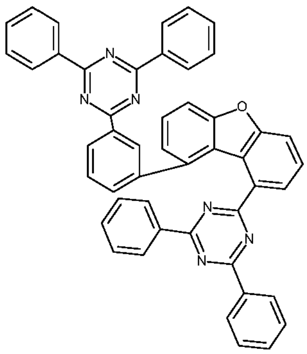 | 69% |
| 5d | 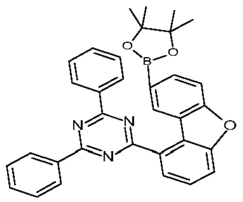 | 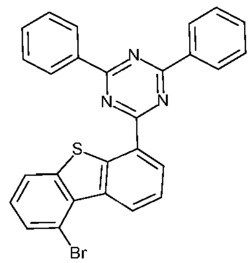 | 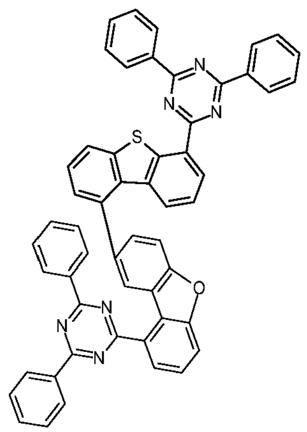 | 65% |

(fortgesetzt)

| | Edukt 1 | Edukt 2 | Produkt | Ausbeute |
|---|---|---|---|---|
| 6d | 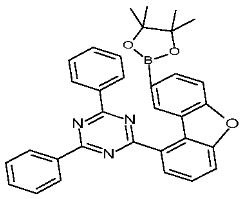 | 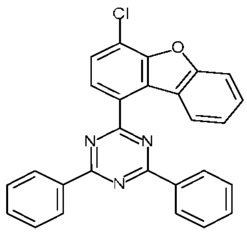 | 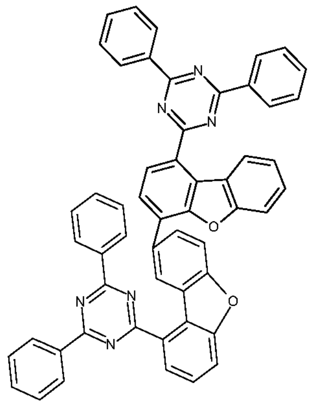 | 66% |
| 7d | 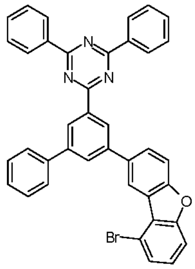 | 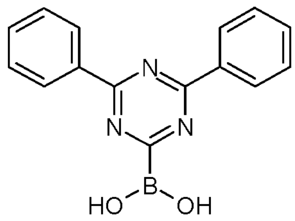 [1252825-65-6] | 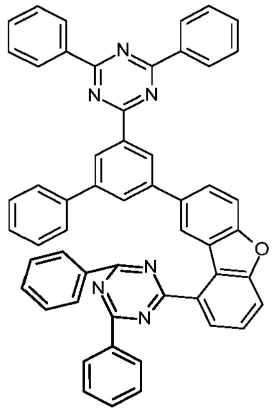 | 62% |
| 8d | 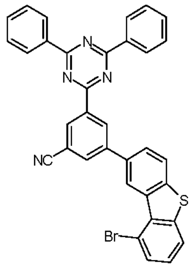 | 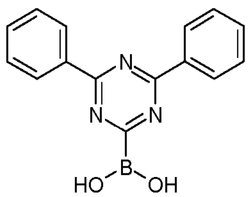 [1252825-65-6] | 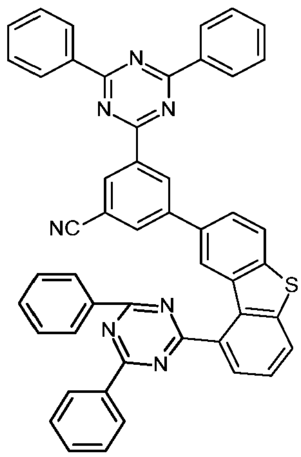 | 64% |

(fortgesetzt)

| | Edukt 1 | Edukt 2 | Produkt | Ausbeute |
|---|---|---|---|---|
| 9d | 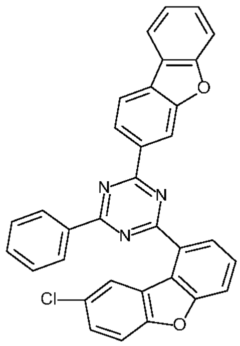 | 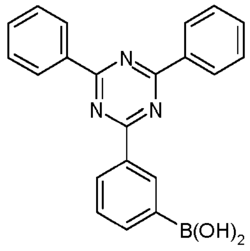 [1612243-82-9] | 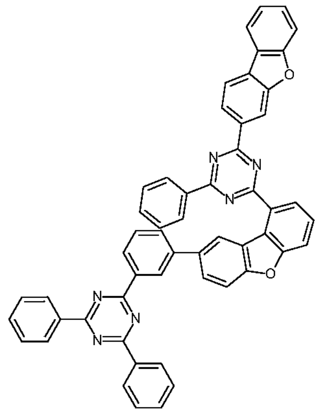 | 76% |

## Patentansprüche

1. Organische elektrolumineszierende Vorrichtung umfassend eine Anode, eine Kathode und mindestens eine organische Schicht, enthaltend mindestens eine lichtemittierende Schicht, wobei die mindestens eine lichtemittierende Schicht mindestens eine Verbindung der Formel (1) als Hostmaterial 1 und mindestens eine Verbindung der Formel (2a) als Hostmaterial 2 enthält,

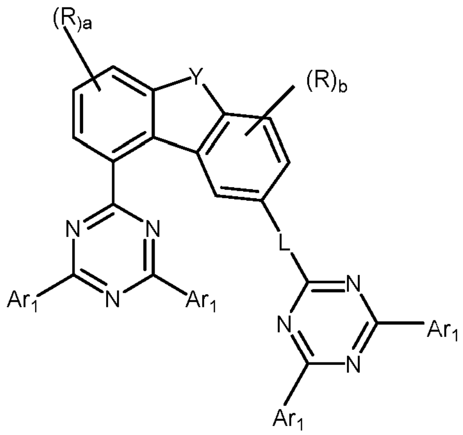

Formel (1)

,

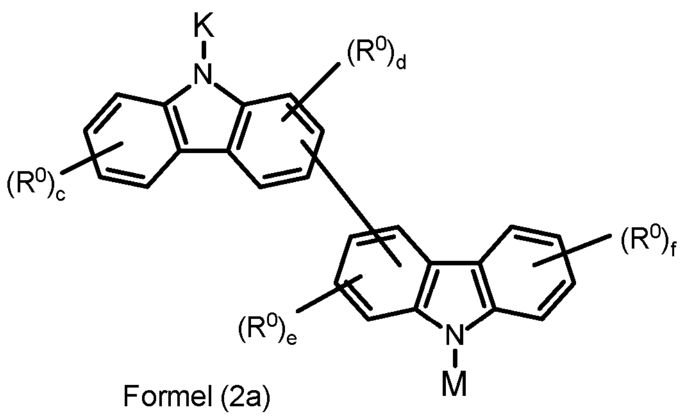

Formel (2a)

,

wobei für die verwendeten Symbole und Indizes gilt:

Y ist ausgewählt aus O, S, $C(CH_3)_2$, $C(Phenyl)_2$ oder wobei * das C-Atom markiert, das an den Rest

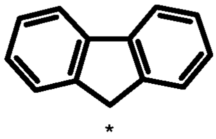

,

der Formel (1) bindet;
L ist ausgewählt aus einem der bivalenten Linker L-1 bis L-26,

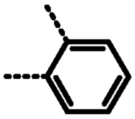
L-1

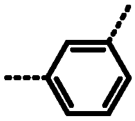
L-2

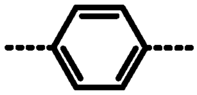
L-3

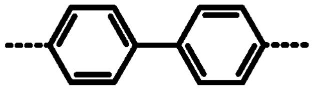
L-4

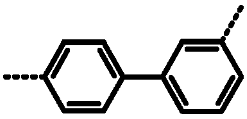
L-5

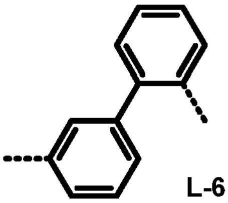
L-6

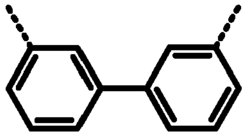
L-7

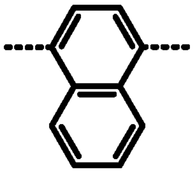
L-8

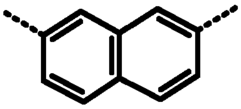
L-9

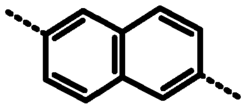
L-10

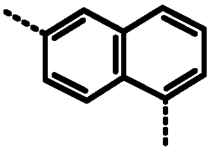
L-11

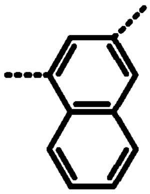
L-12

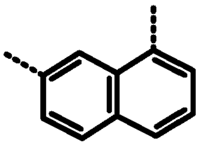
L-13

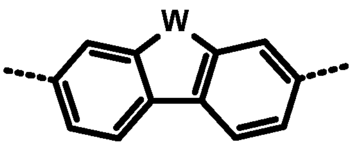
L-14

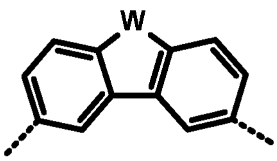
L-15

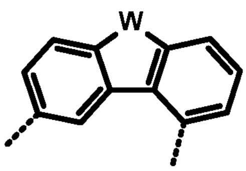
L-16

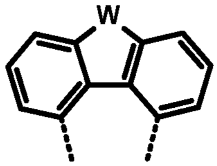

L-17

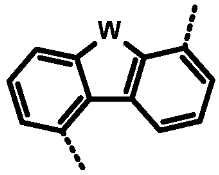

L-18

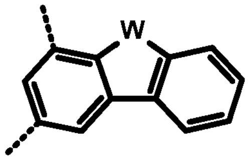

L-19

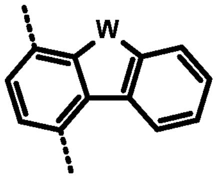

L-20

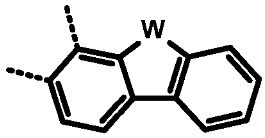

L-21

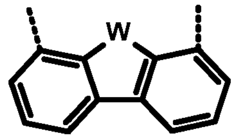

L-22

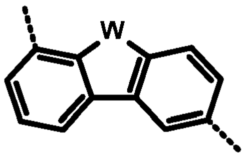

L-23

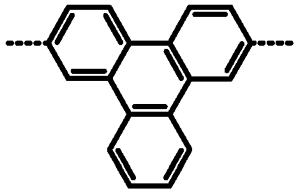

L-24

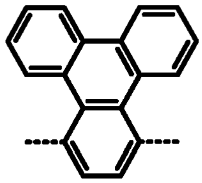

L-25

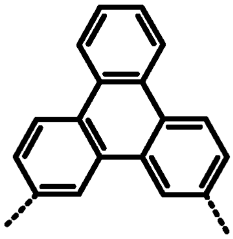

L-26 ,

W wobei die Linker L-1 bis L-26 noch mit einem oder mehreren Substituenten R substituiert sein können; ist O, S oder $C(CH_3)_2$;
a ist 0 oder 1;
b ist 0 oder 1;
R ist bei jedem Auftreten gleich oder verschieden ausgewählt aus der Gruppe bestehend aus CN, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen, einem aromatischen oder heteroaromatischen Ringsystem mit 5 bis 40 aromatischen Ringatomen, einer Aryloxy- oder Heteroaryloxygruppe mit 5 bis 40 aromatischen Ringatomen, oder einer Aralkyl- oder Heteroaralkylgruppe mit 5 bis 40 aromatischen Ringatomen;
$Ar_1$ ist bei jedem Auftreten jeweils unabhängig voneinander eine Aryl- oder Heteroarylgruppe mit 5 bis 40 aromatischen Ringatomen, die mit einem oder mehreren Resten R substituiert sein kann;
K und M bedeuten jeweils unabhängig voneinander ein unsubstituiertes oder teilweise oder vollständig deuteriertes oder einfach durch R* substituiertes aromatisches Ringsystem mit 6 bis 40 aromatischen Ringatomen;
$R^0$ ist bei jedem Auftreten unabhängig voneinander ein unsubstituiertes oder teilweise oder vollständig deuteriertes aromatisches Ringsystem mit 6 bis 18 C-Atomen;
R* ist Dibenzofuranyl oder Dibenzothiophenyl;
c, d, e und f sind unabhängig voneinander 0 oder 1

und wobei die lichtemittierende Schicht neben dem mindestens einen Hostmaterial 1 und dem mindestens einen Hostmaterial 2 mindestens einen phosphoreszierenden Emitter der Formel (3) enthält,

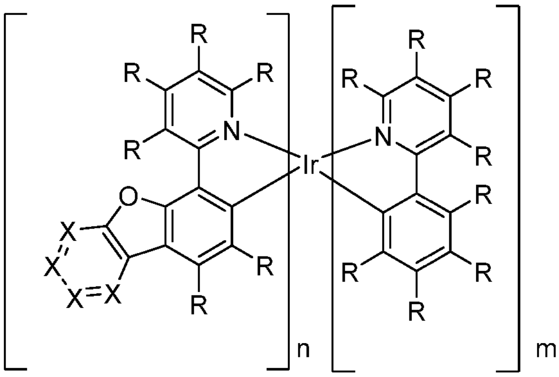

Formel (3)

,

wobei die Symbole und Indizes für diese Formel (3) die Bedeutung haben:

n+m ist 3, n ist 1 oder 2, m ist 2 oder 1,
X ist N oder CR,
R ist H, D oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 7 C-Atomen, die teilweise oder vollständig mit Deuterium substituiert sein kann.

**2.** Organische elektrolumineszierende Vorrichtung nach Anspruch 1, **dadurch gekennzeichnet, dass** im Hostmaterial 1 Y O bedeutet.

**3.** Organische elektrolumineszierende Vorrichtung nach Anspruch 1 oder 2, **dadurch gekennzeichnet, dass** das Hostmaterial 2 einer der folgenden Verbindungen entspricht:

| | | |
|---|---|---|
| 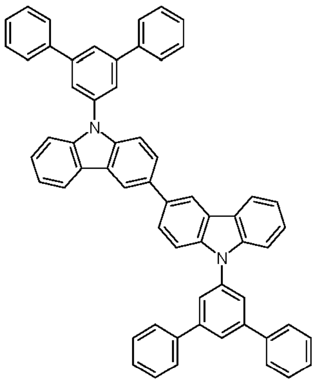 | 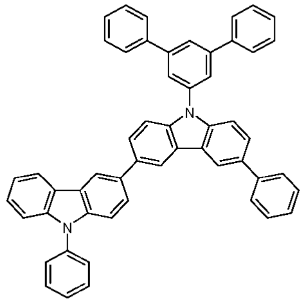 | 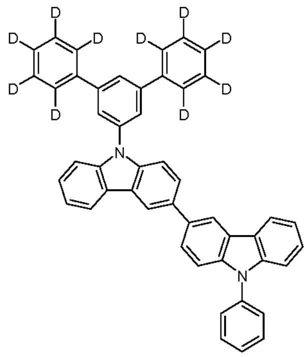 |
| 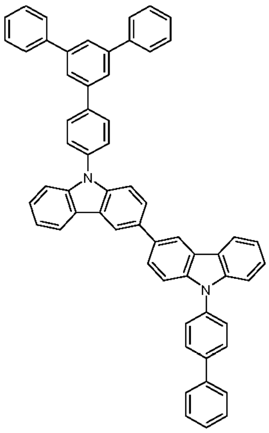 | 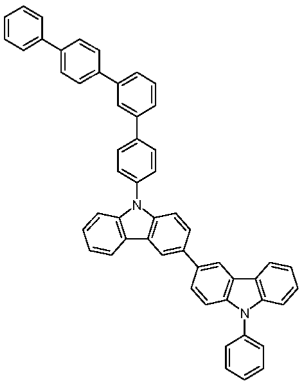 | 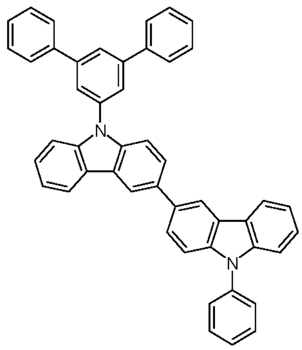 |

| | | |
|---|---|---|
| 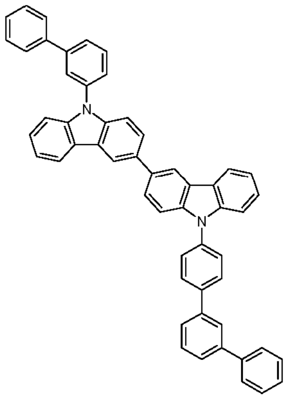 | 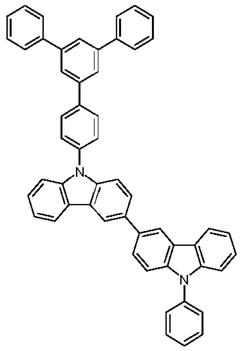 | 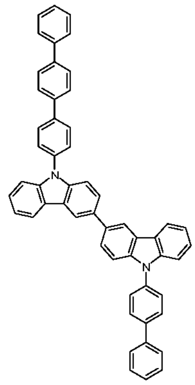 |
| 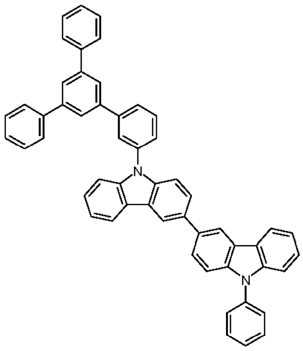 | 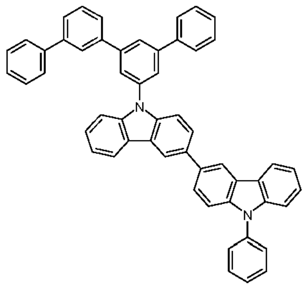 | 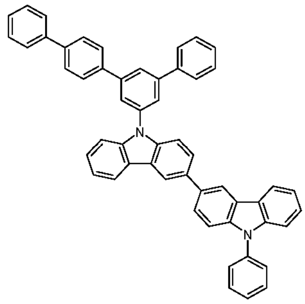 |
| 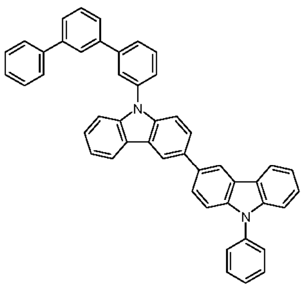 | 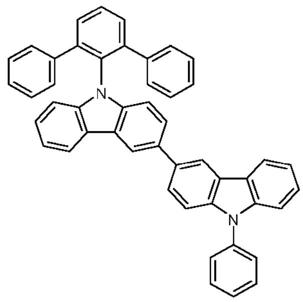 | 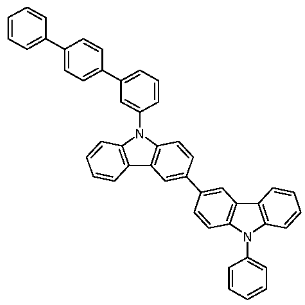 |
| 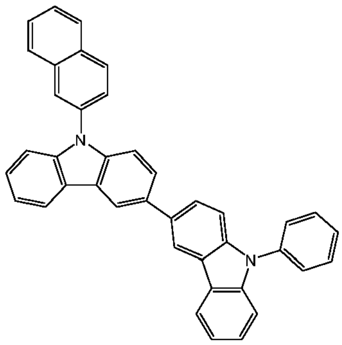 | 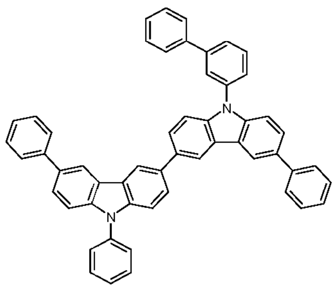 | 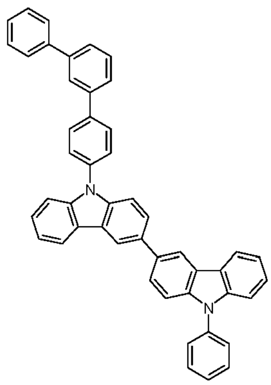 |

| | | |
|---|---|---|
| 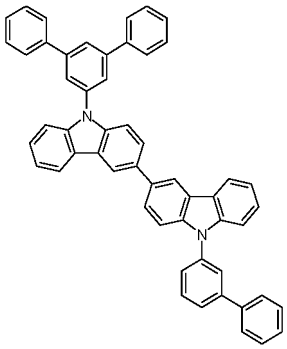 | 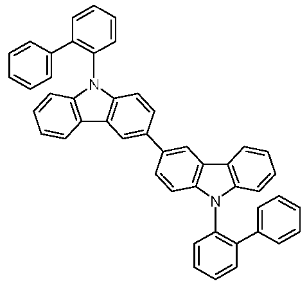 | 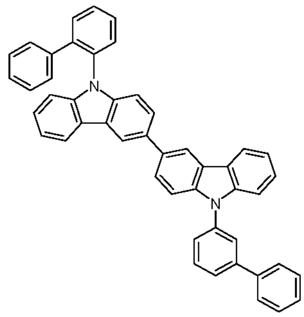 |
| 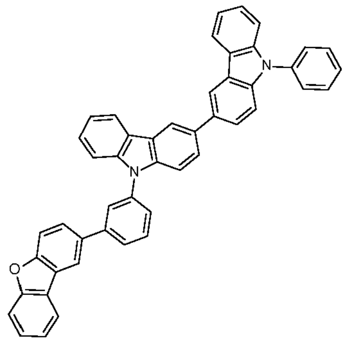 24 | 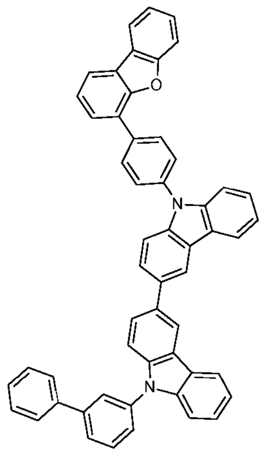 | 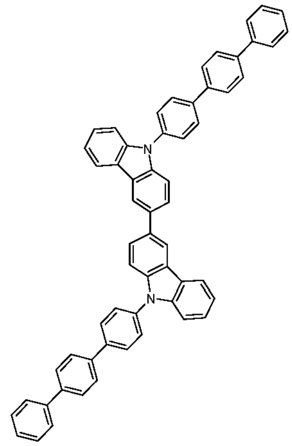 |
| 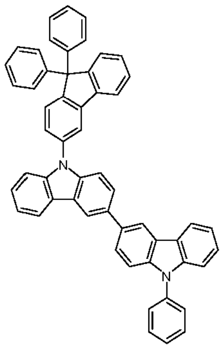 | 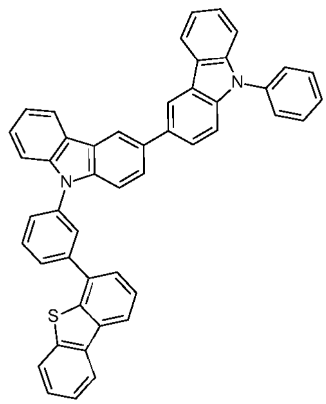 | 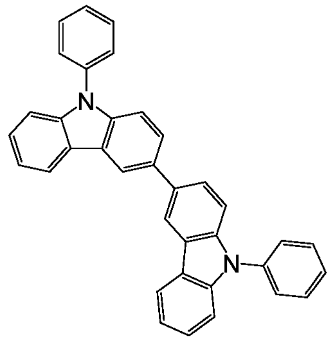 23 |
| | 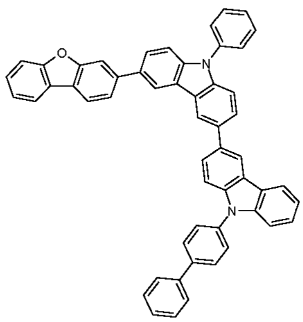 | |

| | | |
|---|---|---|
| | 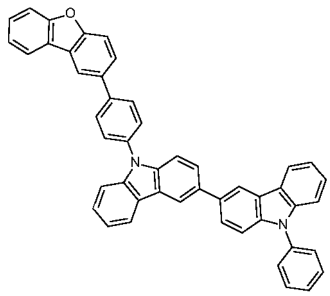 | |
| 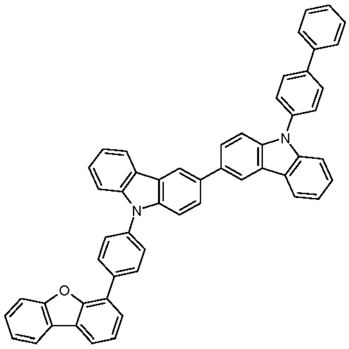 | 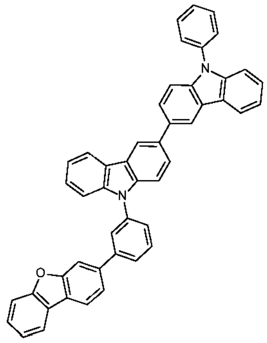 | 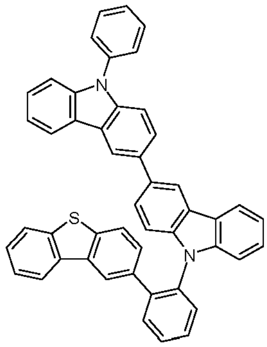 |
| 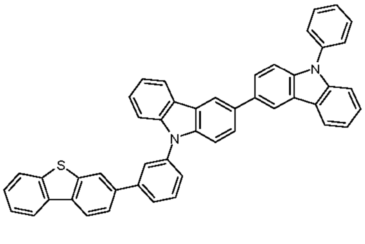 | 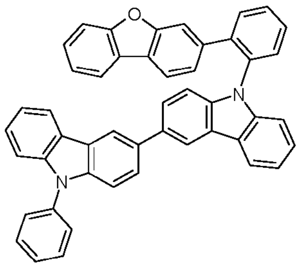 | 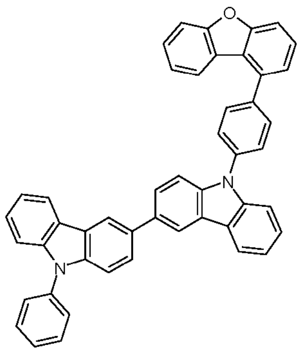 |
| 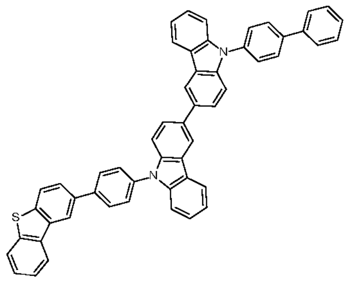 | 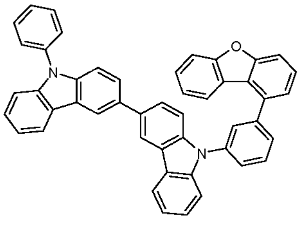 | 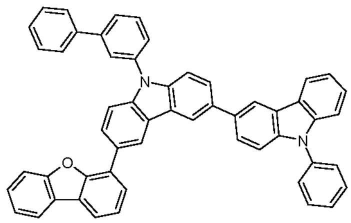 |
| 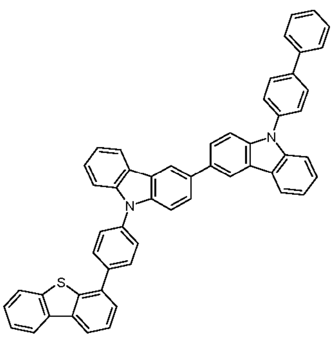 | 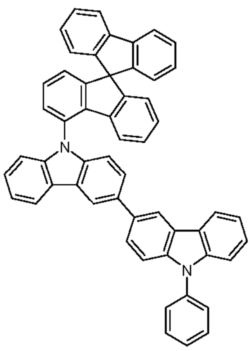 | 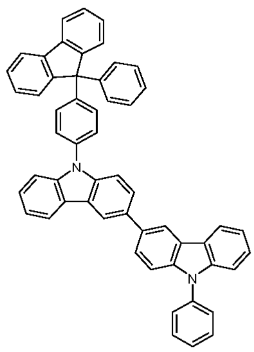 |

| | | |
|---|---|---|
| 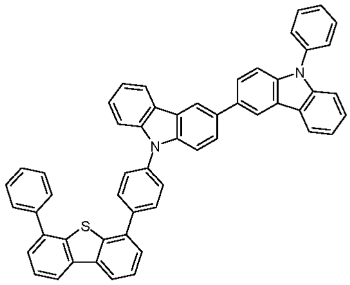 | 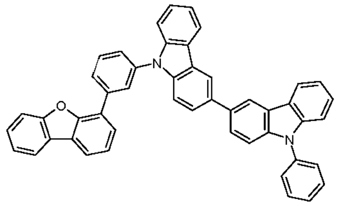 | 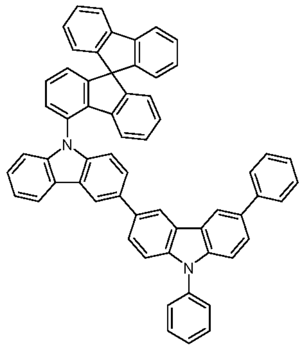 |
| 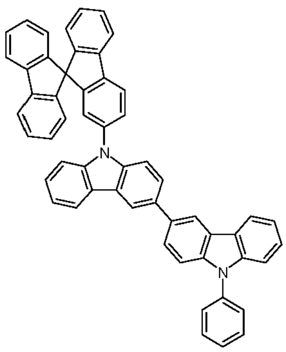 | 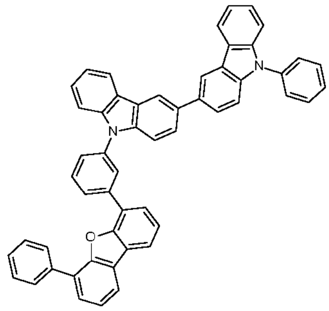 | 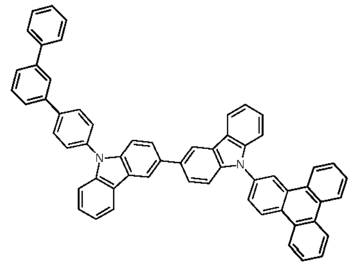 |
| 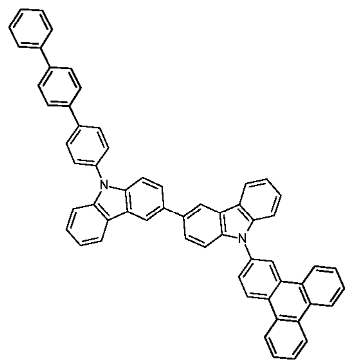 | 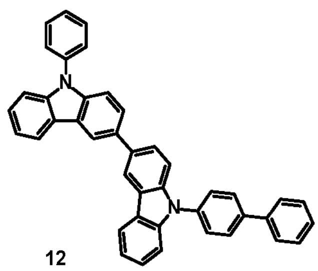 12 | 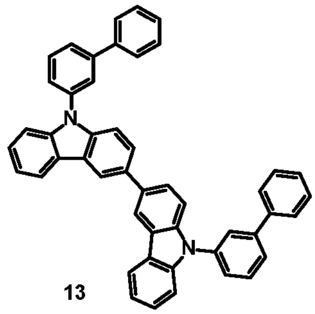 13 |
| 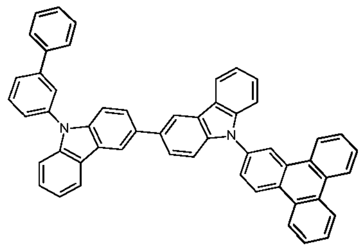 | 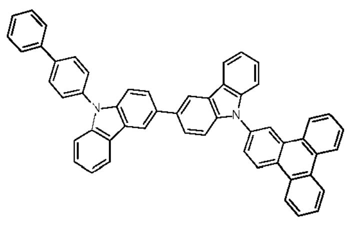 | 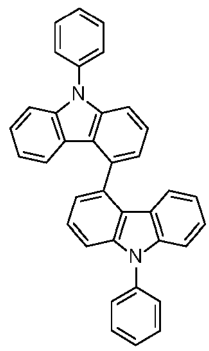 |
| 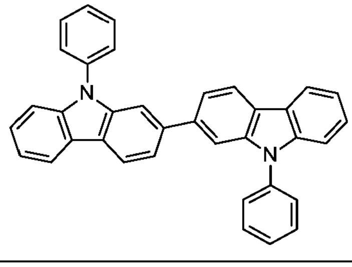 | 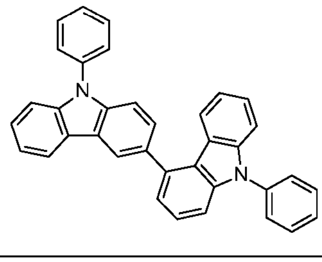 | 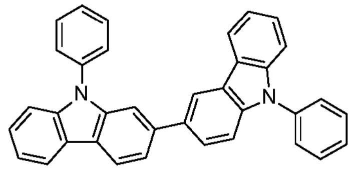 |

| | | |
|---|---|---|
| 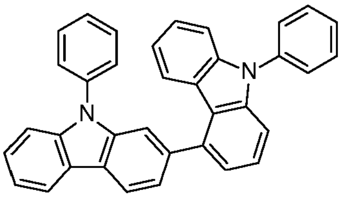 | 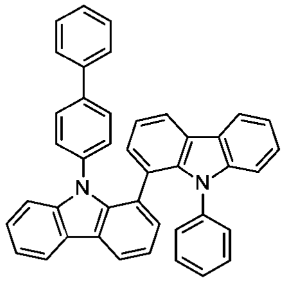 | 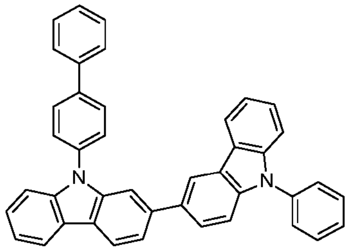 |
| 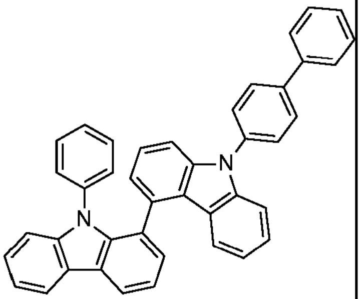 | 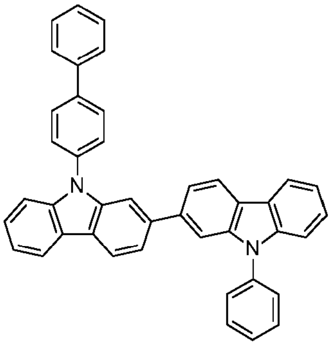 | 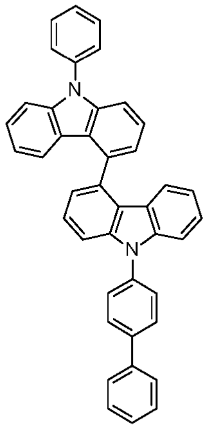 |
| 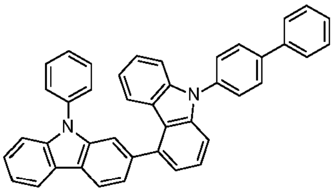 | 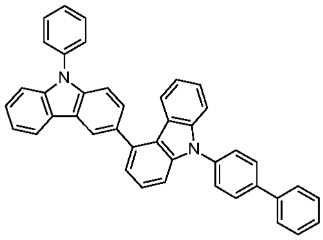 | 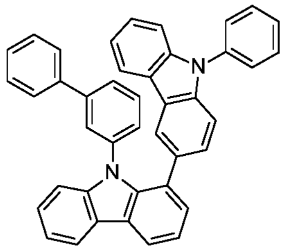 |
| 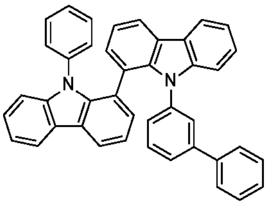 | 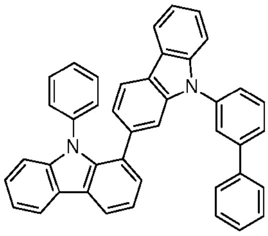 | 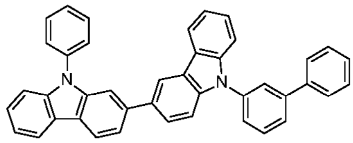 |
| 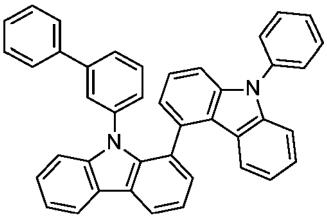 | 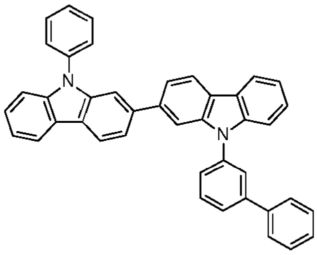 | 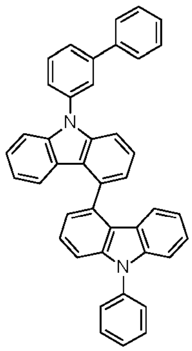 |

| | | |
|---|---|---|
| 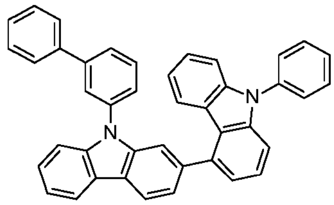 | 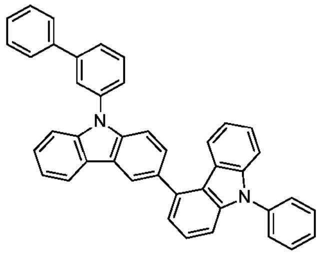 | 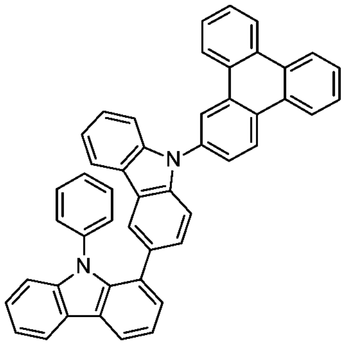 |
| 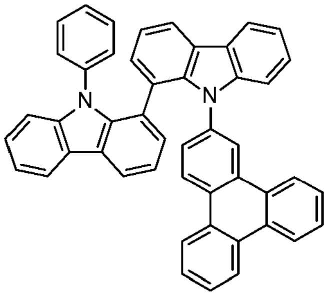 | 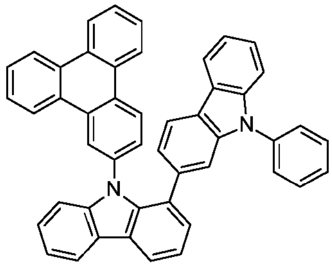 | 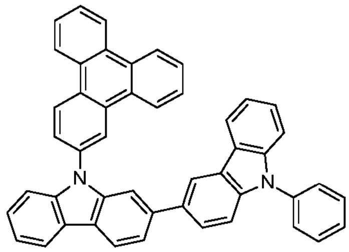 |
| 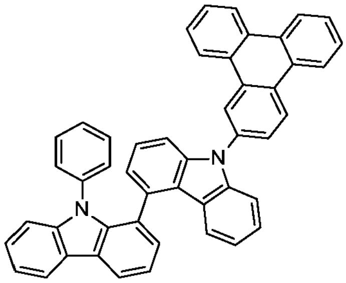 | 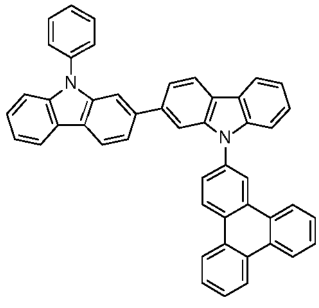 | 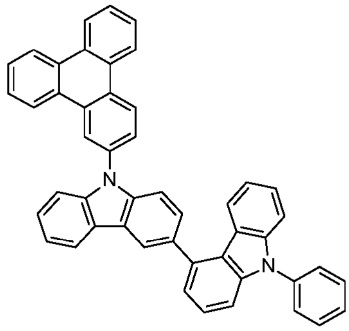 |
| 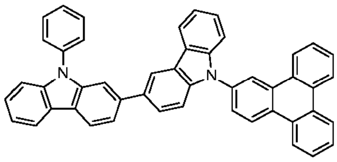 | 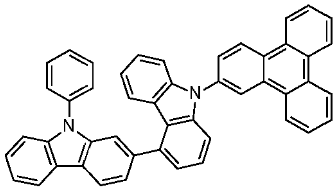 | 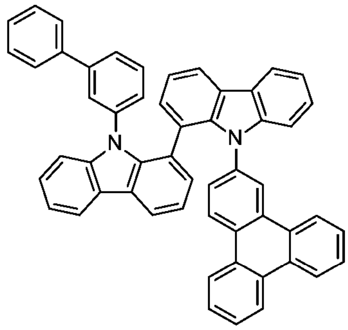 |
| 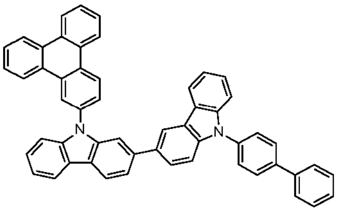 | 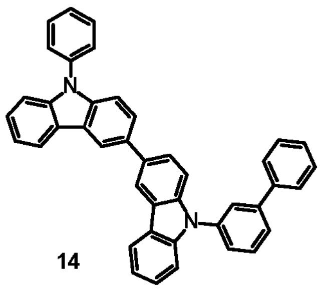 14 | 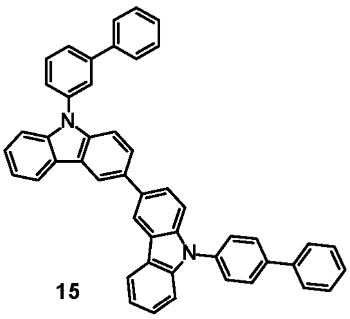 15 |

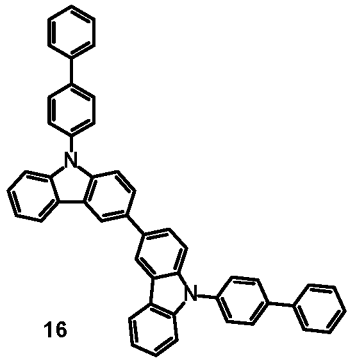

16

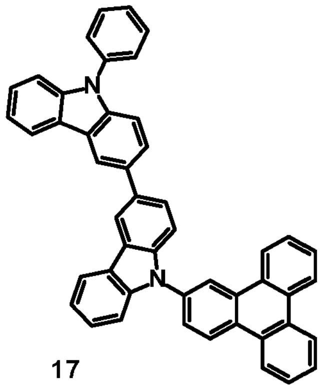

17

.

4. Organische elektrolumineszierende Vorrichtung nach einem oder mehreren der Ansprüche 1 bis 3, **dadurch gekennzeichnet, dass** im Hostmaterial 1, L aus den bivalenten Linkern L-1 bis L-13 und L-24 bis L-26 ausgewählt wird.

5. Organische elektrolumineszierende Vorrichtung nach einem oder mehreren der Ansprüche 1 bis 4, **dadurch gekennzeichnet, dass** es sich um eine Elektrolumineszenzvorrichtung handelt, die ausgewählt ist aus den organischen lichtemittierenden Transistoren (OLETs), organischen Feld-Quench-Devices (OFQDs), organischen lichtemittierenden elektrochemischen Zellen (OLECs, LECs, LEECs), organischen Laserdioden (O-Laser) und den organischen lichtemittierenden Dioden (OLEDs).

6. Organische elektrolumineszierende Vorrichtung nach einem oder mehreren der Ansprüche 1 bis 5, **dadurch gekennzeichnet, dass** diese neben der Licht-emittierenden Schicht (EML), eine Lochinjektionsschicht (HIL), eine Lochtransportschicht (HTL), eine Elektronentransportschicht (ETL), eine Elektroneninjektionsschicht (EIL) und/oder eine Lochblockierschicht (HBL) enthält.

7. Organische elektroluminszierende Vorrichtung nach einem oder mehreren der Ansprüche 1 bis 6, **dadurch gekennzeichnet, dass** das Hostmaterial 1 einer der folgenden Formeln entspricht:

| | | |
|---|---|---|
| 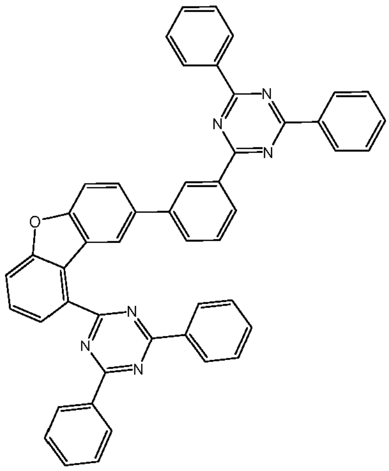 1 | 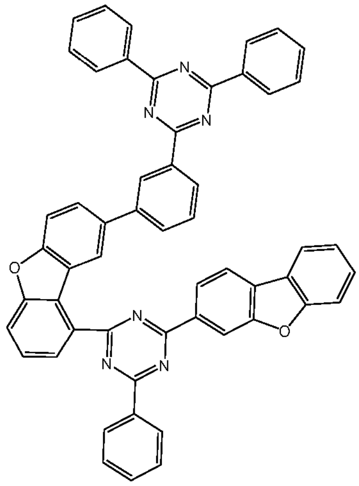 2 | 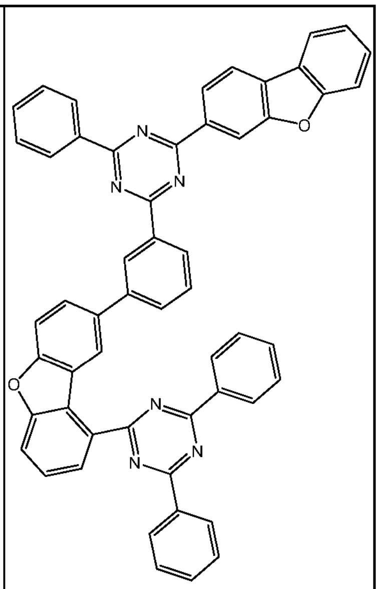 3 |
| 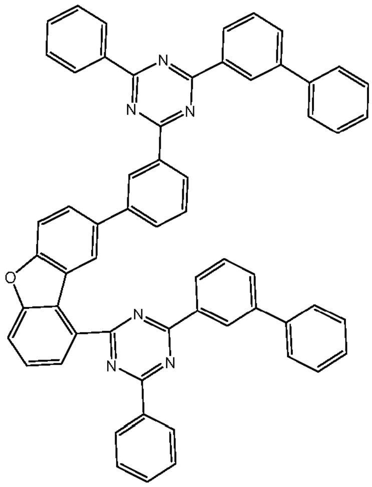 | 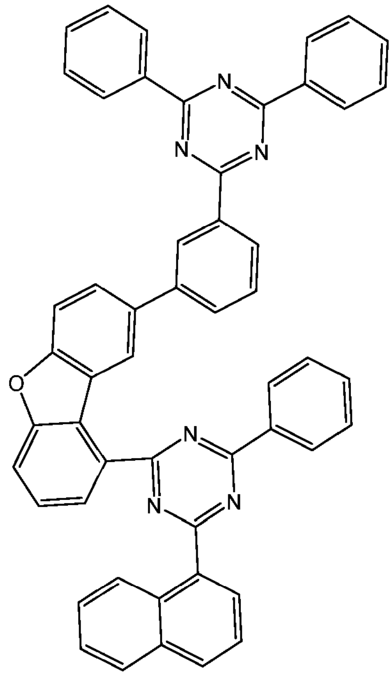 | 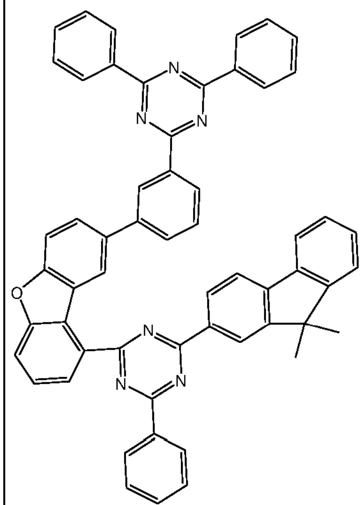 |

| | | |
|---|---|---|
| 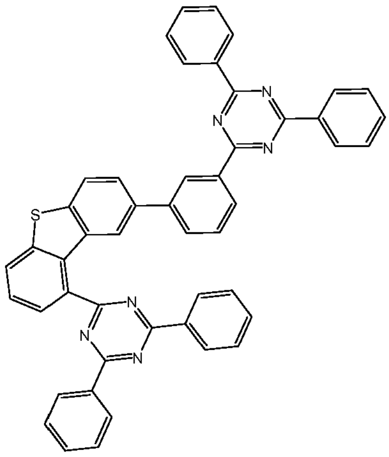 4 | 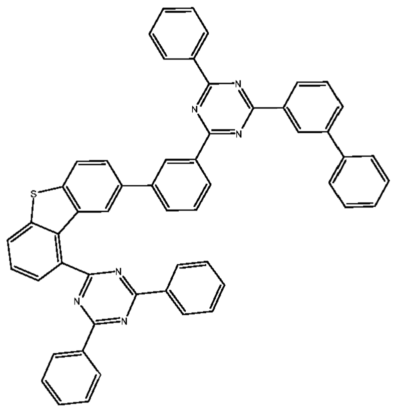 | 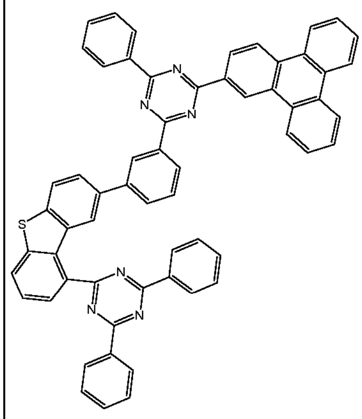 |
| 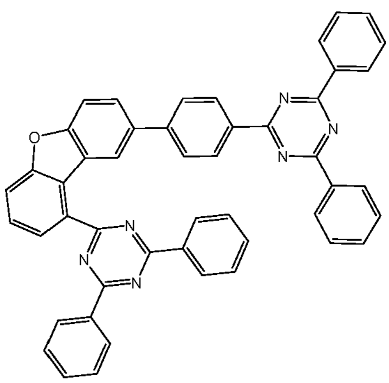 5 | 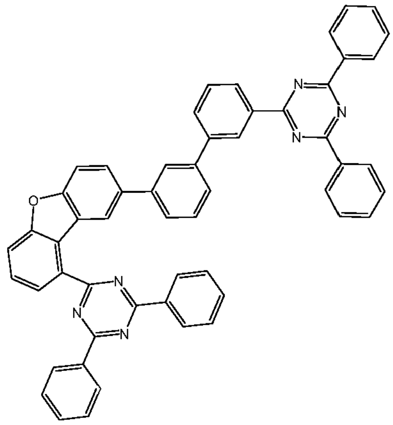 6 | 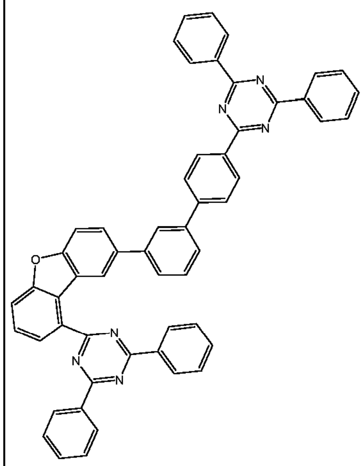 |
| 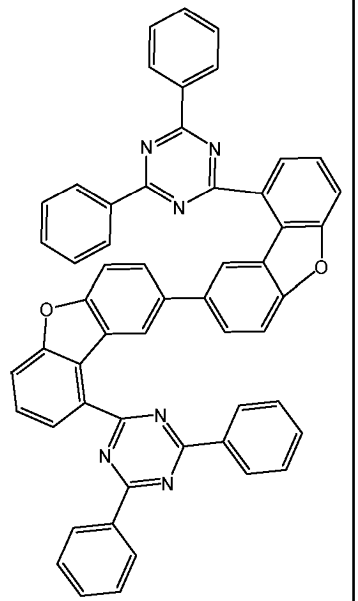 7 | 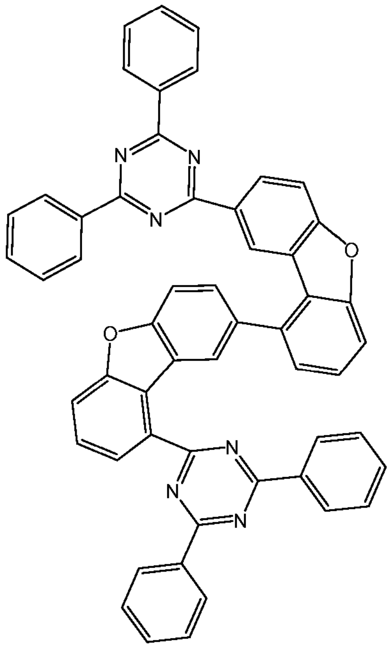 | 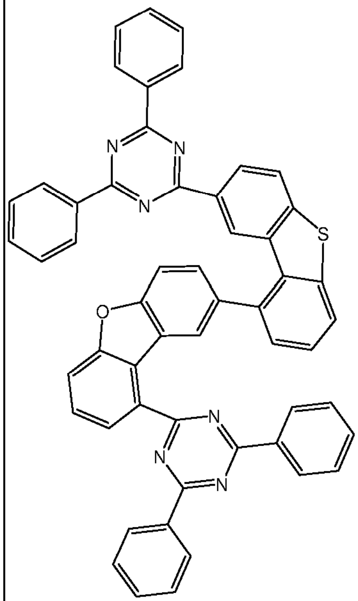 8 |

| | | |
|---|---|---|
| 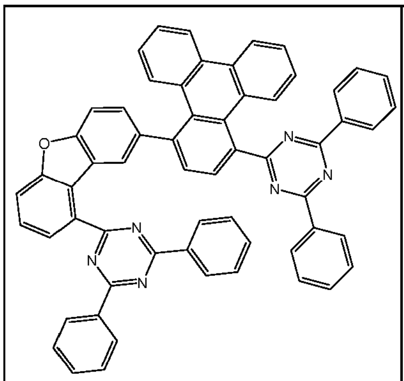 | 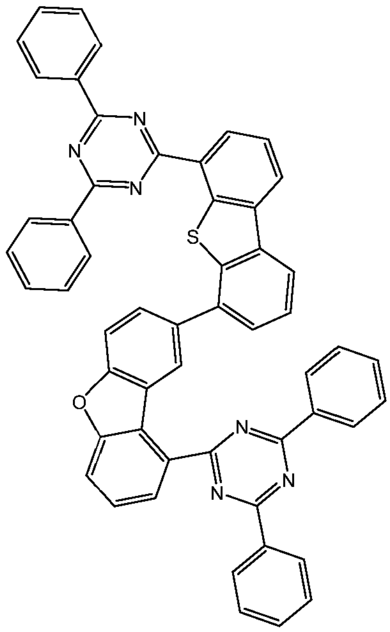 | 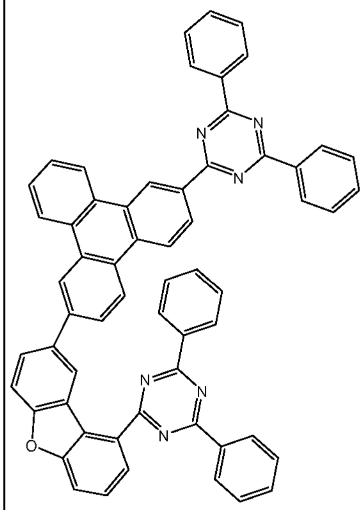 |
| 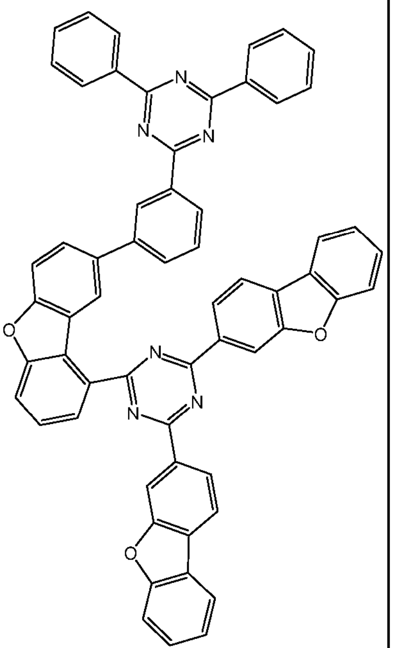<br>9 | 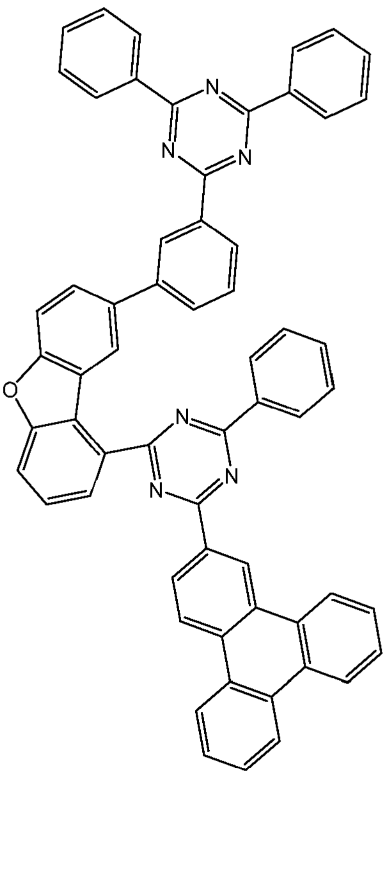 | 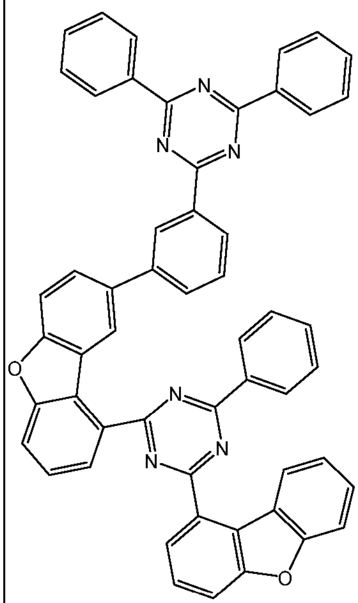 |

| | | |
|---|---|---|
| 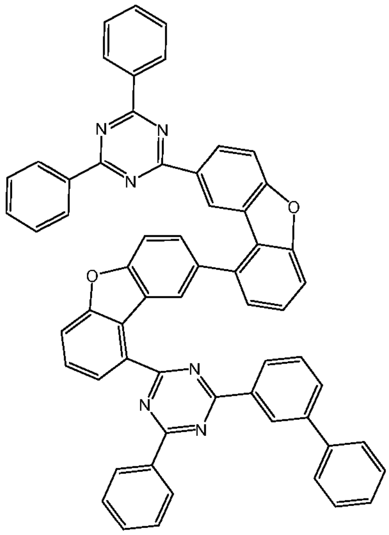 | | |
| | 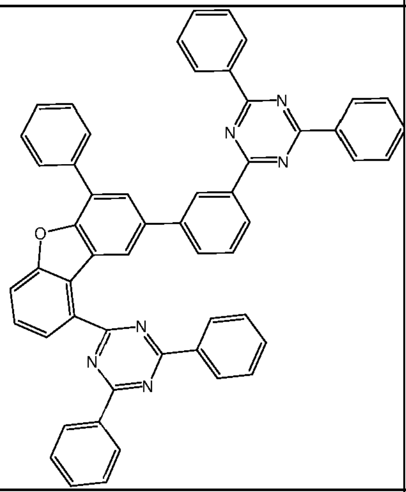 | 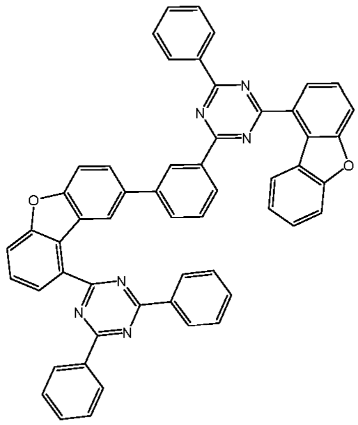 |
| 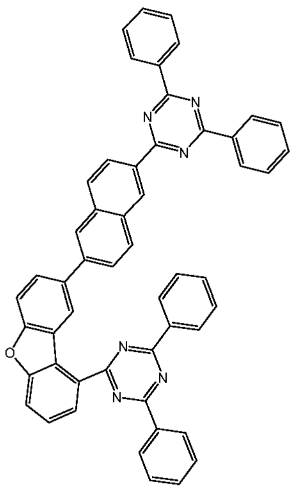 | 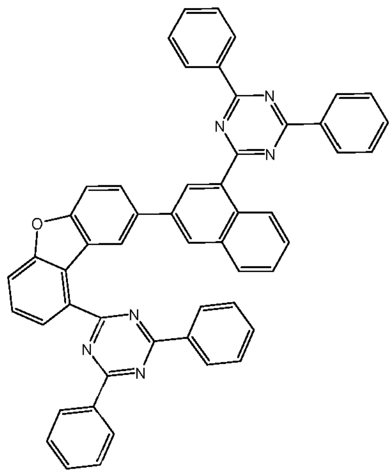 | 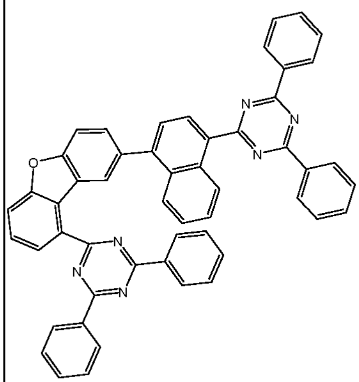 |

| | | |
|---|---|---|
| 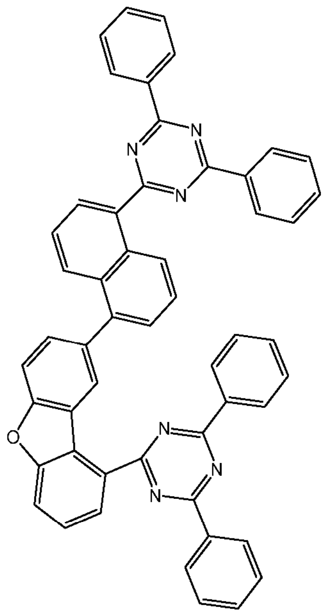 | 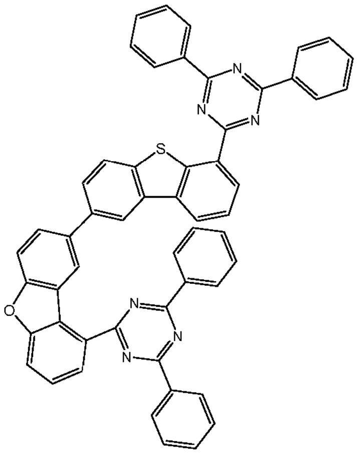 | 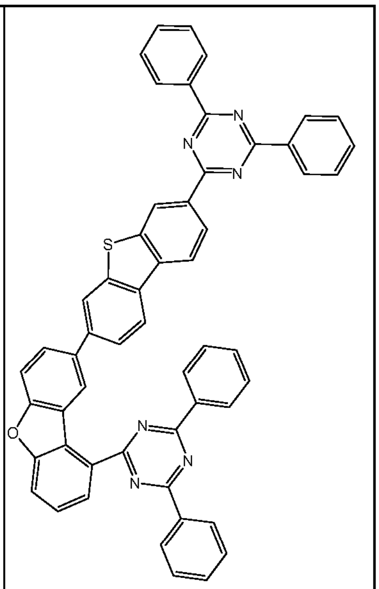 |
| 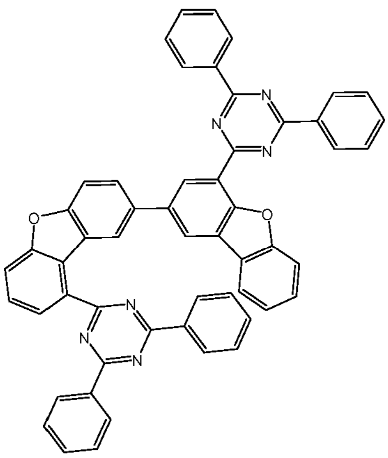 | 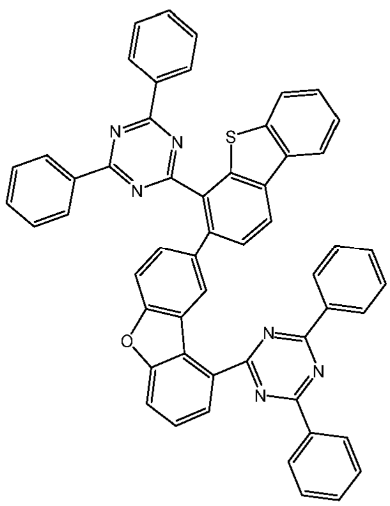 | 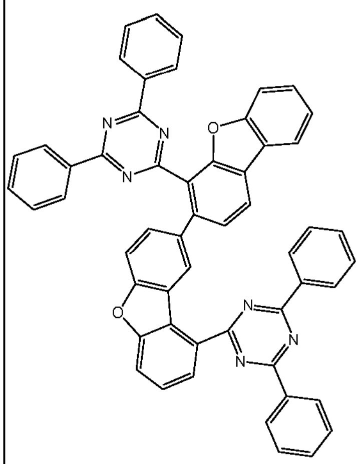 |
| 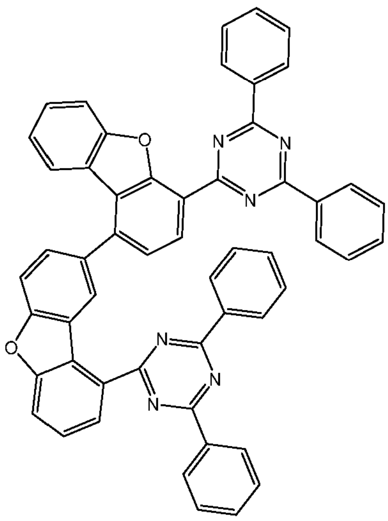 | 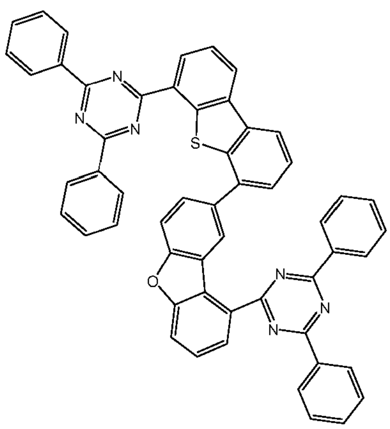 | 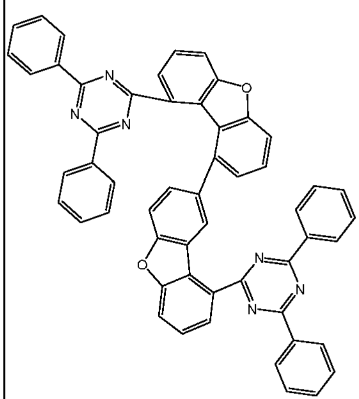 |

| | | |
|---|---|---|
| 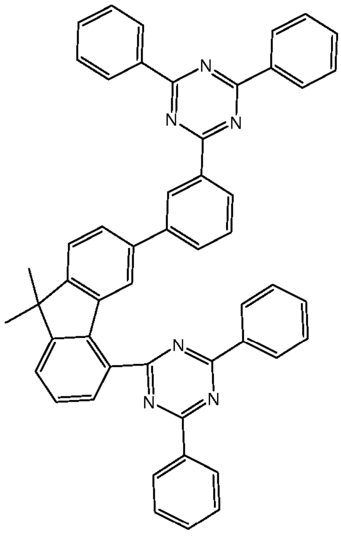 10 | 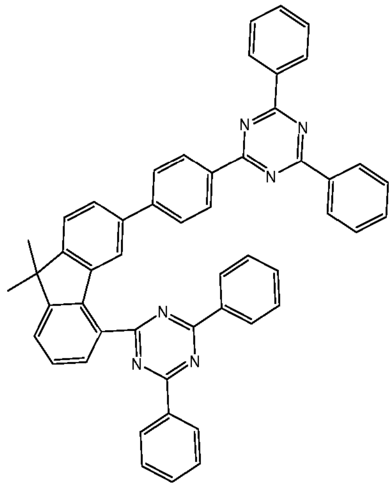 | 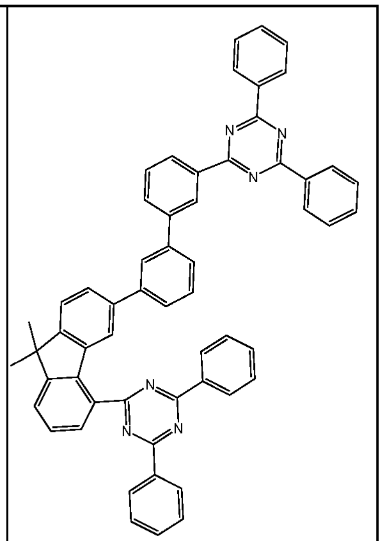 |
| 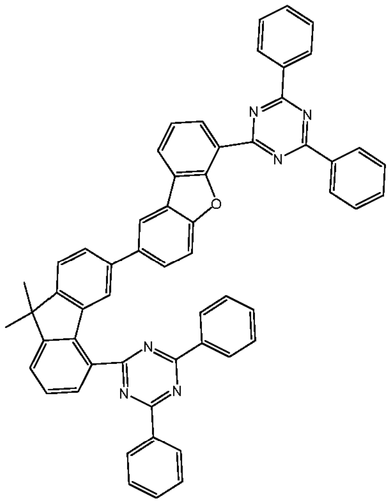 | 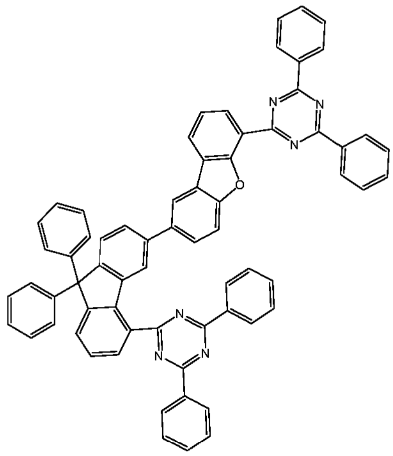 | 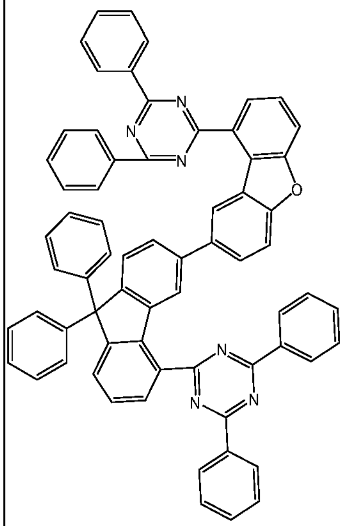 |
| 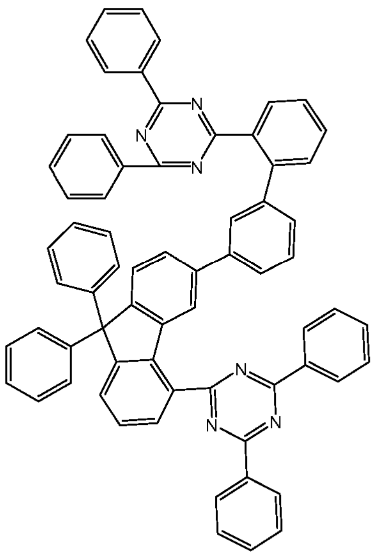 | 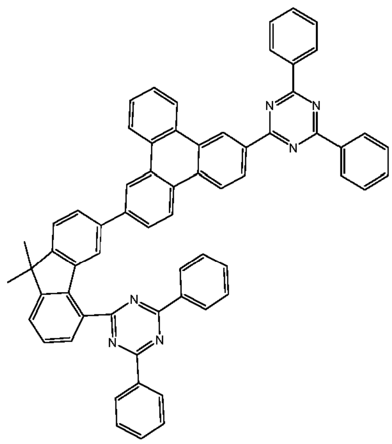 | 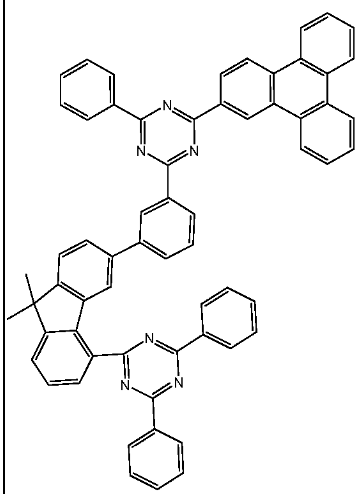 |

| | | |
|---|---|---|
| 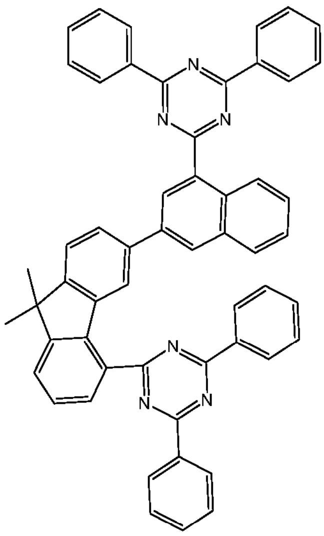 | 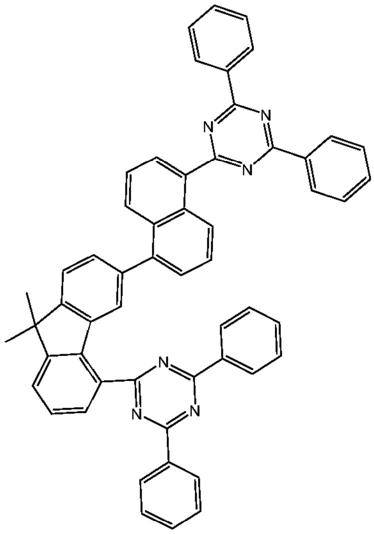 | 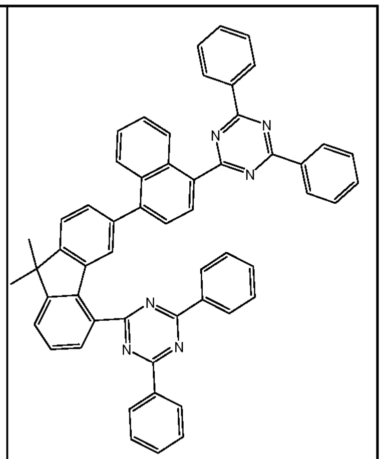 |
| 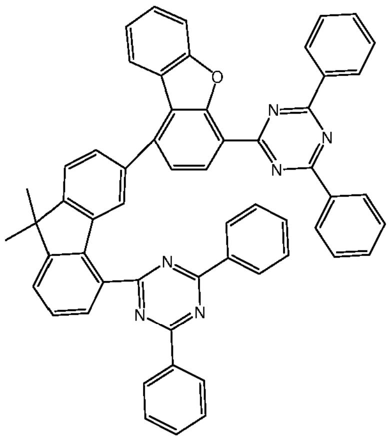 | 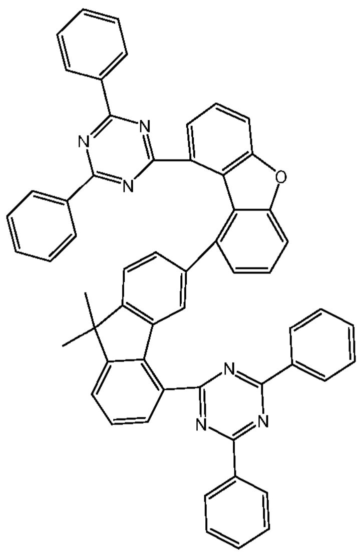 | 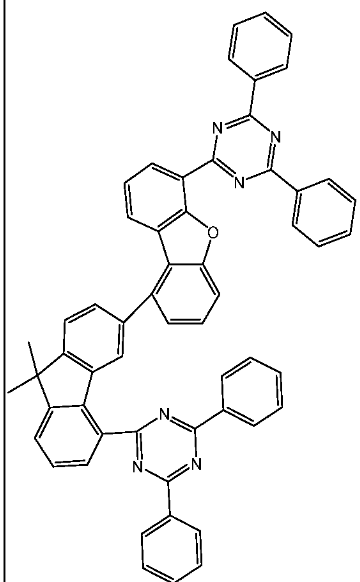 |
| 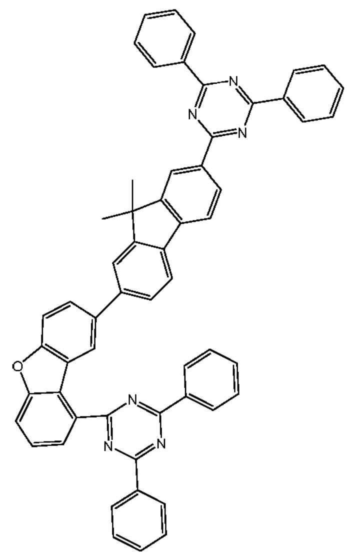 | 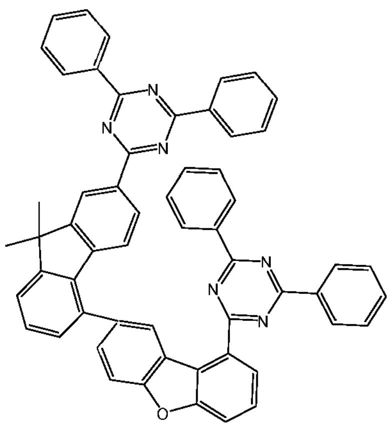 | 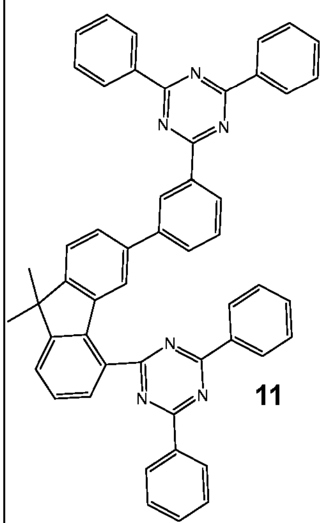 11 |

| | | |
|---|---|---|
| 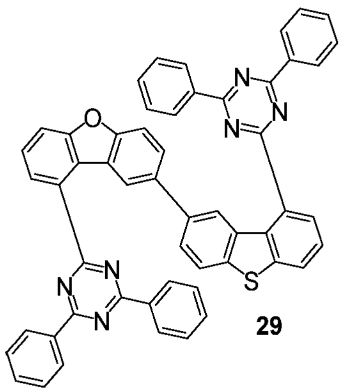 29 | 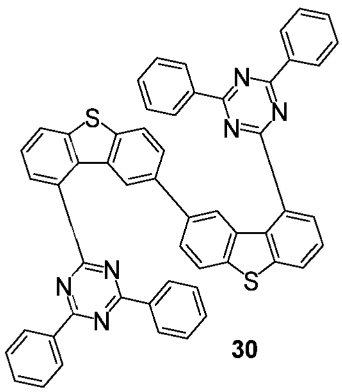 30 | 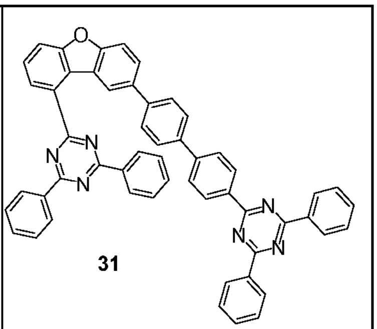 31 |
| 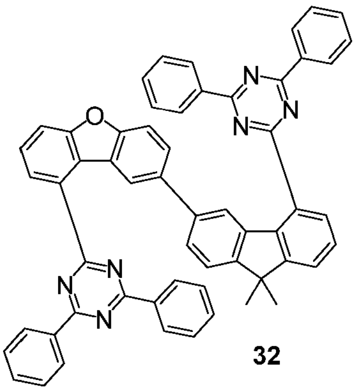 32 | 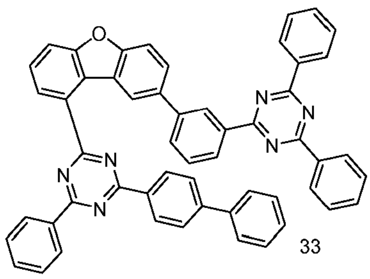 33 | 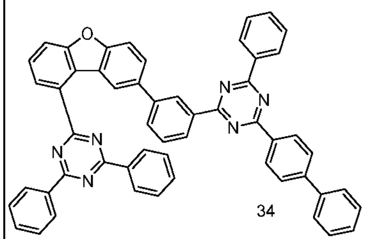 34 |
| 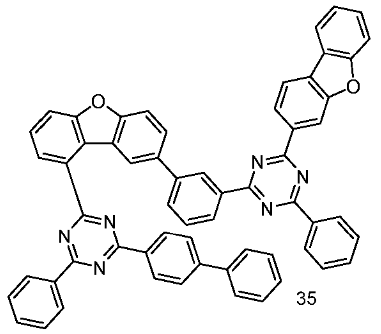 35 | 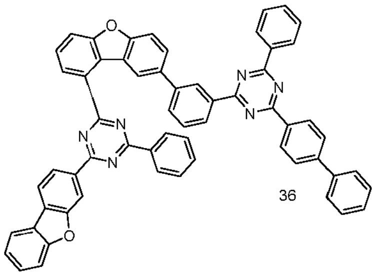 36 | 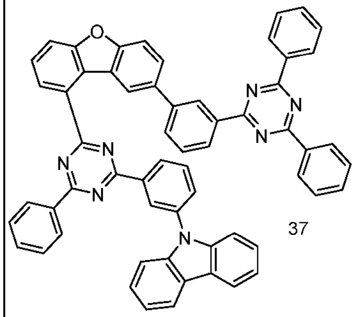 37 |
| 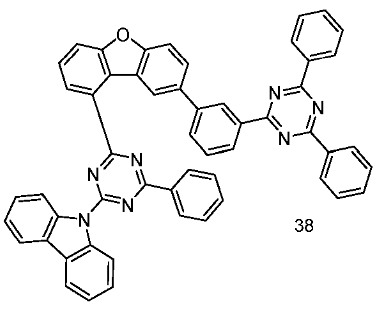 38 | 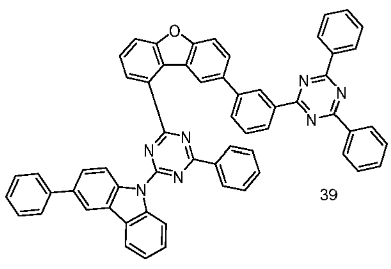 39 | 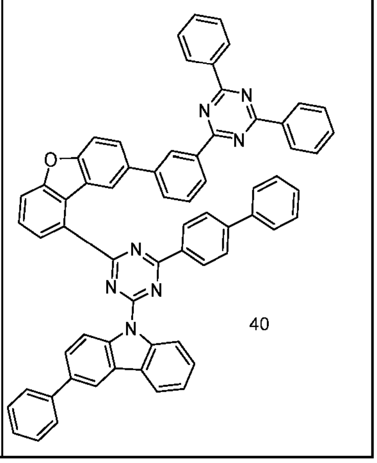 40 |

| | | |
|---|---|---|
| 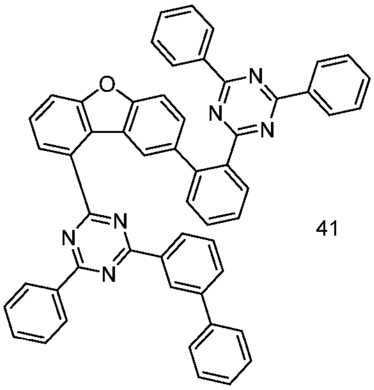 41 | 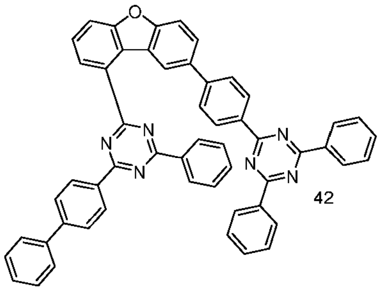 42 | 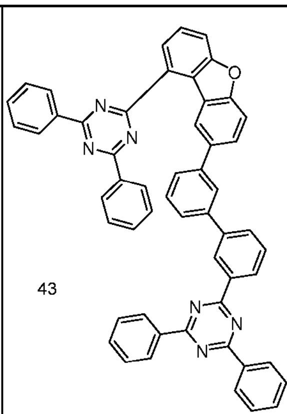 43 |
| 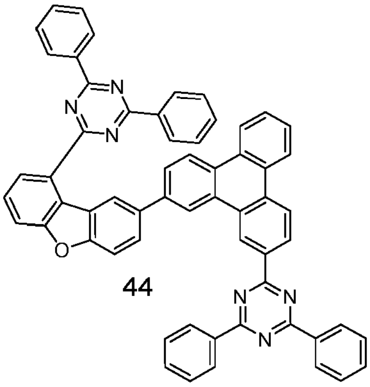 44 | 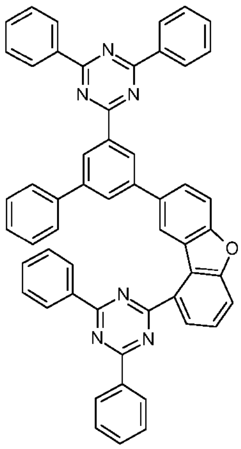 3d | |
| 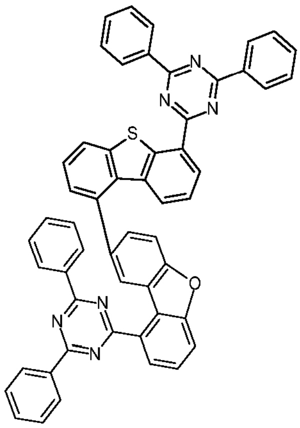 5d | 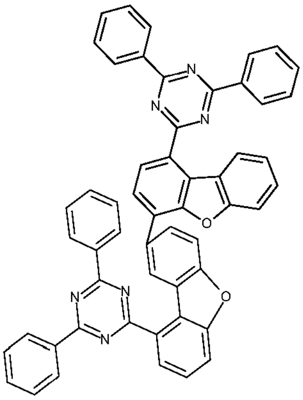 6d | 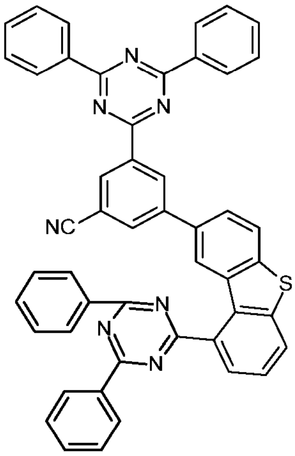 8d. |

8. Organische elektrolumineszierende Vorrichtung nach Anspruch 1, **dadurch gekennzeichnet, dass** der phosphoreszierende Emitter der Formel (3) einer der folgenden Formeln entspricht:

| | | |
|---|---|---|
| 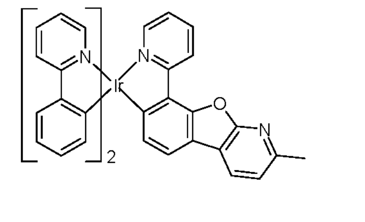 | 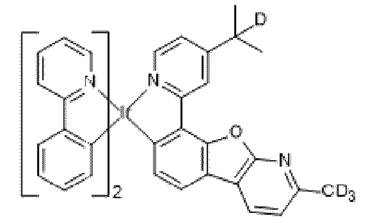 | 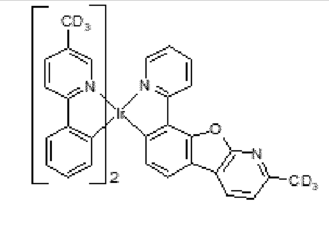 |
| 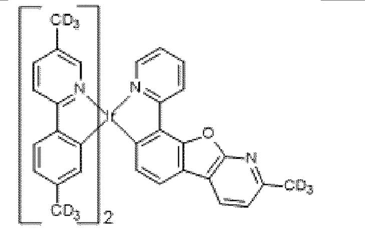 | 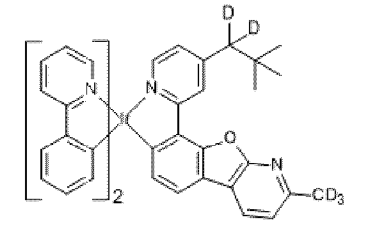 | 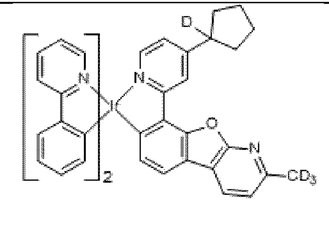 |
| 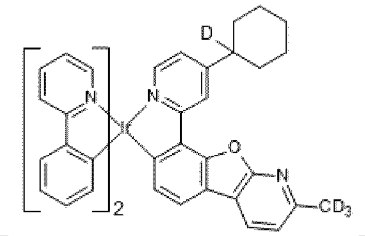 | 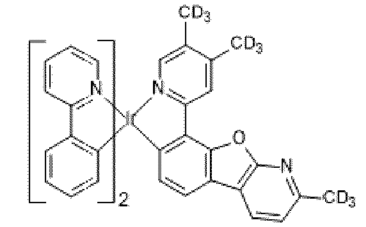 | 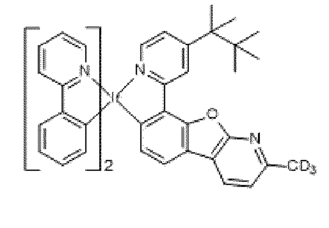 |
| 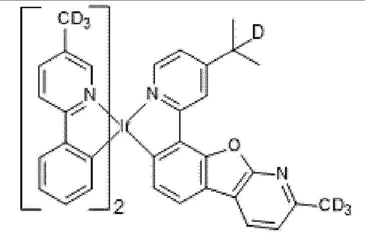 | 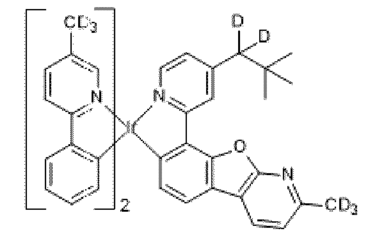 | 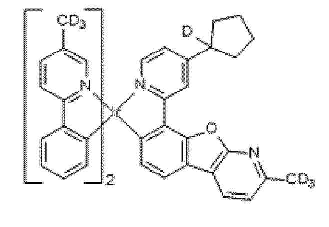 |
| 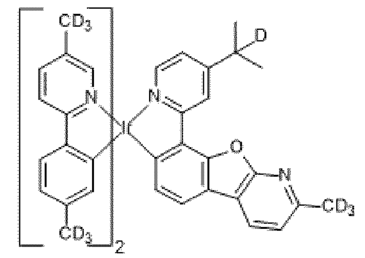 | 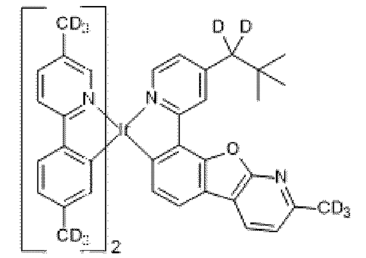 | 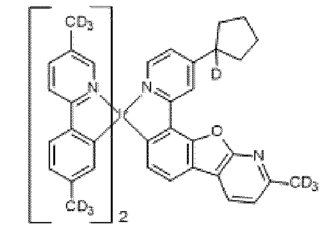 |
| 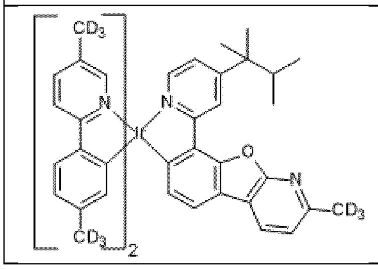 | 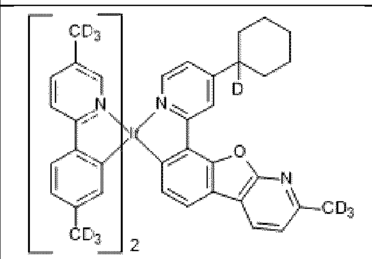 | 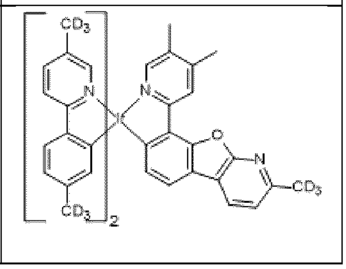 |

| | | |
|---|---|---|
| 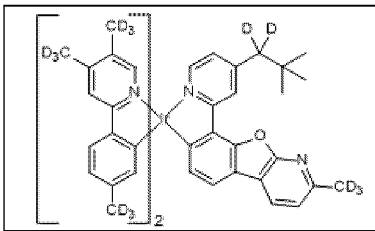 | 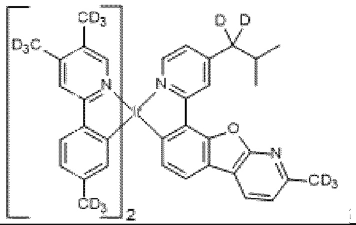 | 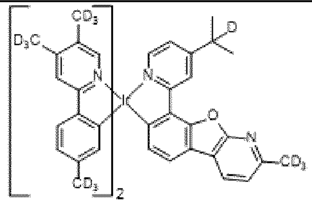 |
| 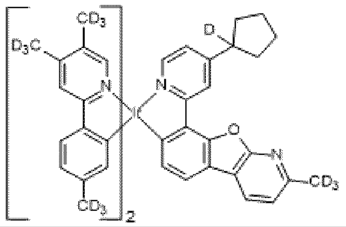 | 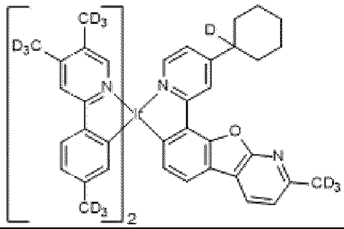 | 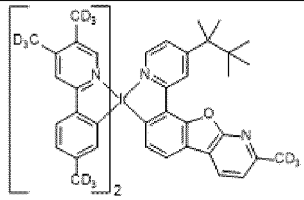 |
| 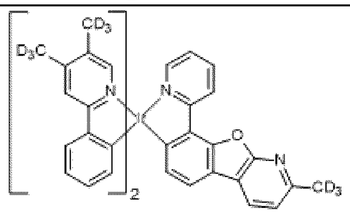 | 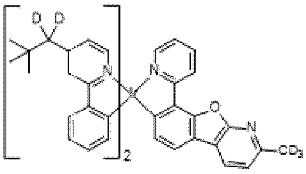 | |

9. Verfahren zur Herstellung einer Vorrichtung nach einem oder mehreren der Ansprüche 1 bis 8, **dadurch gekennzeichnet, dass** die lichtemittierende Schicht durch Gasphasenabscheidung oder aus Lösung aufgebracht wird.

10. Verfahren nach Anspruch 9, **dadurch gekennzeichnet, dass** die mindestens eine Verbindung der Formel (1) und die mindestens eine Verbindung der Formel (2a), nacheinander oder gleichzeitig aus mindestens zwei Materialquellen, mit dem mindestens einen phosphoreszierenden Emitter, aus der Gasphase abgeschieden werden und die lichtemittierende Schicht bilden.

11. Verfahren nach Anspruch 9, **dadurch gekennzeichnet, dass** die mindestens eine Verbindung der Formel (1) und die mindestens eine Verbindung der Formel (2a) als Mischung, nacheinander oder gleichzeitig mit dem mindestens einen phosphoreszierenden Emitter, aus der Gasphase abgeschieden werden und die lichtemittierende Schicht bilden.

12. Verfahren nach Anspruch 9, **dadurch gekennzeichnet, dass** die mindestens eine Verbindung der Formel (1) und die mindestens eine Verbindung der Formel (2a) zusammen mit dem mindestens einen phosphoreszierenden Emitter, aus einer Lösung aufgebracht werden, um die lichtemittierende Schicht zu bilden.

13. Mischung, ausgewählt aus,
der Kombination der Verbindungen 1 bis 11 und 29 bis 44 mit den Verbindungen 12 bis 17, 23 und 24,

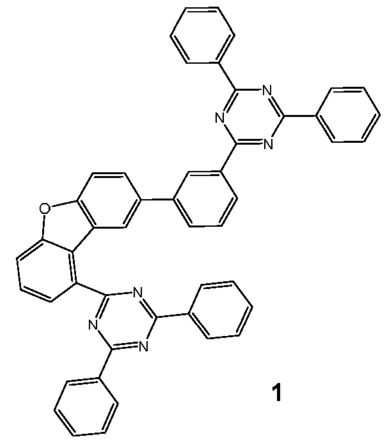

1

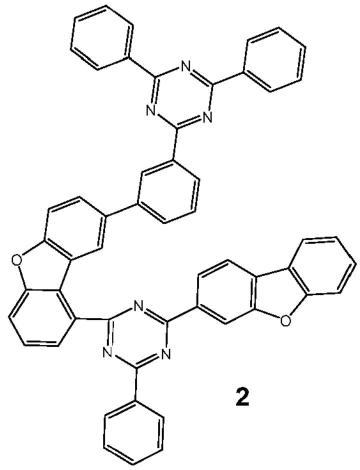

2

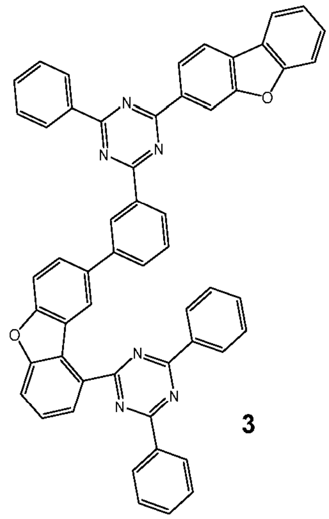

3

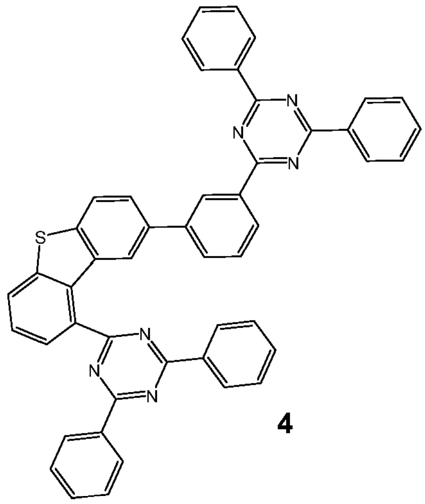

4

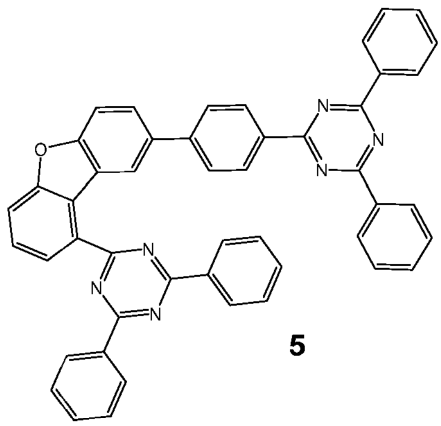

5

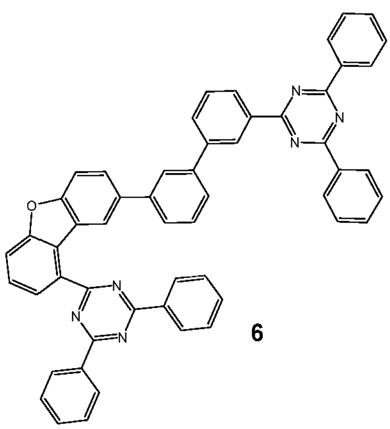

6

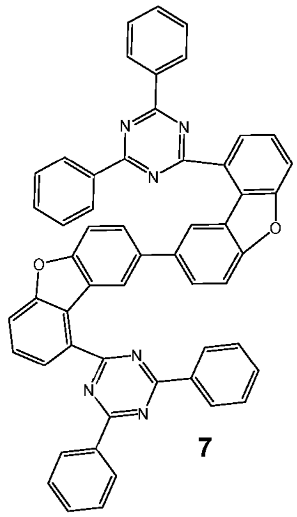

7

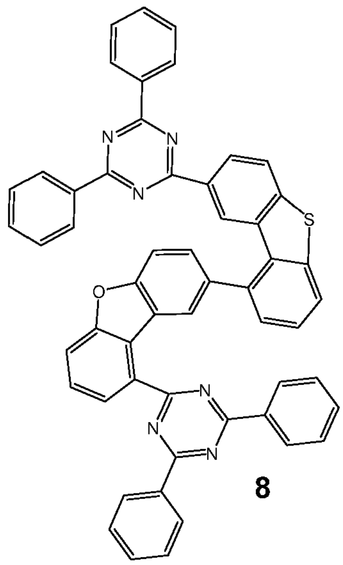

8

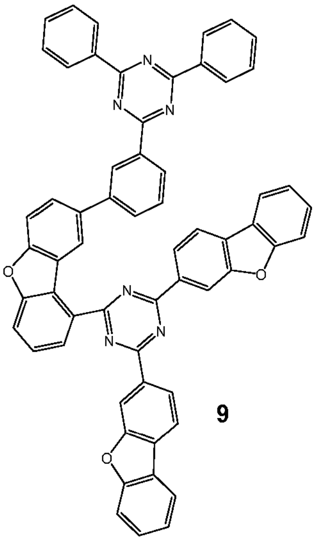

9

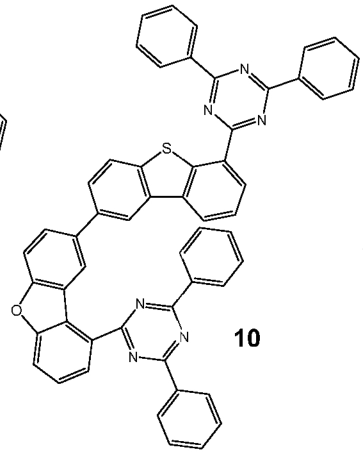

10

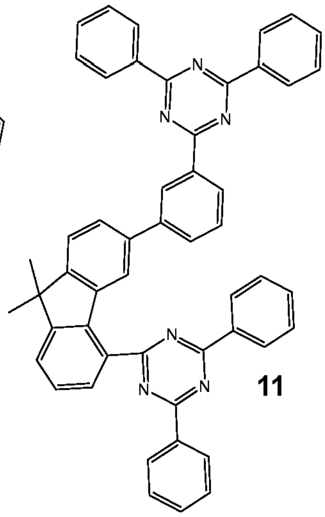

11

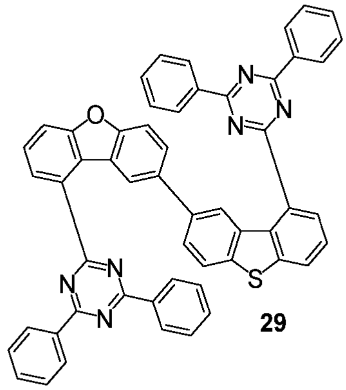

29

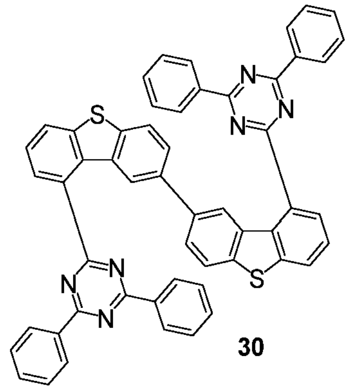

30

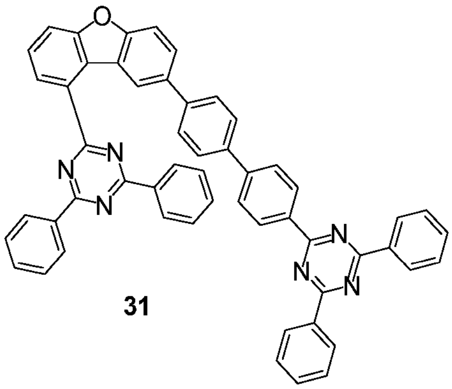

31

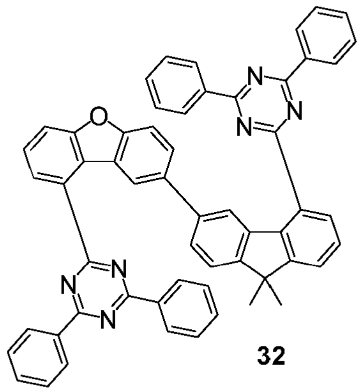

32

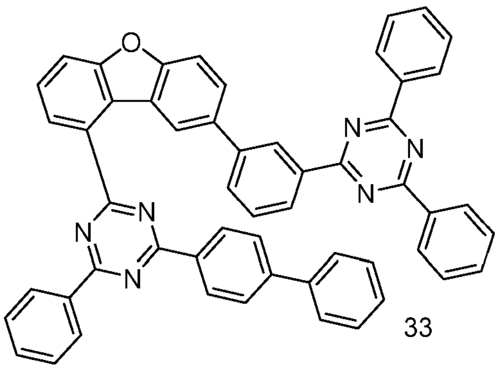

33

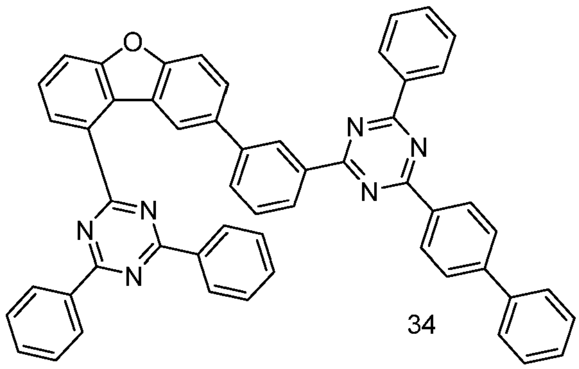

34

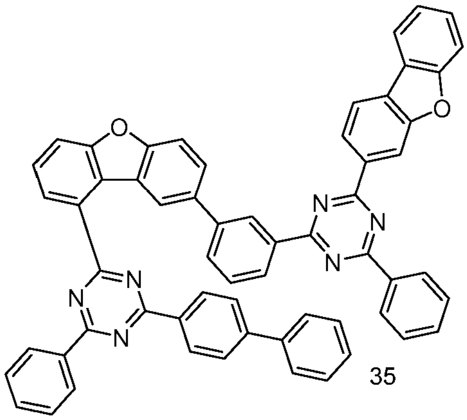

35

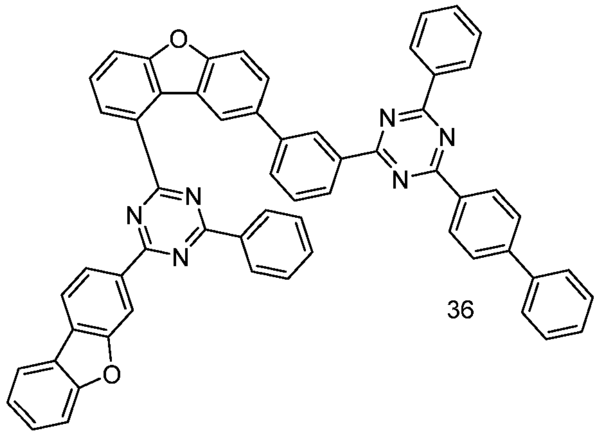

36

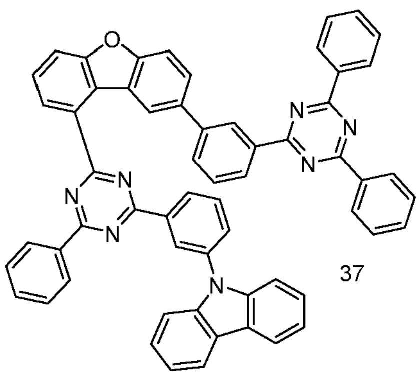

37

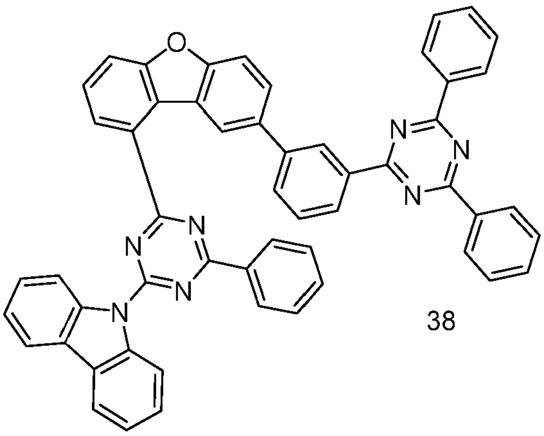

38

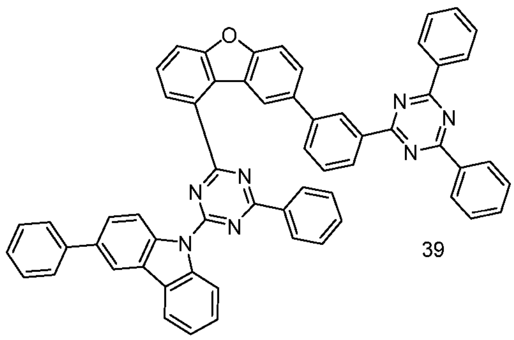

39

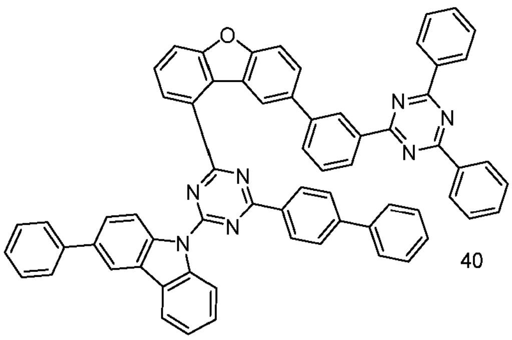

40

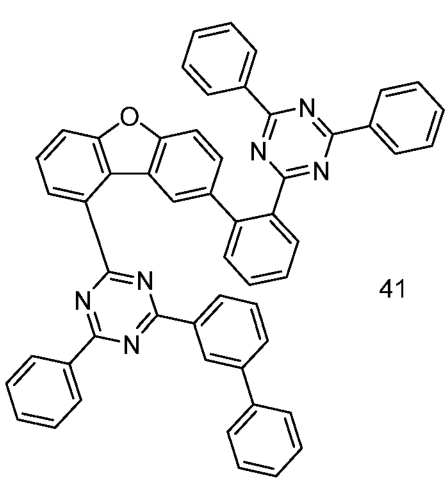

41

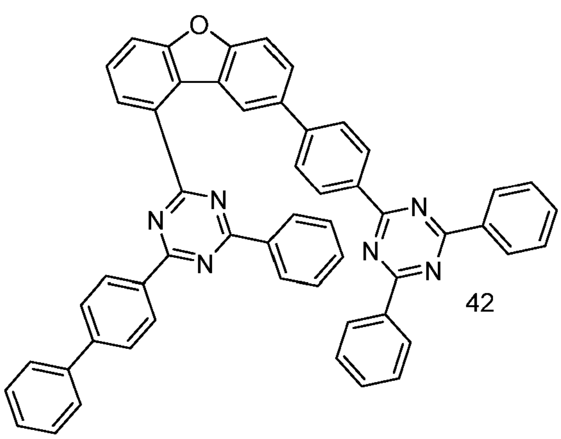

42

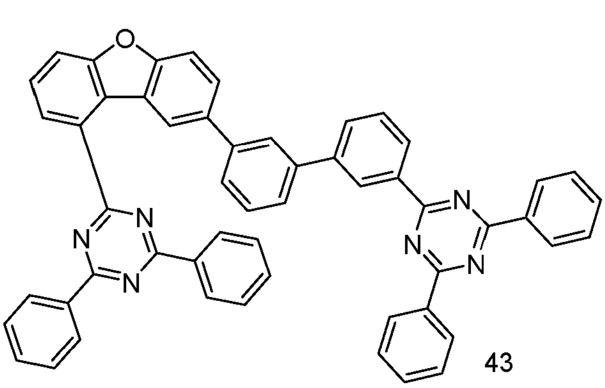

43

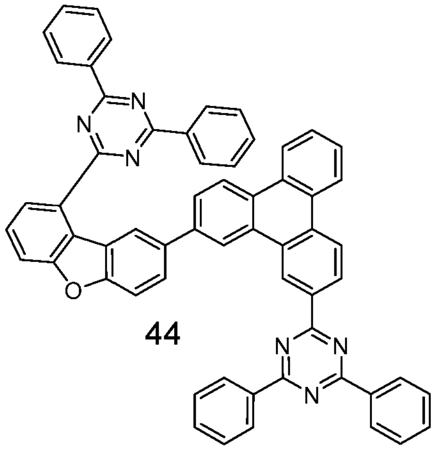

44

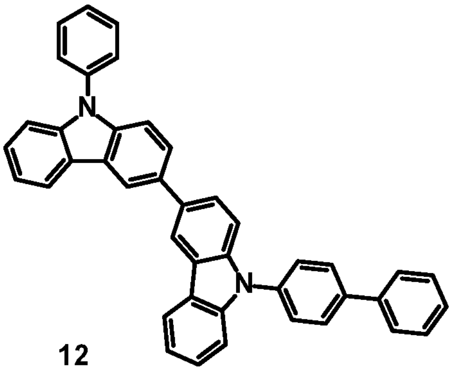

12

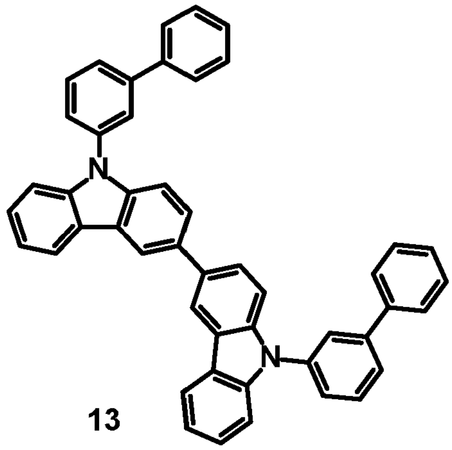

13

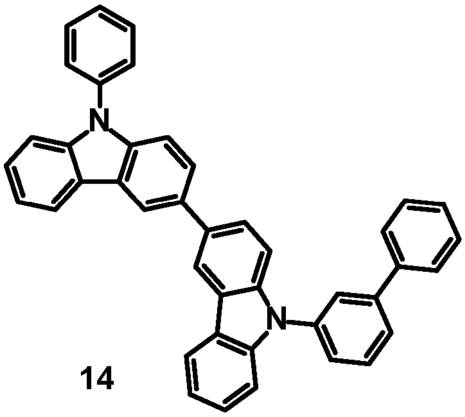

14

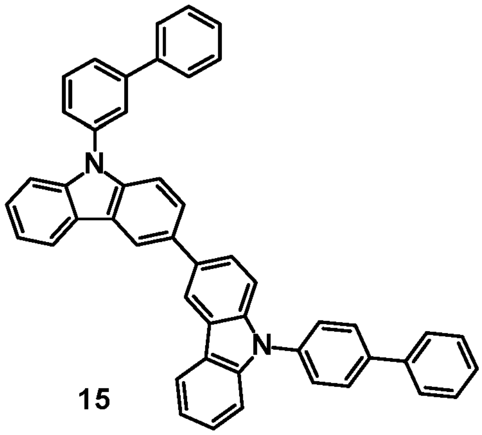

15

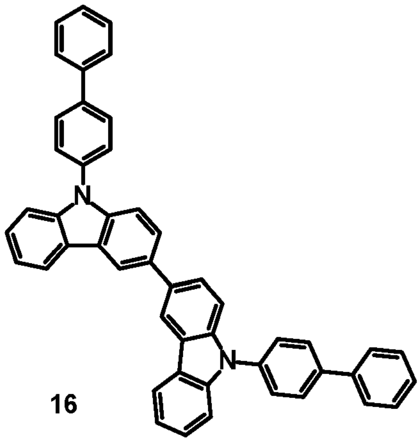

16

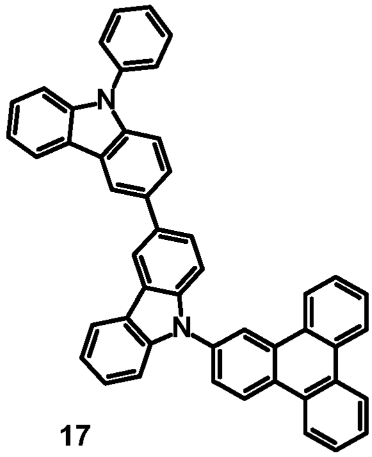

17

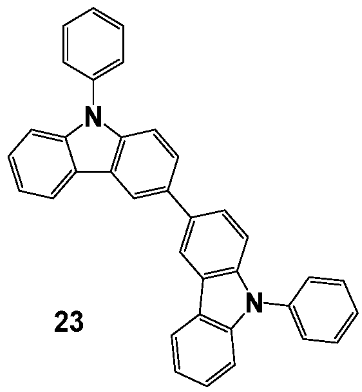

23

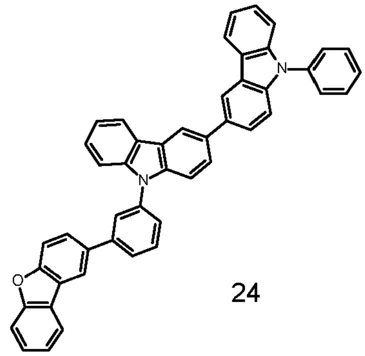

24

und einer Verbindung der Formel (3),

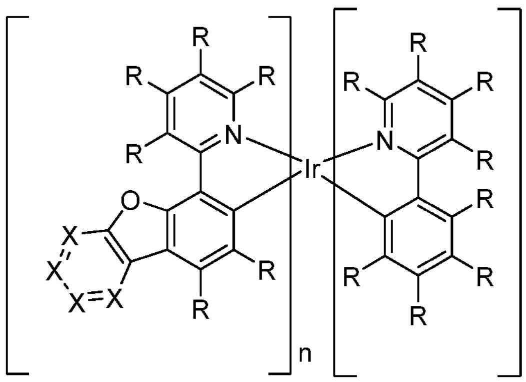

Formel (3)

,

wobei die Symbole und Indizes für diese Formel (3) die Bedeutung haben:

n+m ist 3, n ist 1 oder 2, m ist 2 oder 1,
X ist N oder CR,
R ist H, D oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 7 C-Atomen, die teilweise oder vollständig mit Deuterium substituiert sein kann.

**14.** Formulierung enthaltend eine Mischung nach Anspruch 13 sowie mindestens ein Lösemittel.

## Claims

1. Organic electroluminescent device comprising an anode, a cathode and at least one organic layer, comprising at least one light-emitting layer, where the at least one light-emitting layer comprises at least one compound of the formula (1) as host material 1 and at least one compound of the formula (2a) as host material 2,

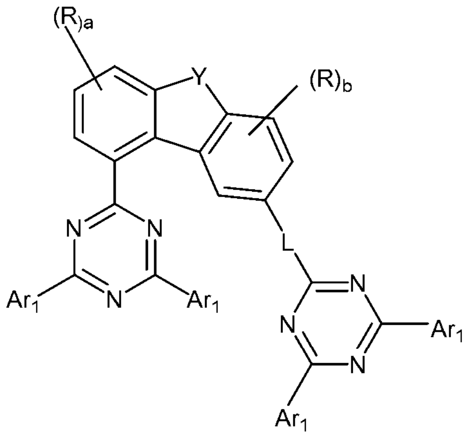

formula (1)

,

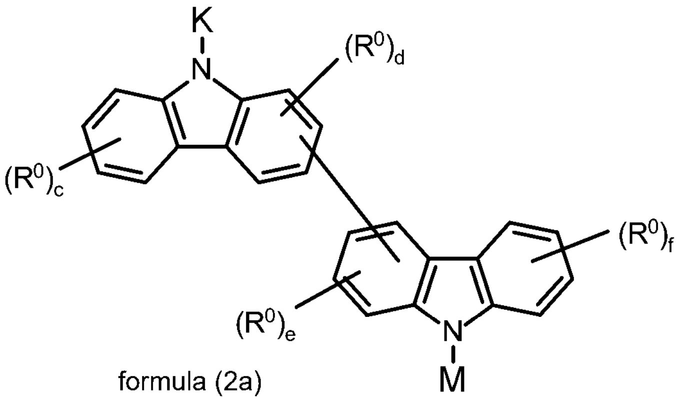

formula (2a)

,

where the following applies to the symbols and indices used:

Y is selected from O, S, $C(CH_3)_2$, $C(phenyl)_2$ or where * marks the C atom that is bonded to the

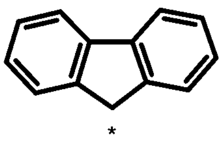

,

remainder of the formula (1);
L is selected from one of the divalent linkers L-1 to L-26,

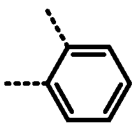

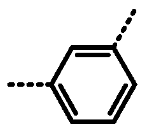

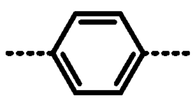

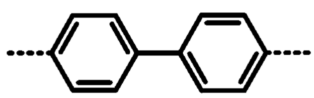

L-1 L-2 L-3 L-4

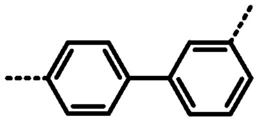
L-5

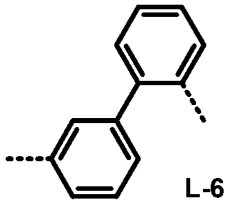
L-6

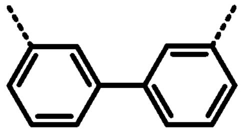
L-7

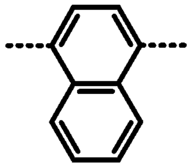
L-8

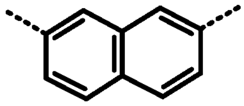
L-9

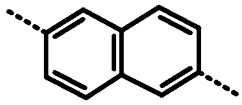
L-10

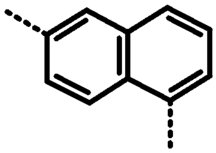
L-11

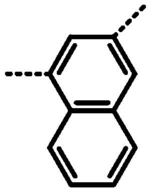
L-12

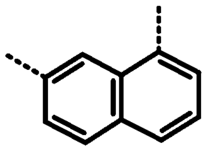
L-13

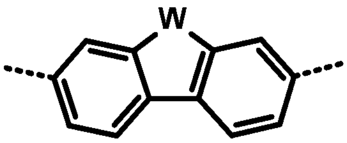
L-14

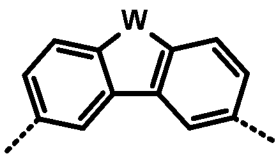
L-15

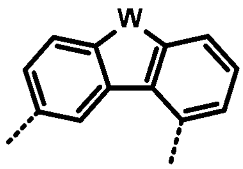
L-16

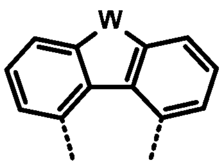
L-17

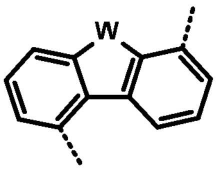
L-18

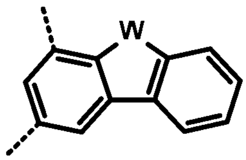
L-19

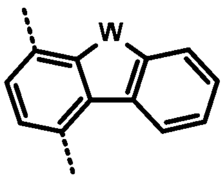
L-20

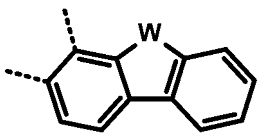
L-21

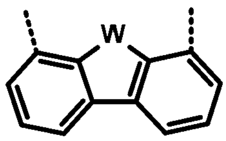
L-22

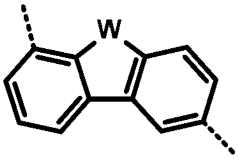
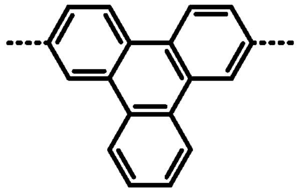
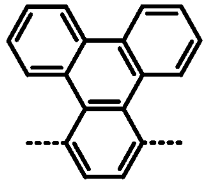

**L-23** **L-24** **L-25**

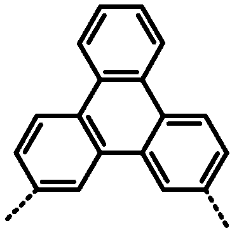

**L-26** ,

where the linkers L-1 to L-26 may also be substituted by one or more substituents R; is O, S or $C(CH_3)_2$;
W a is 0 or 1;
b is 0 or 1;
R is selected on each occurrence, identically or differently, from the group consisting of CN, a straight-chain alkyl, alkoxy or thioalkyl group having 1 to 20 C atoms or a branched or cyclic alkyl, alkoxy or thioalkyl group having 3 to 20 C atoms, an aromatic or heteroaromatic ring system having 5 to 40 aromatic ring atoms, an aryloxy or heteroaryloxy group having 5 to 40 aromatic ring atoms, or an aralkyl or heteroaralkyl group having 5 to 40 aromatic ring atoms;
$Ar_1$ is on each occurrence, in each case independently of one another, an aryl or heteroaryl group having 5 to 40 aromatic ring atoms, which may be substituted by one or more radicals R;
K and M in each case, independently of one another, denote an aromatic ring system having 6 to 40 aromatic ring atoms which is unsubstituted or partially or fully deuterated or monosubstituted by R*;
$R^0$ is on each occurrence, independently of one another, an unsubstituted or partially or fully deuterated aromatic ring system having 6 to 18 C atoms;
R* is dibenzofuranyl or dibenzothiophenyl;
c, d, e and f are, independently of one another, 0 or 1

and where the light-emitting layer, besides the at least one host material 1 and the at least one host material 2, comprises at least one phosphorescent emitter of the formula (3),

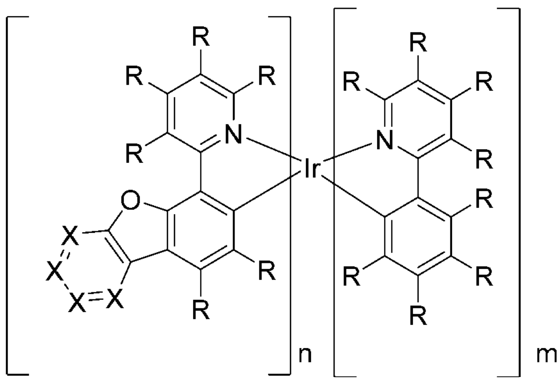

formula (3) ,

where the symbols and indices for this formula (3) have the meaning:

n+m is 3, n is 1 or 2, m is 2 or 1,

X is N or CR,
R is H, D or a branched or linear alkyl group having 1 to 10 C atoms or a partially or fully deuterated branched or linear alkyl group having 1 to 10 C atoms or a cycloalkyl group having 4 to 7 C atoms, which may be partially or fully substituted by deuterium.

2. Organic electroluminescent device according to Claim 1, **characterised in that** Y in host material 1 denotes O.

3. Organic electroluminescent device according to Claim 1 or 2, **characterised in that** host material 2 corresponds to one of the following compounds:

| | | |
|---|---|---|
| 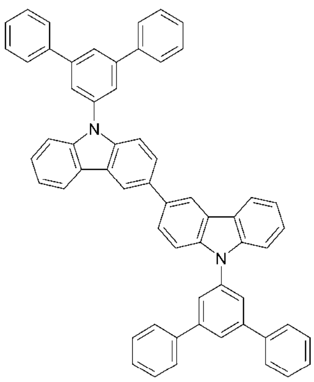 | 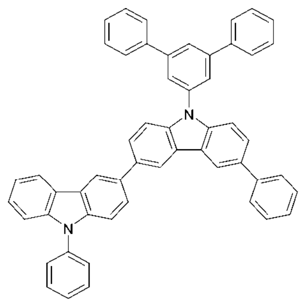 | 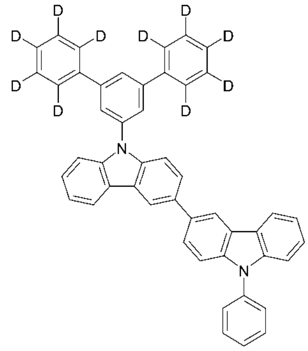 |
| 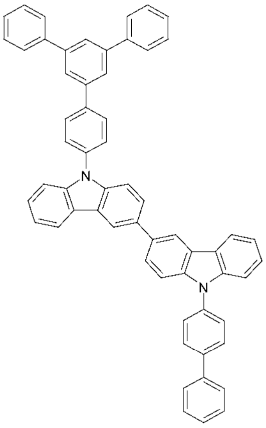 | 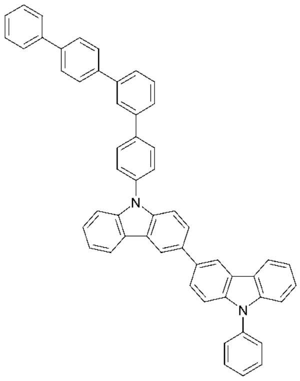 | 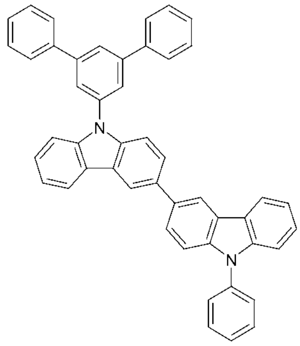 |
| 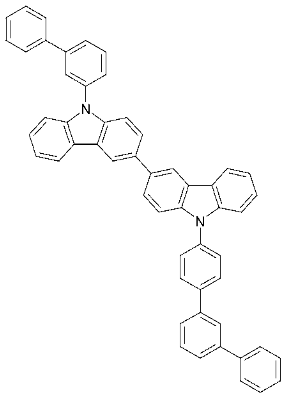 | 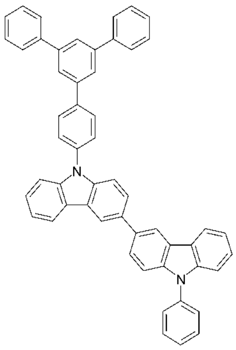 | 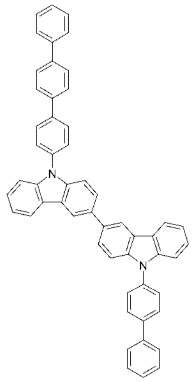 |
| 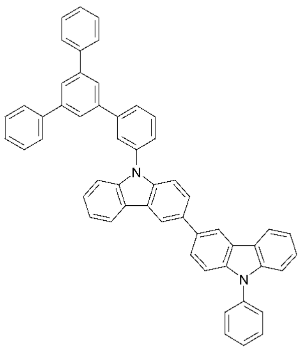 | 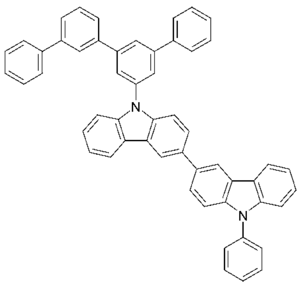 | 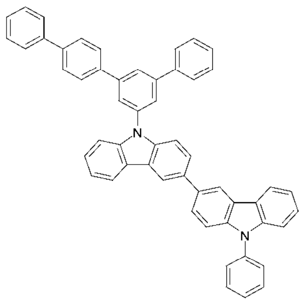 |

| | | |
|---|---|---|
| 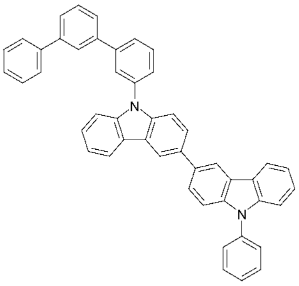 | 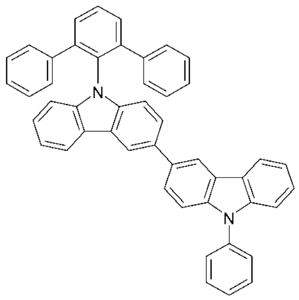 | 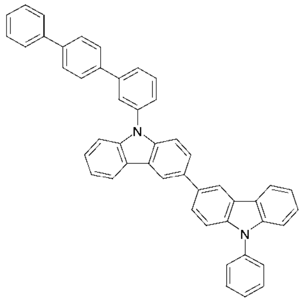 |
| 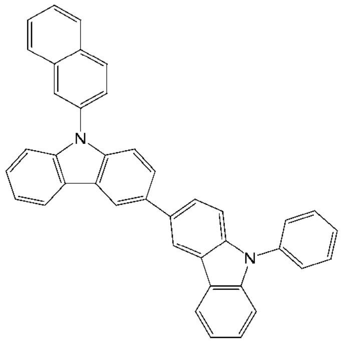 | 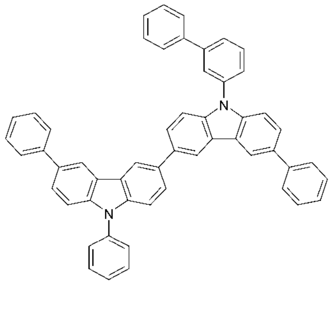 | 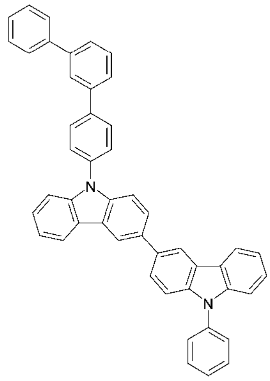 |
| 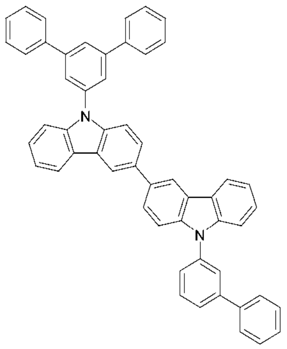 | 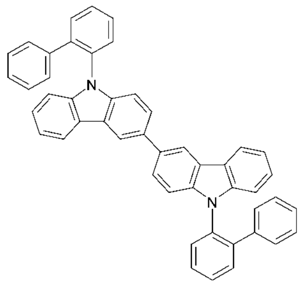 | 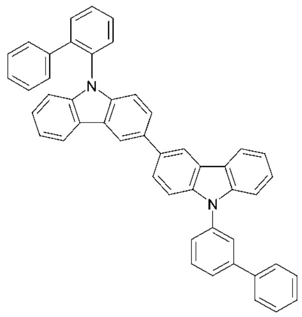 |
| 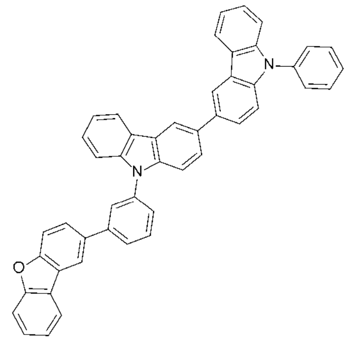 **24** | 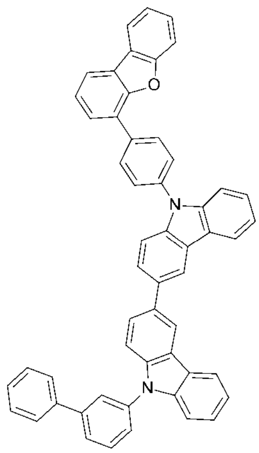 | 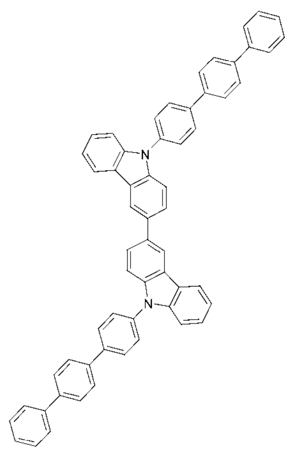 |

| | | |
|---|---|---|
| 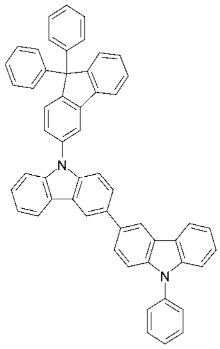 | 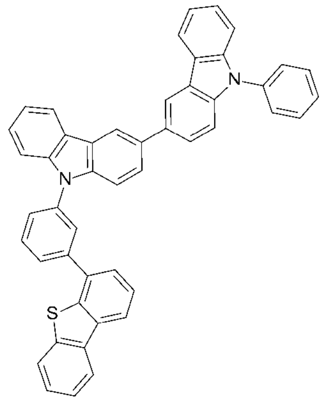 | 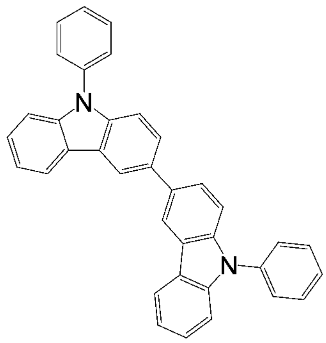 23 |
| | 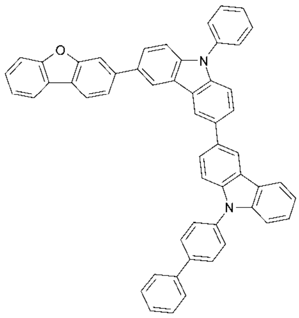 | |
| | 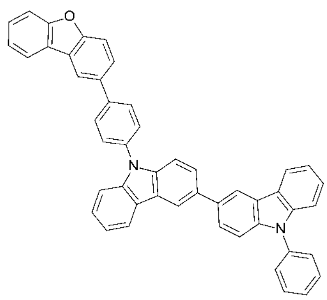 | |
| 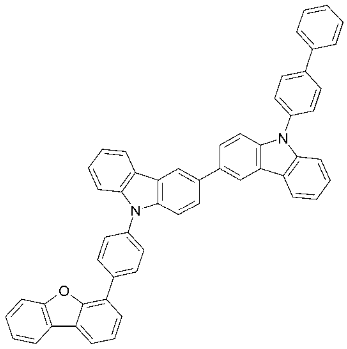 | 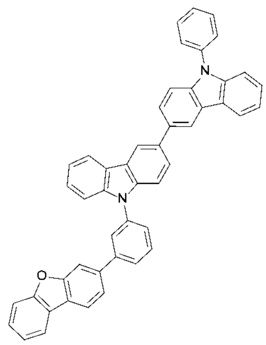 | 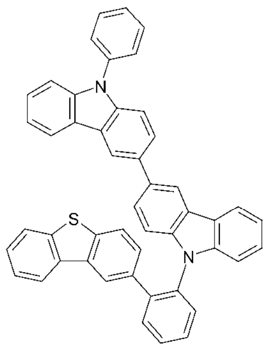 |

| | | |
|---|---|---|
| 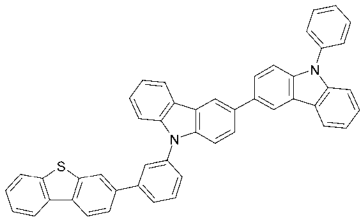 | 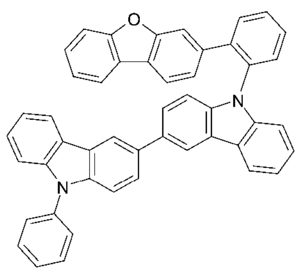 | 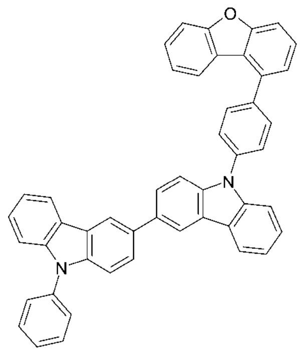 |
| 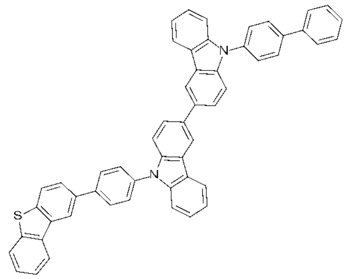 | 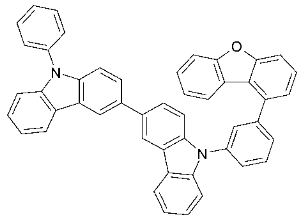 | 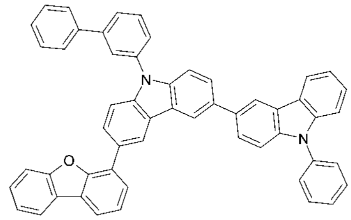 |
| 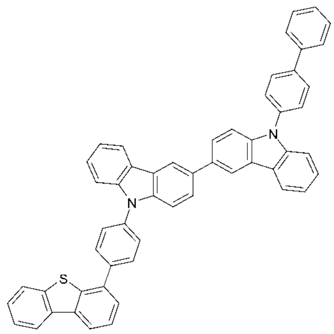 | 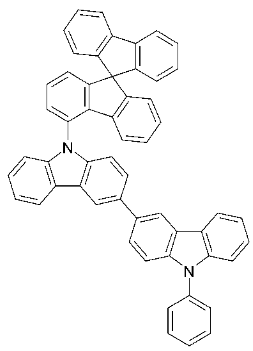 | 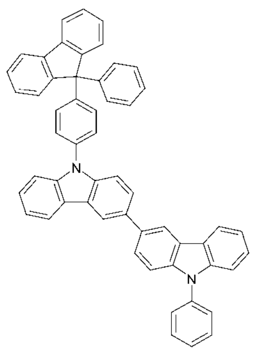 |
| 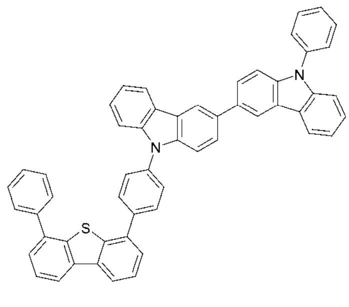 | 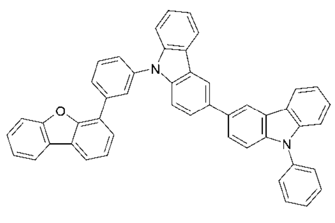 | 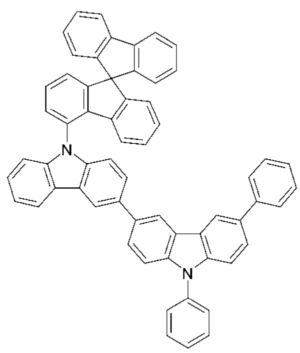 |
| 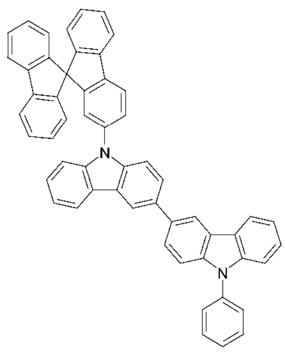 | 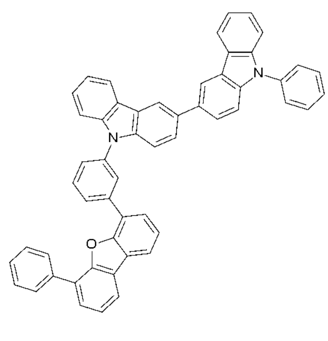 | 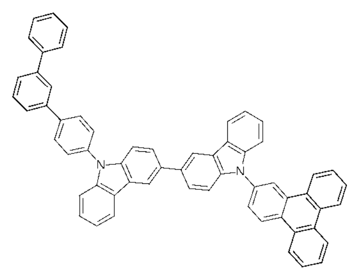 |

| | | |
|---|---|---|
| 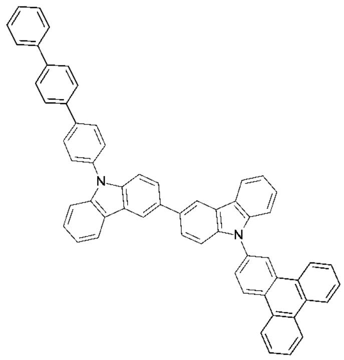 | 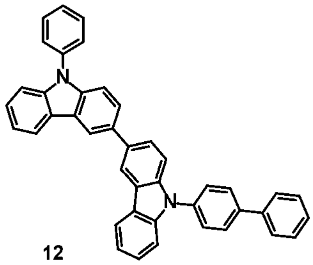 12 | 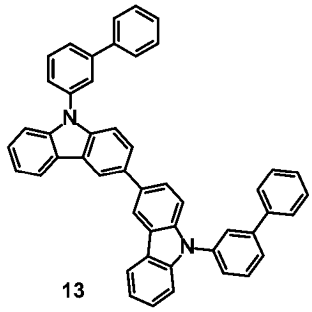 13 |
| 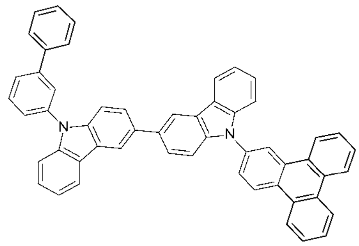 | 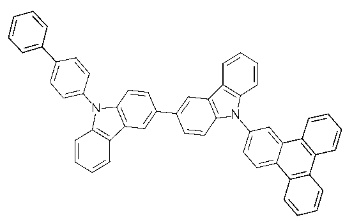 | 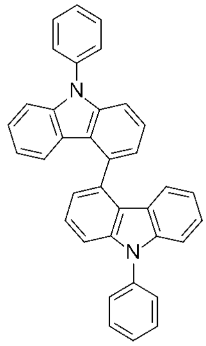 |
| 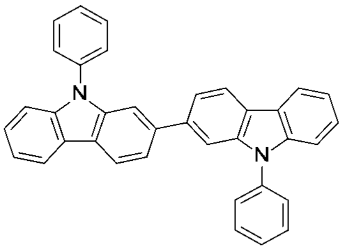 | 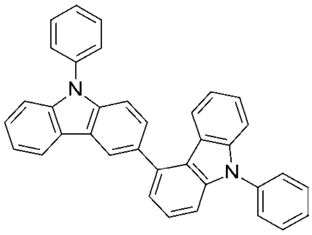 | 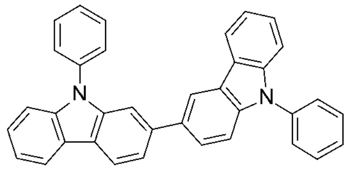 |
| 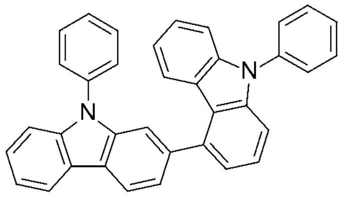 | 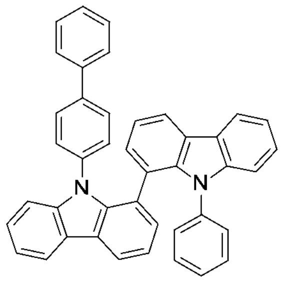 | 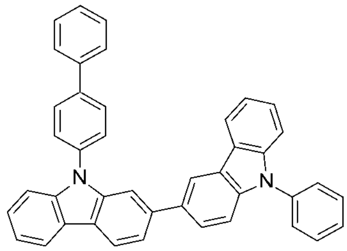 |

| | | |
|---|---|---|
| 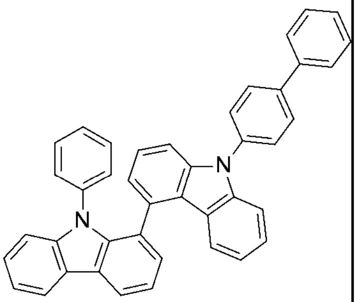 | 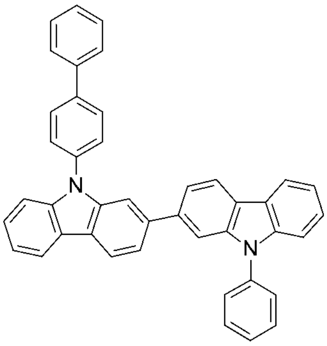 | 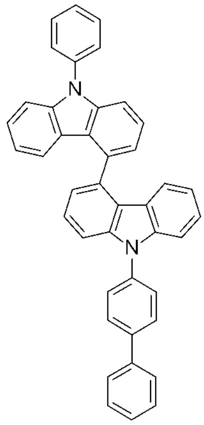 |
| 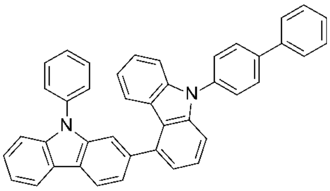 | 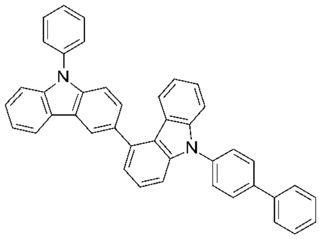 | 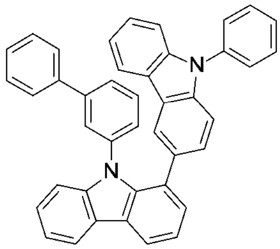 |
| 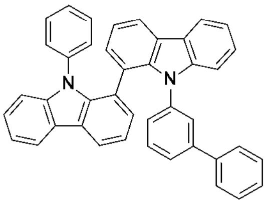 | 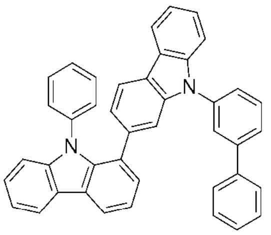 | 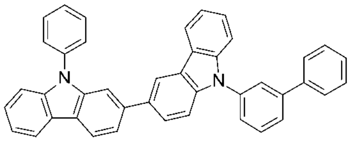 |
| 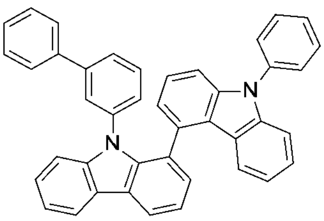 | 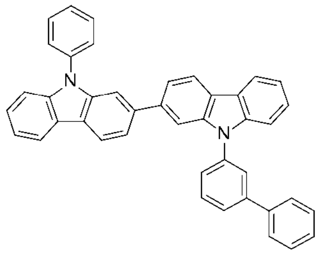 | 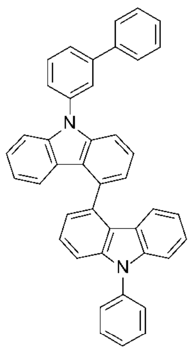 |
| 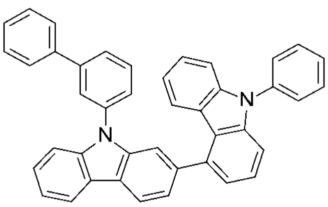 | 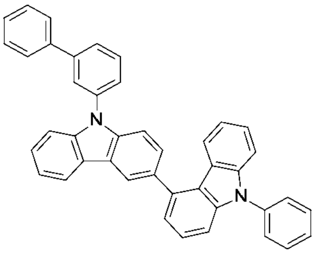 | 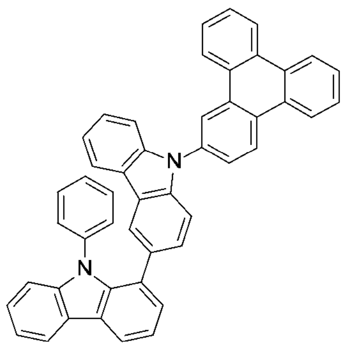 |

| | | |
|---|---|---|
| 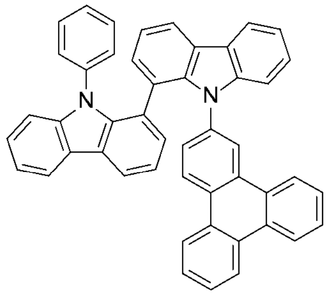 | 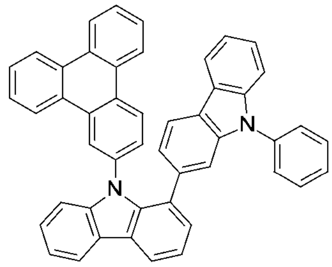 | 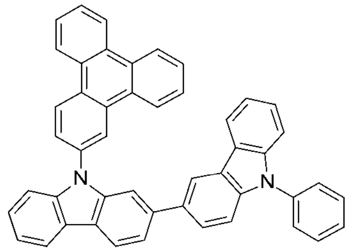 |
| 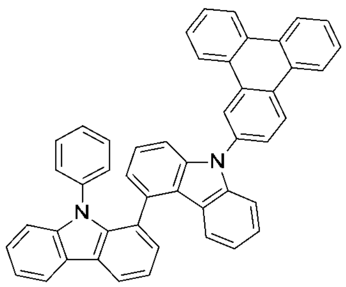 | 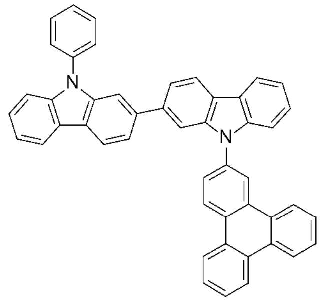 | 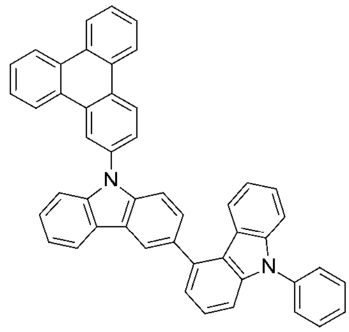 |
| 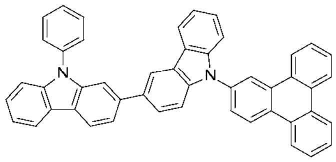 | 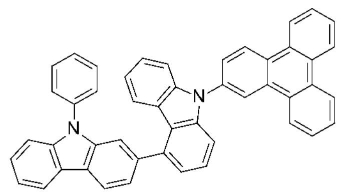 | 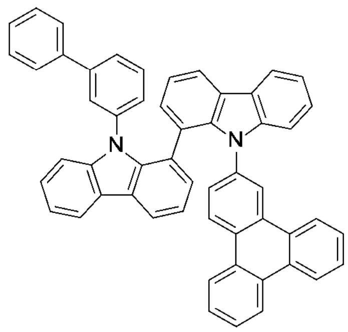 |
| 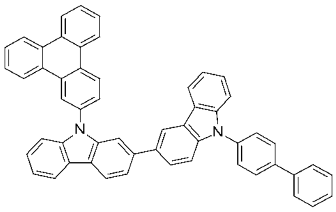 | 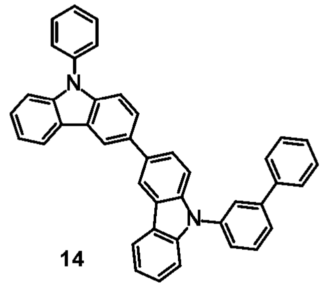 14 | 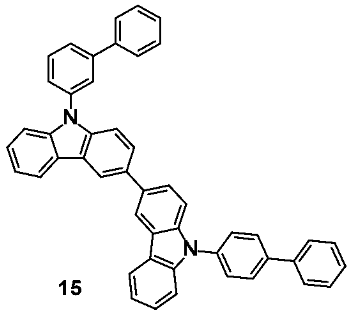 15 |

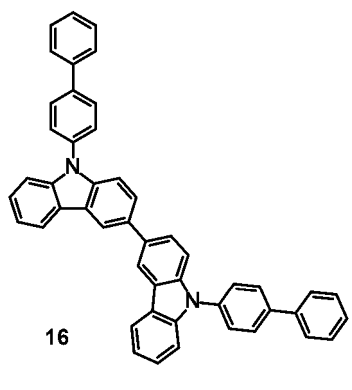

16

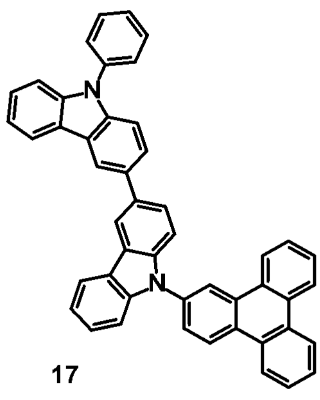

17

.

4. Organic electroluminescent device according to one or more of Claims 1 to 3, **characterised in that** L in host material 1 is selected from the divalent linkers L-1 to L-13 and L-24 to L-26.

5. Organic electroluminescent device according to one or more of Claims 1 to 4, **characterised in that** it is an electroluminescent device selected from organic light-emitting transistors (OLETs), organic field-quench devices (OFQDs), organic light-emitting electrochemical cells (OLECs, LECs, LEECs), organic laser diodes (O-lasers) and organic light-emitting diodes (OLEDs).

6. Organic electroluminescent device according to one or more of Claims 1 5, **characterised in that**, besides the light-emitting layer (EML), it comprises a hole-injection layer (HIL), a hole-transport layer (HTL), an electron-transport layer (ETL), an electron-injection layer (EIL) and/or a hole-blocking layer (HBL).

7. Organic electroluminescent device according to one or more of Claims 1 to 6, **characterised in that** host material 1 conforms to one of the following formulae:

| | | |
|---|---|---|
| 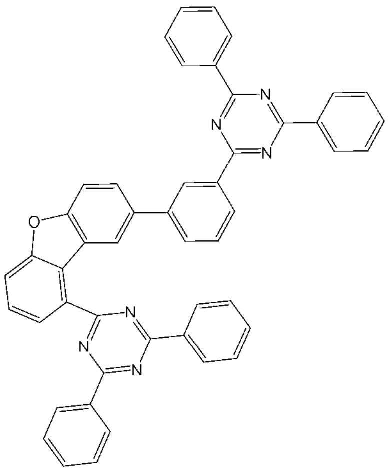 1 | 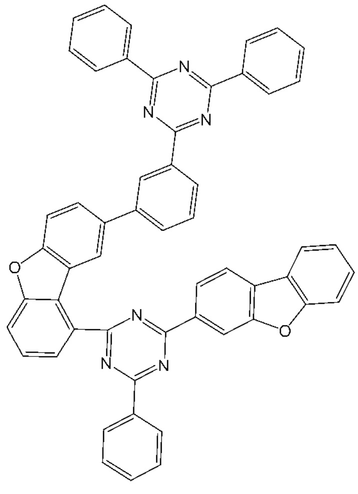 2 | 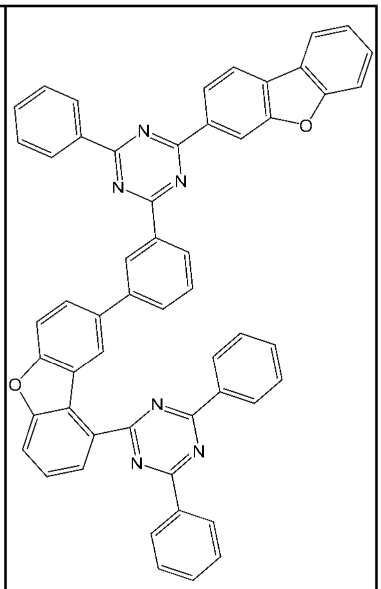 3 |
| 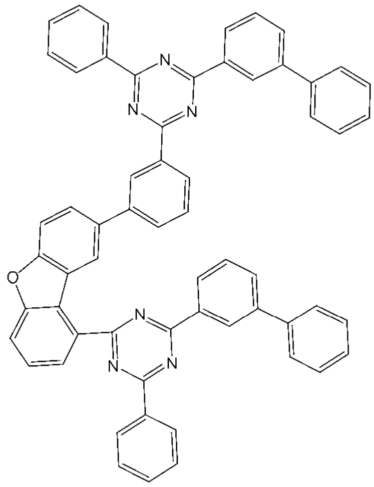 | 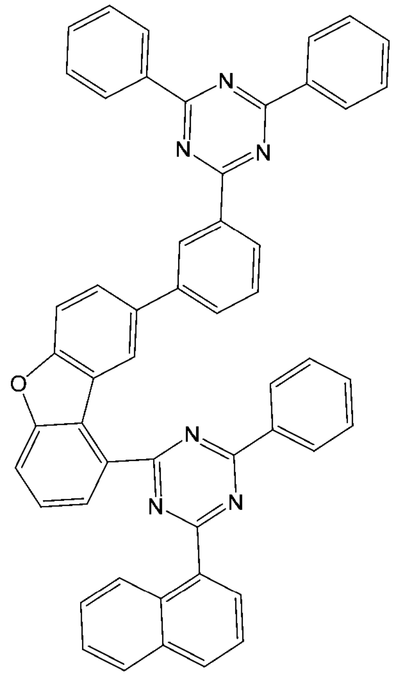 | 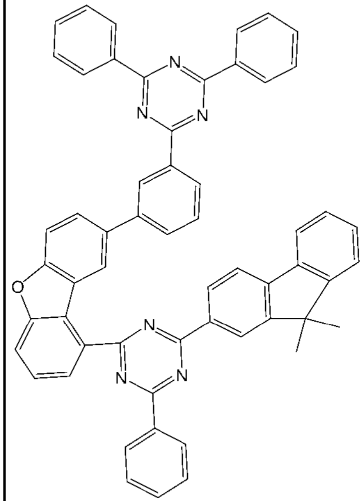 |

| | | |
|---|---|---|
| 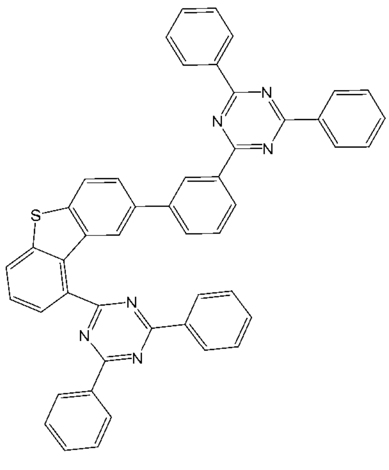<br>4 | 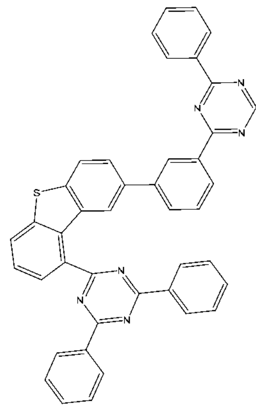 | 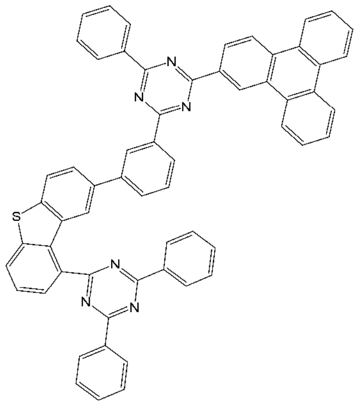 |
| 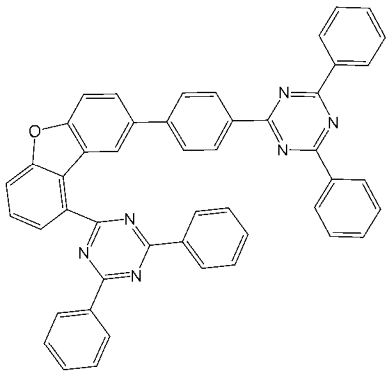<br>5 | 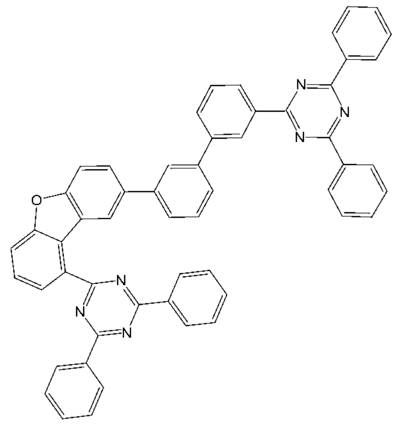<br>6 | 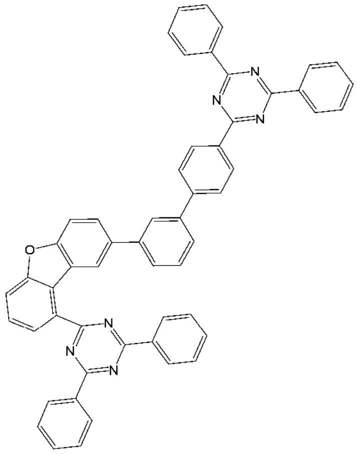 |
| 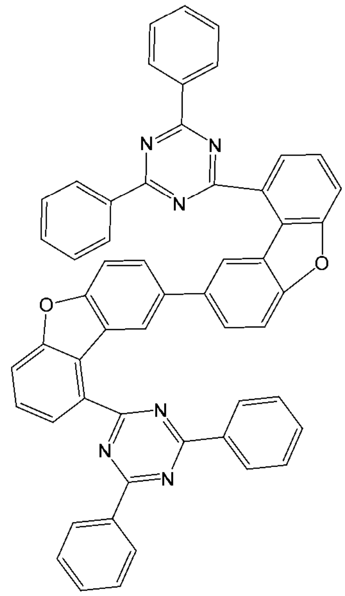<br>7 | 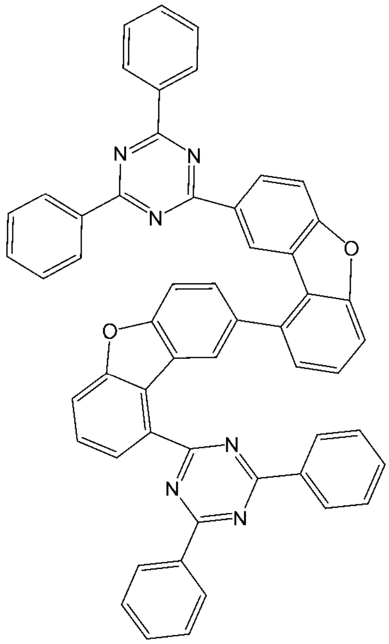 | 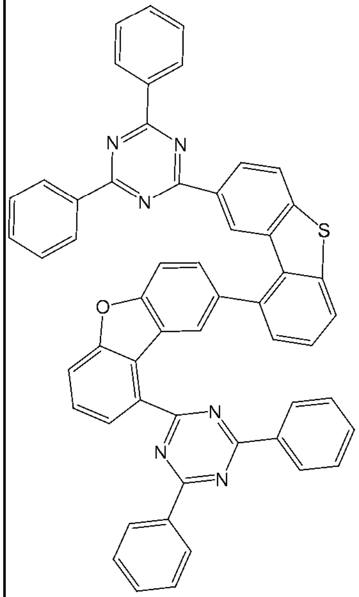<br>8 |

| | | |
|---|---|---|
| 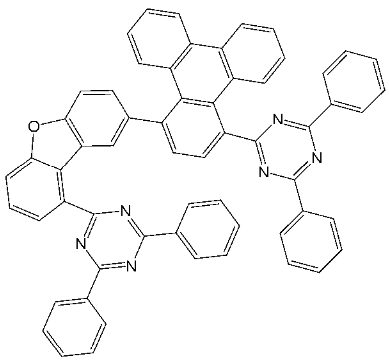 | 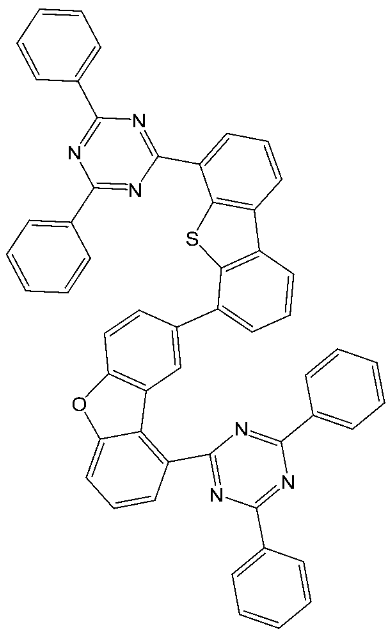 | 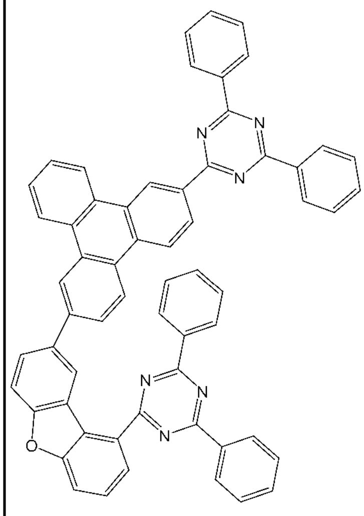 |
| 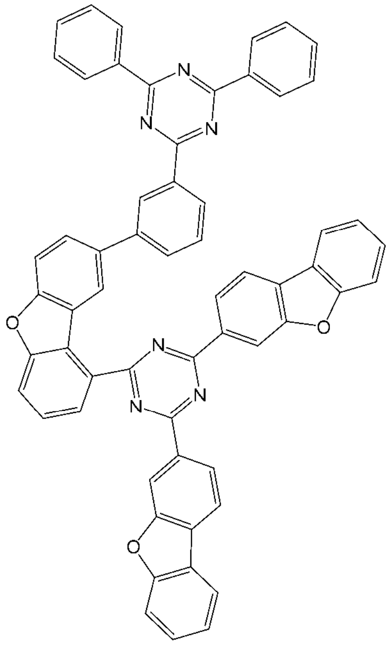<br>9 | 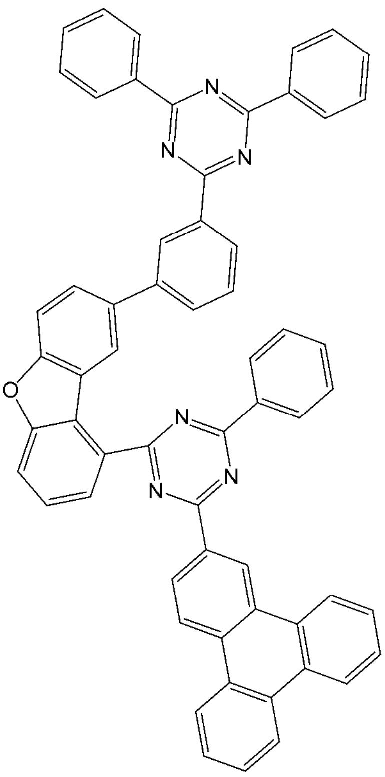 | 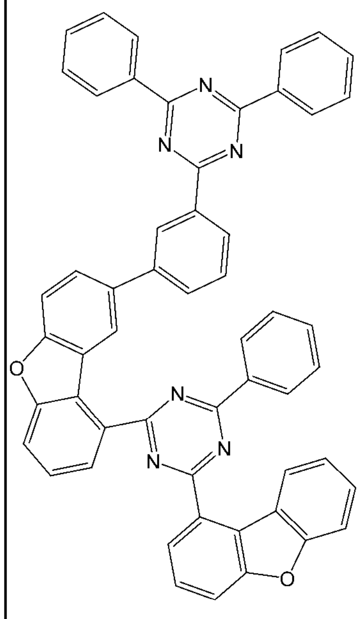 |

| | | |
|---|---|---|
| 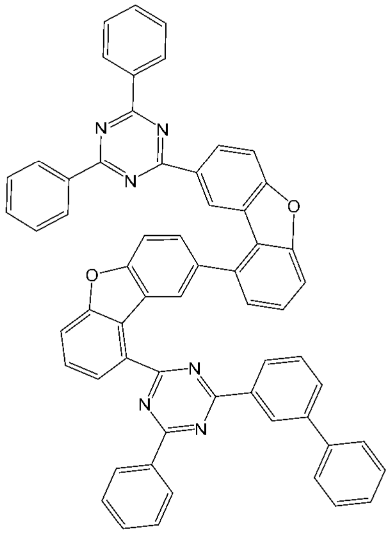 | | |
| | 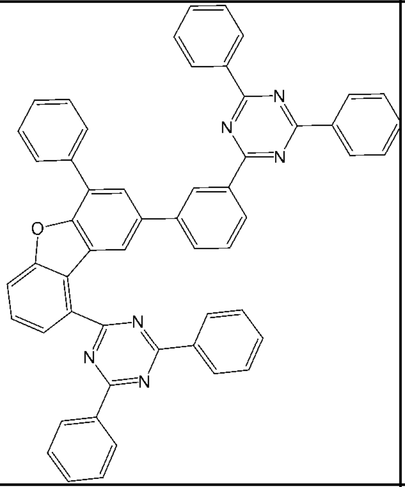 | 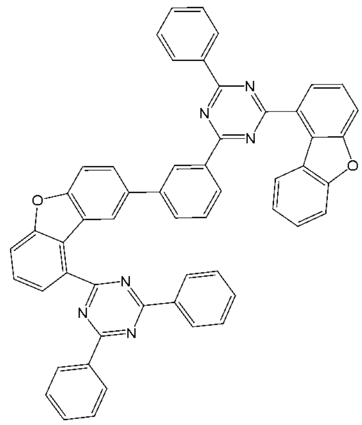 |
| 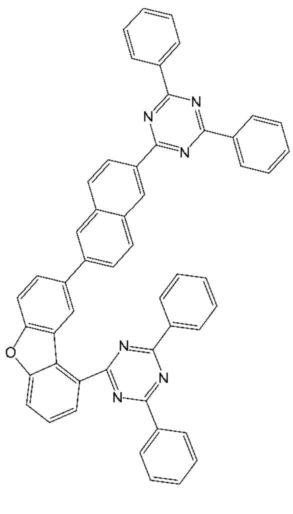 | 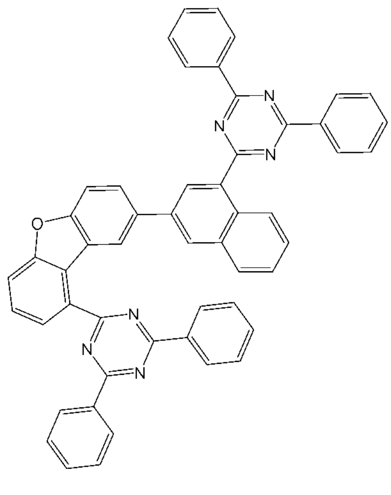 | 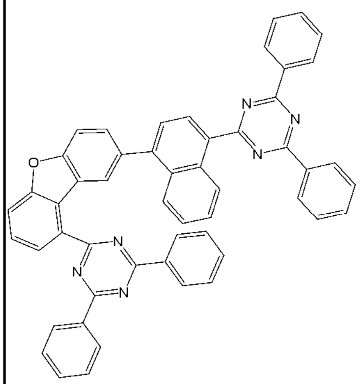 |

| | | |
|---|---|---|
| 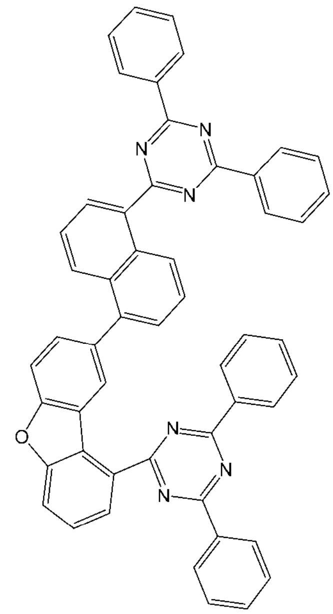 | 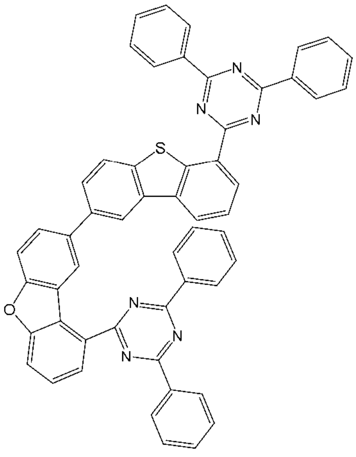 | 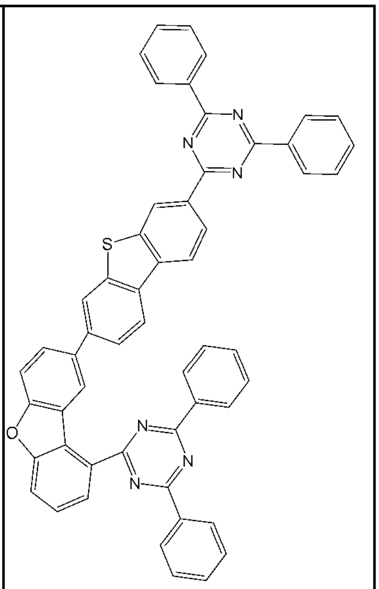 |
| 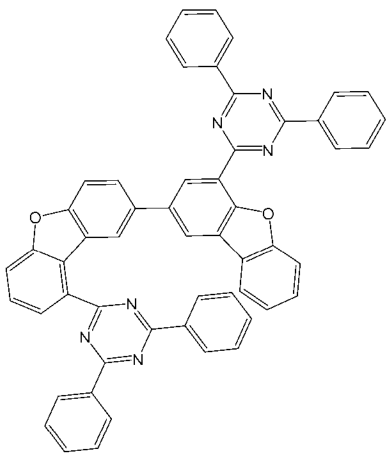 | 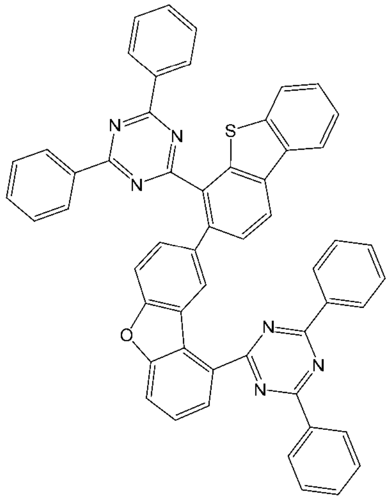 | 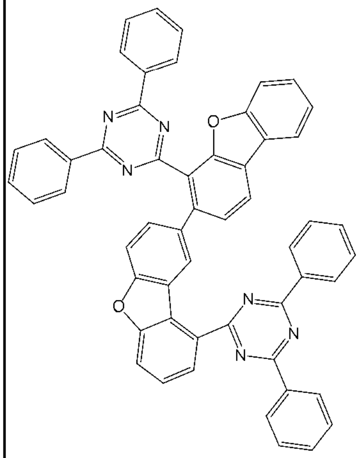 |
| 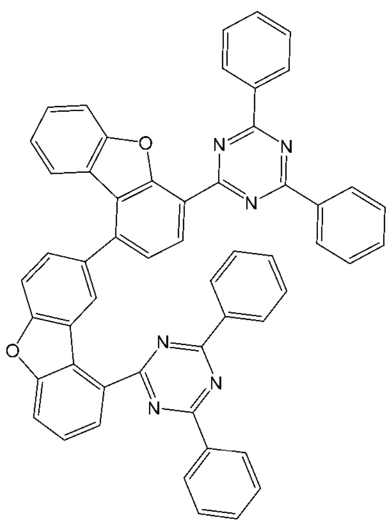 | 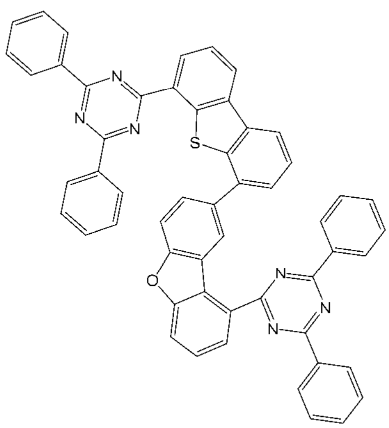 | 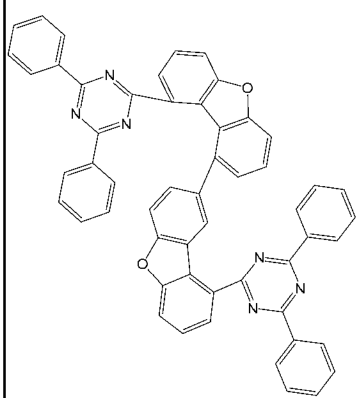 |

| | | |
|---|---|---|
| 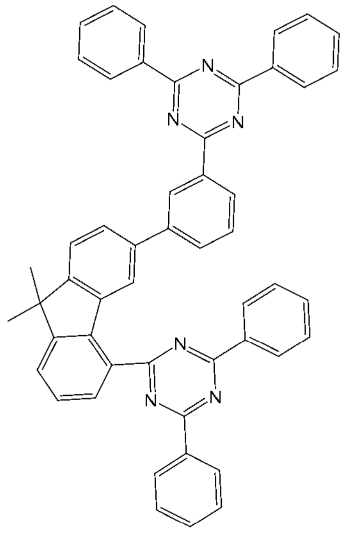<br>10 | 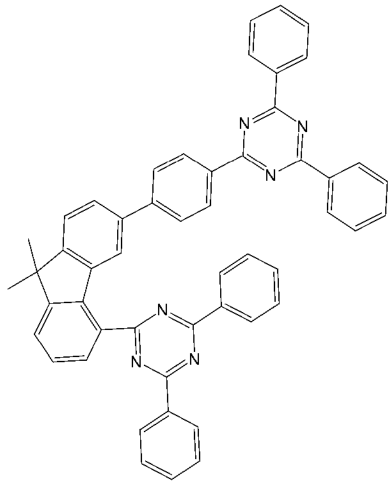 | 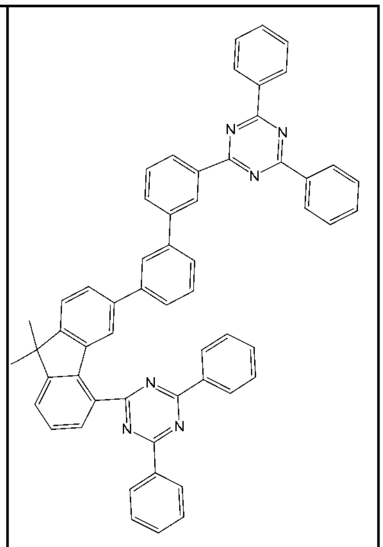 |
| 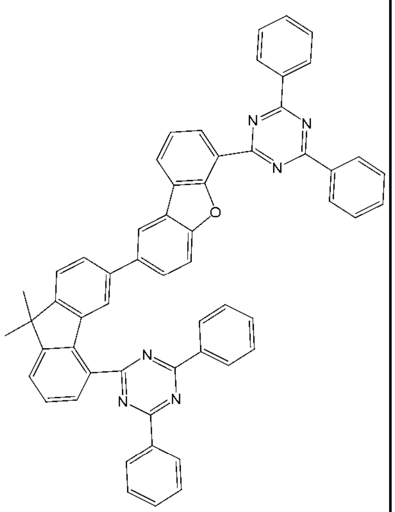 | 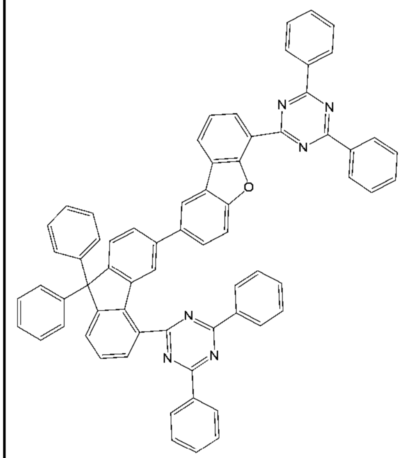 | 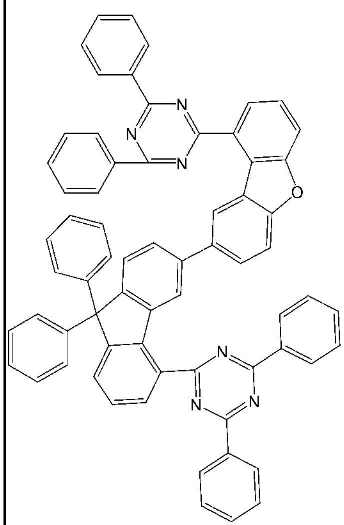 |
| 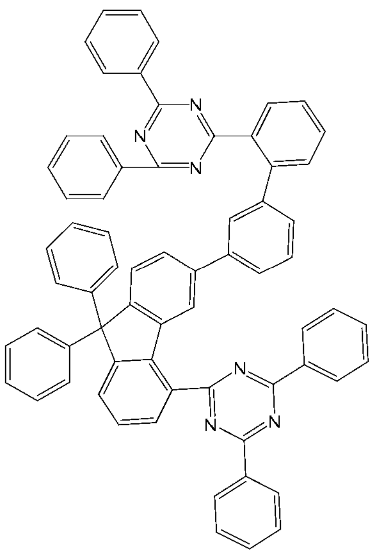 | 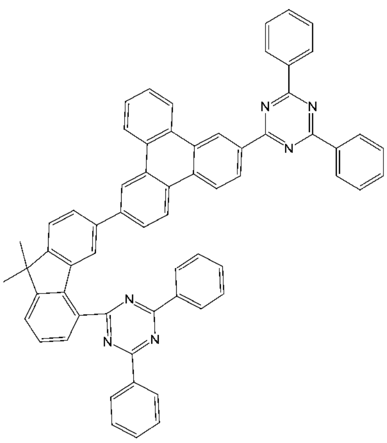 | 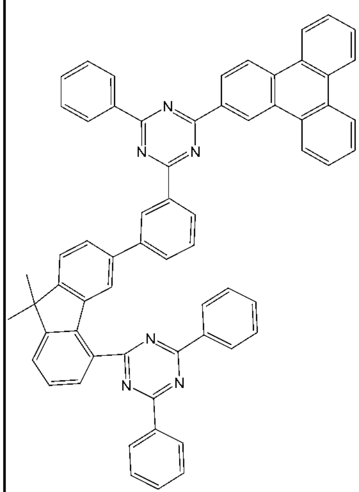 |

| | | |
|---|---|---|
| 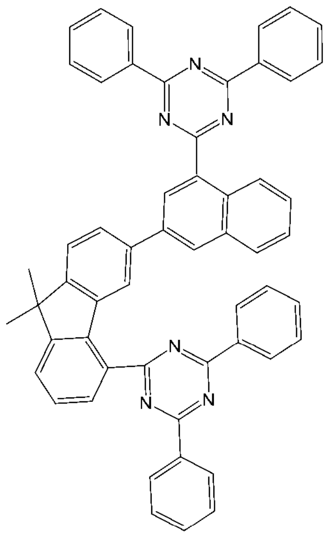 | 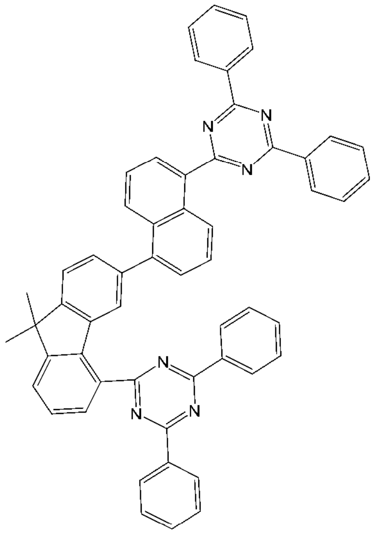 | 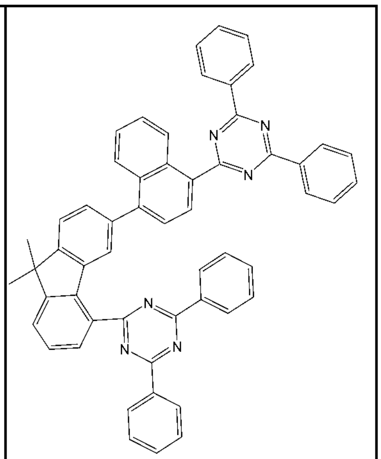 |
| 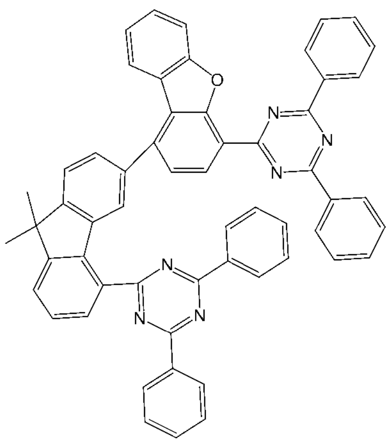 | 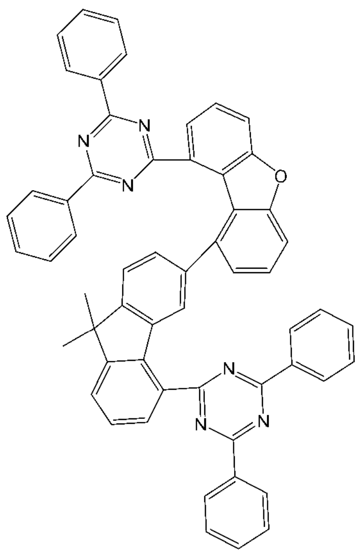 | 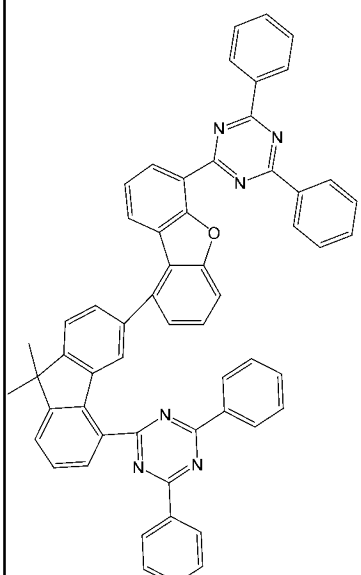 |
| 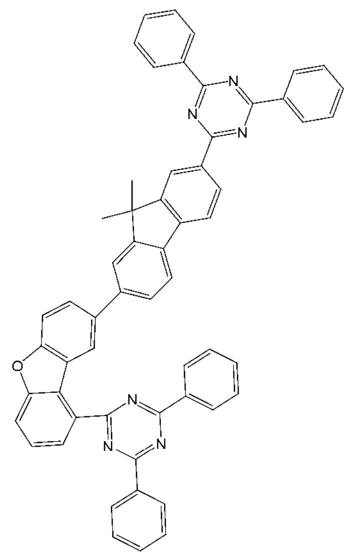 | 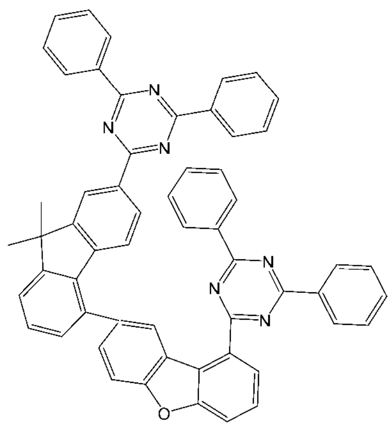 | 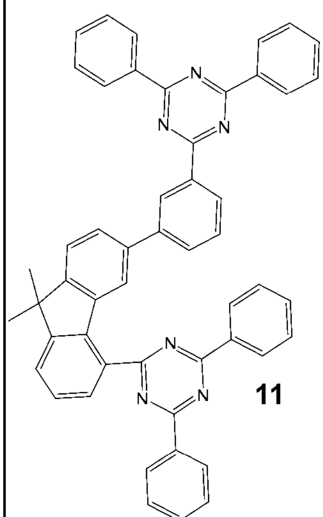 11 |

| | | |
|---|---|---|
| 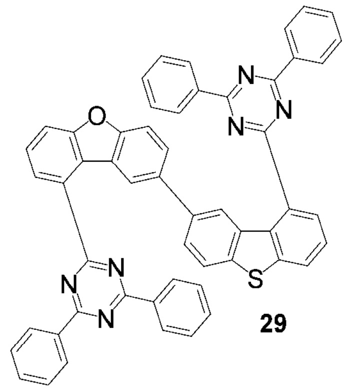 29 | 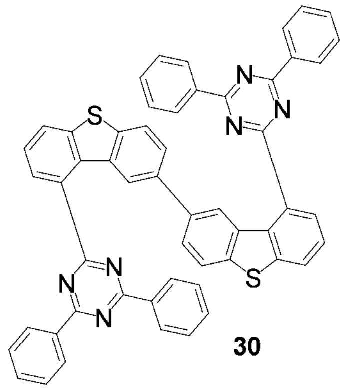 30 | 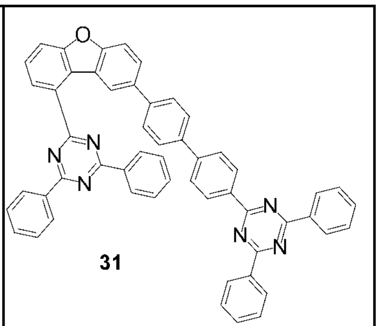 31 |
| 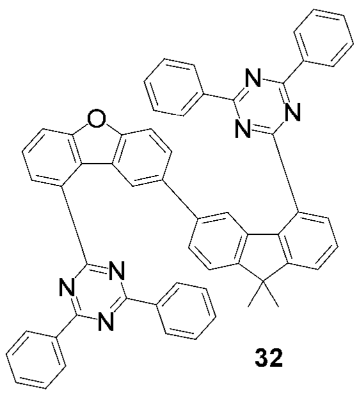 32 | 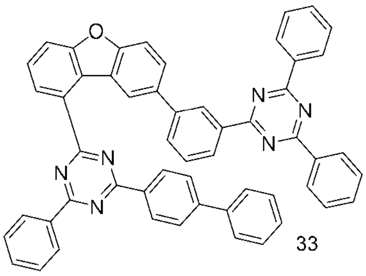 33 | 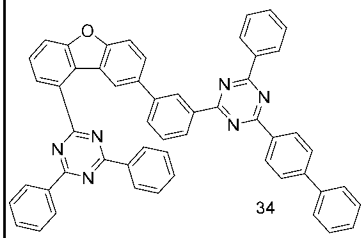 34 |
| 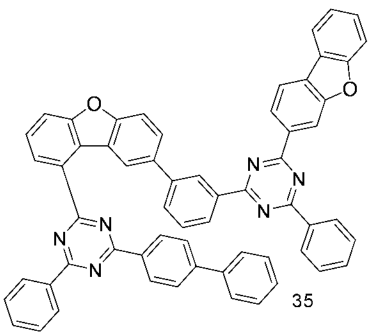 35 | 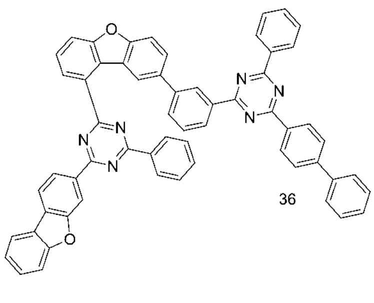 36 | 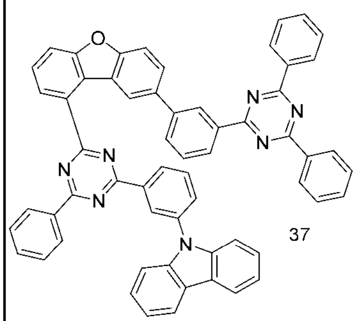 37 |
| 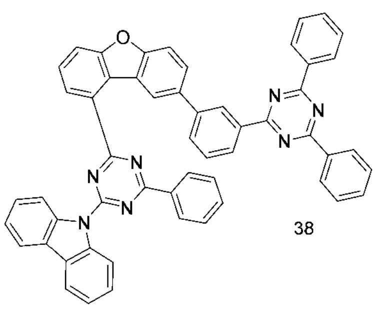 38 | 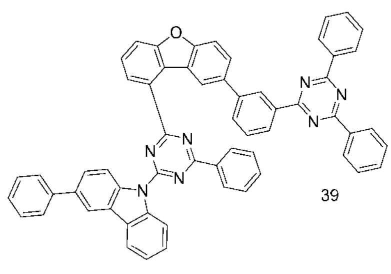 39 | 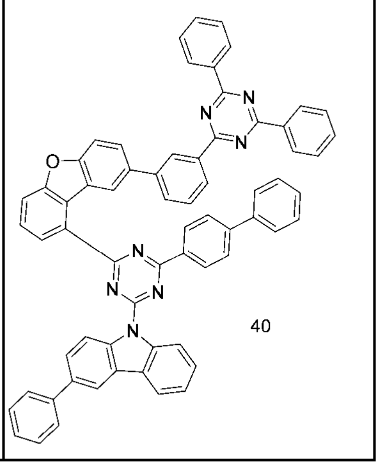 40 |

| | | |
|---|---|---|
| 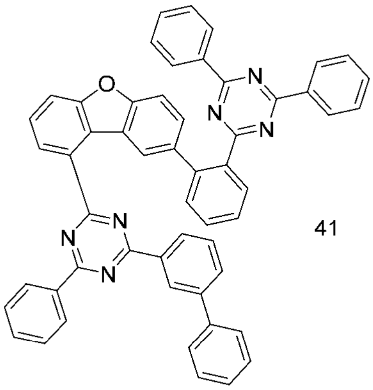 41 | 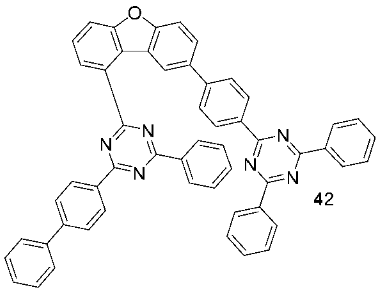 42 | 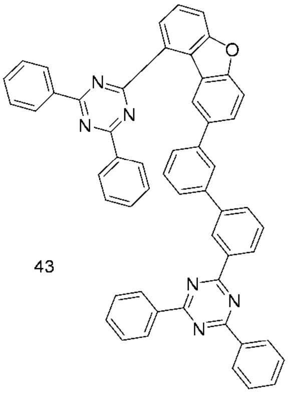 43 |
| 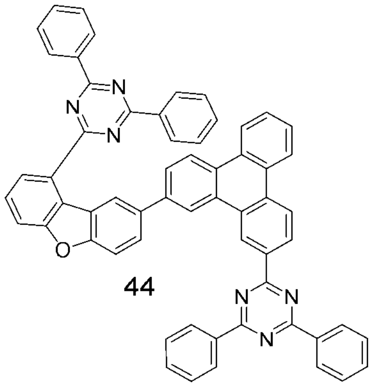 44 | 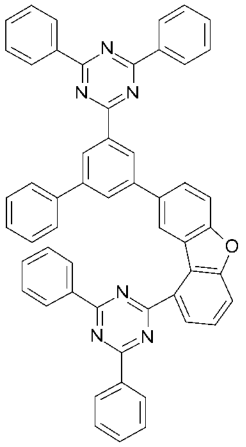 3d | |
| 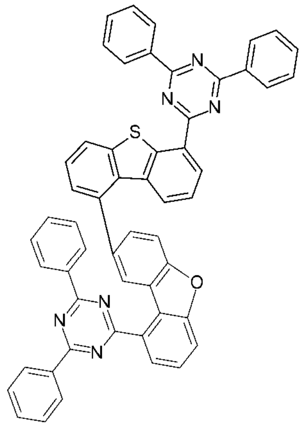 5d | 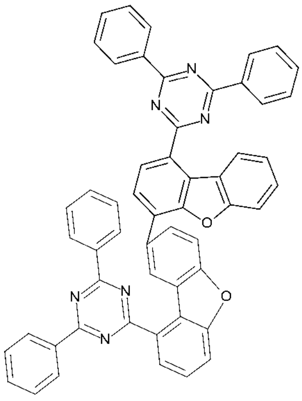 6d | 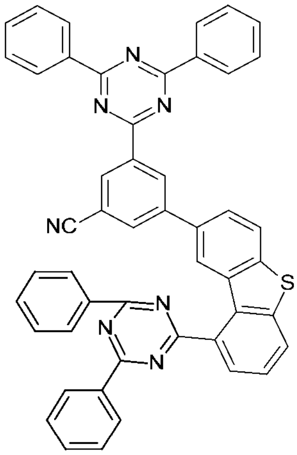 8d. |

**8.** Organic electroluminescent device according to Claim 1, **characterised in that** the phosphorescent emitter of the formula (3) conforms to one of the following formulae:

| | | |
|---|---|---|
| 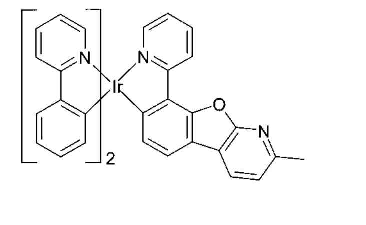 | 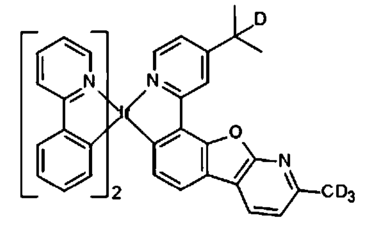 | 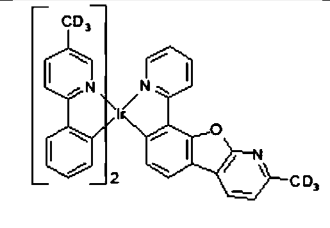 |
| 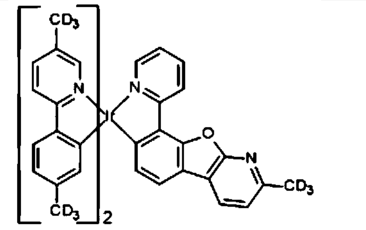 | 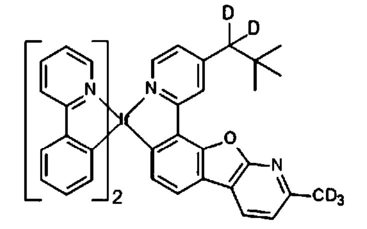 | 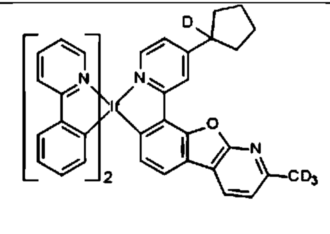 |
| 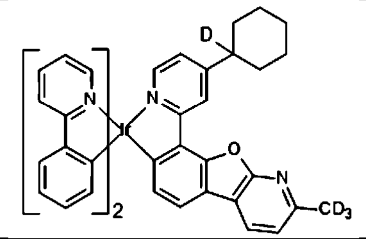 | 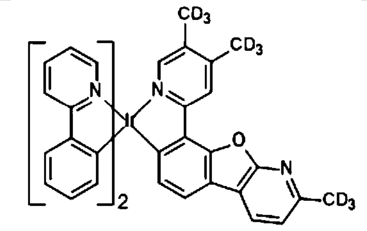 | 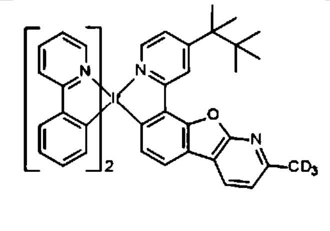 |
| 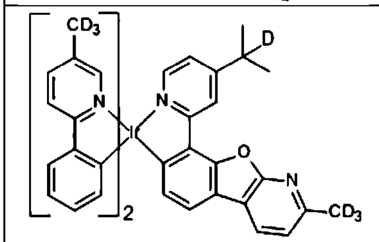 | 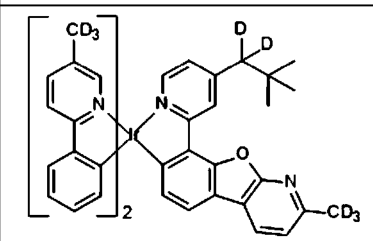 | 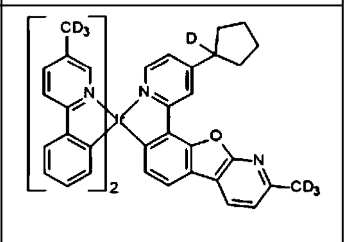 |
| 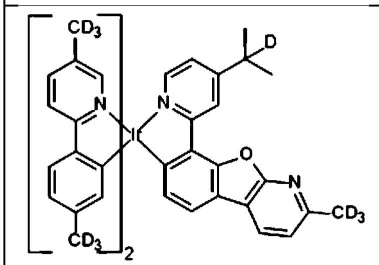 | 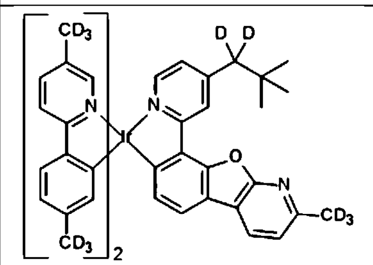 | 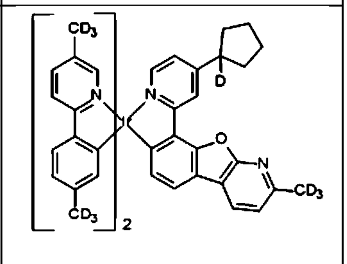 |
| 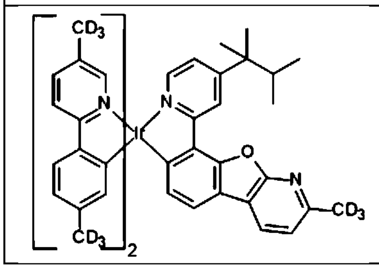 | 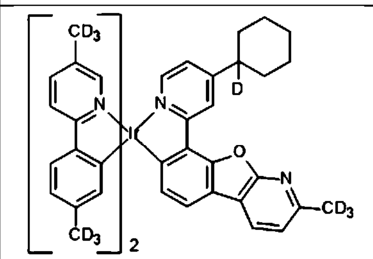 | 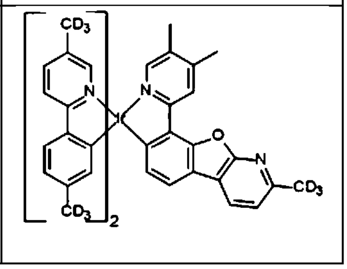 |

| | | |
|---|---|---|
| 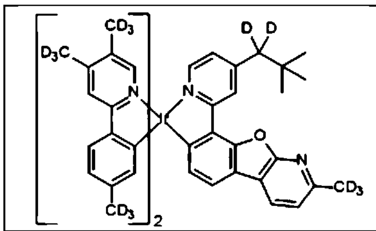 | 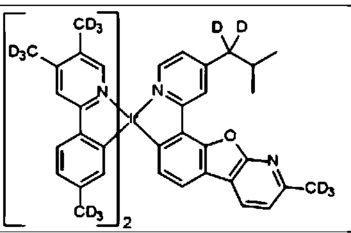 | 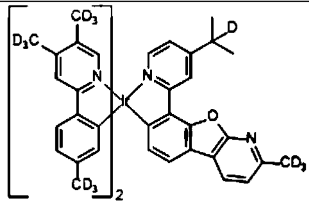 |
| 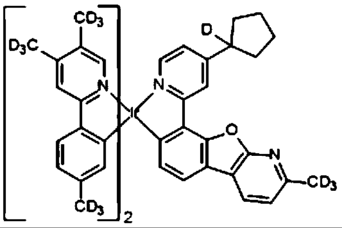 | 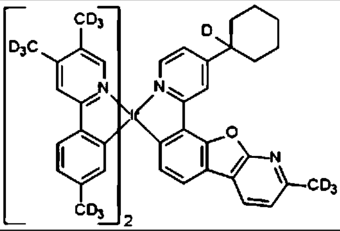 | 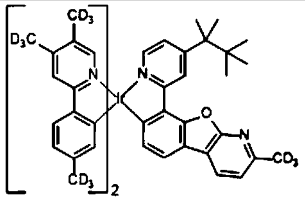 |
| 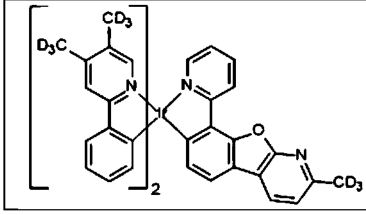 | 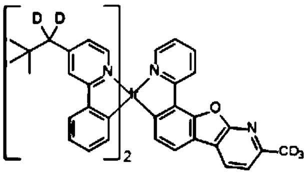 | |

**9.** Process for the production of a device according to one or more of Claims 1 to 8, **characterised in that** the light-emitting layer is applied by gas-phase deposition or from solution.

**10.** Process according to Claim 9, **characterised in that** the at least one compound of the formula (1) and the at least one compound of the formula (2a) are deposited from the gas phase, successively or simultaneously from at least two material sources, with the at least one phosphorescent emitter and form the light-emitting layer.

**11.** Process according to Claim 9, **characterised in that** the at least one compound of the formula (1) and the at least one compound of the formula (2a) are deposited from the gas phase as a mixture, successively or simultaneously with the at least one phosphorescent emitter and form the light-emitting layer.

**12.** Process according to Claim 9, **characterised in that** the at least one compound of the formula (1) and the at least one compound of the formula (2a) are applied from a solution together with the at least one phosphorescent emitter in order to form the light-emitting layer.

**13.** Mixture selected from the combination of compounds 1 to 11 and 29 to 44 with compounds 12 to 17, 23 and 24,

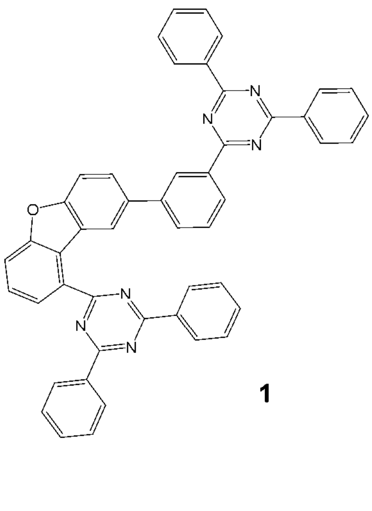

1

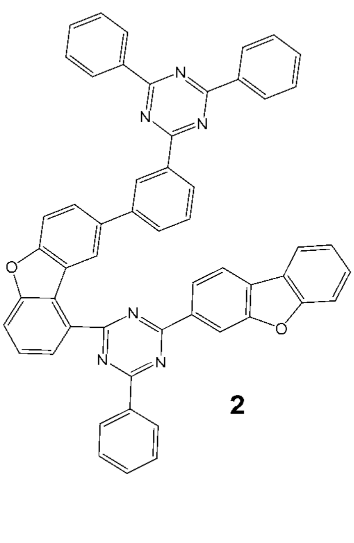

2

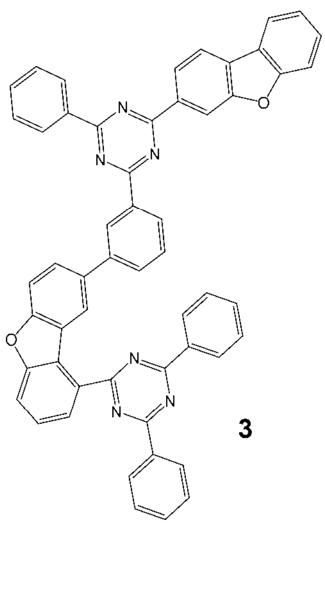

3

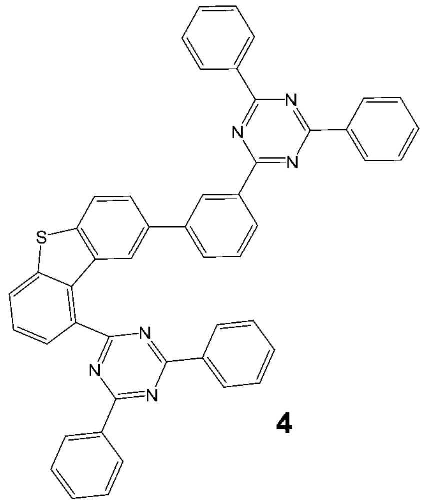

4

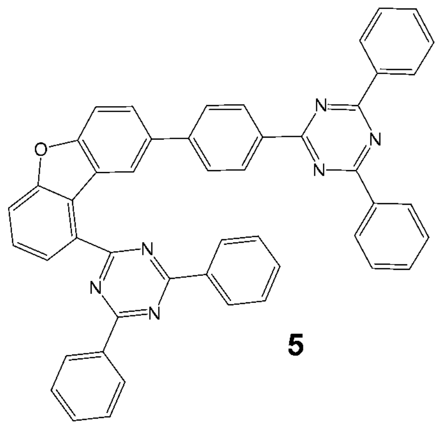

5

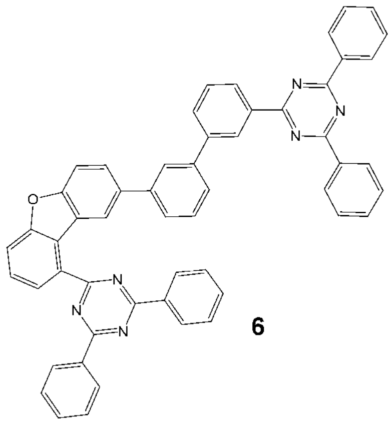

6

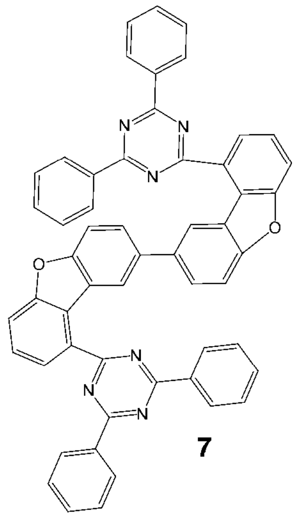

7

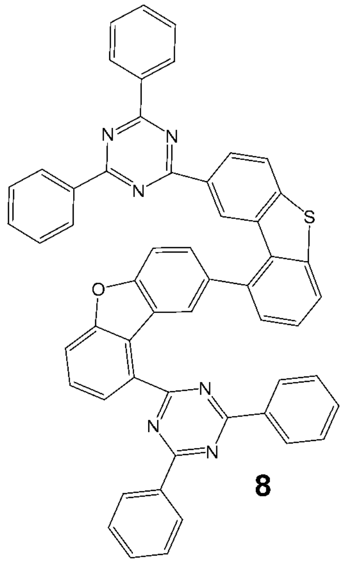

8

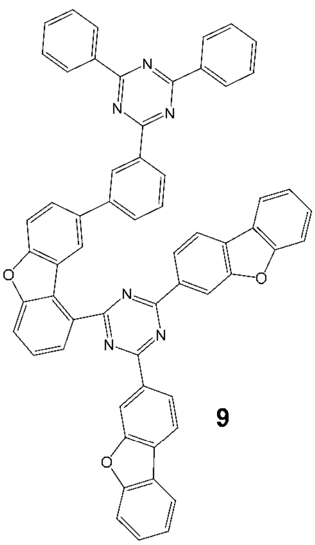

9

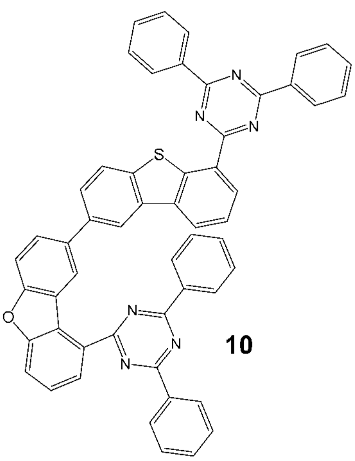

10

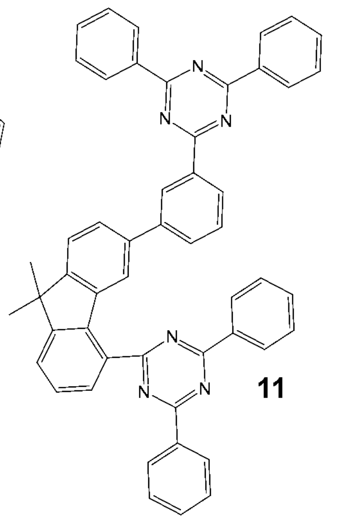

11

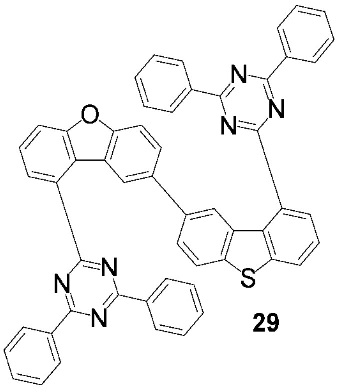

29

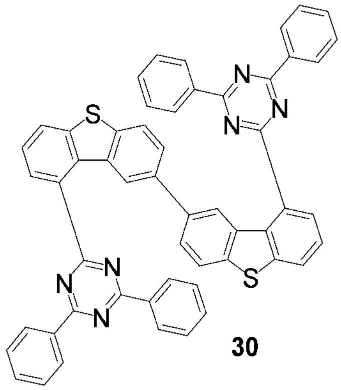

30

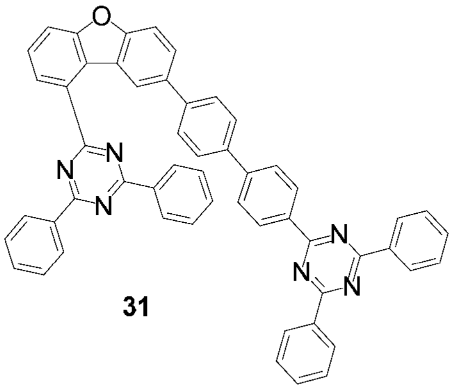

31

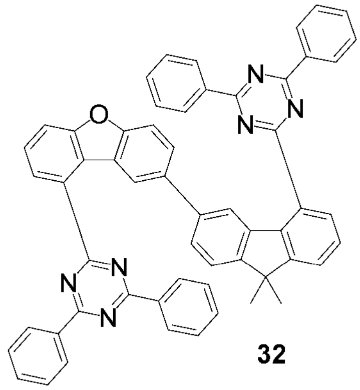

32

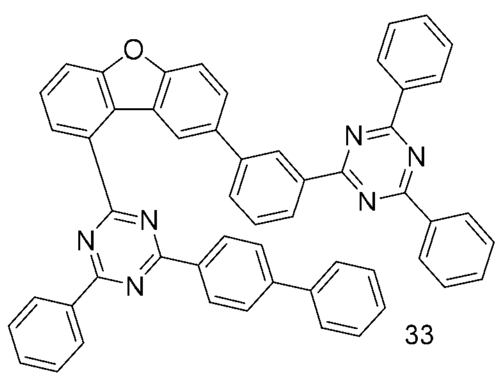

33

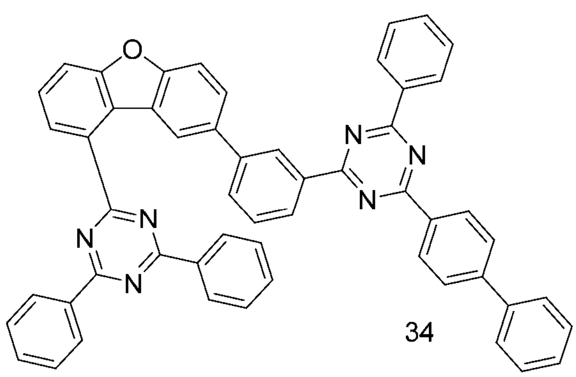

34

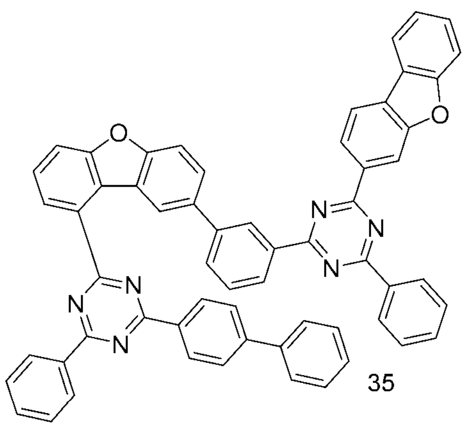

35

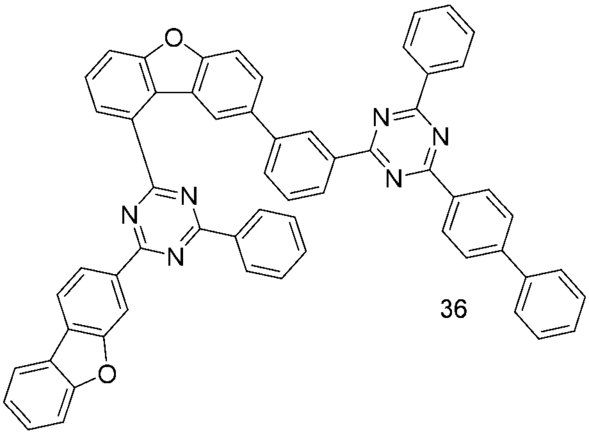

36

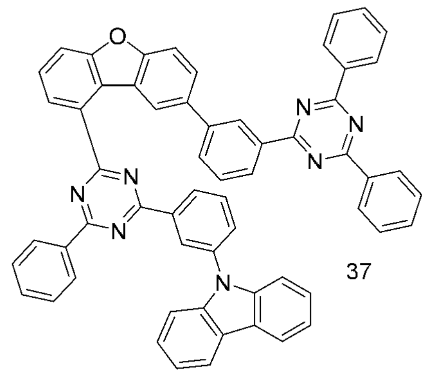

37

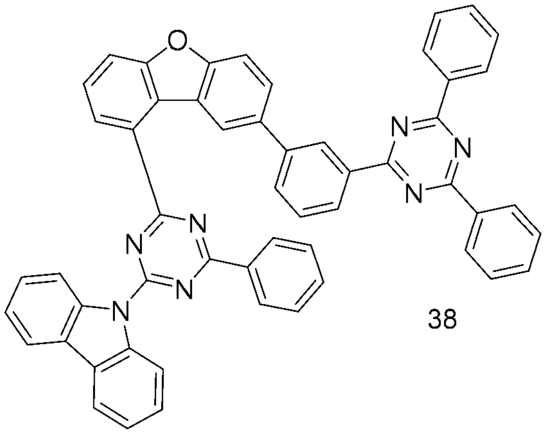

38

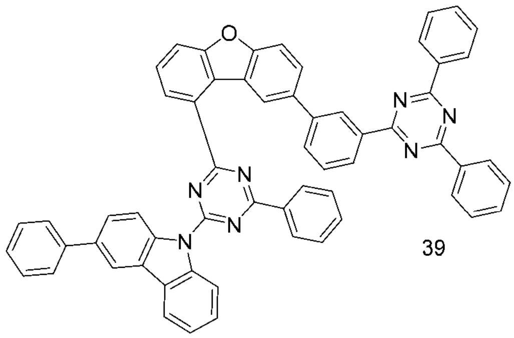

39

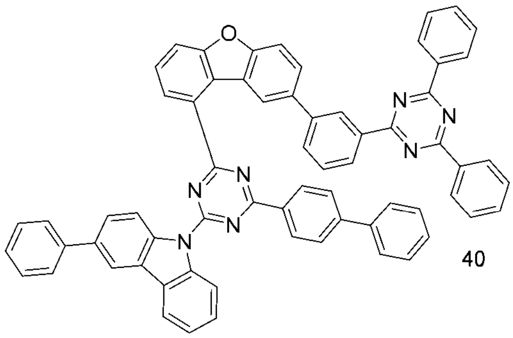

40

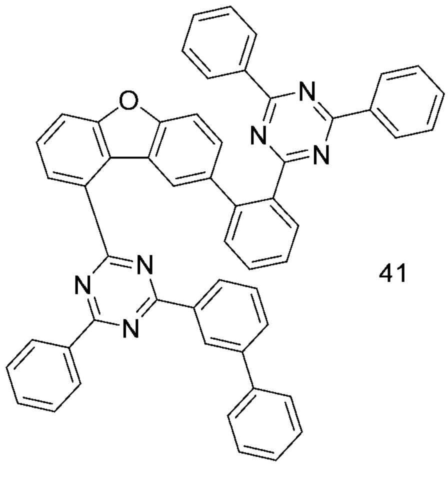

41

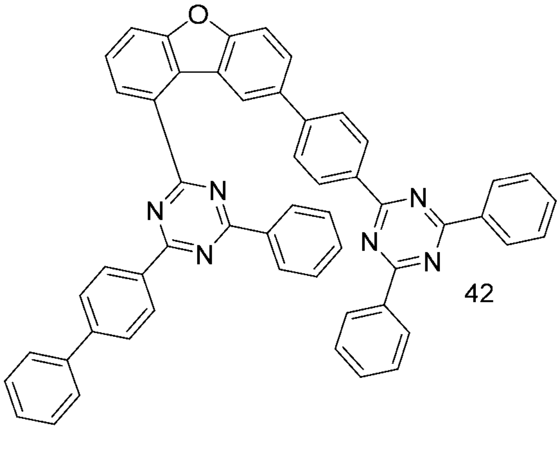

42

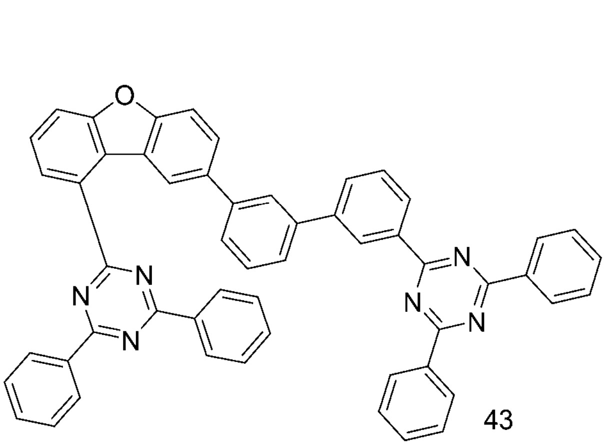

43

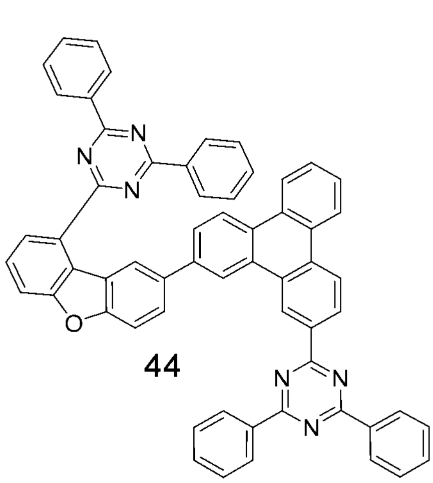

44

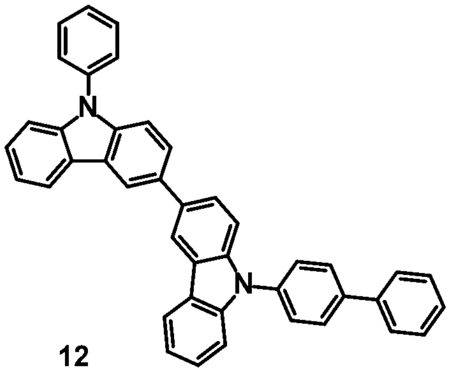

12

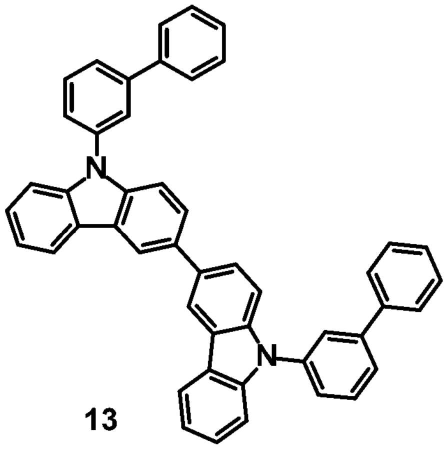

13

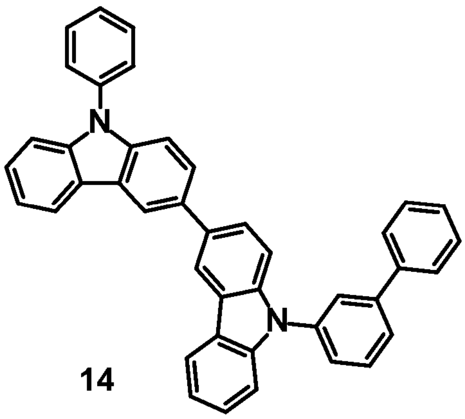

14

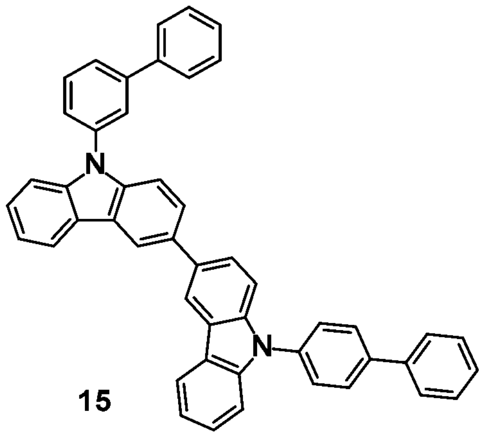

15

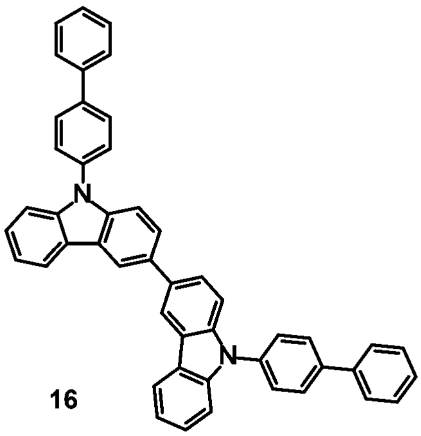

16

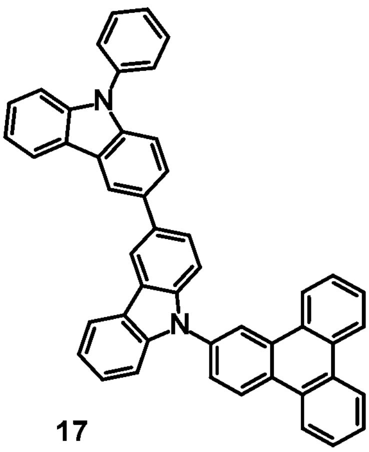

17

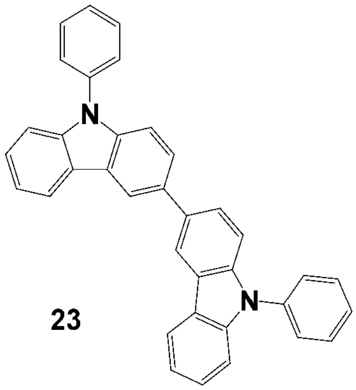

23

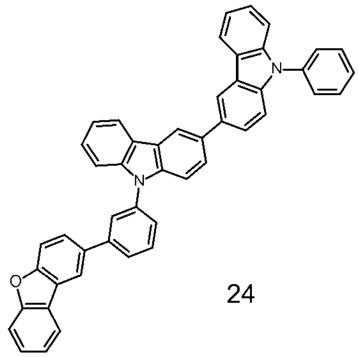

24

and a compound of the formula (3),

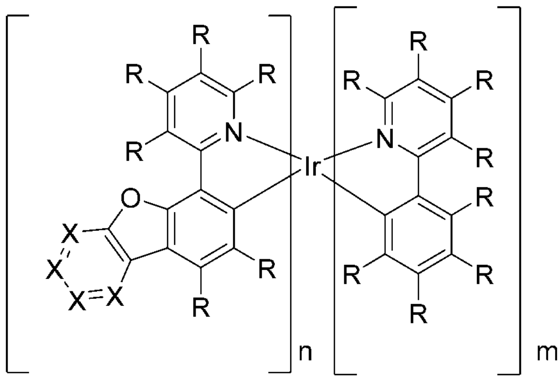

formula (3) ,

where the symbols and indices for this formula (3) have the meaning:

n+m is 3, n is 1 or 2, m is 2 or 1,
X is N or CR,
R is H, D or a branched or linear alkyl group having 1 to 10 C atoms or a partially or fully deuterated branched or linear alkyl group having 1 to 10 C atoms or a cycloalkyl group having 4 to 7 C atoms, which may be partially or fully substituted by deuterium.

**14.** Formulation comprising a mixture according to Claim 13 and at least one solvent.

## Revendications

**1.** Dispositif électroluminescent organique comprenant une anode, une cathode et au moins une couche organique, comprenant au moins une couche émettrice de lumière, où la au moins une couche émettrice de lumière comprend au moins un composé de formule (1) comme matériau hôte 1 et au moins un composé de formule (2a) comme matériau hôte 2,

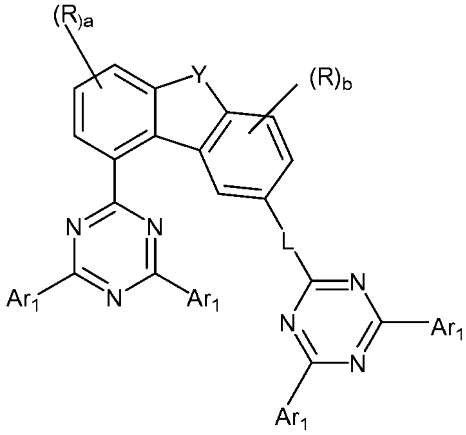

formule (1)

,

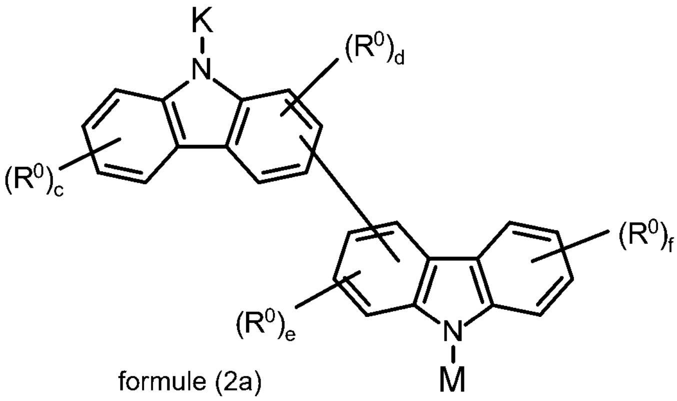

formule (2a)

,

dans lesquelles ce qui suit s'applique aux symboles et indices utilisés :

Y est choisi parmi O, S, $C(CH_3)_2$, $C(phényl)_2$ ou où * marque l'atome de C qui est lié au reste de

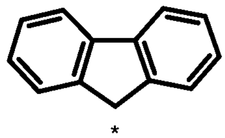

,

la formule (1) ;
L est choisi parmi l'un des bras de liaison divalents L-1 à L-26,

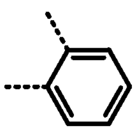

L-1

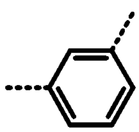

L-2

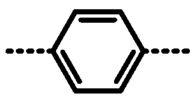

L-3

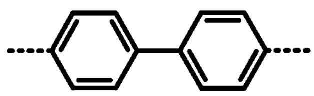

L-4

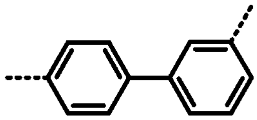

L-5

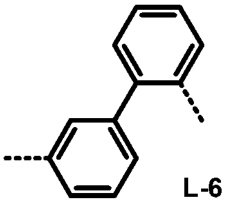

L-6

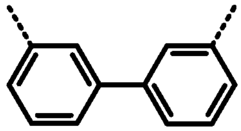

L-7

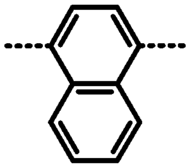

L-8

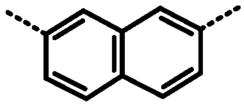

L-9

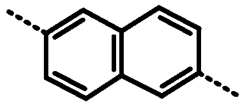

L-10

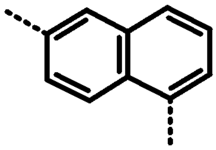

L-11

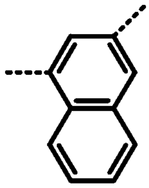

L-12

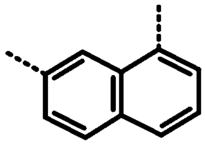

L-13

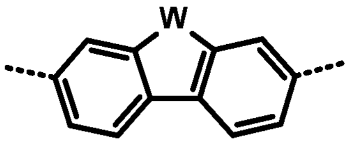

L-14

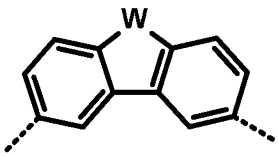

L-15

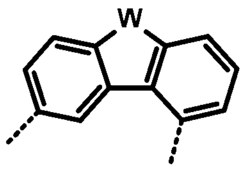

L-16

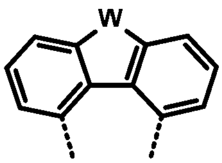

L-17

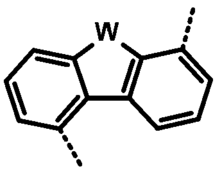

L-18

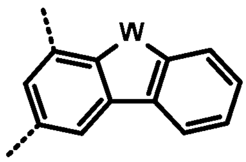

L-19

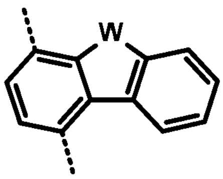

L-20

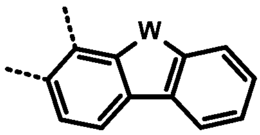

L-21

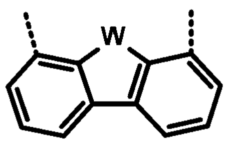

L-22

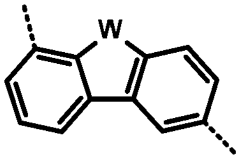 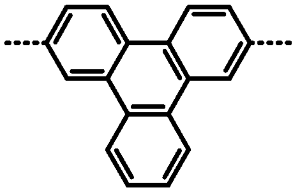 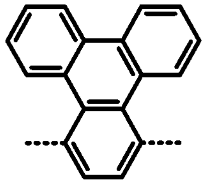

**L-23** **L-24** **L-25**

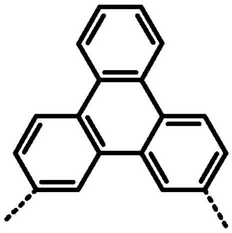

**L-26** ,

où les bras de liaison L-1 à L-26 peuvent également être substitués par un ou plusieurs substituants R ;
W est O, S ou $C(CH_3)_2$ ;
a vaut 0 ou 1 ;
b vaut 0 ou 1 ;
R est choisi à chaque occurrence, de manière identique ou différente, dans le groupe constitué par CN, un groupement alkyle, alcoxy ou thioalkyle à chaîne linéaire ayant de 1 à 20 atomes de C ou un groupement alkyle, alcoxy ou thioalkyle ramifié ou cyclique ayant de 3 à 20 atomes de C, un noyau aromatique ou hétéroaromatique ayant de 5 à 40 atomes de cycle aromatique, un groupement aryloxy ou hétéroaryloxy ayant de 5 à 40 atomes de cycle aromatique, ou un groupement aralkyle ou hétéroaralkyle ayant de 5 à 40 atomes de cycle aromatique ;
$Ar_1$ est à chaque occurrence, dans chaque cas indépendamment les uns des autres, un groupement aryle ou hétéroaryle ayant de 5 à 40 atomes de cycle aromatique, qui peut être substitué par un ou plusieurs radicaux R ;
K et M dans chaque cas, indépendamment l'un de l'autre, désignent un noyau aromatique ayant de 6 à 40 atomes de cycle aromatique qui est non substitué ou partiellement ou totalement deutérié ou monosubstitué par R* ;
$R^0$ est à chaque occurrence, indépendamment les uns des autres, un noyau aromatique non substitué ou partiellement ou totalement deutérié ayant de 6 à 18 atomes de C ;
R* est dibenzofuranyle ou dibenzothiophényle ;
c, d, e et f valent, indépendamment les uns des autres, 0 ou 1

et où la couche émettrice de lumière, outre le au moins un matériau hôte 1 et le au moins un matériau hôte 2, comprend au moins un émetteur phosphorescent de formule (3),

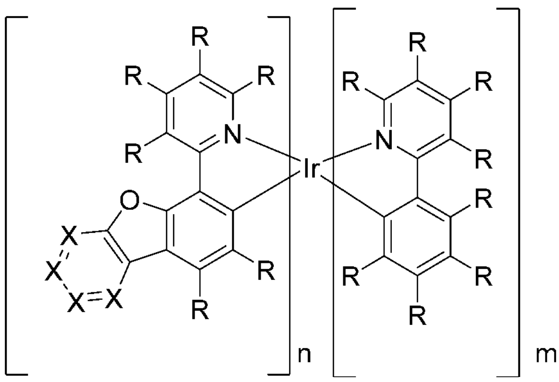

formule (3) ,

dans laquelle les symboles et indices pour cette formule (3) revêtent la signification :

n+m vaut 3, n vaut 1 ou 2, m vaut 2 ou 1,
X est N ou CR,
R est H, D ou un groupement alkyle ramifié ou linéaire ayant de 1 à 10 atomes de C ou un groupement alkyle ramifié ou linéaire partiellement ou totalement deutérié ayant de 1 à 10 atomes de C ou un groupement cycloalkyle ayant de 4 à 7 atomes de C, qui peut être partiellement ou totalement substitué par du deutérium.

**2.** Dispositif électroluminescent organique selon la revendication 1, **caractérisé en ce que** Y dans le matériau hôte 1 désigne O.

**3.** Dispositif électroluminescent organique selon la revendication 1 ou 2, **caractérisé en ce que** le matériau hôte 2 correspond à l'un des composés suivants :

| | | |
|---|---|---|
| 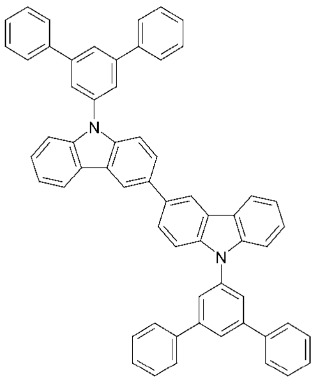 | 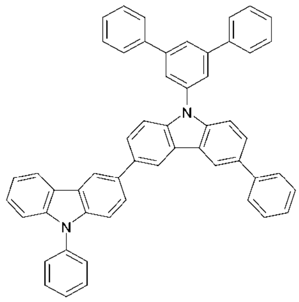 | 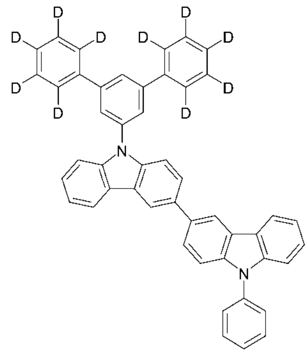 |
| 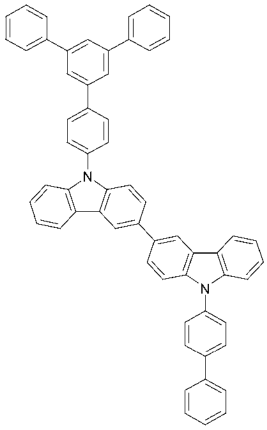 | 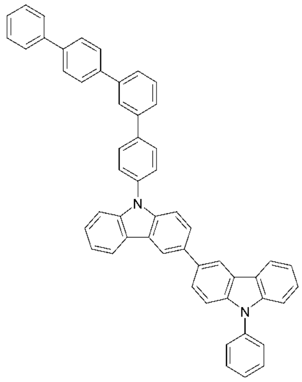 | 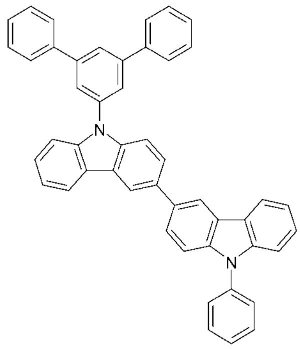 |
| 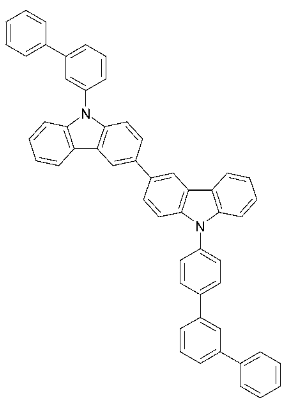 | 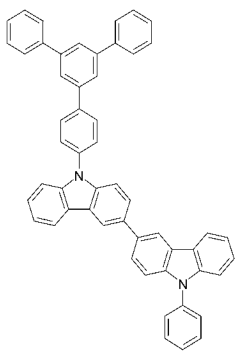 | 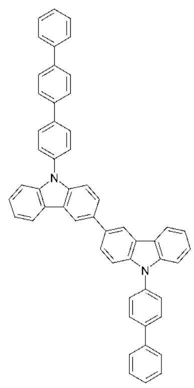 |

| | | |
|---|---|---|
| 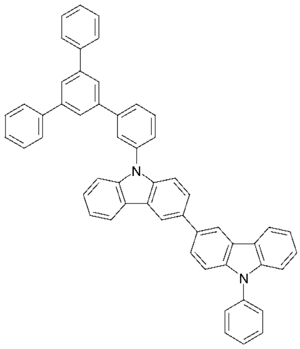 | 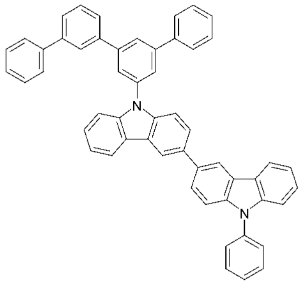 | 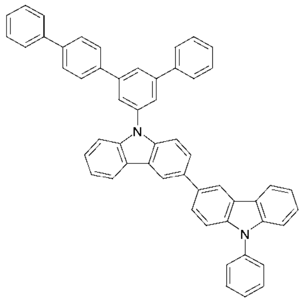 |
| 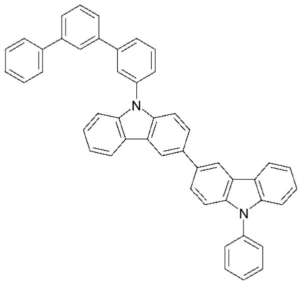 | 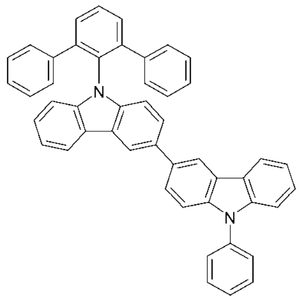 | 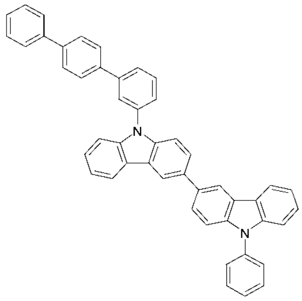 |
| 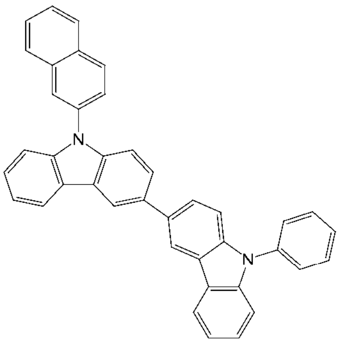 | 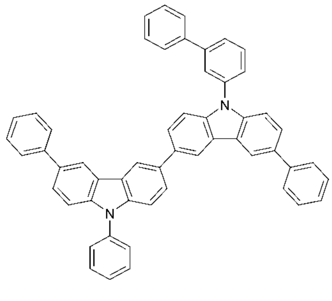 | 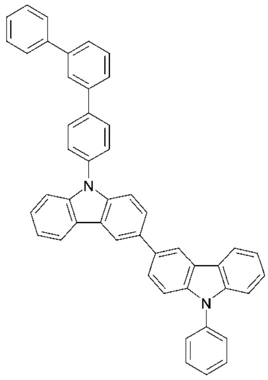 |
| 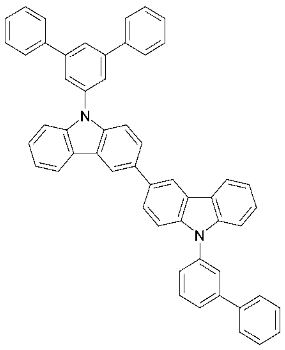 | 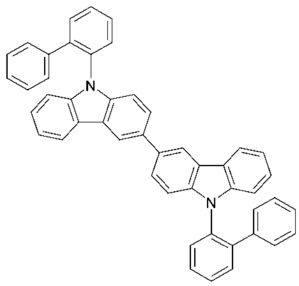 | 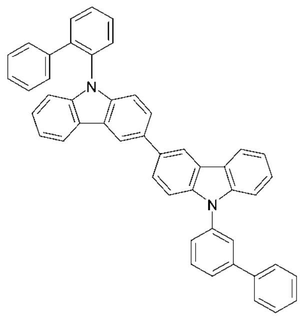 |

| | | |
|---|---|---|
| 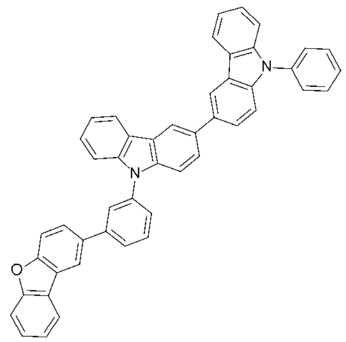 24 | 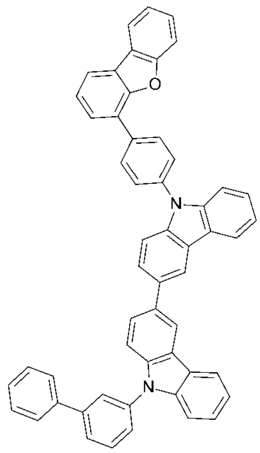 | 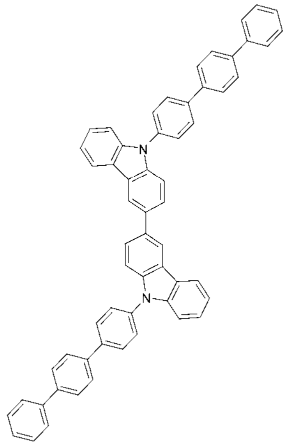 |
| 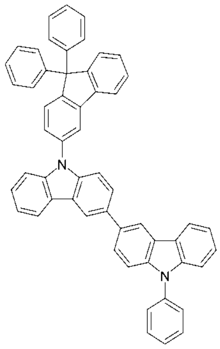 | 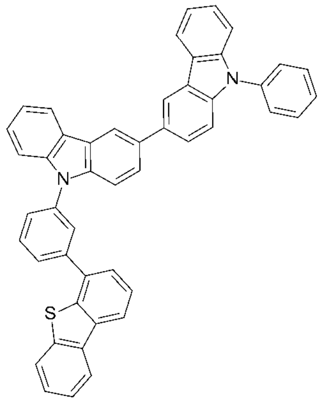 | 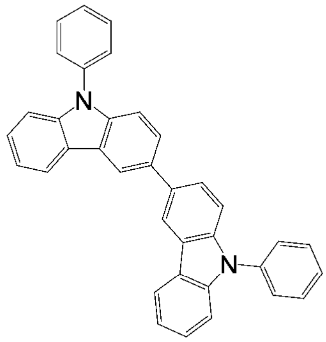 23 |
| | 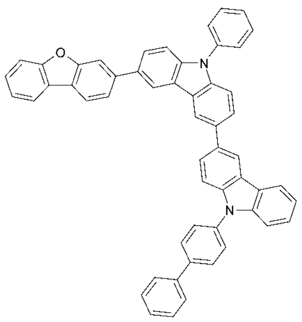 | |
| | 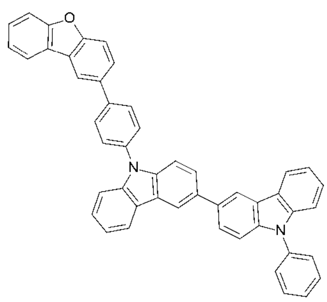 | |

| | | |
|---|---|---|
| 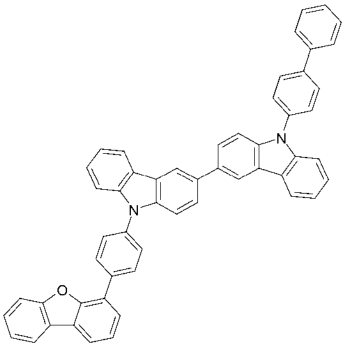 | 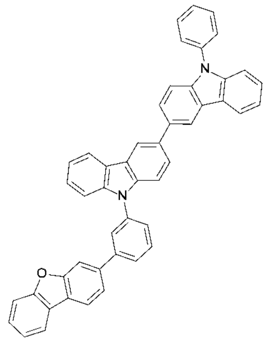 | 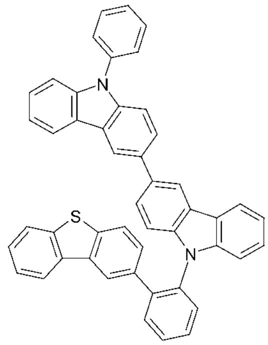 |
| 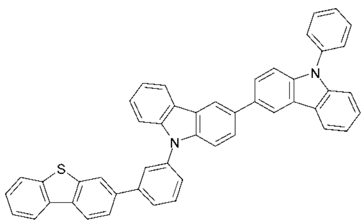 | 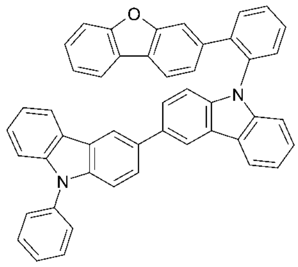 | 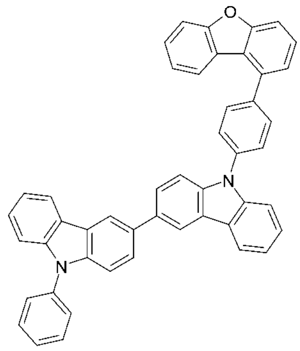 |
| 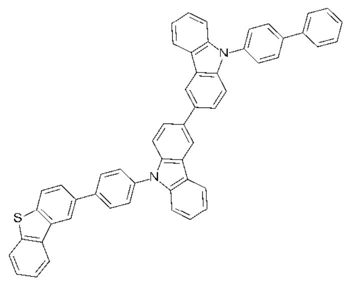 | 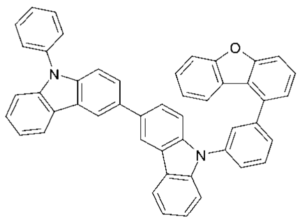 | 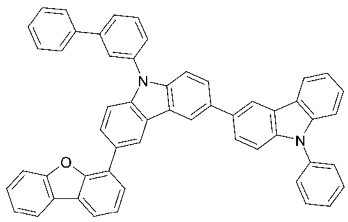 |
| 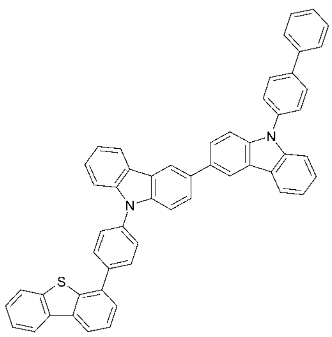 | 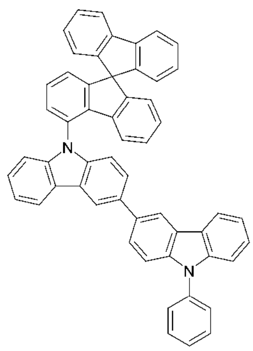 | 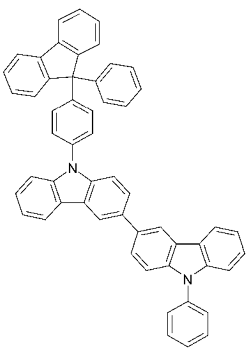 |
| 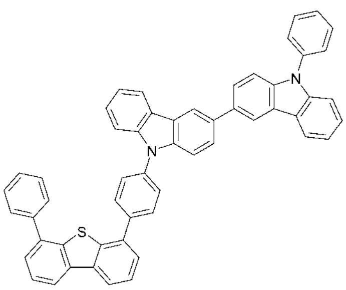 | 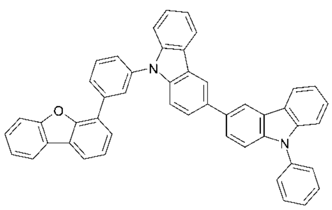 | 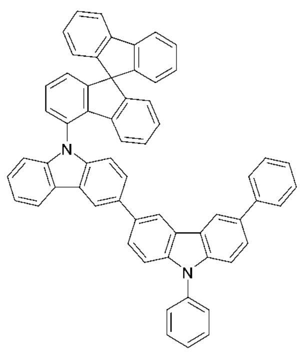 |

| | | |
|---|---|---|
| 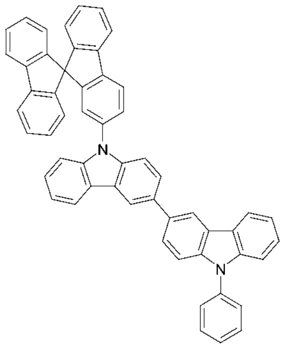 | 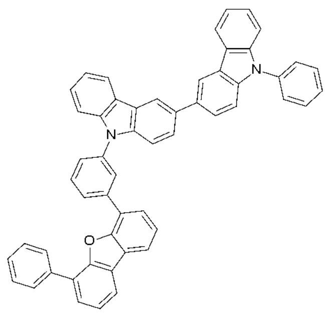 | 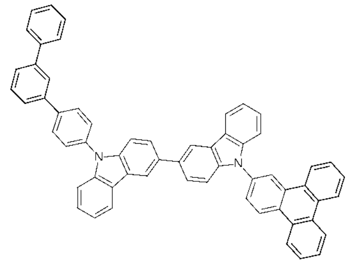 |
| 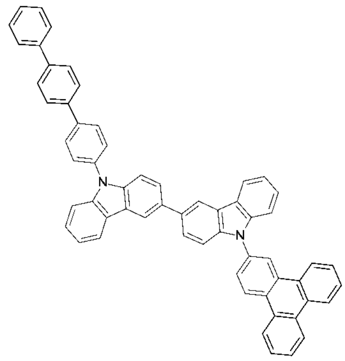 | 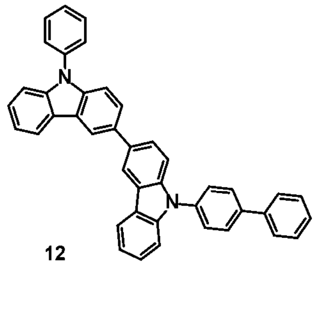 12 | 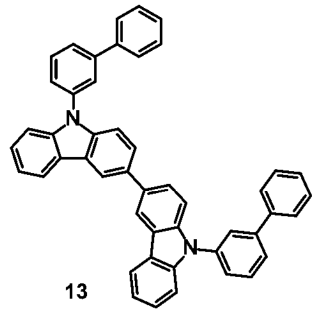 13 |
| 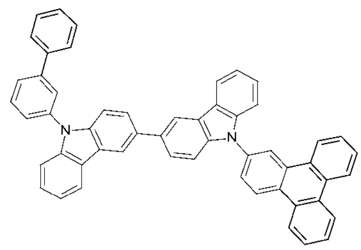 | 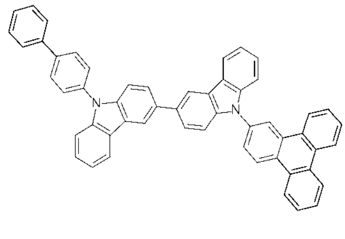 | 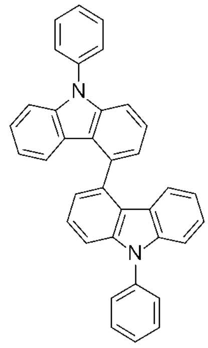 |
| 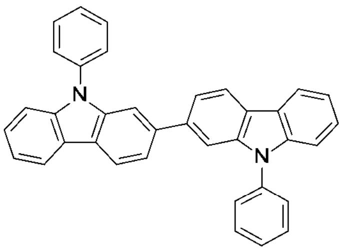 | 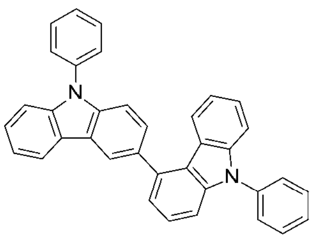 | 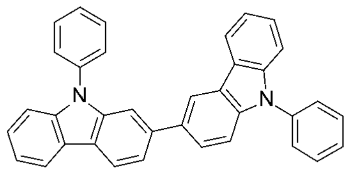 |
| 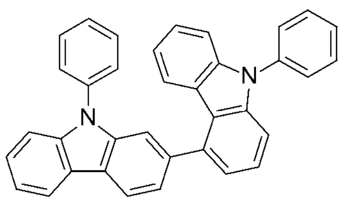 | 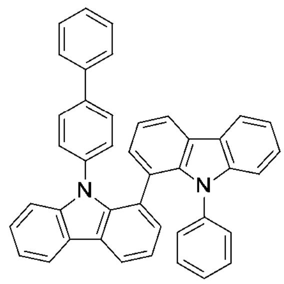 | 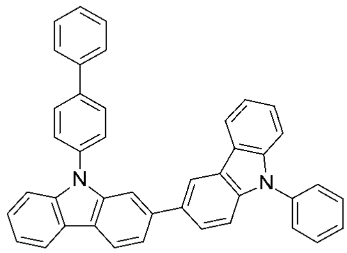 |

| | | |
|---|---|---|
| 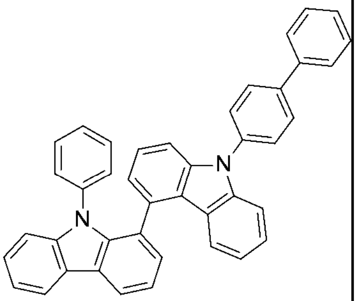 | 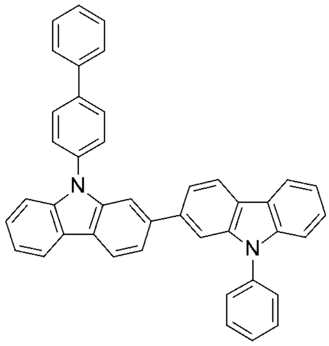 | 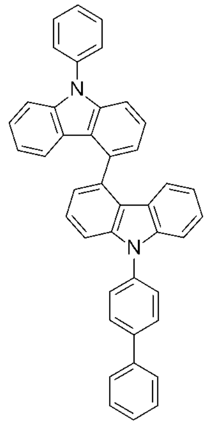 |
| 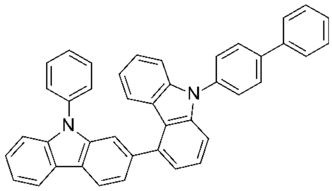 | 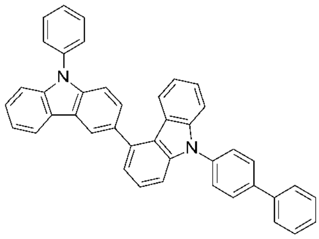 | 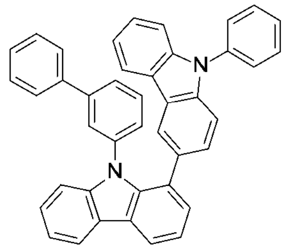 |
| 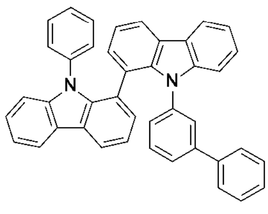 | 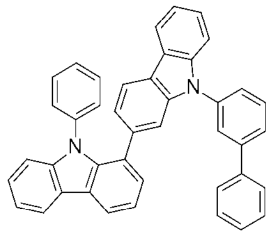 | 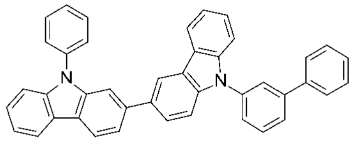 |
| 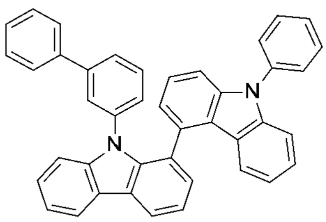 | 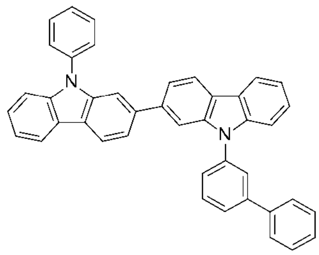 | 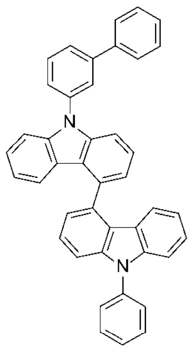 |
| 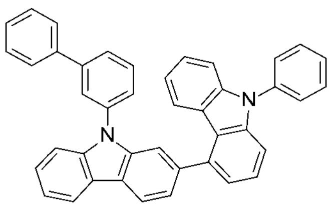 | 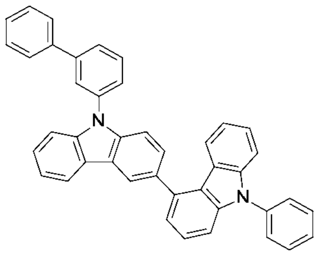 | 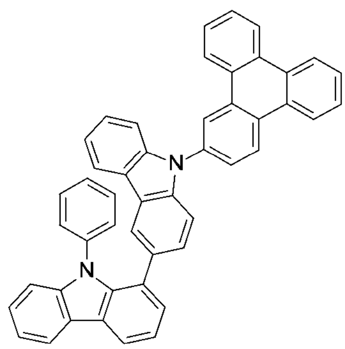 |

| | | |
|---|---|---|
| 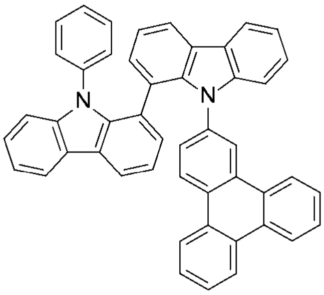 | 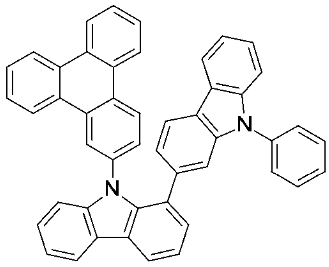 | 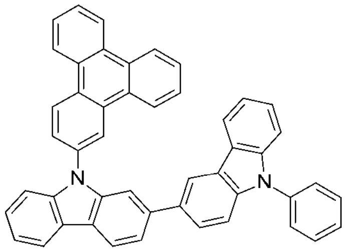 |
| 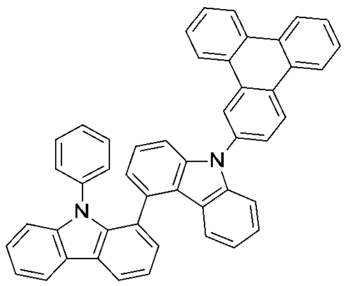 | 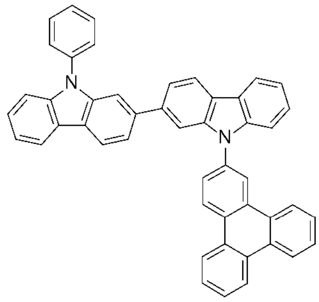 | 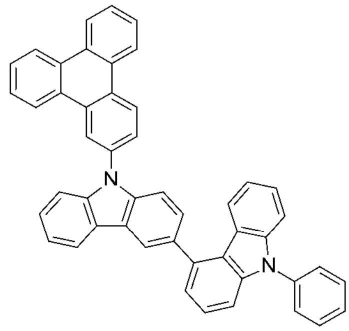 |
| 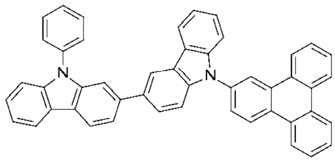 | 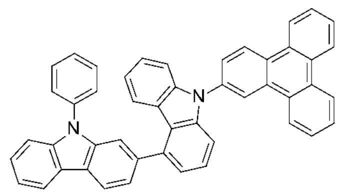 | 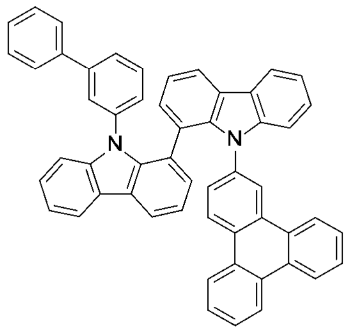 |
| 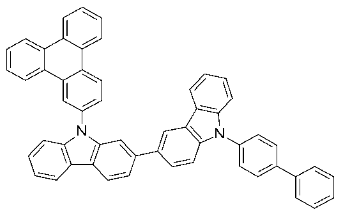 | 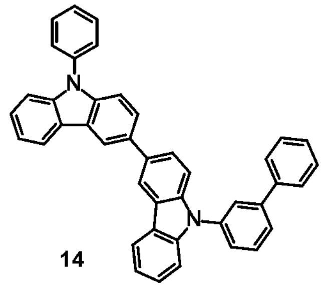 14 | 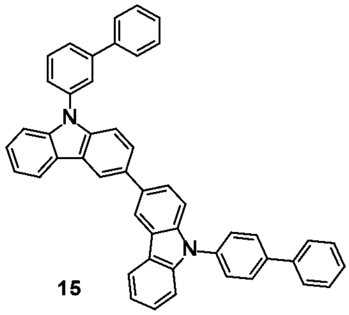 15 |

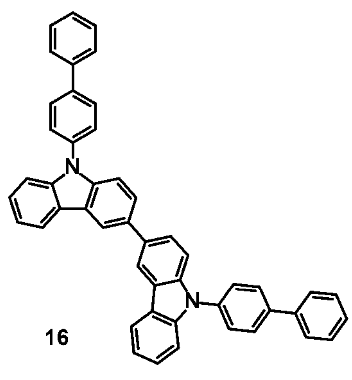
16

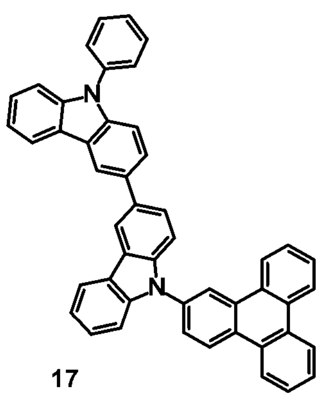
17

.

4. Dispositif électroluminescent organique selon l'une ou plusieurs parmi les revendications 1 à 3, **caractérisé en ce que** L dans le matériau hôte 1 est choisi parmi les bras de liaison divalents L-1 à L-13 et L-24 à L-26.

5. Dispositif électroluminescent organique selon l'une ou plusieurs parmi les revendications 1 à 4, **caractérisé en ce qu'**il s'agit d'un dispositif électroluminescent choisi parmi les transistors organiques émetteurs de lumière (OLET), les dispositifs organiques à extinction de champ (OFQD), les cellules électrochimiques organiques émettrices de lumière (OLEC, LEC, LEEC), les diodes laser organiques (O-lasers) et les diodes électroluminescentes organiques (OLED).

6. Dispositif électroluminescent organique selon l'une ou plusieurs parmi les revendications 1 à 5, **caractérisé en ce que**, outre la couche émettrice de lumière (EML), il comprend une couche d'injection de trous (HIL), une couche de transport de trous (HTL), une couche de transport d'électrons (ETL), une couche d'injection d'électrons (EIL) et/ou une couche de blocage de trous (HBL).

7. Dispositif électroluminescent organique selon l'une ou plusieurs parmi les revendications 1 à 6, **caractérisé en ce que** le matériau hôte 1 répond à l'une des formules suivantes :

| | | |
|---|---|---|
| 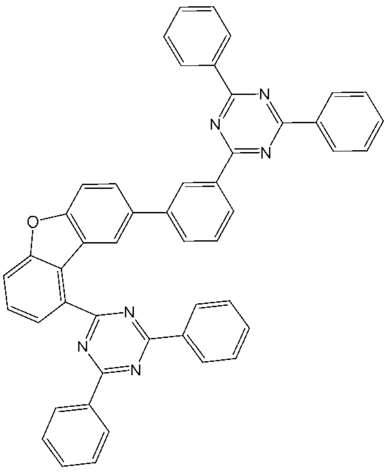 1 | 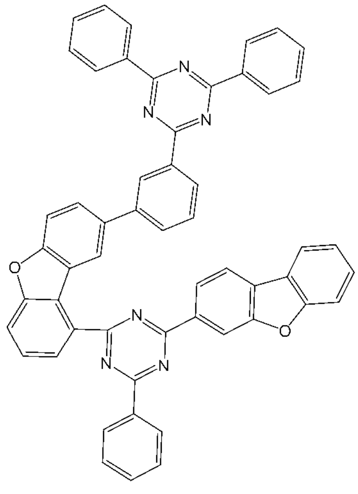 2 | 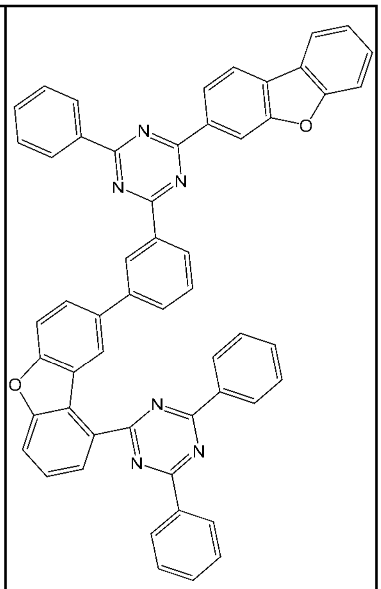 3 |
| 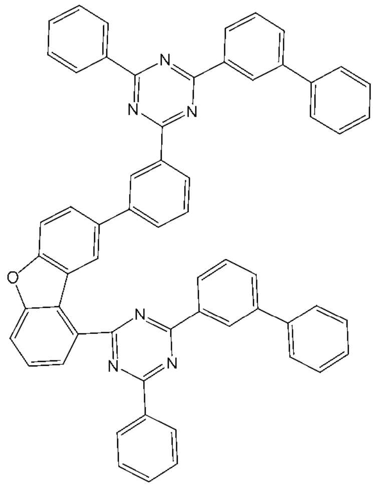 | 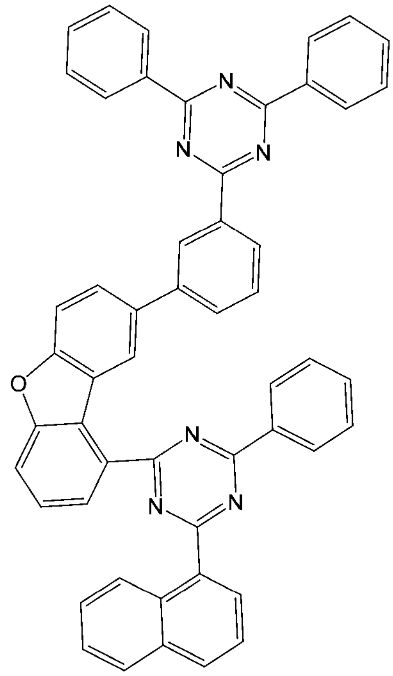 | 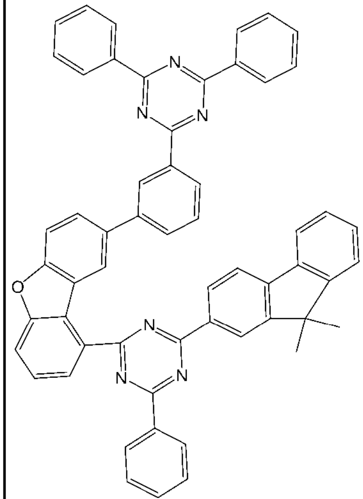 |

| | | |
|---|---|---|
| 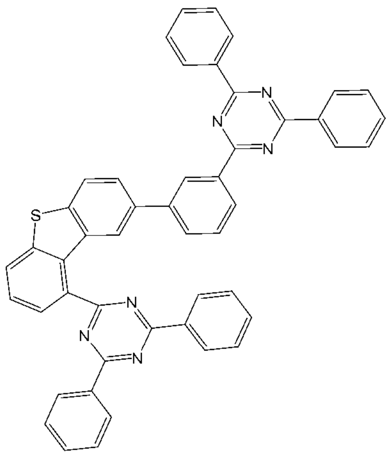 4 | 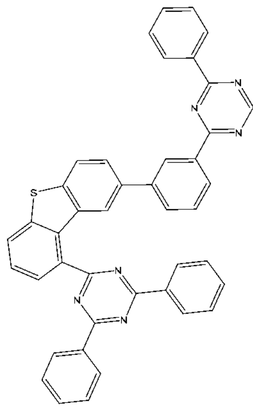 | 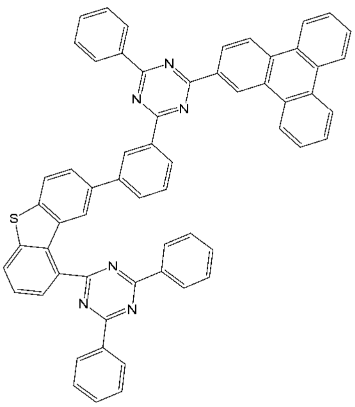 |
| 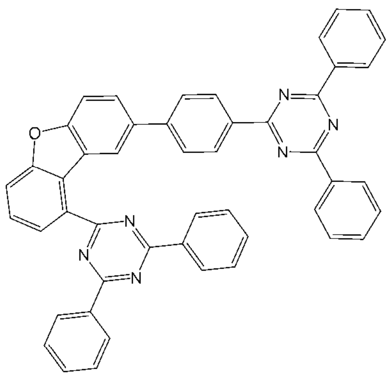 5 | 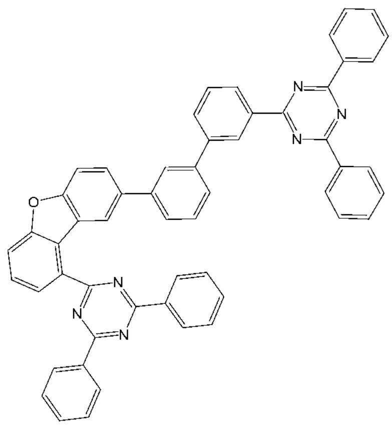 6 | 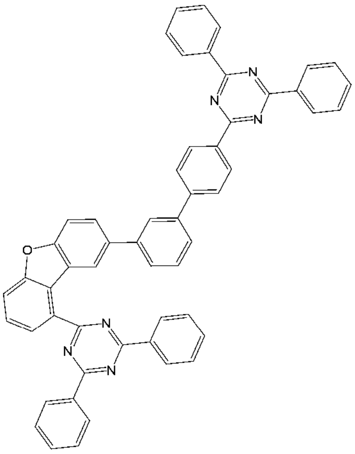 |
| 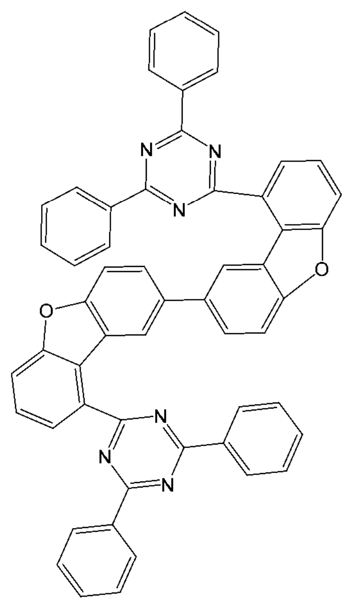 7 | 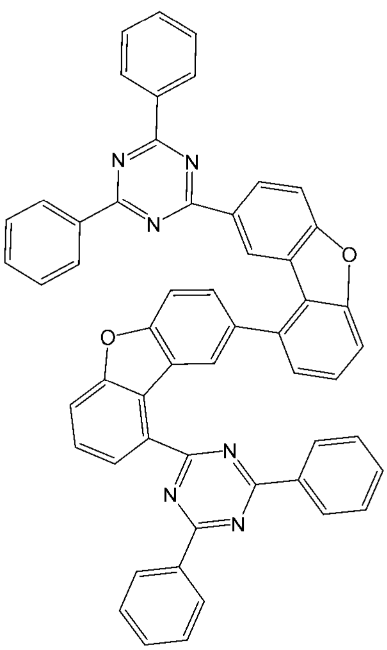 | 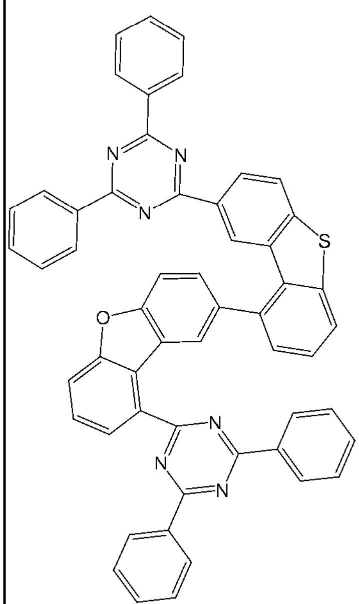 8 |

| | | |
|---|---|---|
| 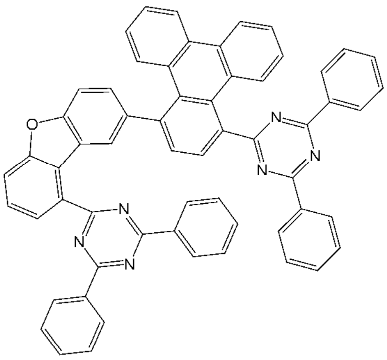 | 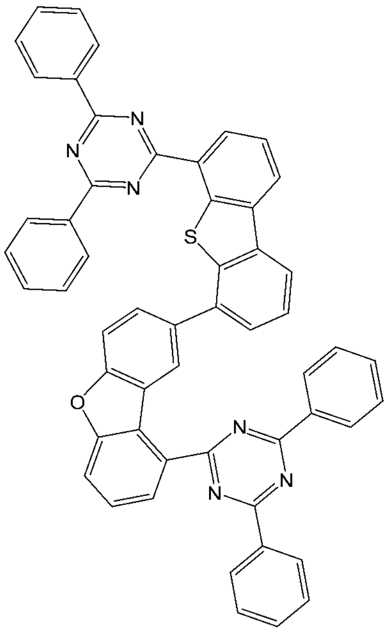 | 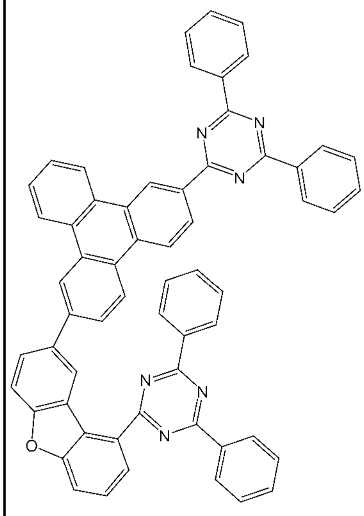 |
| 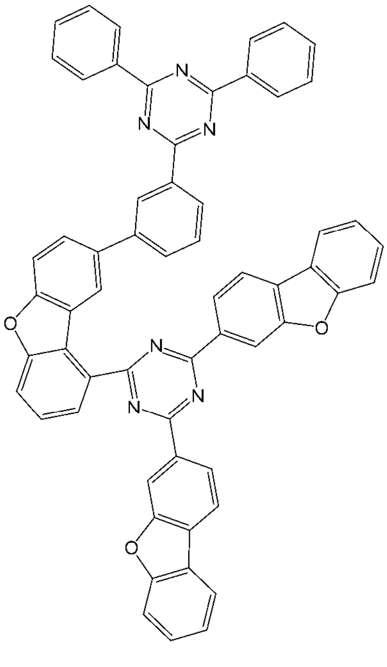<br>9 | 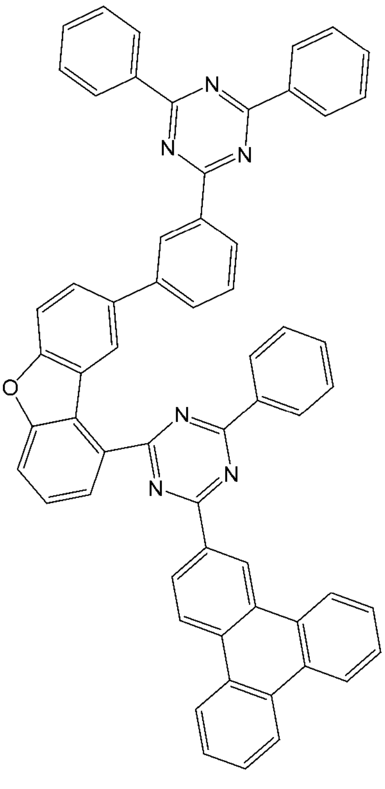 | 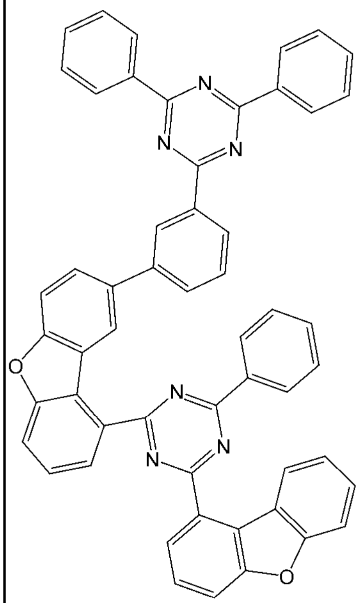 |

| | | |
|---|---|---|
| 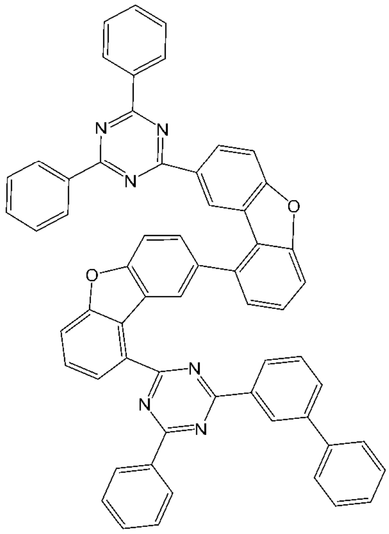 | | |
| | 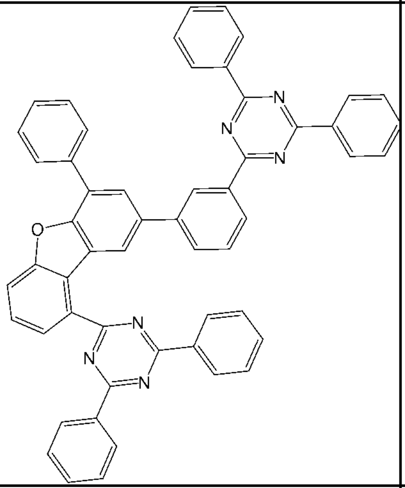 | 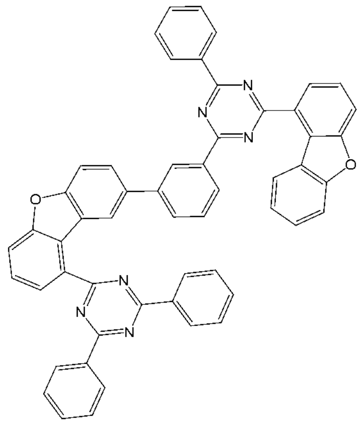 |
| 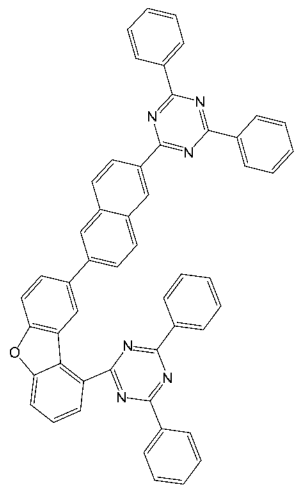 | 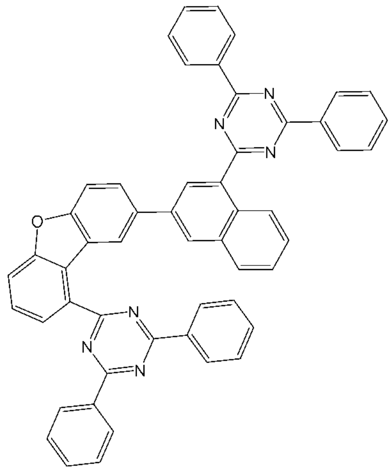 | 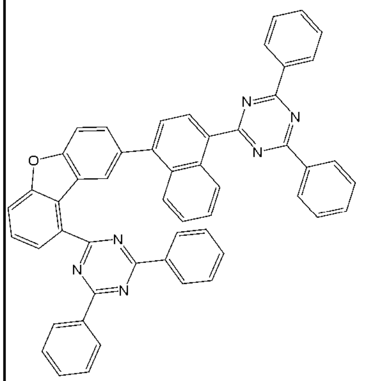 |

| | | |
|---|---|---|
| 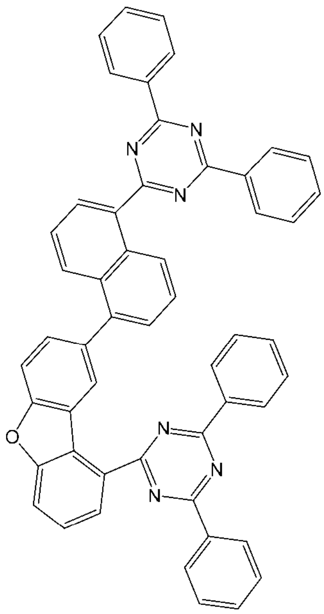 | 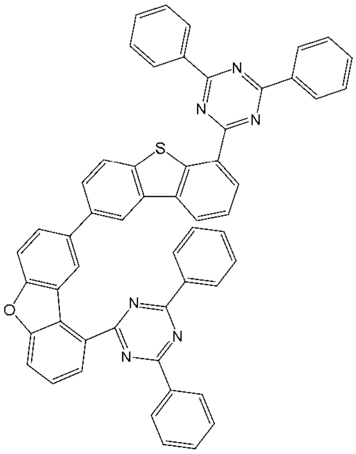 | 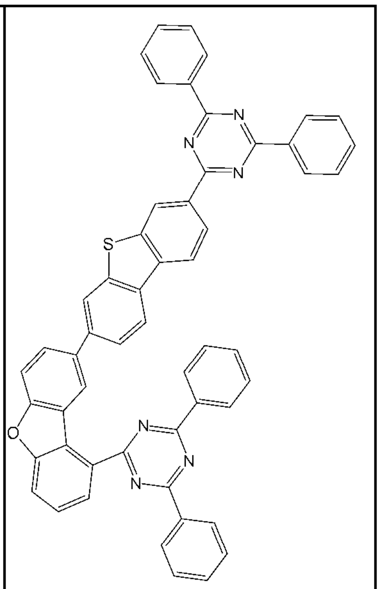 |
| 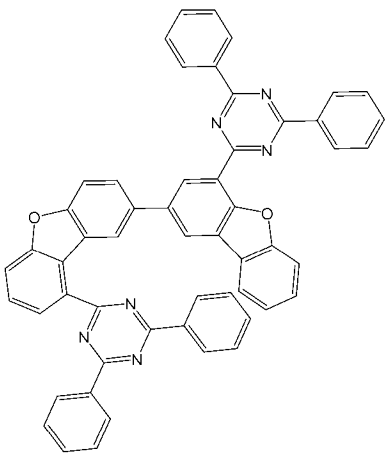 | 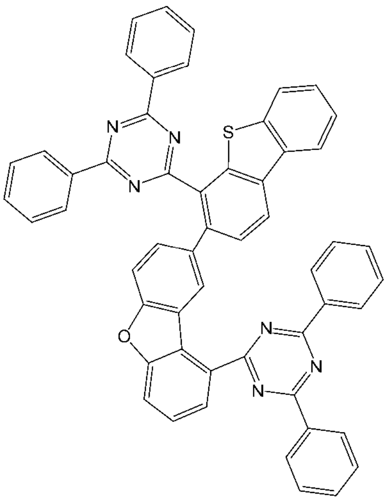 | 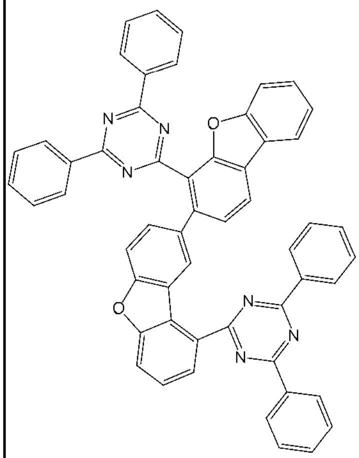 |
| 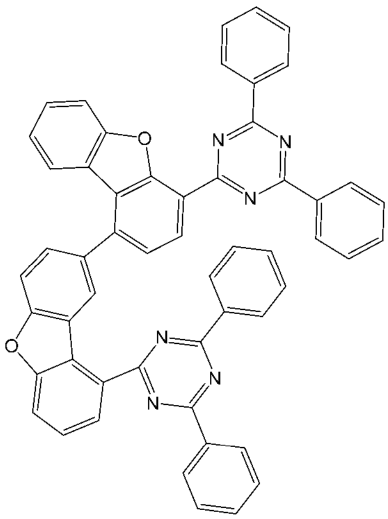 | 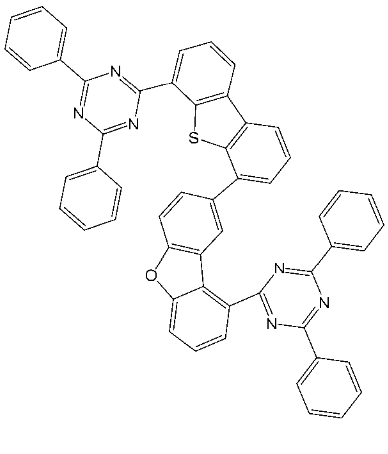 | 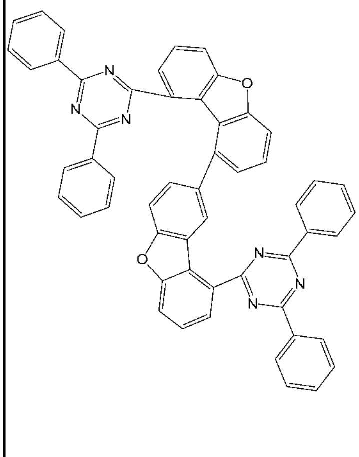 |

| | | |
|---|---|---|
| 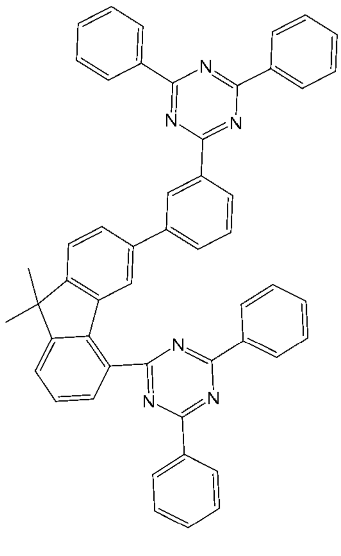 10 | 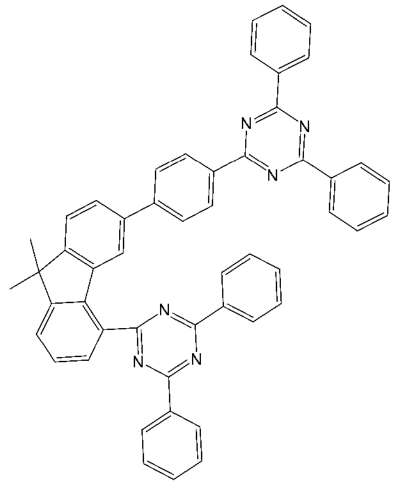 | 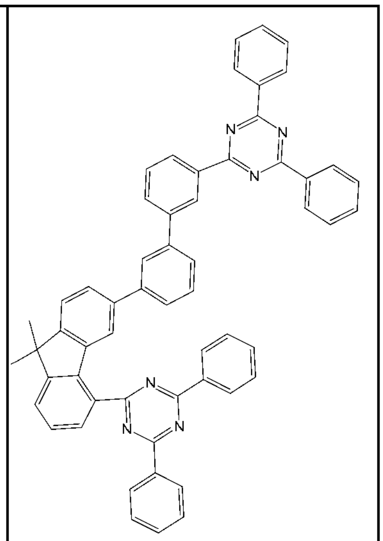 |
| 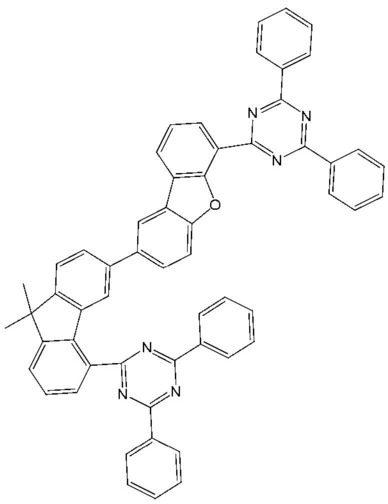 | 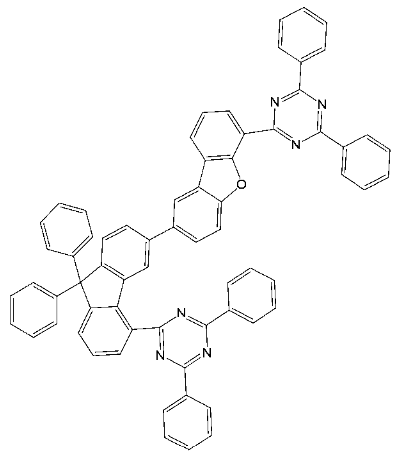 | 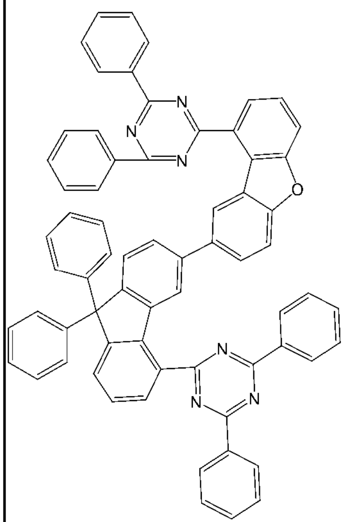 |
| 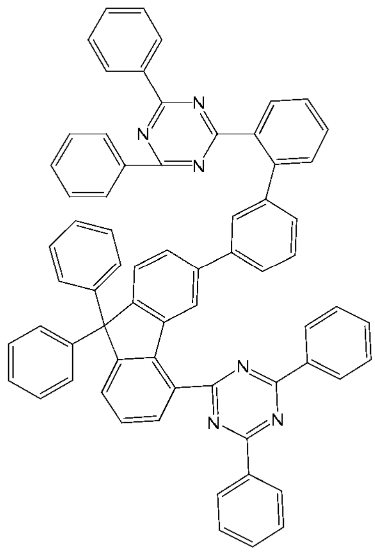 | 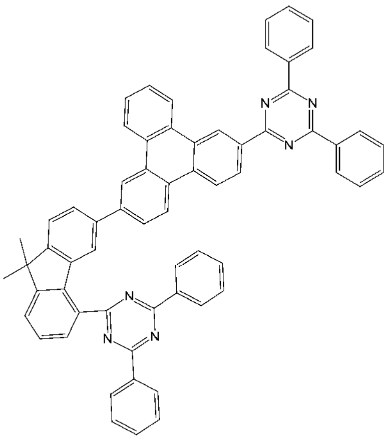 | 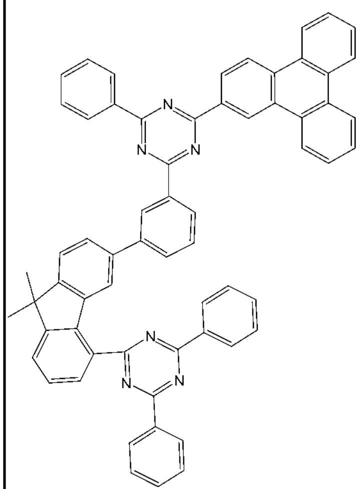 |

| | | |
|---|---|---|
| 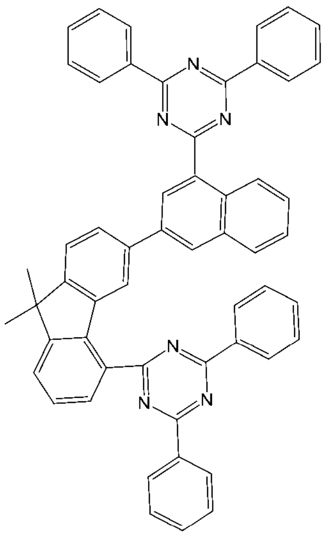 | 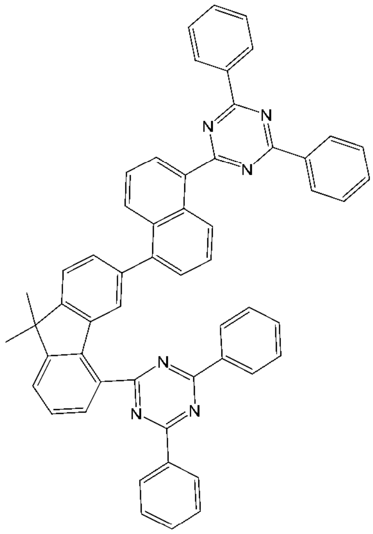 | 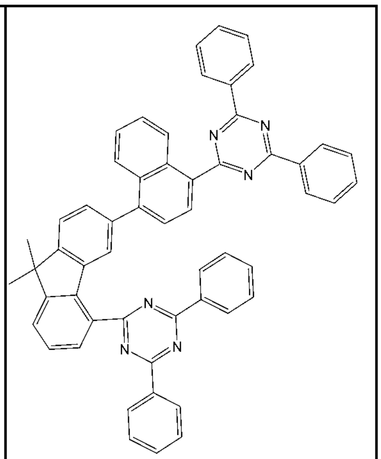 |
| 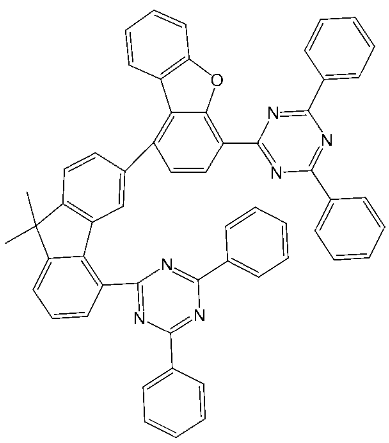 | 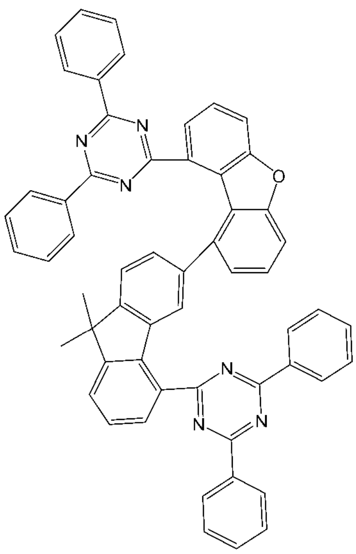 | 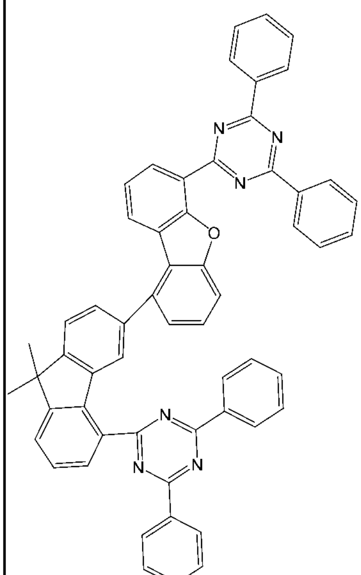 |
| 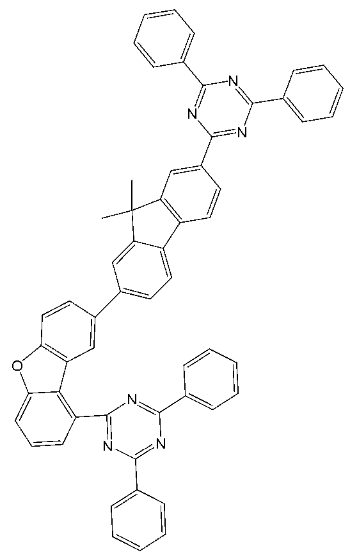 | 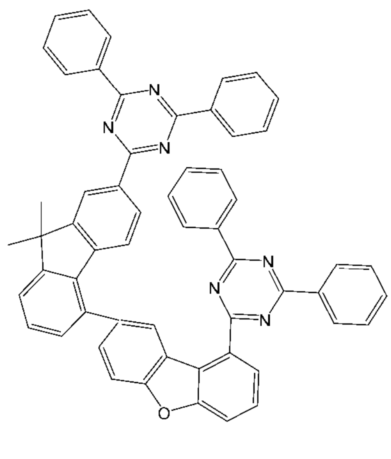 | 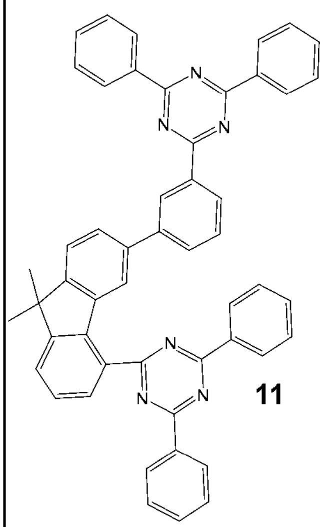 11 |

| | | |
|---|---|---|
| 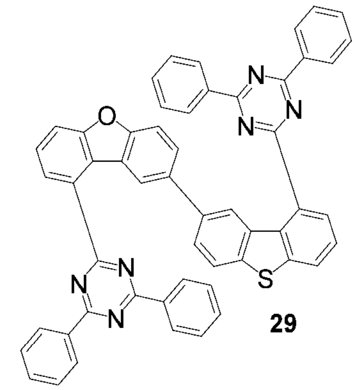 **29** | 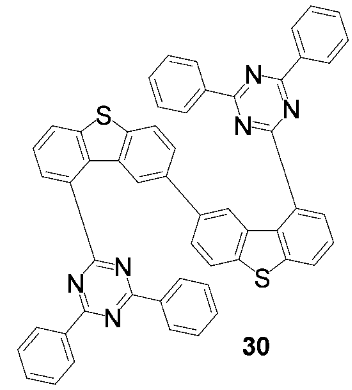 **30** | 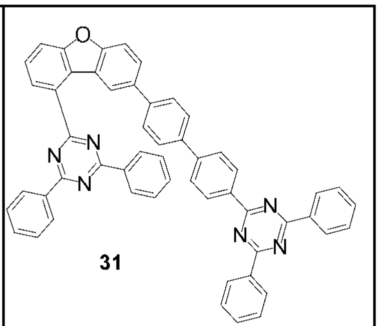 **31** |
| 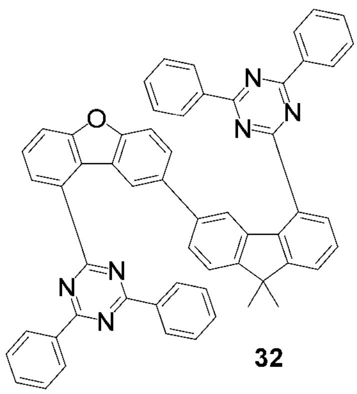 **32** | 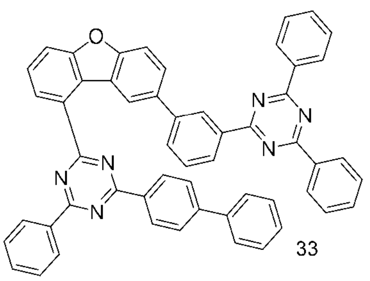 33 | 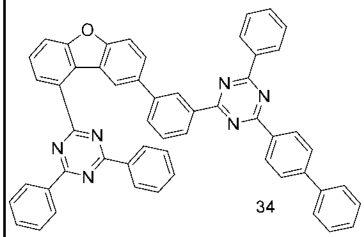 34 |
| 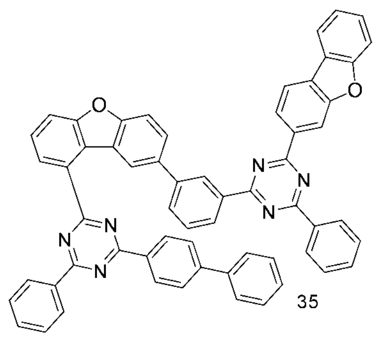 35 | 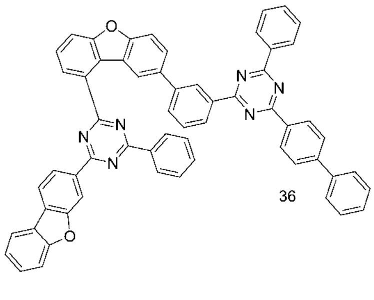 36 | 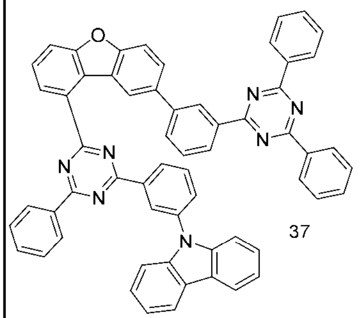 37 |
| 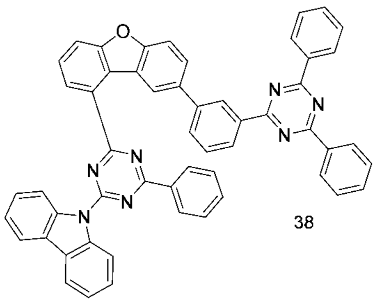 38 | 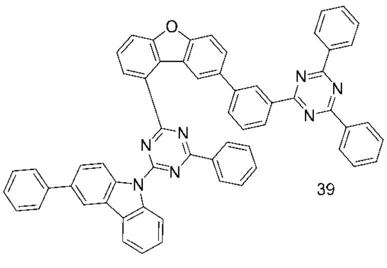 39 | 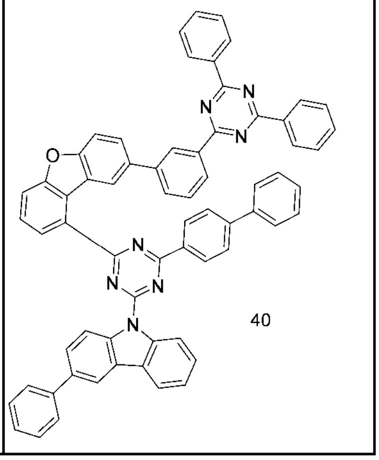 40 |

| | | |
|---|---|---|
| 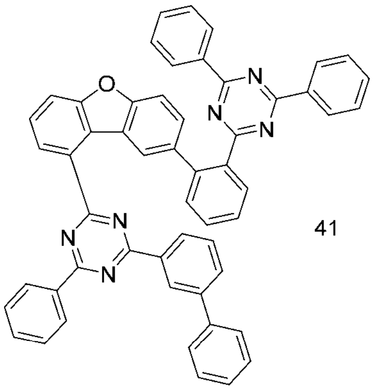 41 | 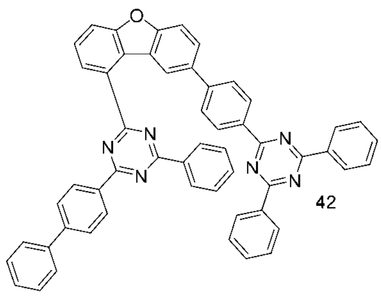 42 | 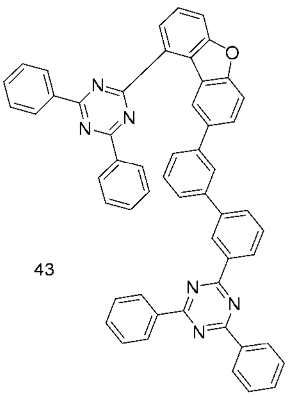 43 |
| 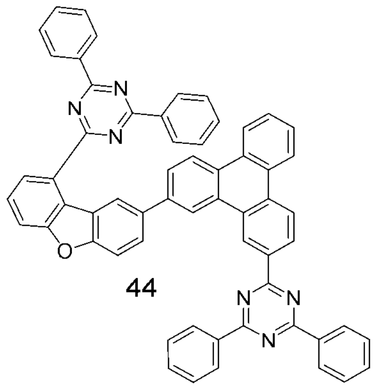 44 | 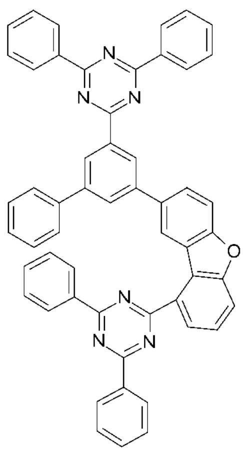 3d | |
| 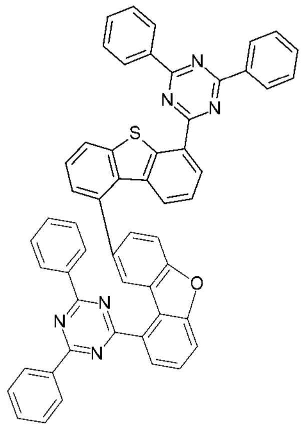 5d | 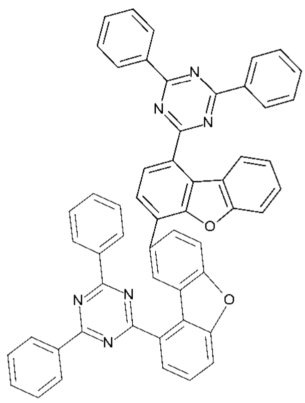 6d | 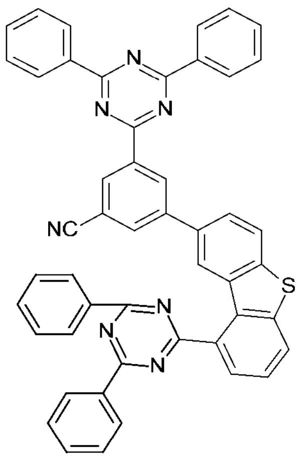 8d. |

**8.** Dispositif électroluminescent organique selon la revendication 1, **caractérisé en ce que** l'émetteur phosphorescent de formule (3) répond à l'une des formules suivantes :

| | | |
|---|---|---|
| 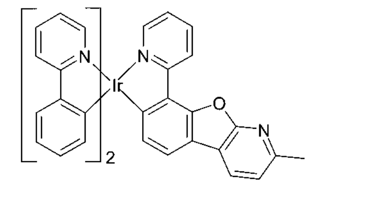 | 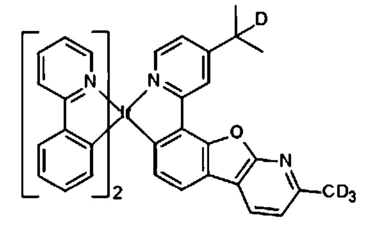 | 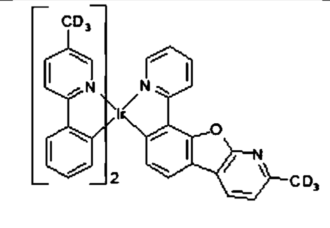 |
| 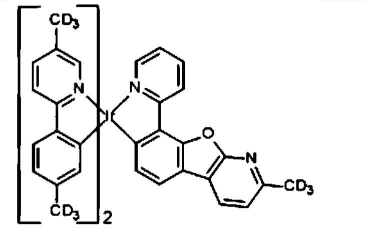 | 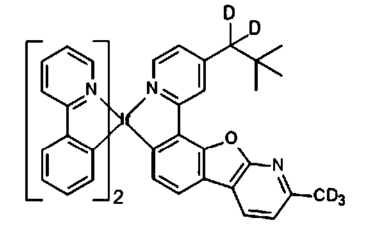 | 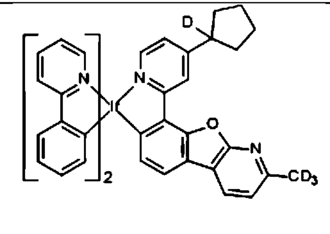 |
| 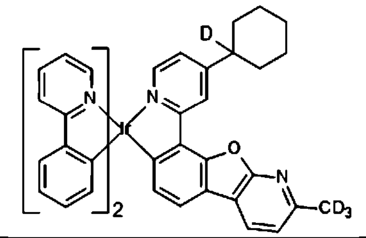 | 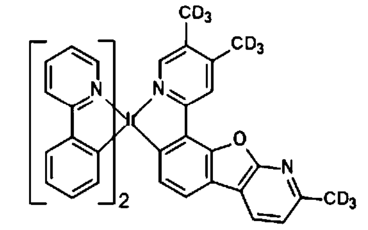 | 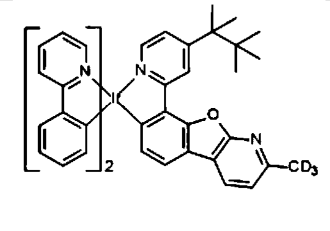 |
| 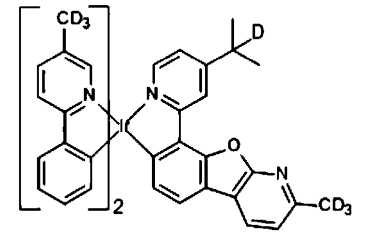 | 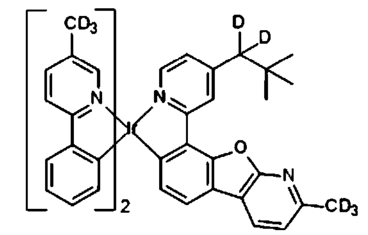 | 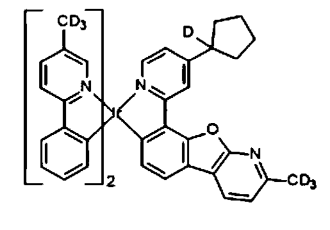 |
| 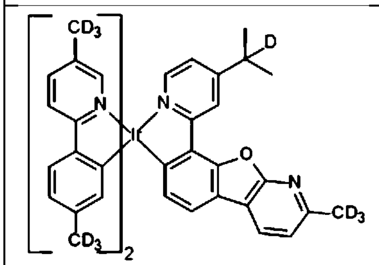 | 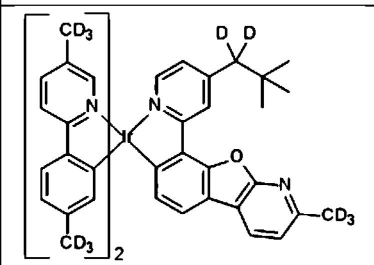 | 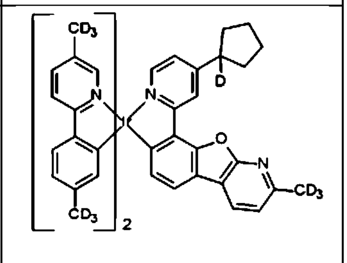 |
| 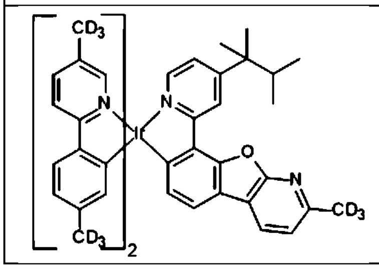 | 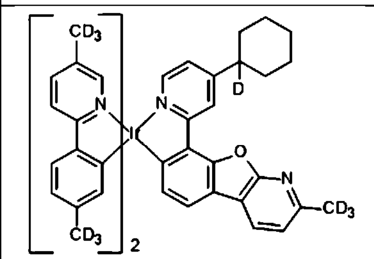 | 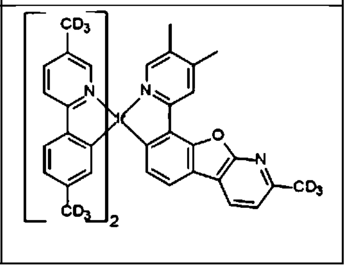 |

| | | |
|---|---|---|
| 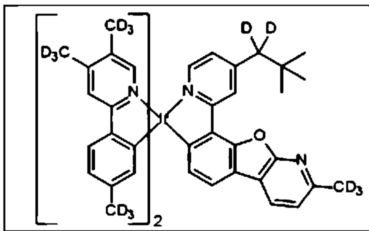 | 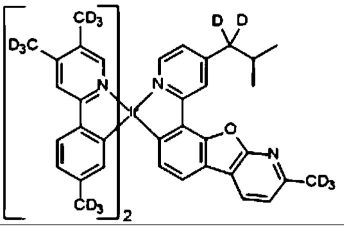 | 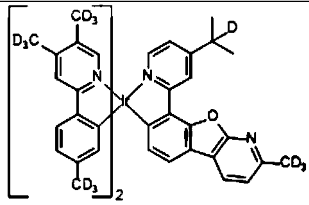 |
| 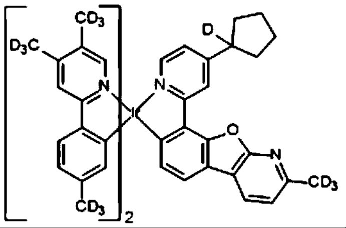 | 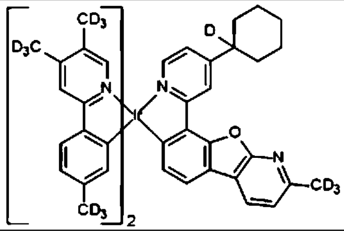 | 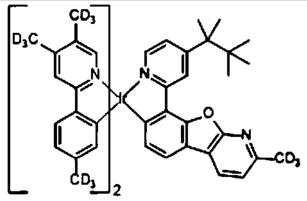 |
| 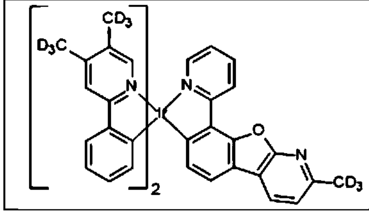 | 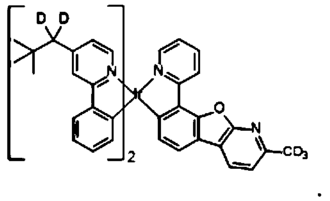 | |

**9.** Procédé de production d'un dispositif selon l'une ou plusieurs parmi les revendications 1 à 8, **caractérisé en ce que** la couche émettrice de lumière est appliquée par dépôt en phase gazeuse ou à partir d'une solution.

**10.** Procédé selon la revendication 9, **caractérisé en ce que** le au moins un composé de formule (1) et le au moins un composé de formule (2a) sont déposés à partir de la phase gazeuse successivement ou simultanément à partir d'au moins deux sources de matériau, avec le au moins un émetteur phosphorescent, et forment la couche émettrice de lumière.

**11.** Procédé selon la revendication 9, **caractérisé en ce que** le au moins un composé de formule (1) et le au moins un composé de formule (2a) sont déposés à partir de la phase gazeuse sous forme de mélange, successivement ou simultanément avec le au moins un émetteur phosphorescent, et forment la couche émettrice de lumière.

**12.** Procédé selon la revendication 9, **caractérisé en ce que** le au moins un composé de formule (1) et le au moins un composé de formule (2a) sont appliqués à partir d'une solution conjointement avec le au moins un émetteur phosphorescent, afin de former la couche émettrice de lumière.

**13.** Mélange choisi parmi la combinaison des composés 1 à 11 et 29 à 44 avec les composés 12 à 17, 23 et 24,

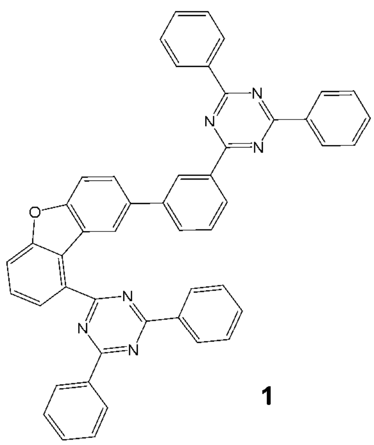
1

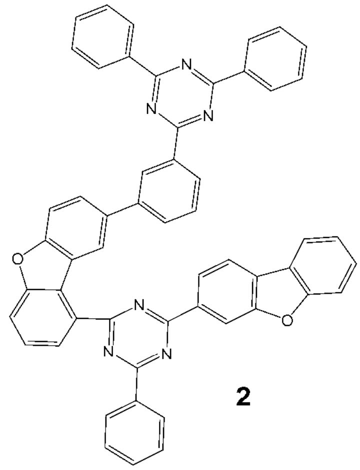
2

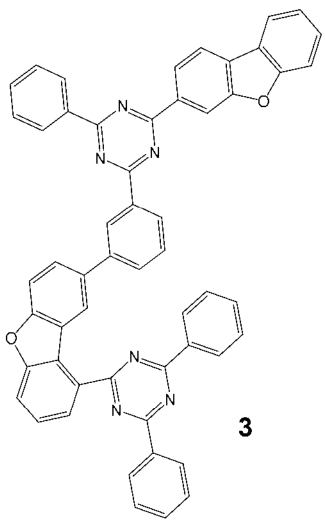
3

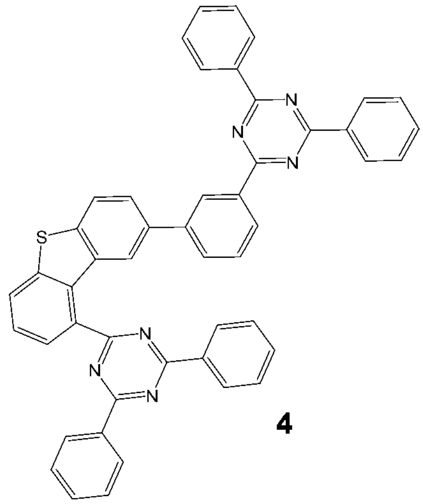

4

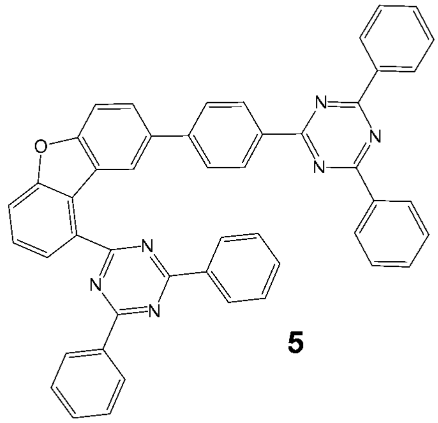

5

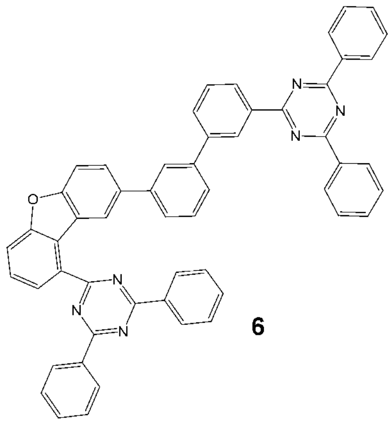

6

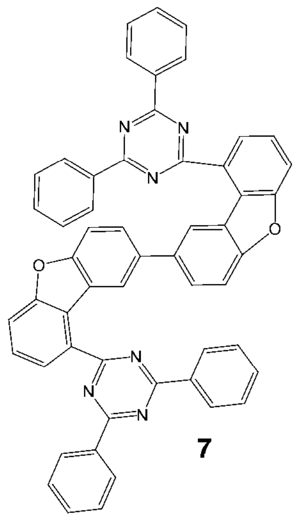

7

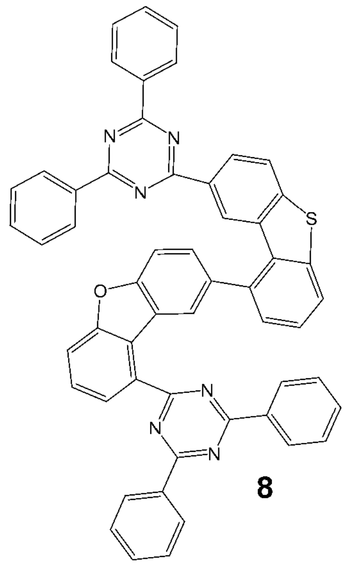

8

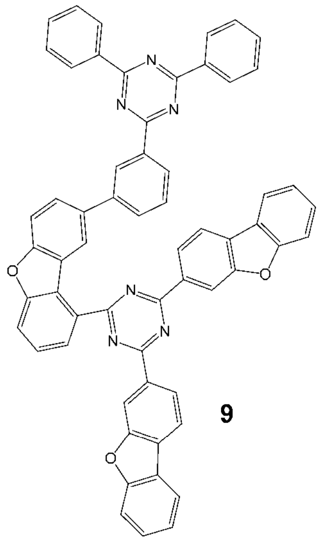

9

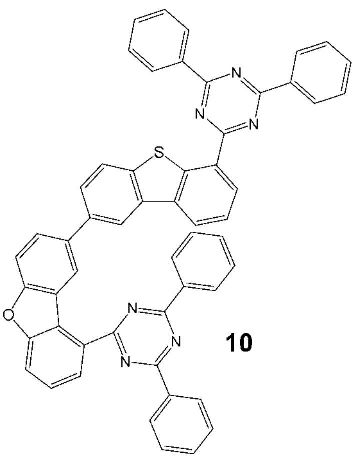

10

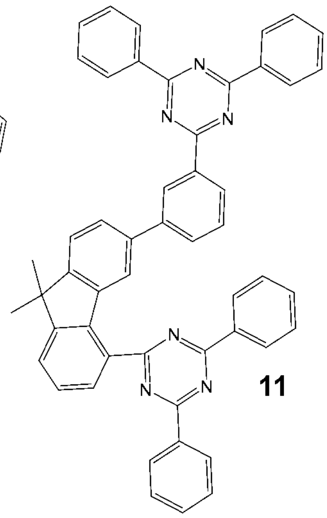

11

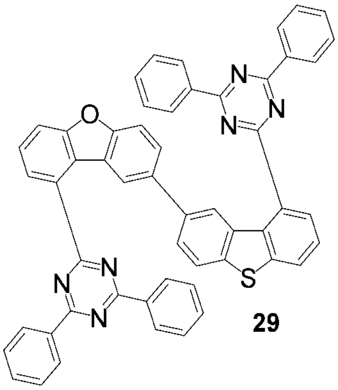

29

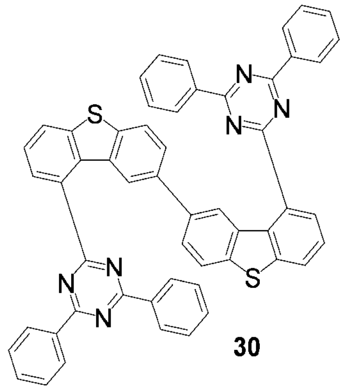

30

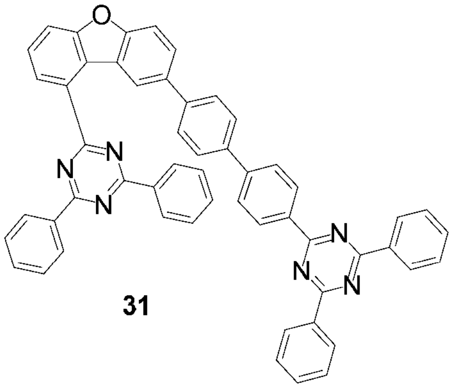

31

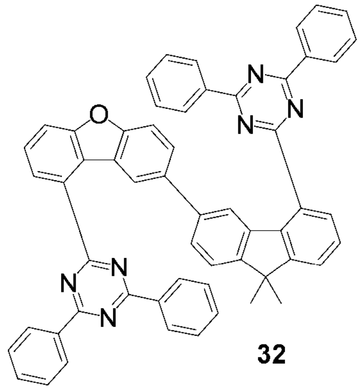

32

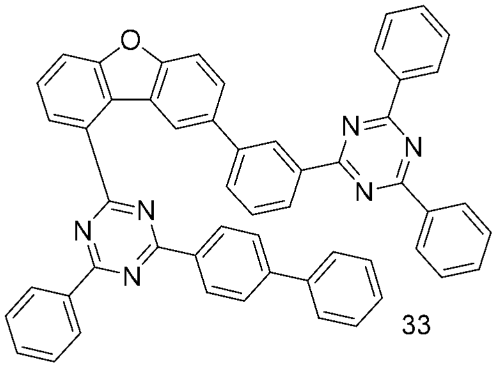

33

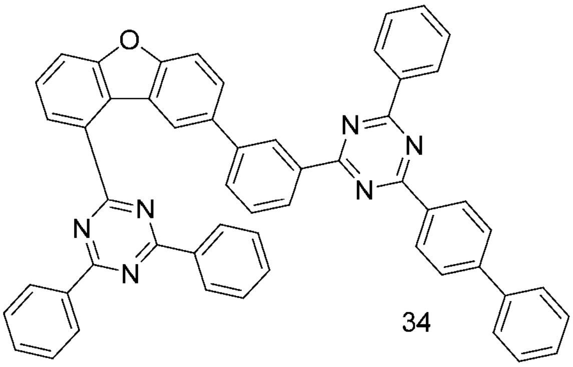

34

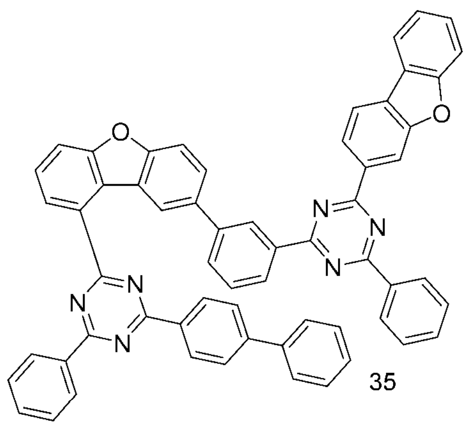

35

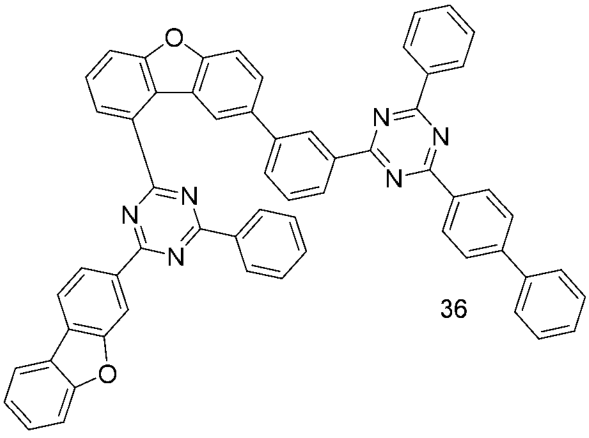

36

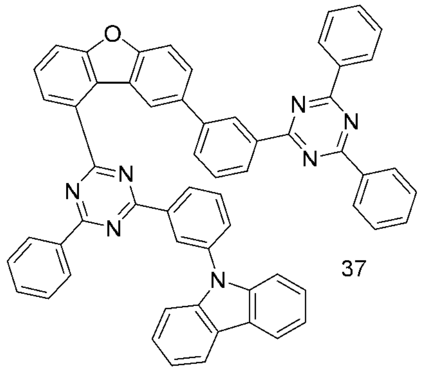

37

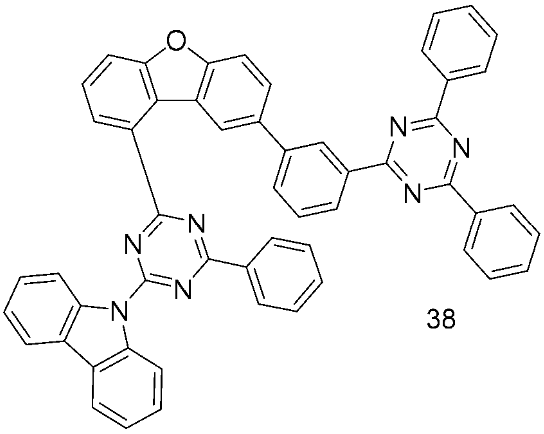

38

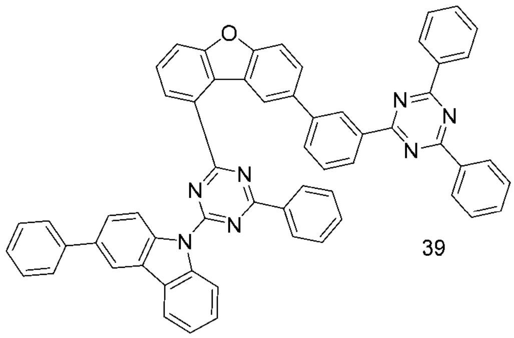

39

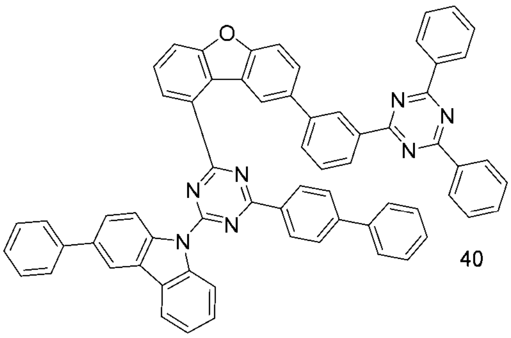

40

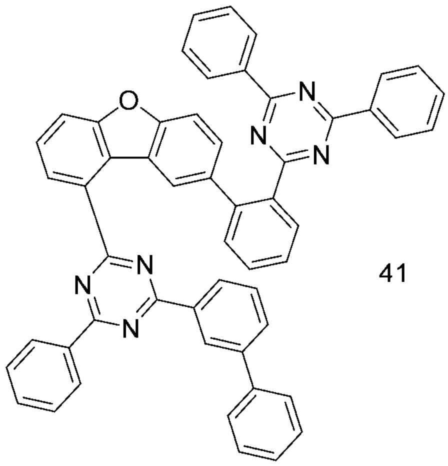

41

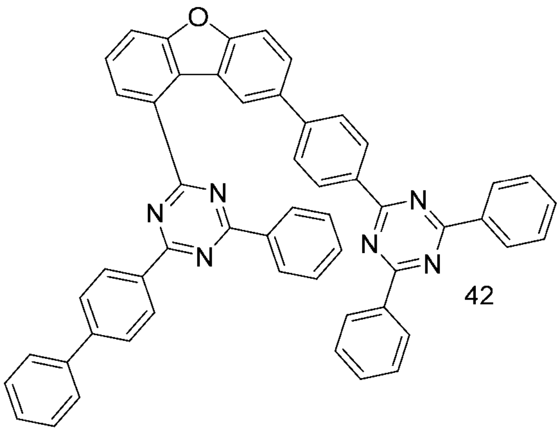

42

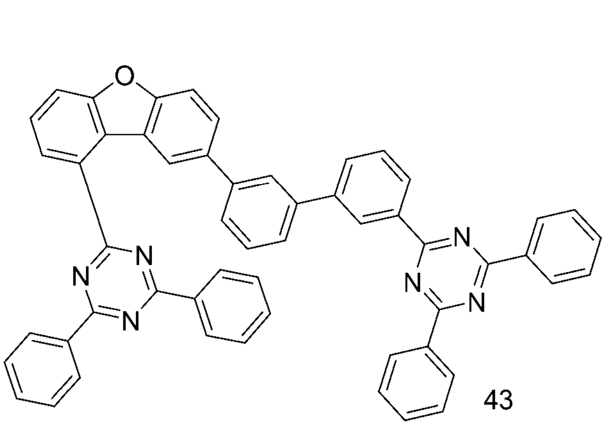

43

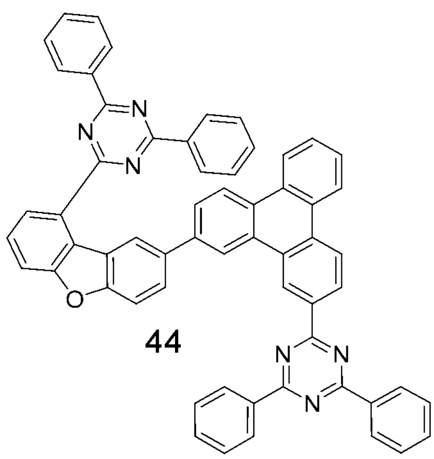

44

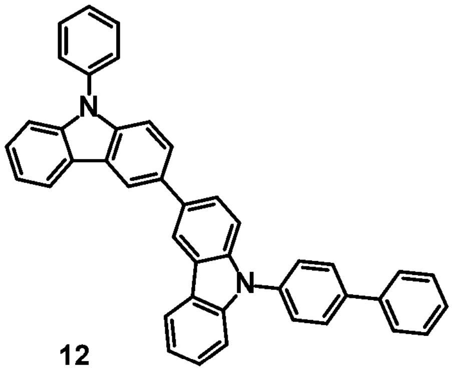

12

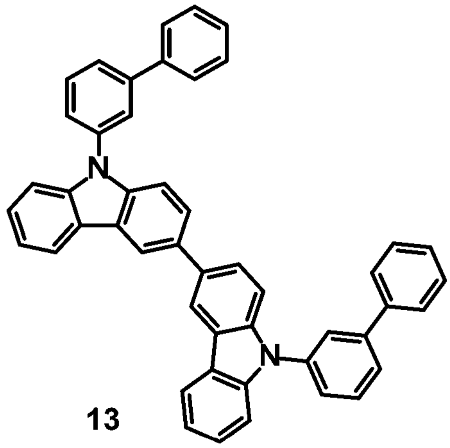

13

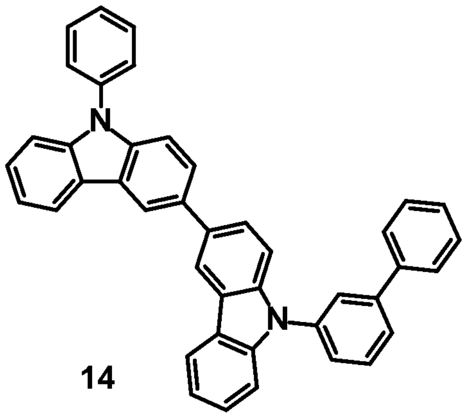

14

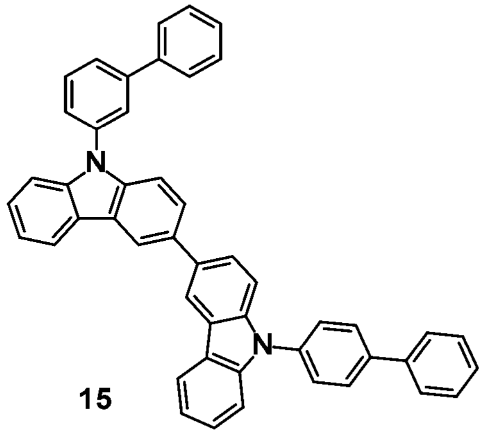

15

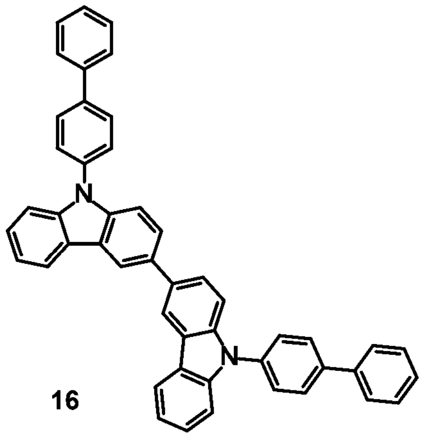

16

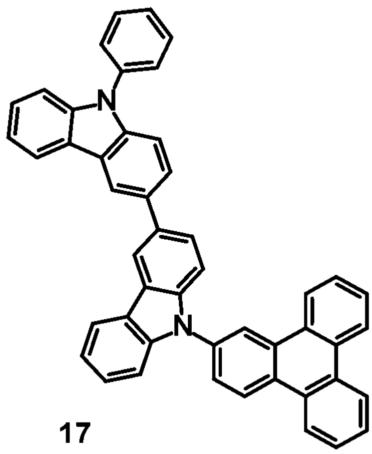

17

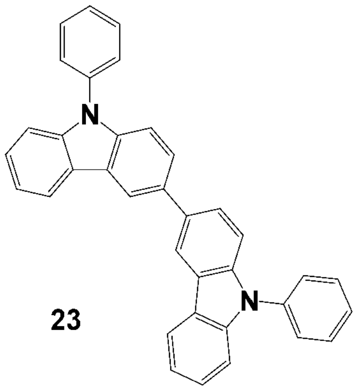

23

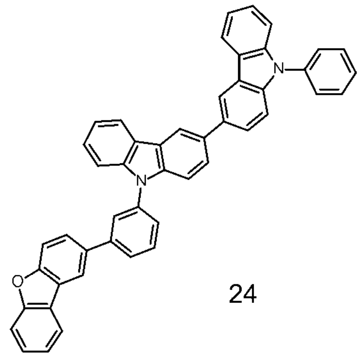

24

et un composé de formule (3),

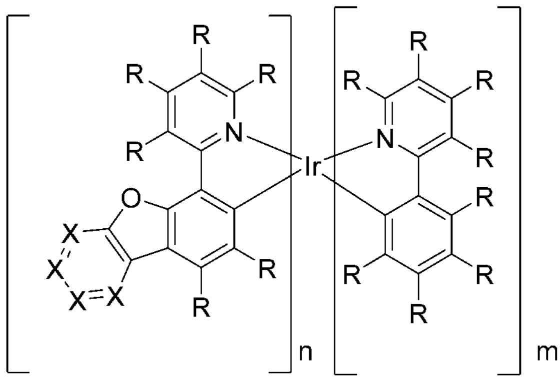

formule (3)

,

dans laquelle les symboles et indices pour cette formule (3) revêtent la signification :

n+m vaut 3, n vaut 1 ou 2, m vaut 2 ou 1,
X est N ou CR,
R est H, D ou un groupement alkyle ramifié ou linéaire ayant de 1 à 10 atomes de C ou un groupement alkyle ramifié ou linéaire partiellement ou totalement deutérié ayant de 1 à 10 atomes de C ou un groupement cycloalkyle ayant de 4 à 7 atomes de C, qui peut être partiellement ou totalement substitué par du deutérium.

**14.** Formulation comprenant un mélange selon la revendication 13 et au moins un solvant.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 6392250 B1
- US 6803720 B1
- KR 20100131745
- WO 2012048779 A
- US 20140299192 A
- JP 2015106658 B
- WO 2015169412 A
- US 2016329502 A
- US 20170054087 A
- WO 2017178311 A
- CN 108250189
- US 2019013490 A
- WO 19017730 A
- WO 19122899 A
- KR 101857703 B1
- WO 2006108497 A
- WO 2006122630 A
- WO 2008006449 A
- WO 2007140847 A
- WO 2010012328 A
- US 7294849 B
- WO 2010108579 A
- EP 676461 A
- WO 2004081017 A
- WO 2004058911 A
- WO 2005084081 A
- WO 2005084082 A
- WO 2006048268 A
- WO 2006117052 A
- WO 2008145239 A
- US 20050069729 A
- WO 2005039246 A
- JP 2004288381 A
- EP 1205527 A
- WO 2008086851 A
- WO 2011088877 A
- WO 2011128017 A
- WO 2010136109 A
- WO 2011000455 A
- EP 1617710 A
- EP 1617711 A
- EP 1731584 A
- JP 2005347160 A
- WO 2007063754 A
- WO 2008056746 A
- WO 2004093207 A
- WO 2010006680 A
- WO 2005003253 A
- WO 2007137725 A
- WO 2005111172 A
- WO 2010015306 A
- EP 652273 A
- WO 2009062578 A
- WO 2010054729 A
- WO 2010054730 A
- WO 2005011013 A
- JP 2000053957 A
- WO 2003060956 A
- WO 2004028217 A
- WO 2004080975 A
- WO 2010072300 A
- WO 06122630 A
- WO 06100896 A
- EP 1661888 A
- WO 01049806 A
- US 5061569 A
- WO 9509147 A
- WO 08006449 A
- WO 07140847 A
- WO 2012034627 A
- EP 12000929
- WO 2014015937 A
- WO 2014015938 A
- WO 2014015935 A
- WO 2013083216 A
- WO 2012150001 A


### In der Beschreibung aufgeführte Nicht-Patentliteratur


- **Y. SHIROTA et al.** *Chem. Rev.*, 2007, vol. 107 (4), 953-1010
- **Z. B. M. S. ARNOLD et al.** *Appl. Phys. Lett.*, 2008, vol. 92, 053301
- *CHEMICAL ABSTRACTS*, 73183-34-3